# EUROPEAN PATENT SPECIFICATION

(11) **EP 3 389 104 B1**
(45) Date of publication and mention of the grant of the patent: **16.09.2020**
(21) Application number: 16872910.1
(22) Date of filing: 02.12.2016
(51) Int. Cl.: C09K 11/06, H01L 51/50

(54) **LIGHT EMITTING ELEMENT**
LICHTEMITTIERENDES ELEMENT
ÉLÉMENT ÉLECTROLUMINESCENT

(30) Priority: 07.12.2015 JP 2015238662
(43) Date of publication of application: 17.10.2018
(73) Proprietor: Sumitomo Chemical Company, Limited, Tokyo 104-8260 (JP)
(72) Inventor: SASADA Toshiaki, Tsukuba-shi Ibaraki 300-3294 (JP); ASADA Kohei, Tsukuba-shi Ibaraki 300-3294 (JP); YOKOYA Seiichirou, Tokyo 104-8260 (JP); OHUCHI Kazuei, Tsukuba-shi Ibaraki 300-3294 (JP)
(74) Representative: J A Kemp LLP
(86) International application number: PCT/JP2016/085886
(87) International publication number: WO 2017/099012

(56) References cited:
- WO-A1-2008/140115
- WO-A1-2009/157424
- WO-A1-2014/097865
- WO-A1-2016/006523
- JP-A- 2013 033 915
- JP-A- 2013 197 323
- JP-A- 2014 003 249
- JP-A- 2014 148 663
- JP-A- 2016 219 490
- US-A1- 2008 038 586
- US-A1- 2011 057 559

## Description

### Technical Field

The present invention relates to a light emitting device.

### Background Art

An organic electroluminescent device (hereinafter also referred to as "light emitting device") can be suitably used for display and lighting applications, and research and development into such devices is being actively carried out.

Patent Literature 1 discloses a light emitting device comprising a first light emitting layer comprising a metal complex (M01) represented by the following formula and a second light emitting layer comprising a crosslinked product of a polymer compound comprising a constitutional unit derived from a metal complex (M02) represented by the following formula. The structure of the metal complex (M01) differs from the structure of the metal complex represented by formula (1) described later.

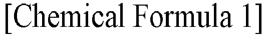

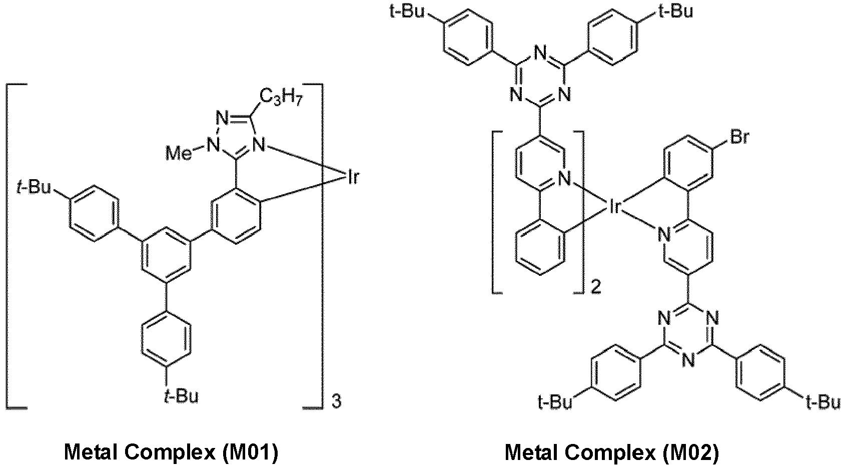

Patent Literature 2 discloses a light emitting device comprising a light emitting layer comprising a metal complex (M03) represented by the following formula. Note that this light emitting device comprises only one light emitting layer. 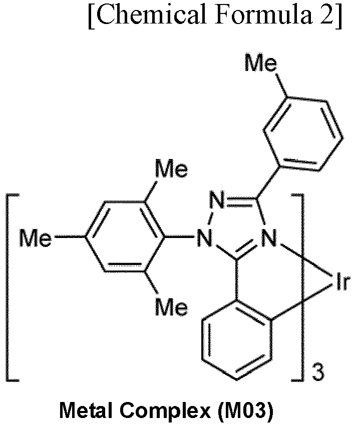 Patent Literature 3 discloses a white light emitting organic electroluminescent element comprising two electrodes having therebetween one or more constituting layers including a light emission layer, the one or more constituting layers comprising at least two phosphorescent compounds, wherein at least one of the phosphorescent compounds is a green light emitting ortho metalated complex; and a spectral ratio of the green light emitting ortho metalated complex in an emission spectral distribution in a range of 400-800 nm is not less than 60%.
Patent Literature 4 discloses devices containing twisted aryl compounds having extended conjugation in combination with dibenzothiophene or dibenzofuran containing host materials. The document also discloses compounds containing a twisted aryl having extended conjugation.

### Citation List

### Patent Literature

[Patent Literature 1]
   Japanese Unexamined Patent Publication No. 2014-148663
[Patent Literature 2]
   International Publication No. 2014/156922
[Patent Literature 3]
   US 2008/038586
[Patent Literature 4]
   US 2011/057559

### Summary of Invention

### Technical Problem

However, the light emitting devices disclosed in the above-mentioned Patent Literatures 1 and 2 do not always exhibit a sufficient luminance lifetime.

Therefore, it is an object of the present invention to provide a light emitting device which shows an excellent luminance lifetime.

### Solution to Problem

The present invention is defined in the claims.

### Advantageous Effects of Invention

According to the present invention, a light emitting device which shows an excellent luminance lifetime can be provided.

### Description of Embodiments

Preferable embodiments of the present invention will now be described in detail.

### <Description of Common Terms>

Unless otherwise stated, terms commonly used in the present specification have the following meanings.

Me represents a methyl group, Et represents an ethyl group, Bu represents a butyl group, i-Pr represents an isopropyl group, and t-Bu represents a tert-butyl group.

The hydrogen atom may be a heavy hydrogen atom or a light hydrogen atom.

In the formula representing a metal complex, a solid line representing a bond to the central metal represents a covalent bond or a coordinate bond.

The term "polymer compound" means a polymer having molecular weight distribution and having a polystyrene-equivalent number-average molecular weight of 1 ×10³ to 1 × 10⁸.

The polymer compound may be any of a block copolymer, a random copolymer, an alternating copolymer, and a graft copolymer, or may even be some other form.

If a polymerization active group remains intact at the terminal group of the polymer compound, light emitting properties may deteriorate if such a polymer compound is used to fabricate the light emitting device, and therefore, it is preferable that the terminal group be a stable group. This terminal group is preferably a group covalently bonded to the main chain, and examples thereof include groups bonding to an aryl group or a monovalent heterocyclic group via a carbon-carbon bond.

The term "low molecular weight compound" means a compound that does not have a molecular weight distribution and that has a molecular weight of 1 × 10⁴ or less.

The term "constitutional unit" means a unit occurring one or more times in a polymer compound.

The "alkyl group" may be either linear or branched. The linear alkyl group usually has 1 to 50 carbon atoms, preferably 3 to 30 carbon atoms, and more preferably 4 to 20 carbon atoms, not including the carbon atoms of the substituent. The branched alkyl group usually has 3 to 50 carbon atoms, preferably 3 to 30 carbon atoms, and more preferably 4 to 20 carbon atoms, not including the carbon atoms of the substituent.

The alkyl group may have a substituent, and examples thereof include a methyl group, an ethyl group, a propyl group, an isopropyl group, a butyl group, a 2-butyl group, an isobutyl group, a tert-butyl group, a pentyl group, an isoamyl group, 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group, and a dodecyl group, and groups obtained by substituting a hydrogen atom of these groups with a cycloalkyl group, an alkoxy group, a cycloalkoxy group, an aryl group, and a fluorine atom; and examples thereof include a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group, and a 6-ethyloxyhexyl group.

The "cycloalkyl group" usually has 3 to 50 carbon atoms, preferably 3 to 30 carbon atoms, and more preferably 4 to 20 carbon atoms, not including the carbon atoms of the substituent.

The cycloalkyl group may have a substituent, and examples thereof include a cyclohexyl group, a cyclohexylmethyl group, and a cyclohexylethyl group.

The term "aryl group" means the atomic group remaining after removing from an aromatic hydrocarbon one hydrogen atom that is directly bonded to a carbon atom constituting the ring. The aryl group usually has 6 to 60 carbon atoms, preferably 6 to 20 carbon atoms, and more preferably 6 to 10 carbon atoms, not including the carbon atoms of the substituent.

The aryl group may have a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, and a 4-phenylphenyl group, and groups obtained by substituting a hydrogen atom of these groups with an alkyl group, a cycloalkyl group, an alkoxy group, a cycloalkoxy group, an aryl group, and a fluorine atom.

The "alkoxy group" may be any of linear and branched. The linear alkoxy group usually has 1 to 40 carbon atoms, and preferably 4 to 10 carbon atoms, not including the carbon atoms of the substituent. The branched alkoxy group usually has 3 to 40 carbon atoms, and preferably 4 to 10 carbon atoms, not including the carbon atoms of the substituent.

The alkoxy group may have a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, and a lauryloxy group, and groups obtained by substituting a hydrogen atom of these groups with a cycloalkyl group, an alkoxy group, a cycloalkoxy group, an aryl group, and a fluorine atom.

The "cycloalkoxy group" usually has 3 to 40 carbon atoms, and preferably 4 to 10 carbon atoms, not including the carbon atoms of the substituent.

The cycloalkoxy group may have a substituent, and examples thereof include a cyclohexyloxy group.

The "aryloxy group" usually has 6 to 60 carbon atoms, and preferably 6 to 48, not including the carbon atoms of the substituent.

The aryloxy group may have a substituent, and examples thereof include a phenoxy group, a 1-naphthyloxy group, a 2-naphthyloxy group, a 1-anthracenyloxy group, a 9-anthracenyloxy group, and a 1-pyrenyloxy group, and groups obtained by substituting a hydrogen atom of these groups with an alkyl group, a cycloalkyl group, an alkoxy group, a cycloalkoxy group, and a fluorine atom.

The term "p-valent heterocyclic group" (p represents an integer of 1 or more) means an atomic group remaining after removing from a heterocyclic compound p atoms of hydrogen among the hydrogen atoms that are directly bonded to carbon atoms or hetero atoms constituting the ring. Among p-valent heterocyclic groups, preferable are the "p-valent aromatic heterocyclic groups", which are the atomic groups remaining after p atoms of hydrogen among the hydrogen atoms directly bonded to carbon atoms or hetero atoms constituting the ring are removed from an aromatic heterocyclic compound.

The term "aromatic heterocyclic compound" means, for example, a compound in which the heterocyclic ring itself exhibits aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, and dibenzophosphole, or a compound in which an aromatic ring is condensed to a heterocyclic ring even if the heterocyclic ring itself does not exhibit aromaticity, such as phenoxazine, phenothiazine, dibenzoborole, dibenzosilole, and benzopyran.

The monovalent heterocyclic group usually has 2 to 60 carbon atoms, and preferably 4 to 20 carbon atoms, not including the carbon atoms of the substituent.

The monovalent heterocyclic group may have a substituent, and examples thereof include a thienyl group, a pyrrolyl group, a furyl group, a pyridyl group, a piperidinyl group, a quinolinyl group, an isoquinolinyl group, a pyrimidinyl group and a triazinyl group, and groups obtained by substituting a hydrogen atom of these groups with an alkyl group, a cycloalkyl group, an alkoxy group, and a cycloalkoxy group.

The term "halogen atom" means a fluorine atom, a chlorine atom, a bromine atom, or an iodine atom.

An "amino group" may have a substituent, and a substituted amino group is preferable. As the substituent that the amino group has, an alkyl group, a cycloalkyl group, an aryl group, or a monovalent heterocyclic group is preferable.

Examples of the substituted amino group include a dialkylamino group, a dicycloalkylamino group, and a diarylamino group.

Examples of the amino group include a dimethylamino group, a diethylamino group, a diphenylamino group, a bis(4-methylphenyl)amino group, a bis(4-tert-butylphenyl)amino group, and a bis(3,5-di-tert-butylphenyl)amino group.

An "alkenyl group" may be any of linear and branched. The linear alkenyl group usually has 2 to 30 carbon atoms, and preferably 3 to 20 carbon atoms, not including the carbon atoms of the substituent. The branched alkenyl group usually has carbon atoms 3 to 30, and preferably 4 to 20 carbon atoms, not including the carbon atoms of the substituent.

A "cycloalkenyl group" usually has 3 to 30 carbon atoms, and preferably 4 to 20 carbon atoms, not including the carbon atoms of the substituent.

The alkenyl group and the cycloalkenyl group each may have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, and a 7-octenyl group, and these groups having a substituent.

An "alkynyl group" may be any of linear and branched. The alkynyl group usually has 2 to 20 carbon atoms, and preferably 3 to 20 carbon atoms, not including the carbon atoms of the substituent. The branched alkynyl group usually has 4 to 30 carbon atoms, and preferably 4 to 20 carbon atoms, not including the carbon atoms of the substituent.

A "cycloalkynyl group" usually has 4 to 30 carbon atoms, and preferably 4 to 20 carbon atoms, not including the carbon atoms of the substituent.

The alkynyl group and the cycloalkynyl group each may have a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

An "arylene group" means an atomic group remaining after removing from an aromatic hydrocarbon two hydrogen atoms that are directly bonded to a carbon atom constituting the ring. The arylene group usually has 6 to 60 carbon atoms, preferably 6 to 30 carbon atoms, and more preferably 6 to 18 carbon atoms, not including the carbon atoms of the substituent.

The arylene group may have a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups having a substituent, and preferable are groups represented by formulas (A-1) to (A-20). The arylene group may be a group obtained by bonding a plurality of these groups.

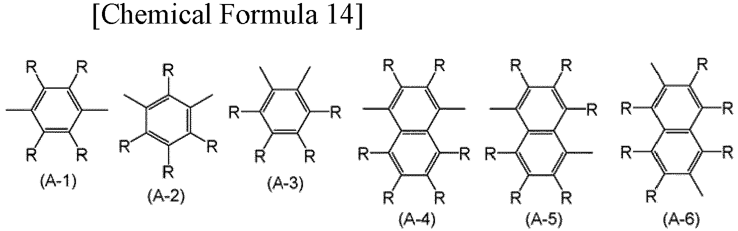

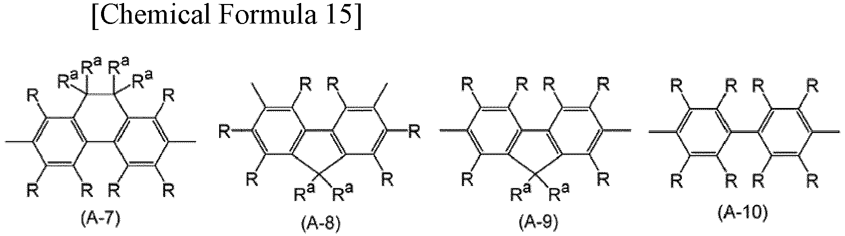

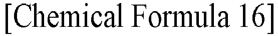

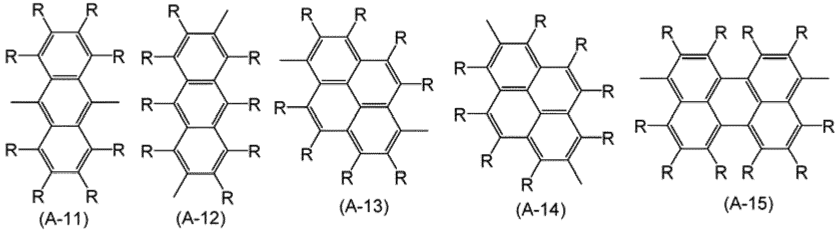

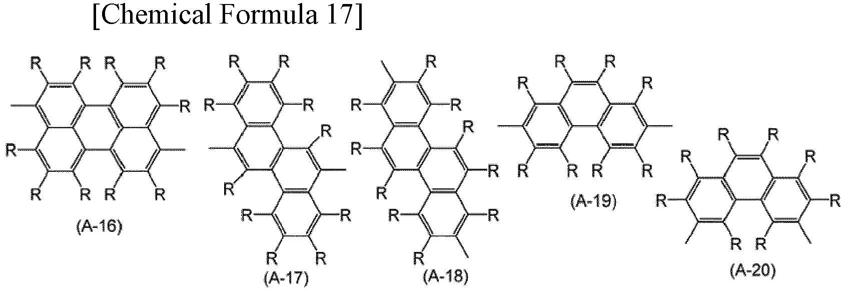

(Wherein R and R^{a} each independently represent a hydrogen atom, an alkyl group, a cycloalkyl group, an aryl group or a monovalent heterocyclic group; the plurality of R and R^{a} may be the same or different at each occurrence; and the plurality of R^{a} may be bonded to each other to form a ring together with the atoms to which they are bonded.)

The divalent heterocyclic group usually has 2 to 60 carbon atoms, preferably 3 to 20 carbon atoms, and more preferably 4 to 15 carbon atoms, not including the carbon atoms of the substituent.

The divalent heterocyclic group may have a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among the hydrogen atoms directly bonded to a carbon atom or a hetero atom constituting the ring. Preferable are groups represented by formulas (AA-1) to (AA-34). The divalent heterocyclic group may be a group obtained by bonding a plurality of these groups. 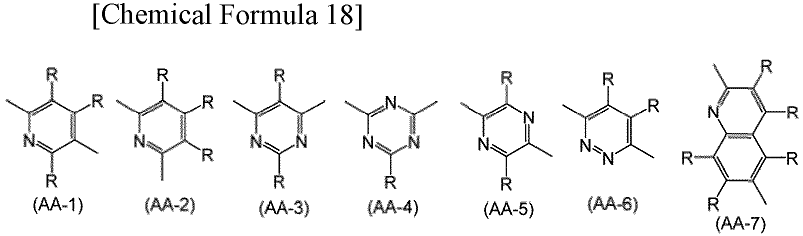 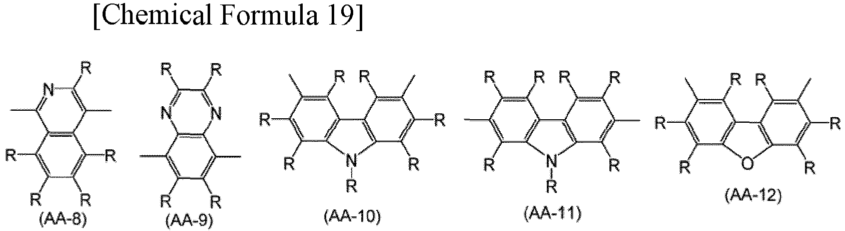 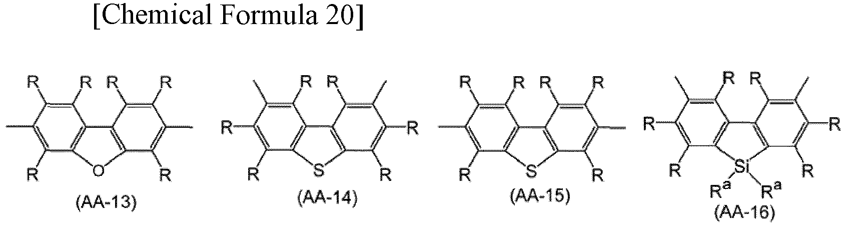 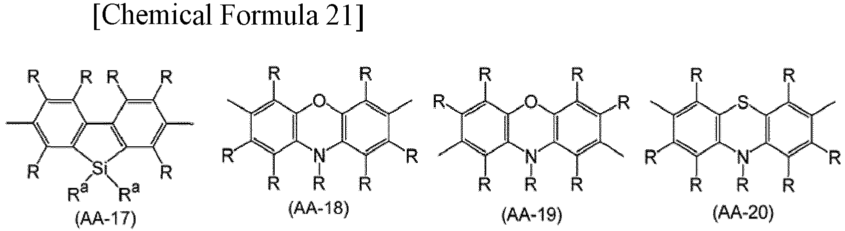 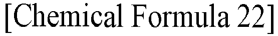 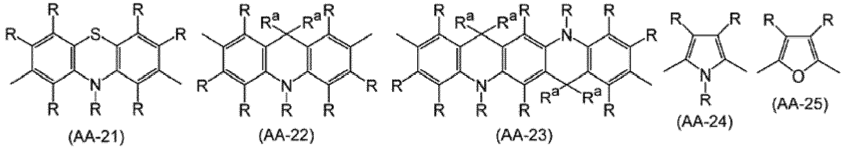 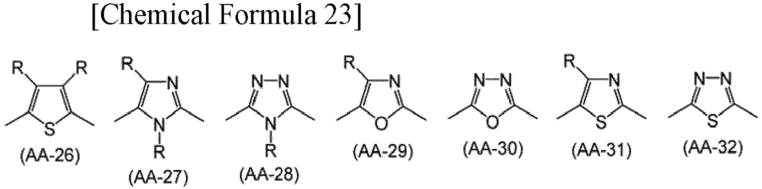 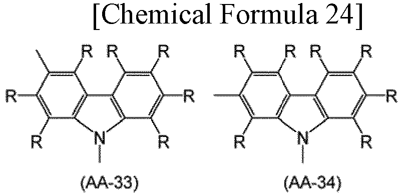 (Wherein R and R^{a} represent the same meanings as described above.)

The term "crosslinkable group" means a group capable of producing a new bond when subjected, for example, to heat, UV-irradiation, near-UV irradiation, visible light irradiation, infrared irradiation, or a radical reaction. Preferable are crosslinkable groups represented by formulas (XL-1) to (XL-17) of the group of crosslinkable groups A.

### (Group of Crosslinkable Groups A)

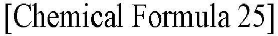

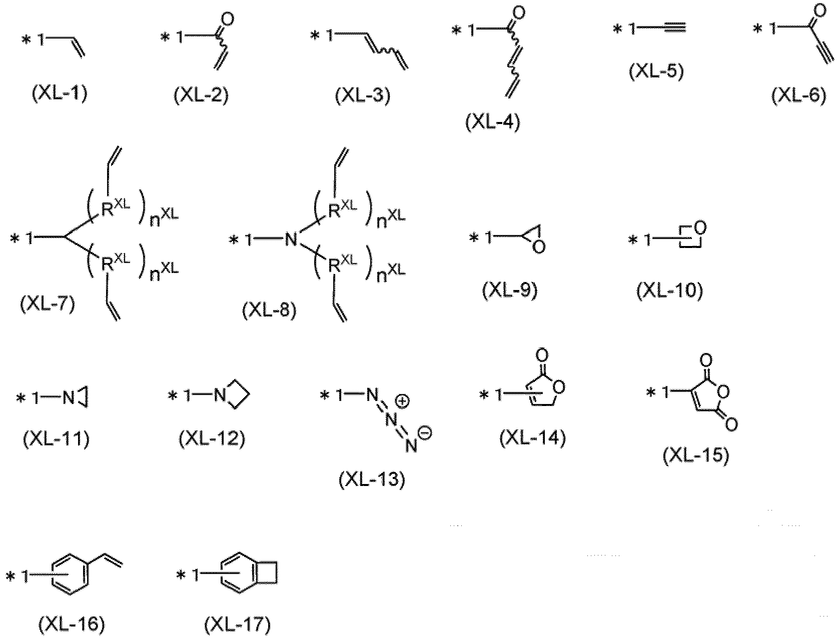

(Wherein R^{XL} represents a methylene group, an oxygen atom, or a sulfur atom, and n^{XL} represents an integer of 0 to 5; when there are a plurality of R^{XL}, they may be the same or different, and when there are a plurality of n^{XL}, they may be the same or different; *1 represents a bonding position; and these crosslinkable groups each may have a substituent.)

The term "substituent" represents a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, or a cycloalkynyl group. The substituent may also be a crosslinkable group.

### <Light Emitting Device>

Next, the light emitting device according to the present embodiment will be described.

The light emitting device according to the present embodiment comprises an anode, a cathode, a first light emitting layer provided between the anode and the cathode, and a second light emitting layer provided between the anode and the cathode, wherein the first light emitting layer comprises a metal complex represented by formula (1).

### <First Light Emitting Layer>

Next, the first light emitting layer contained in the light emitting device according to the present embodiment will be described.

The first light emitting layer is a layer comprising a metal complex represented by formula (1).

The metal complex represented by formula (1) may be contained in the first light emitting layer as it is, or in an intramolecularly, an intermolecularly, or an intramolecularly and intermolecularly crosslinked state. More specifically, the first light emitting layer may comprise a metal complex represented by formula (1) and/or a crosslinked product of the metal complex.

The first light emitting layer may also comprise a single metal complex represented by formula (1), or may comprise two or more metal complexes represented by formula (1).

The content of the metal complex represented by formula (1) in the first light emitting layer may be any content as long as the first light emitting layer exhibits a function as a light emitting layer. For example, the content of the metal complex represented by formula (1) may be 0.1 to 50% by mass, preferably 1 to 40% by mass, and more preferably 10 to 30% by mass, based on the total amount of the first light emitting layer.

The first light emitting layer may further comprise a metal complex represented by formula (2) described later.

The content of the metal complex represented by formula (2) in the first light emitting layer is not particularly limited. When the first light emitting layer comprises a metal complex represented by formula (2), the content of the metal complex represented by formula (2) is, for example, 0.01 to 50% by mass, preferably 0.1 to 20% by mass, and more preferably 0.5 to 5% by mass, based on the total amount of the first light emitting layer.

Examples of the method for forming the first light emitting layer include a vacuum evaporation method, a coating method typified by spin coating and an ink jet printing, and a coating method is preferable.

When the first light emitting layer is formed by a coating method, it is preferable to use an ink of the first light emitting layer, which is described later. After the first light emitting layer is formed, the metal complex represented by formula (1) contained in the first light emitting layer can be crosslinked by heating or irradiating with light. When the metal complex represented by formula (1) is contained in the first light emitting layer in a crosslinked state (i.e., in the case of a crosslinked product of the metal complex represented by formula (1)), the first light emitting layer is practically insoluble in solvents. As a result, the first light emitting layer can be suitably used for lamination of the light emitting device.

In the present specification, unless otherwise stated, the heating temperature for crosslinking is usually 25 to 300°C, preferably 50 to 250°C, and more preferably 150 to 200°C. The heating time is usually 0.1 minutes to 1000 minutes, preferably 1 minute to 500 minutes, more preferably 10 minutes to 100 minutes, and further preferably 50 minutes to 70 minutes.

In the present specification, unless otherwise stated, the type of light used for light irradiation for crosslinking is, for example, UV light, near-UV light, or visible light.

### [Metal Complex Represented by Formula (1)]

Next, the metal complex represented by formula (1) will be described.

The metal complex represented by formula (1) is usually a metal complex that exhibits phosphorescence at room temperature (25°C), and is preferably a metal complex that exhibits luminescence from a triplet excited state at room temperature.

The metal complex represented by formula (1) contains M¹, which is a central metal, a ligand whose number is defined by the suffix n¹, and a ligand whose number is defined by the suffix n².

M¹ is preferably an iridium atom or a platinum atom, and more preferably an iridium atom, because the luminance lifetime of the light emitting device according to the present embodiment is better.

When M¹ is a rhodium atom or an iridium atom, n¹ is preferably 2 or 3, and more preferably 3.

When M¹ is a palladium atom or a platinum atom, n¹ is preferably 2.

E¹ and E² are preferably carbon atoms.

When the ring R^{1A} is a diazole ring, it is preferably an imidazole ring in which E^{11A} is a nitrogen atom or an imidazole ring in which E^{12A} is a nitrogen atom, and more preferably the ring R^{1A} is an imidazole ring in which E^{11A} is a nitrogen atom.

When the ring R^{1A} is a triazole ring, it is preferably a triazole ring in which E^{11A} and E^{12A} are nitrogen atoms.

When E^{11A} is a nitrogen atom and R^{11A} is present, R^{11A} is preferably an alkyl group, a cycloalkyl group, an aryl group, or a monovalent heterocyclic group, more preferably an alkyl group, an aryl group, or a monovalent heterocyclic group, still more preferably an aryl group or a monovalent heterocyclic group, and particularly preferably an aryl group, and these groups each may have a substituent.

When E^{11A} is a carbon atom, R^{11A} is preferably a hydrogen atom, an alkyl group, a cycloalkyl group, an aryl group, or a monovalent heterocyclic group, more preferably a hydrogen atom, an alkyl group, a cycloalkyl group, or an aryl group, still more preferably a hydrogen atom, an alkyl group, or a cycloalkyl group, and particularly preferably a hydrogen atom, and these groups each may have a substituent.

When E^{12A} is a nitrogen atom and R^{12A} is present, R^{12A} is preferably an alkyl group, a cycloalkyl group, an aryl group, or a monovalent heterocyclic group, more preferably an aryl group or a monovalent heterocyclic group, and still more preferably an aryl group, and these groups each may have a substituent.

When E^{12A} is a carbon atom, R^{12A} is preferably a hydrogen atom, an alkyl group, a cycloalkyl group, an aryl group, or a monovalent heterocyclic group, more preferably a hydrogen atom, an alkyl group, a cycloalkyl group, or an aryl group, still more preferably a hydrogen atom, an alkyl group, or a cycloalkyl group, and particularly preferably a hydrogen atom, and these groups each may have a substituent.

The aryl group in R^{11A} and R^{12A} is preferably a phenyl group, a naphthyl group, an anthracenyl group, a phenthrenyl group, a dihydrooenthrenyl group, a fluorenyl group, or a pyrenyl group, more preferably a phenyl group, a naphthyl group or a fluorenyl group, and still more preferably a phenyl group, and these groups each may have a substituent.

Preferable examples of the monovalent heterocyclic group in R^{11A} and R^{12A} include a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group, and a phenothiazinyl group, more preferable are a pyridyl group, a pyrimidinyl group, a triazinyl group, a dibenzofuranyl group, a carbazolyl group, an azacarbazolyl group, and a diazacarbazolyl group, and still more preferable are a pyridyl group, a pyrimidinyl group and a triazinyl group, and these groups each may have a substituent.

In the substituted amino group of R^{11A} and R^{12A}, the substituent possessed by the amino group is preferably an aryl group or a monovalent heterocyclic group, and these groups each may further have a substituent. The examples and preferable ranges of the aryl group in the substituent that the amino group has are the same as the examples and preferable ranges of the aryl group in R^{11A} and R^{12A}. The examples and preferable ranges of the monovalent heterocyclic group in the substituent that the amino group has are the same as the examples and preferable ranges of the monovalent heterocyclic group in R^{11A} and R^{12A}.

The optional substituents of R^{11A} and R^{12A} are preferably an alkyl group, a cycloalkyl group, an aryl group, a monovalent heterocyclic group, an alkoxy group, a cycloalkoxy group, an aryloxy group, or a substituted amino group, more preferably an alkyl group, a cycloalkyl group, an aryl group, a monovalent heterocyclic group, or a substituted amino group, still more preferably an alkyl group, a cycloalkyl group, an aryl group, or a monovalent heterocyclic group, and particularly preferably an alkyl group or an aryl group, and these groups each may further have a substituent.

The aryl group, monovalent heterocyclic group, or substituted amino group in R^{11A} and R^{12A} is preferably a group represented by formula (D-A), (D-B), or (D-C), more preferably a group represented by formula (D-A) or (D-C), and still more preferably a group represented by formula (D-C), because the luminance lifetime of the light emitting device according to the present embodiment is better. 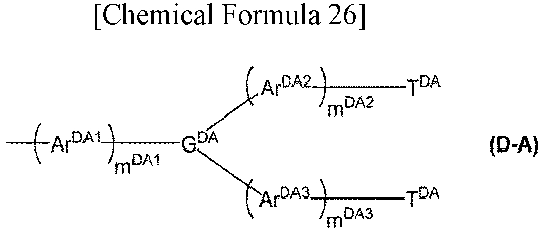 (Wherein,
m^{DA1}, m^{DA2}, and m^{DA3} each independently represent an integer of 0 or more,
G^{DA} represents a nitrogen atom, an aromatic hydrocarbon group, or a heterocyclic group, and these groups each may have a substituent,
Ar^{DA1}, Ar^{DA2}, and Ar^{DA3} each independently represent an arylene group or a divalent heterocyclic group, and these groups each may have a substituent; and when there are a plurality of Ar^{DA1}, Ar^{DA2}, and Ar^{DA3}, they may be the same or different at each occurrence, and
T^{DA} represents an aryl group or a monovalent heterocyclic group, and these groups each may have a substituent; and the plurality of T^{DA} may be the same or different.) 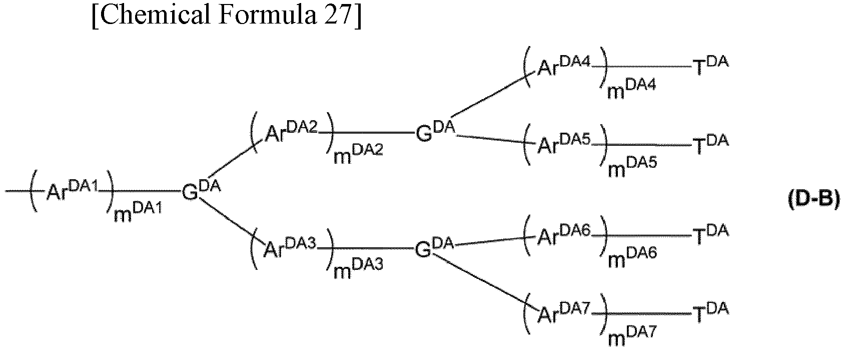
(Wherein,
m^{DA1}, m^{DA2}, m^{DA3}, m^{DA4}, m^{DA5}, m^{DA6}, and m^{DA7} each independently represent an integer of 0 or more,
G^{DA} represents a nitrogen atom, an aromatic hydrocarbon group, or a heterocyclic group, and these groups each may have a substituent; the plurality of G^{DA} may be the same or different,
AR^{DA1}, Ar^{DA2}, Ar^{DA3}, Ar^{DA4}, Ar^{DA5}, Ar^{DA6}, and Ar^{DA7} each independently represent an arylene group or a divalent heterocyclic group, and these groups each may have a substituent; and when there are a plurality of Ar^{DA1}, Ar^{DA2}, Ar^{DA3}, Ar^{DA4}, Ar^{DA5}, Ar^{DA6}, and Ar^{DA7}, they may be the same or different at each occurrence, and
T^{DA} represents an aryl group or a monovalent heterocyclic group, and these groups each may have a substituent; the plurality of T^{DA} may be the same or different.) 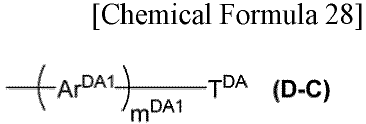
(Wherein,
m^{DA1} represents an integer of 0 or more,
Ar^{DA1} represents an arylene group or a divalent heterocyclic group, and these groups each may have a substituent; and when there are a plurality of Ar^{DA1}, they may be the same or different, and
T^{DA} represents an aryl group or a monovalent heterocyclic group, and these groups each may have a substituent.)

m^{DA1}, m^{DA2}, m^{DA3}, m^{DA4}, m^{DA5}, m^{DA6}, and m^{DA7} are generally an integer of 10 or less, preferably an integer of 5 or less, more preferably an integer of 2 or less, and still more preferably 0 or 1. It is preferable that m^{DA2}, m^{DA3}, m^{DA4}, m^{DA5}, m^{DA6}, and m^{DA7} are the same integer, and it is more preferable that m^{DA1} , m^{DA2} , m^{DA3}, m^{DA4}, m^{DA5} , m^{DA6} , and m^{DA7} are the same integer.

G^{DA} is preferably a group represented by formula (GDA-11) to (GDA-15), more preferably a group represented by formula (GDA-11) to (GDA-14), still more preferably a group represented by formula (GDA-11) or (GDA-14), and particularly preferably a group represented by formula (GDA-11). 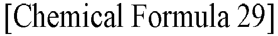 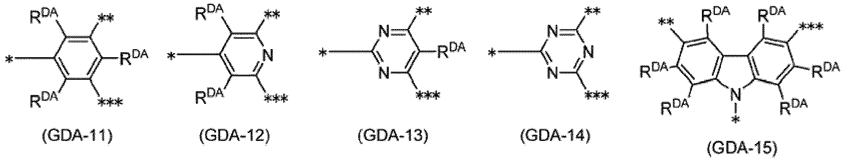 (Wherein,
* represents a bond with Ar^{DA1} in formula (D-A), Ar^{DA1} in formula (D-B), Ar^{DA2} in formula (D-B), or Ar^{DA3} in formula (D-B),
** represents a bond with Ar^{DA2} in formula (D-A), Ar^{DA2} in formula (D-B), Ar^{DA4} in formula (D-B), or Ar^{DA6} in formula (D-B),
*** represents a bond with Ar^{DA3} in formula (D-A), Ar^{DA3} in formula (D-B), Ar^{DA5} in formula (D-B), or Ar^{DA7} in formula (D-B), and

R^{DA} represents a hydrogen atom, an alkyl group, a cycloalkyl group, an alkoxy group, a cycloalkoxy group, an aryl group, or a monovalent heterocyclic group, and these groups each may further have a substituent; when there are a plurality of R^{DA}, they may be the same or different.)

R^{DA} is preferably a hydrogen atom, an alkyl group, a cycloalkyl group, an alkoxy group, or a cycloalkoxy group, more preferably a hydrogen atom, an alkyl group, or a cycloalkyl group, and these groups each may have a substituent.

Ar^{DA1}, Ar^{DA2}, Ar^{DA3}, Ar^{DA4}, Ar^{DA5}, Ar^{DA6}, and Ar^{DA7} are preferably a phenylene group, a fluorenediyl group, or a carbazolediyl group, more preferably a group represented by formula (A-1) to (A-3), (A-8), (A-9), (AA-10), (AA-11), (AA-33), or (AA-34), and still more preferably a group represented by formula (ArDA-1) to (ArDA-5), particularly preferably a group represented by formula (ArDA-1) to (ArDA-3), and especially preferably a group represented by formula (ArDA-1). 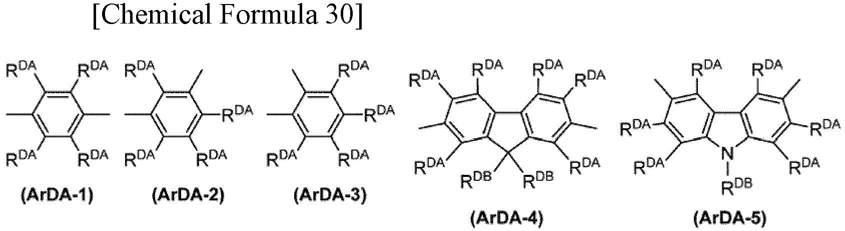
(Wherein R^{DA} represents the same meaning as described above,
R^{DB} represents a hydrogen atom, an alkyl group, a cycloalkyl group, an aryl group, or a monovalent heterocyclic group, and these groups each may have a substituent; and when there are a plurality of R^{DB}, they may be the same or different.)

R^{DB} is preferably an alkyl group, a cycloalkyl group, an aryl group, or a monovalent heterocyclic group, more preferably an aryl group or a monovalent heterocyclic group, and still more preferably an aryl group, and these groups each may have a substituent.

T^{DA} is preferably a group represented by formula (TDA-1) to (TDA-3), more preferably a group represented by formula (TDA-1). 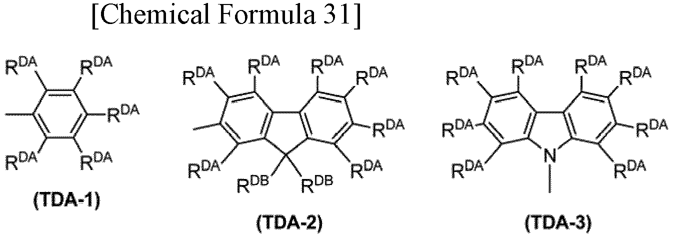 (Wherein R^{DA} and R^{DB} represent the same meanings as described above.)

The group represented by formula (D-A) is preferably a group represented by formula (D-A1) to (D-A4), more preferably a group represented by formula (D-A1) or (D-A4), and still more preferably a group represented by formula (D-A1). 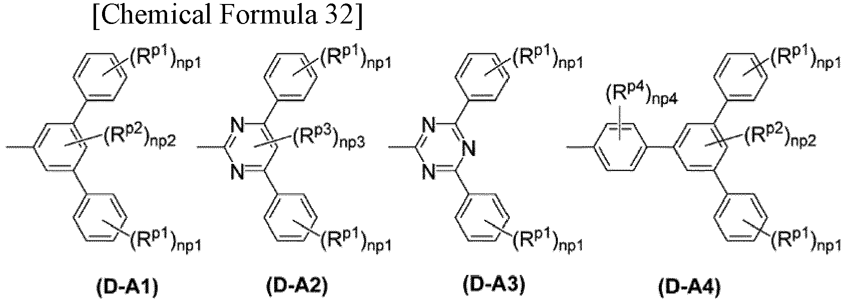 (Wherein,
R^{p1}, R^{p2}, R^{p3}, and R^{p4} each independently represent an alkyl group, a cycloalkyl group, an alkoxy group, a cycloalkoxy group, or a fluorine atom; when there are a plurality of R^{p1}, R^{p2}, and R^{p4}, they may be the same or different at each occurrence, and
np1 represents an integer of 0 to 5, np2 represents an integer of 0 to 3, np3 represents 0 or 1, and np4 represents an integer of 0 to 4; the plurality of np1 may be the same or different.)

The group represented by formula (D-B) is preferably a group represented by formula (D-B1) to (D-B3), and more preferably a group represented by formula (D-B1). 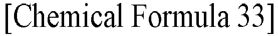 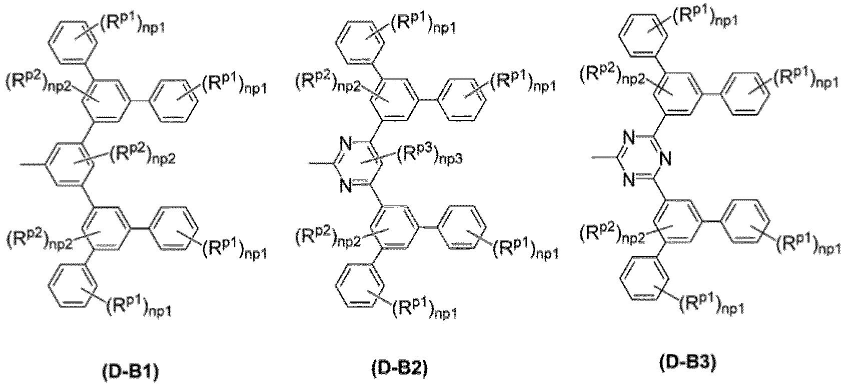 (Wherein,
R^{p1}, R^{p2}, and R^{p3} each independently represent an alkyl group, a cycloalkyl group, an alkoxy group, a cycloalkoxy group, or a fluorine atom; when there are a plurality of R^{p1} and R^{p2}, they may be the same or different at each occurrence, and
np1 represents an integer of 0 to 5, np2 represents an integer of 0 to 3, and np3 represents 0 or 1; when there are a plurality of np1 and np2, they may be the same or different at each occurrence.)

The group represented by formula (D-C) is preferably a group represented by formula (D-C1) to (D-C4), more preferably a group represented by formula (D-C1) to (D-C3), and more preferably a group represented by formula (D-C1) or (D-C2). 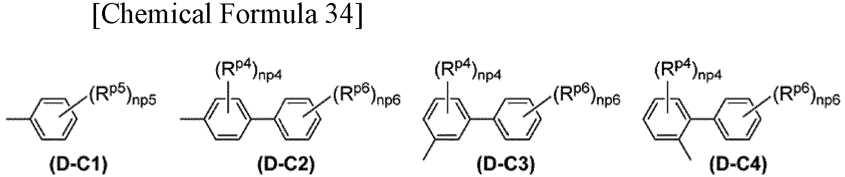
(Wherein R^{p4}, R^{p5}, and R^{p6} each independently represent an alkyl group, a cycloalkyl group, an alkoxy group, a cycloalkoxy group, or a fluorine atom; when there are a plurality of R^{p4}, R^{p5}, and R^{p6}, they may be the same or different at each occurrence, and
np4 represents an integer of 0 to 4, np5 represents an integer of 0 to 5, and np6 represents an integer of 0 to 5.)

np1 is preferably 0 or 1, more preferably 1. np2 is preferably 0 or 1, and more preferably 0. np3 is preferably 0. np4 is preferably an integer of 0 to 2. np 5 is preferably an integer of 1 to 3. np6 is preferably an integer of 0 to 2.

R^{p1}, R^{p2}, R^{p3}, R^{p4}, R^{p5}, and R^{p6} are preferably an alkyl group or a cycloalkyl group, more preferably a methyl group, an ethyl group, an isopropyl group, a tert-butyl group, a hexyl group, a 2-ethylhexyl group, a cyclohexyl, a methoxy group, a 2-ethylhexyloxy group, a tert-octyl group or a cyclohexyloxy group, and still more preferably a methyl group, an ethyl group, an isopropyl group, a tert-butyl group, a hexyl group, a 2-ethylhexyl group, or a tert-octyl group.

Examples of the group represented by formula (D-A) include groups represented by formulas (D-A-1) to (D-A-12). 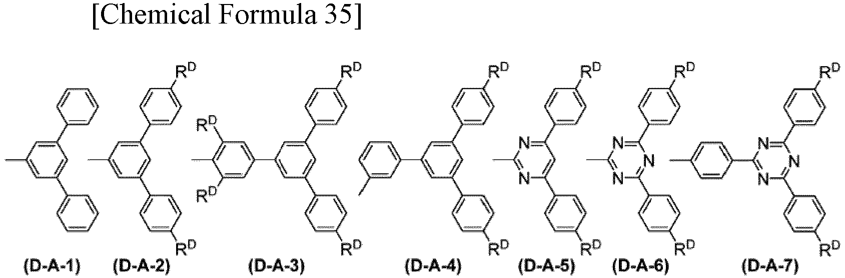 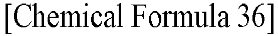 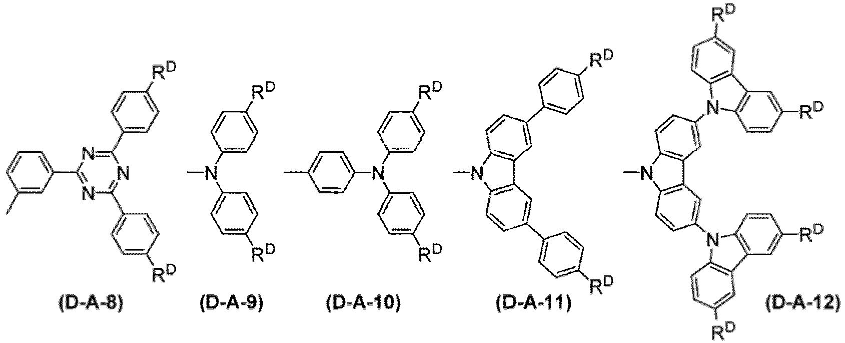 (Wherein,
R^{D} represents a methyl group, an ethyl group, an isopropyl group, a tert-butyl group, a hexyl group, a 2-ethylhexyl group, a tert-octyl group, a cyclohexyl group, a methoxy group, a 2-ethylhexyloxy group, or a cyclohexyloxy group; when there are a plurality of R^{D}, they may be the same or different.)

Examples of the group represented by formula (D-B) include groups represented by formulas (D-B-1) to (D-B-4). 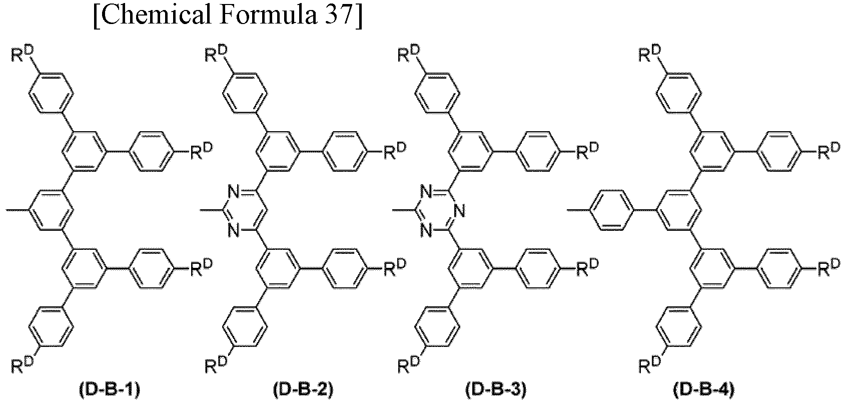 (Wherein,
R^{D} represents the same meaning as described above.

Examples of the group represented by formula (D-C) include groups represented by formulas (D-C-1) to (D-C-17). 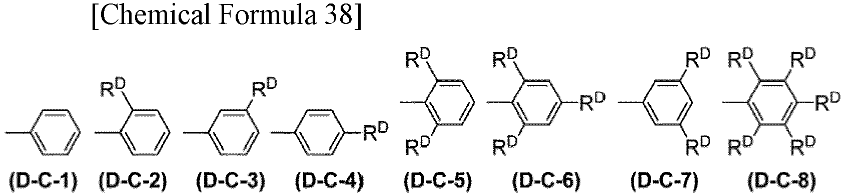 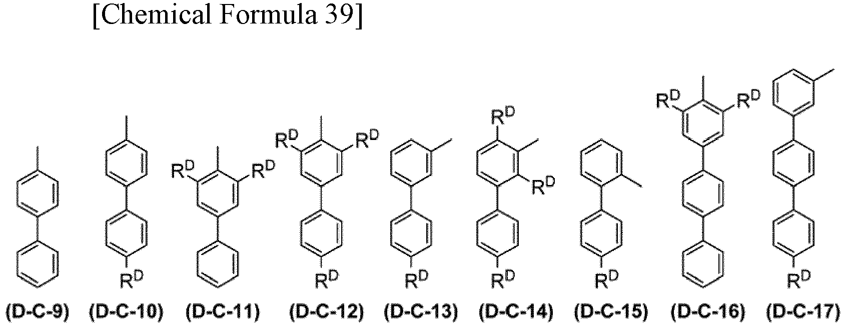 (Wherein R^{D} represents the same meaning as described above.)

R^{D} is preferably a methyl group, an ethyl group, an isopropyl group, a tert-butyl group, a hexyl group, a 2-ethylhexyl group, or a tert-octyl group.

To achieve a better luminance lifetime of the light emitting device according to the present embodiment, at least one selected from the group consisting of R^{11A} and R^{12A} is preferably an aryl group which may have a substituent or a monovalent heterocyclic group which may have a substituent, more preferably is an aryl group which may have a substituent, still more preferably is a group represented by formula (D-A1), (D-A4), (D-B1), or (D-C1) to (D-C4), particularly preferably a group represented by formula (D-C1) to (D-C3), especially preferably a group represented by formula (D-C1) or (D-C2), and even more especially preferably a group represented by formula (D-C1).

When at least one member selected from the group consisting of R^{11A} and R^{12A} is an aryl group which may have a substituent or a monovalent heterocyclic group which may have a substituent, it is preferable that R^{11A} be an aryl group which may have a substituent or a monovalent heterocyclic group which may have a substituent, and it is more preferable that R^{11A} be an aryl group which may have a substituent.

R^{11A} and R^{12A} may be bonded to each other to form a ring together with the atoms to which they are bonded, but because the maximum peak wavelength of the emission spectrum of the metal complex represented by formula (1) becomes a long wavelength, it is preferable not to form a ring.

R^{13A} is preferably an aryl group or a monovalent heterocyclic group, and more preferably an aryl group, and these groups each may have a substituent.

The examples and preferable ranges of the aryl group, the monovalent heterocyclic group, and the substituted amino group in R^{13A} are each the same as the examples and preferable ranges of the aryl group, the monovalent heterocyclic group, and the substituted amino group in R^{11A} and R^{12A}.

The examples and preferable ranges of the optional substituent of R^{13A} are the same as the examples and preferable ranges of the optional substituents of R^{11A} and R^{12A}.

The ring R² is preferably a 5-or 6-membered aromatic hydrocarbon ring or a 5-or 6-membered aromatic heterocyclic ring, more preferably a 6-membered aromatic hydrocarbon ring or a 6-membered aromatic heterocyclic ring, and still more preferably a 6-membered aromatic hydrocarbon ring, and these rings each may have a substituent. When the ring R² is a 6-membered aromatic heterocyclic ring, E² is preferably a carbon atom.

Examples of the ring R² include a benzene ring, a naphthalene ring, a fluorene ring, a phenanthrene ring, an indene ring, a pyridine ring, a diazabenzene ring, and a triazine ring, A benzene ring, a naphthalene ring, a fluorene ring, a pyridine ring, or a pyrimidine ring is preferable, a benzene ring, a pyridine ring, or a pyrimidine ring is more preferable, and a benzene ring is still more preferable, and these rings each may have a substituent.

The optional substituent of the ring R² is preferably a fluorine atom, an alkyl group, a cycloalkyl group, an alkoxy group, a cycloalkoxy group, an aryloxy group, an aryl group, a monovalent heterocyclic group, or a substituted amino group, more preferably an alkyl group, a cycloalkyl group, an alkoxy group, an aryl group, a monovalent heterocyclic group, or a substituted amino group, still more preferably an alkyl group, a cycloalkyl group, an aryl group, a monovalent heterocyclic group, or a substituted amino group, particularly preferably an alkyl group or a group represented by formula (D-A), (D-B), or (D-C), especially preferably a group represented by formula (D -D), (D-B) or (D-C), even more especially preferably a group represented by formula (D-A) or (D-C), and most preferably a group represented by (D-A), and these groups each may further have a substituent.

The examples and preferable ranges of the aryl group, the monovalent heterocyclic group, and the substituted amino group of the optional substituent of the ring R² are each the same as the examples and preferable ranges of the aryl group, the monovalent heterocyclic group, and the substituted amino group in R^{11A} and R^{12A}.

The examples and preferable ranges of the substituent that the optional substituent of the ring R² may further have are the same as the examples and preferable ranges of the optional substituents of R^{11A} and R^{12A}.

### [Anionic Bidentate Ligand]

Examples of the anionic bidentate ligand represented by A¹-G¹-A² include ligands represented by the following formulas. 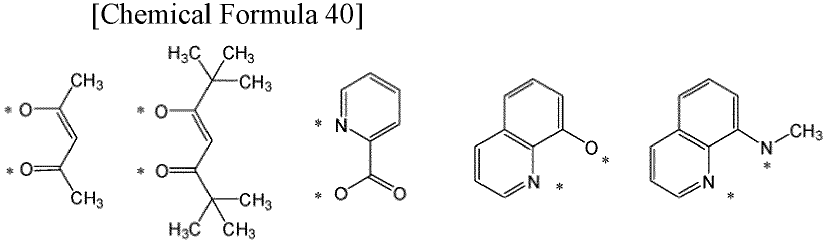 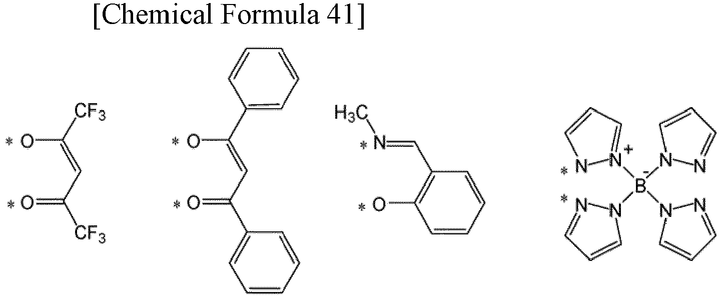 (Wherein * represents a site that binds to M¹.)

The anionic bidentate ligand represented by A¹-G¹-A² may be a ligand represented by the following formulas. The anionic bidentate ligand represented by A¹-G¹-A² is different from the ligand whose number is defined by the suffix n¹. 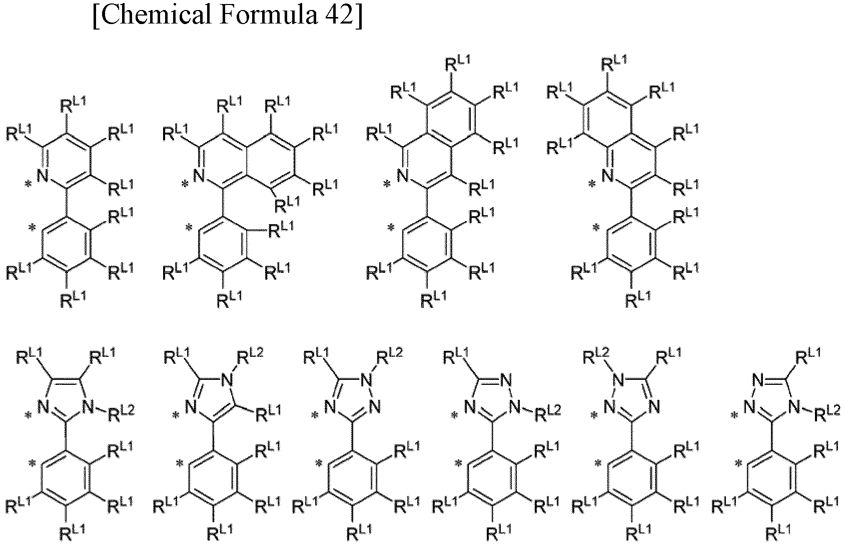 (Wherein,
* represents a site that binds to M¹,
R^{L1} represents a hydrogen atom, an alkyl group, a cycloalkyl group, or a halogen atom, and these groups each may have a substituent; the plurality of R^{L1} may be the same or different, and
R^{L2} represents an alkyl group, a cycloalkyl group, an aryl group, a monovalent heterocyclic group, or a halogen atom, and these groups each may have a substituent.)

R^{L1} is preferably a hydrogen atom, an alkyl group, a cycloalkyl group, or a fluorine atom, and more preferably a hydrogen atom or an alkyl group, and these groups each may have a substituent.

R^{L2} is preferably an alkyl group, a cycloalkyl group, an aryl group, or a monovalent heterocyclic group, more preferably an aryl group or a monovalent heterocyclic group, and still more preferably an aryl group, and these groups each may have a substituent.

The metal complex represented by formula (1) is preferably a metal complex represented by formula (1-A), because the luminance lifetime of the light emitting device according to the present embodiment is better.

When the ring R^{2A} is a pyridine ring, a pyridine ring in which E^{21A} is a nitrogen atom, a pyridine ring in which E^{22A} is a nitrogen atom, or a pyridine ring in which E^{23A} is a nitrogen atom is preferable, and a pyridine ring in which E^{22A} is a nitrogen atom is more preferable.

When the ring R^{2A} is a pyrimidine ring, a pyrimidine ring in which E^{21A} and E^{23A} are nitrogen atoms, or a pyrimidine ring in which E^{22A} and E^{24A} are nitrogen atoms is preferable, and a pyrimidine ring in which E^{22A} and E^{24A} are nitrogen atoms is more preferable.

The ring R^{2A} is preferably a benzene ring.

R^{21A}, R^{22A}, R^{23A}, and R^{24A} are preferably a hydrogen atom, a fluorine atom, an alkyl group, a cycloalkyl group, an alkoxy group, a cycloalkoxy group, an aryloxy group, an aryl group, a monovalent heterocyclic group, or a substituted amino group, more preferably a hydrogen atom, an alkyl group, a cycloalkyl group, an alkoxy group, an aryl group, a monovalent heterocyclic group, or a substituted amino group, still more preferably a hydrogen atom, an alkyl group, a cycloalkyl group, an aryl group, a monovalent heterocyclic group, or a substituted amino group, particularly preferably a hydrogen atom, an alkyl group or a group represented by formula (D-A), (D-B) or (D-C), especially preferably a hydrogen atom or a group represented by formula (D-A), (D-B) or (D-C), even more especially preferably a hydrogen atom or a group represented by formula (D-A) or (D-C), and most preferably a hydrogen atom or a group represented by formula (D-A), and these groups each may have a substituent.

The examples and preferable ranges of the aryl group, the monovalent heterocyclic group, and the substituted amino group in R^{21A}, R^{22A}, R^{23A}, and R^{24A} are each the same as the examples and preferable ranges of the aryl group, the monovalent heterocyclic group, and the substituted amino group of the optional substituent of the ring R².

The examples and preferable ranges of the optional substituent of R^{21A}, R^{22A}, R^{23A}, and R^{24A} are the same as the examples and preferable ranges of the substituent that the optional substituent of the ring R² may further have.

To achieve a better luminance lifetime of the light emitting device according to the present embodiment, at least one selected from the group consisting of R^{21A}, R^{22A}, R^{23A}, and R^{24A} is preferably a group represented by formula (D-A), (D-B), or (D-C), more preferably a group represented by formula (D-A) or (D-C), and still more preferably a group represented by formula (D-A).

When at least one member selected from the group consisting of R^{21A}, R^{22A}, R^{23A}, and R^{24A} is a group represented by formula (D-A), (D-B), or (D-C), it is preferable that R^{22A} or R^{23A} be a group represented by formula (D-A), (D-B), or (D-C), and more preferable that R^{22A} be a group represented by formula (D-A), (D-B), or (D-C).

To achieve an even better luminance lifetime of the light emitting device according to the present embodiment, the metal complex represented by formula (1-A) is preferably a metal complex represented by formula (1-A1), a metal complex represented by formula (1-A2), a metal complex represented by formula (1-A3), or a metal complex represented by formula (1-A4), more preferably a metal complex represented by formula (1-A1) or a metal complex represented by formula (1-A3), and still more preferably a metal complex represented by formula (1-A1).

Examples of the metal complex represented by formula (1) include compounds represented by formulas (Ir-100) to (Ir-133), (Pt-100) to (Pt-104), (Pd-100), or (Rh-100), and the metal complexes represented by formulas (Ir-100) to (Ir-129), (Pt-100) to (Pt-104), (Pd-100), or (Rh-100) are preferable. In the formula, E^{A} represents a group represented by -CH= or a group represented by -N=.

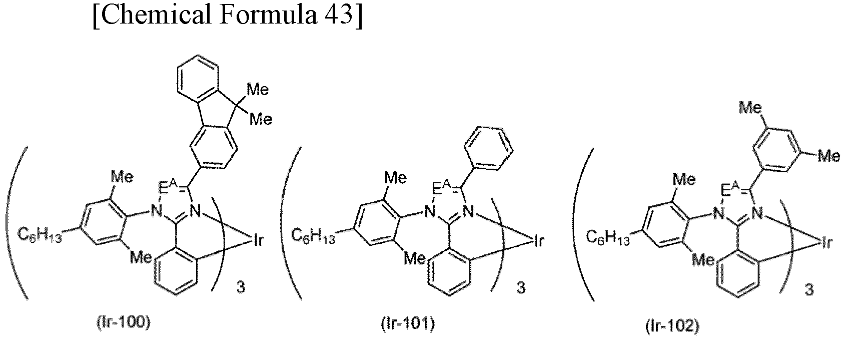

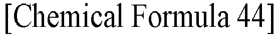

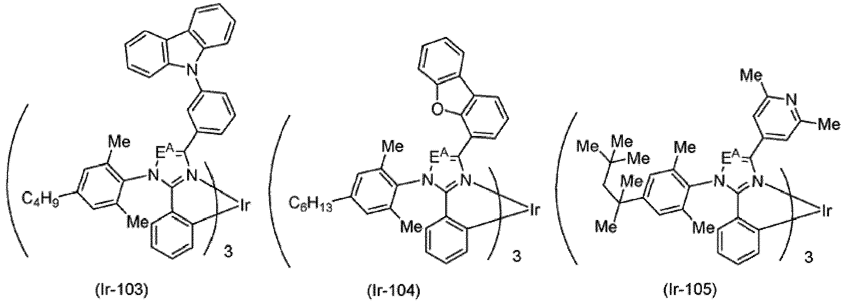

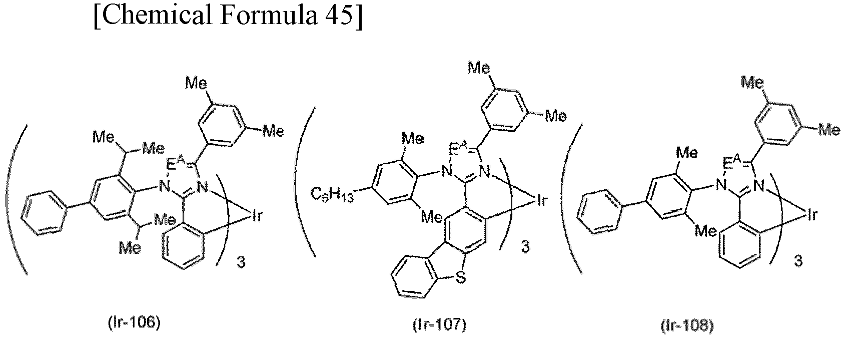

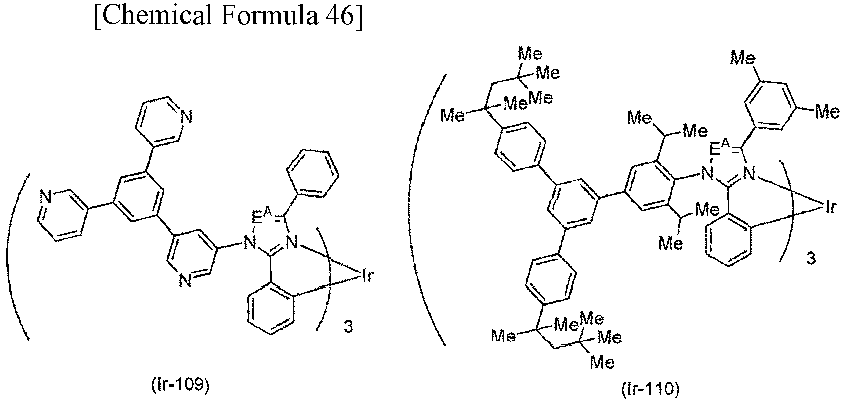

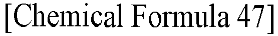

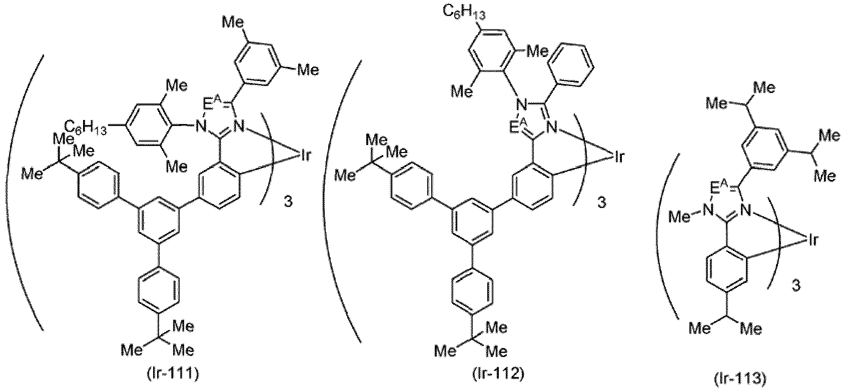

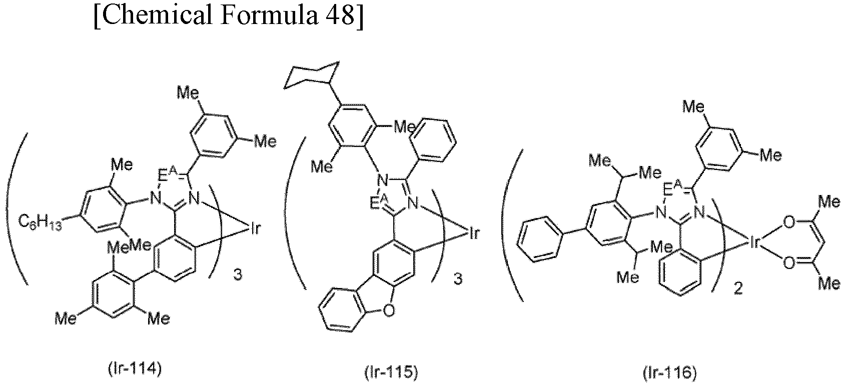

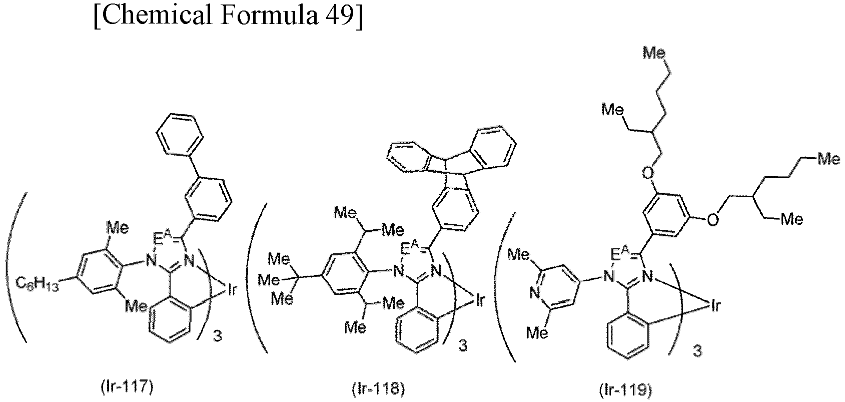

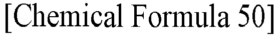

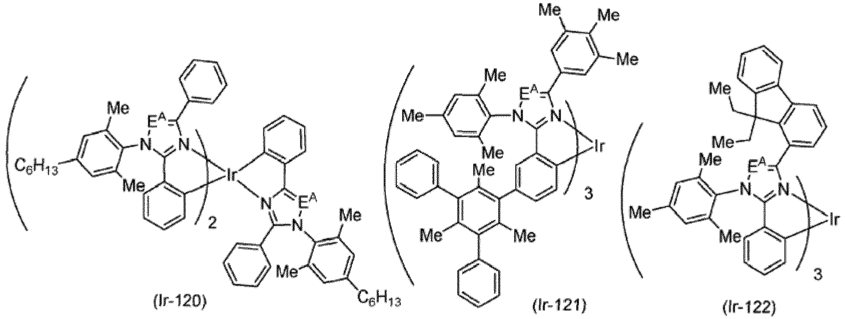

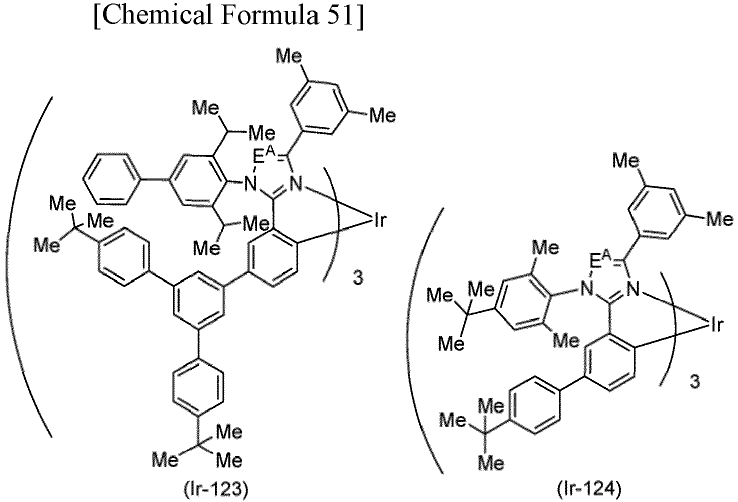

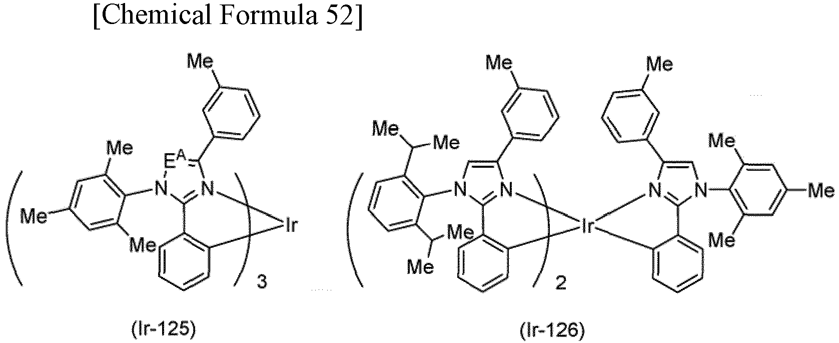

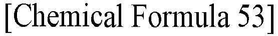

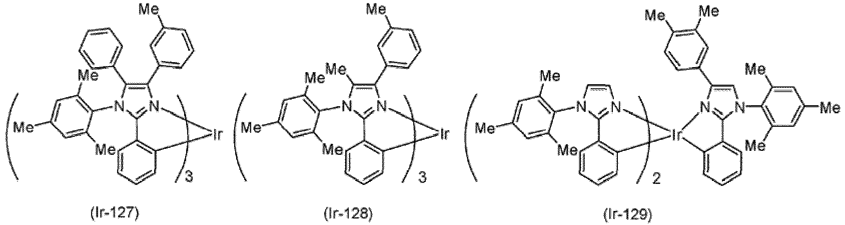

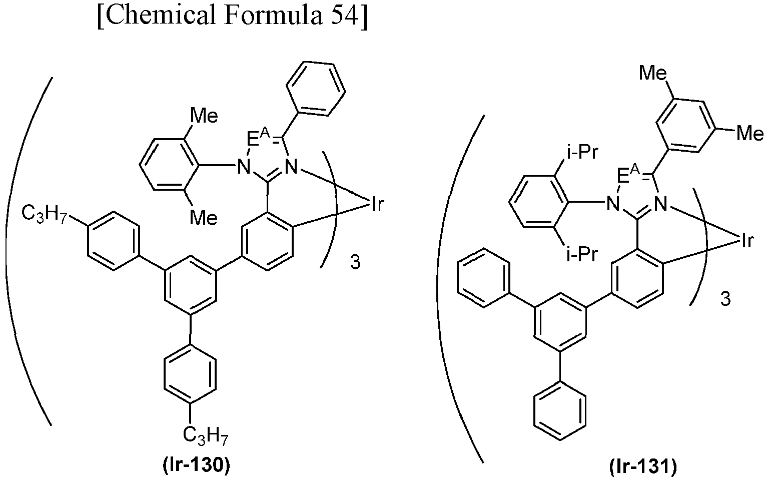

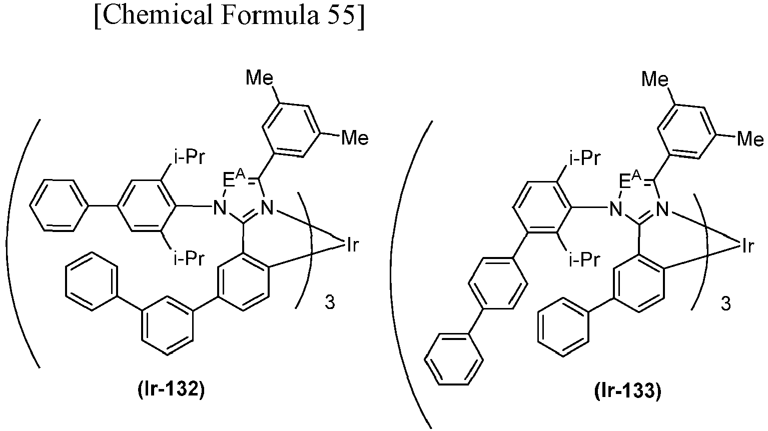

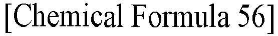

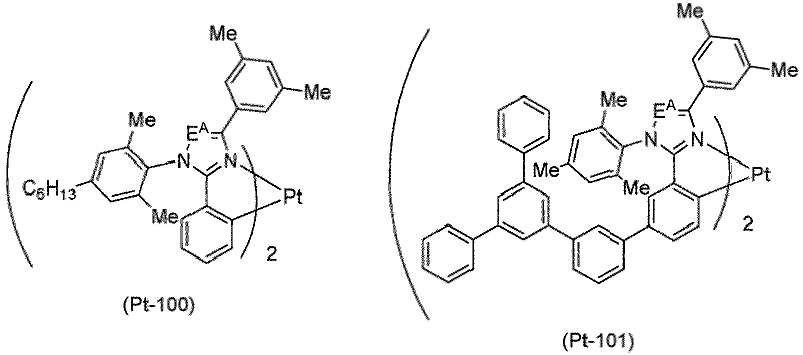

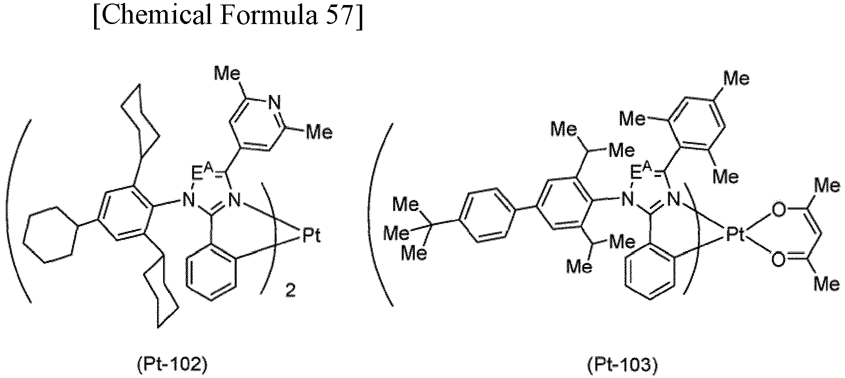

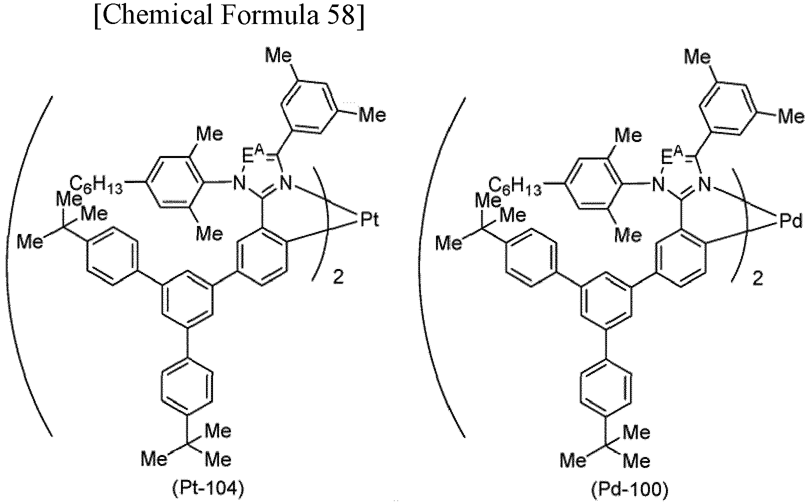

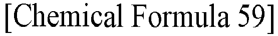

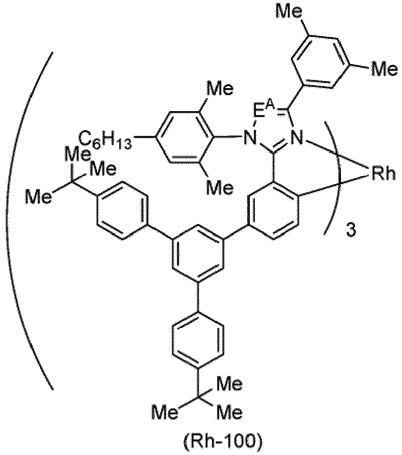

### <Method for Producing Metal Complex Represented by Formula (1)>

The metal complex represented by formula (1) can be produced by, for example, a method in which a compound serving as a ligand is reacted with a metal compound. Optionally, a functional group conversion reaction of the ligand of the metal complex may be carried out.

The metal complex represented by formula (1) can be produced by, for example, a step A of reacting a compound represented by formula (M-1) with a metal compound or a hydrate thereof, and a step B of reacting the compound obtained in step A (hereinafter also referred to as "metal complex intermediary (1)") with a compound represented by formula (M-1) or a precursor of a ligand represented by A¹-G¹-A² (hereinafter also referred to as "production method 1"). 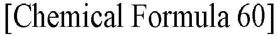 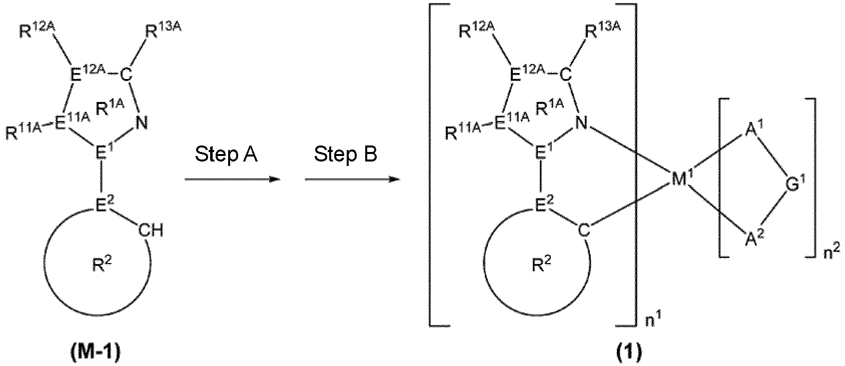 (Wherein M¹, n¹, n², the ring R^{1A}, the ring R², E¹, E², E^{11A}, E^{12A}, R^{11A}, R^{12A}, R^{13A}, and A¹-G¹-A² represent the same meanings as described above.)

In step A, examples of the metal compound include iridium compounds such as iridium chloride, tris(acetylacetonato)iridium(III), chloro(cyclooctadiene)iridium(I) dimer, and iridium(III) acetate; platinum compounds such as potassium chloroplatinate; palladium compounds such as palladium chloride and palladium acetate; and rhodium compounds such as rhodium chloride. Examples of hydrates of metal compounds include iridium chloride trihydrate and rhodium chloride trihydrate.

Examples of the metal complex intermediary (1) include a metal complex represented by formula (M-2). 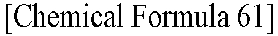 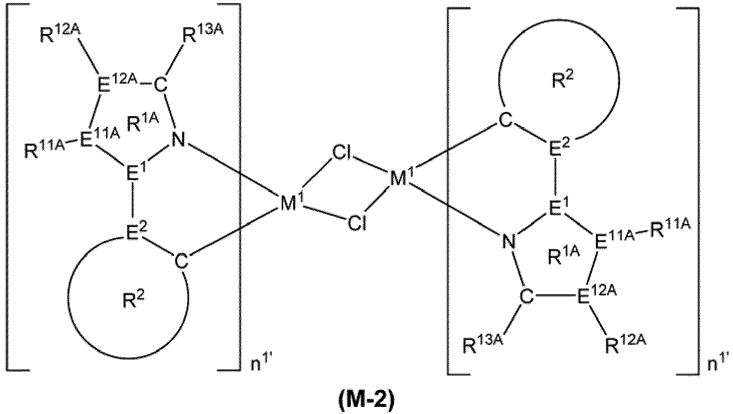 (Wherein,
M¹, n¹, n², the ring R^{1A}, the ring R², E¹, E², E^{11A}, E^{12A}, R^{11A}, R^{12A}, and R^{13A} represent the same meanings as described above, and
n^{1'} represents 1 or 2. When M¹ is a rhodium atom or an iridium atom, n^{1'} is 2, and when M¹ is a palladium atom or a platinum atom, n^{1'} is 1.)

In step A, the compound represented by formula (M-1) is usually 2 to 20 moles with respect to 1 mole of the metal compound or its hydrate.

In step B, the amount of the compound represented by formula (M-1) or the precursor of the ligand represented by A¹-G¹-A² is usually 1 to 100 moles with respect to 1 mole of the metal complex intermediate (1).

In step B, the reaction is preferably carried out in the presence of a silver compound such as silver trifluoromethanesulfonate. When a silver compound is used, its amount is usually 2 to 20 moles relative to 1 mole of the metal complex intermediate (1).

Next, the functional group conversion reaction (hereinafter also referred to as "production method 2") of the ligand of the metal complex represented by formula (1) will be described.

In production method 2, examples of the functional group conversion reaction include known coupling reactions that use a transition metal catalyst, such as the Suzuki reaction, Buchwald reaction, Stille reaction, Negishi reaction, and Kumada reaction.

Examples of the production method 2 may include a method including a step C of performing a coupling reaction between a metal complex represented by formula (M-3) and a compound represented by formula (M-4). 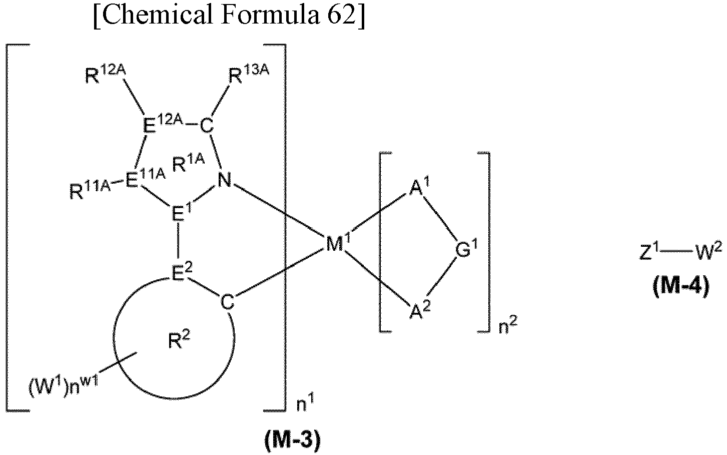 (Wherein,
M¹, n¹, n², the ring R^{1A}, the ring R², E¹, E², E^{11A}, E^{12A}, R^{11A}, R^{12A}, R^{13A}, and A¹-G¹-A² represent the same meanings as described above,
W¹ represents a chlorine atom, a bromine atom or an iodine atom; when there are a plurality of W¹, they may be the same or different,
n^{W1} represents an integer of 1 or more and 10 or less,
Z¹ represents an alkyl group, a cycloalkyl group, an aryl group, or a monovalent heterocyclic group, and these groups each may have a substituent, and
W² represents a group selected from the group consisting of the group of substituents B.)

### (Group of Substituents B)

A group represented by -B(OR^{C2})₂ (wherein R^{C2} represents a hydrogen atom, an alkyl group, a cycloalkyl group, or an aryl group, and these groups each may have a substituent; and the plurality of R^{C2} may be the same or different, and may be connected to each other to form a ring structure together with the oxygen atom to which they are bonded);
a group represented by -BF₃Q' (wherein Q' represents Li, Na, K, Rb, or Cs);
a group represented by -MgY' (wherein Y' represents a chlorine atom, a bromine atom, or an iodine atom);
a group represented by -ZnY" (wherein Y" represents a chlorine atom, a bromine atom, or an iodine atom); and
a group represented by -Sn(R^{C3})₃ (wherein R^{C3} represents a hydrogen atom, an alkyl group, a cycloalkyl group, or an aryl group, and these groups each may have a substituent; and the plurality of R^{C3} may be the same or different, and may be connected to each other to form a ring structure together with the tin atom to which they are bonded.

Examples of the group represented by -B(OR^{C2})₂ include groups represented by formulas (W-1) to (W-10).

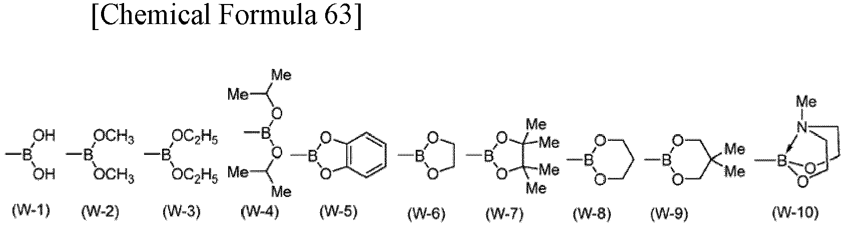

W¹ is preferably a bromine atom or an iodine atom, as this enables the coupling reaction to proceed more easily.

n^{W1} is preferably an integer of 1 to 5, more preferably 1 or 2, and still more preferably 1.

Z¹ is preferably an aryl group or a monovalent heterocyclic group, and more preferably an aryl group, and these groups each may have a substituent.

The examples and preferable ranges of the aryl group and monovalent heterocyclic group of Z¹ are each the same as the examples and preferable ranges of the aryl group and monovalent heterocyclic group of the optional substituent of the ring R².

The examples and preferable ranges of the optional substituent of Z¹ are the same as the examples and preferable ranges of the substituent that the optional substituent of the ring R² may further have.

W² is preferably a group represented by -B(OR^{C2})₂, and more preferably a group represented by formula (W-7).

In the coupling reaction, in order to accelerate the reaction, a catalyst such as a palladium catalyst may be used. Examples of the palladium catalyst may include palladium acetate, bis(triphenylphosphine)palladium(II) dichloride, tetrakis(triphenylphosphine)palladium(0), [1,1'-bis(diphenylphosphino)ferrocene]dichloropalladium(II), and tris(dibenzylideneacetone)dipalladium(0).

The palladium catalyst may be used in combination with a phosphorus compound such as triphenylphosphine, tri(o-tolyl)phosphine, tri(tert-butyl)phosphine, tricyclohexylphosphine, and 1,1'-bis (diphenylphosphino)ferrocene.

When a palladium catalyst is used in the coupling reaction, the amount thereof is usually an effective amount, for example, with respect to 1 mole of the compound represented by formula (M-3), preferably 0.00001 to 10 moles in terms of the palladium element.

In the coupling reaction, optionally, a palladium catalyst and a base may be used in combination.

The metal complex represented by formula (M-3) can be synthesized, for example, by a method including a step D in which a metal complex represented by formula (1) is reacted with a halogenating agent.

In step D, examples of the halogenating agent include N-chlorosuccinimide, N-bromosuccinimide, and N-iodosuccinimide.

In step D, the amount of the halogenating agent is usually 1 to 50 moles with respect to 1 mole of the metal complex represented by formula (1).

Steps A, B, C, and D are usually carried out in a solvent. Examples of the solvent include alcohol solvents such as methanol, ethanol, propanol, ethylene glycol, glycerin, 2-methoxyethanol, and 2-ethoxyethanol; ether solvents such as diethyl ether, tetrahydrofuran (THF), dioxane, cyclopentyl methyl ether, and diglyme; halogen type solvents such as methylene chloride and chloroform; nitrile type solvents such as acetonitrile and benzonitrile; hydrocarbon solvents such as hexane, decalin, toluene, xylene, and mesitylene; amide solvents such as N,N-dimethylformamide, N,N-dimethylacetamide; acetone, dimethylsulfoxide, and water.

In steps A, B, C, and D, the reaction time is usually 30 minutes to 200 hours, and the reaction temperature is usually between the melting point and the boiling point of the solvent present in the reaction system.

The compounds, catalysts, and solvents used in the reactions described in <Method for Producing Metal Complex Represented by Formula (1)> may be used singly or in combination of two or more.

### [Host Material]

To achieve a better luminance lifetime of the light emitting device according to the present embodiment, the first light emitting layer is preferably comprises the metal complex represented by formula (1) and a host material having at least one function selected from the group consisting of hole injectability, hole transportability, electron injectability, and electron transportability. In the first light emitting layer, one host material may be contained, or two or more host materials may be contained.

When the first light emitting layer comprises a metal complex represented by formula (1) and a host material, the content of the metal complex represented by formula (1) is usually 0.1 to 50 parts by mass, preferably 1 to 40 parts by mass, and more preferably 10 to 30 parts by mass, based on a total of the metal complex represented by formula (1) and the host material of 100 parts by mass.

When the first light emitting layer comprises the metal complex represented by formula (1) and the host material, the lowest excited triplet state (T₁) of the host material is preferably the equal to or higher than the energy level of T₁ of the metal complex represented by formula (1), because in such case the luminance lifetime of the light emitting device according to the present embodiment is better.

It is preferable that the host material exhibits solubility in solvents capable of dissolving the metal complex represented by formula (1), because this enables the light emitting device according to the present embodiment to be produced by a solution coating process.

The host material is classified into a low molecular weight compound and a polymer compound, and a low molecular weight compound is preferable.

### [Low Molecular Weight Host]

Low molecular weight compounds (hereinafter referred to as "low molecular weight host") preferable as the host material will now be described.

The low molecular weight host is preferably a compound represented by formula (H-1).

Ar^{H1} and Ar^{H2} are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group, or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group, or an azacarbazolyl group, still more preferably a phenyl group, a pyridyl group, a carbazolyl group, or an azacarbazolyl group, particularly preferably a group represented by formula (TDA-1) or (TDA-3), and especially preferably a group represented by formula (TDA-3), and these groups each may have a substituent.

The optional substituent of Ar^{H1} and Ar^{H2} is preferably a halogen atom, an alkyl group, a cycloalkyl group, an alkoxy group, a cycloalkoxy group, an aryl group, or a monovalent heterocyclic group, more preferably an alkyl group, a cycloalkyl group, an alkoxy group, or a cycloalkoxy group, and still more preferably an alkyl group or a cycloalkyl group is more preferable, and these groups each may further have a substituent.

n^{H1} is preferably 1. n^{H2} is preferably 0.

n^{H3} is usually an integer of 0 to 10, preferably an integer of 0 to 5, more preferably an integer of 1 to 3, and particularly preferably 1.

n^{H11} is preferably an integer of 1 or more and 5 or less, more preferably an integer of 1 or more and 3 or less, and still more preferably 1.

R^{H11} is preferably a hydrogen atom, an alkyl group, a cycloalkyl group, an aryl group, or a monovalent heterocyclic group, more preferably a hydrogen atom, an alkyl group, or a cycloalkyl group, and still more preferably a hydrogen atom or an alkyl group, and these groups each may have a substituent.

L^{H1} is preferably an arylene group or a divalent heterocyclic group.

L^{H1} is a compound represented by formula (A-1) to (A-3), (A-8) to (A-10), (AA-1) to (AA-6), (AA-10) to (AA-21), or (A-24) to (AA-34), more preferably a group represented by formula (A-1), (A-2), (A-8), (A-9), (AA-1) to (AA-4), (AA-10) to (AA-15), or (A-29) to (AA-34), still more preferably a group represented by formula (A-1), (A-2), (A-8), (A-9), (AA-2), (AA-4), or (AA-10) to (AA-15), particularly preferably a group represented by formula (A-1), (A-2), (A-8), (AA-2), (AA-4), (AA-10), (AA-12), or (AA-14), and especially preferably a group represented by formula (A-1), (A-2), (AA-2), (AA-4), or (AA-14).

The optional substituent of L^{H1} is preferably a halogen atom, an alkyl group, a cycloalkyl group, an alkoxy group, a cycloalkoxy group, an aryl group, or a monovalent heterocyclic group, more preferably an alkyl group, an alkoxy group, an aryl group, or a monovalent heterocyclic group, and still more preferably an alkyl group, an aryl group, or a monovalent heterocyclic group, and these groups each may further have a substituent.

L^{H21} is preferably a single bond or an arylene group, and more preferably a single bond, and the arylene group may have a substituent.

The definition and examples of the arylene group or divalent heterocyclic group represented by L^{H21} are the same as the definition and examples of the arylene group or divalent heterocyclic group represented by L^{H1}.

R^{H21} is preferably an aryl group or a monovalent heterocyclic group, and these groups each may have a substituent.

The definition and examples of the aryl group or the monovalent heterocyclic group represented by R^{H21} are the same as the definition and examples of the aryl group or the monovalent heterocyclic group represented by Ar^{H1} and Ar^{H2}.

The definition and examples of the optional substituent of R^{H21} are the same as the definitions and examples of the optional substituent of Ar^{H1} and Ar^{H2}.

The compound represented by formula (H-1) is preferably a compound represented by formula (H-2). 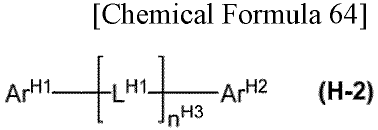 (Wherein Ar^{H1}, Ar^{H2}, n^{H3}, and L^{H1} represent the same meanings as described above.)

Examples of the compound represented by formula (H-1) include the compounds represented by formulas (H-101) to (H-118).

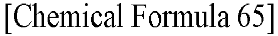

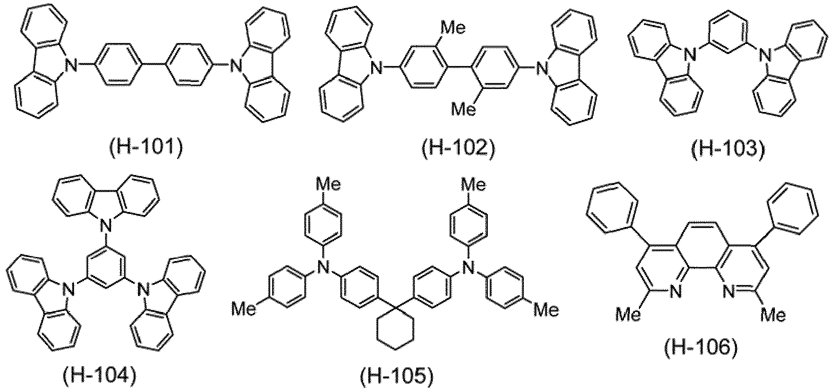

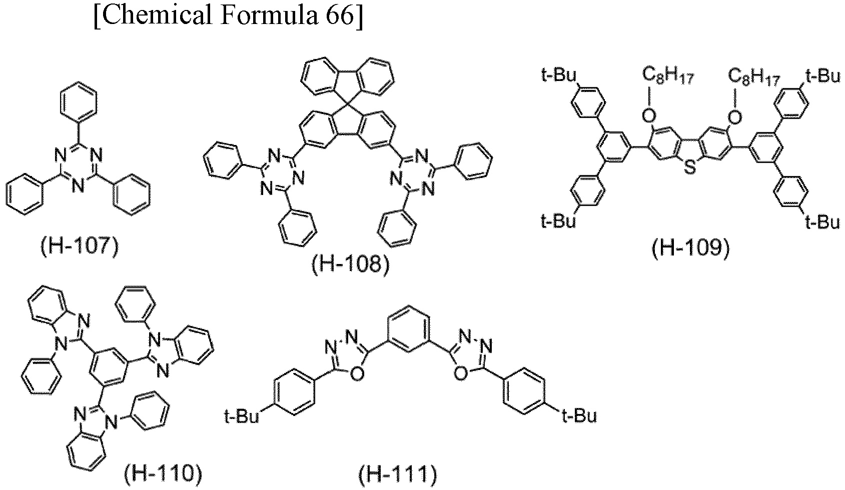

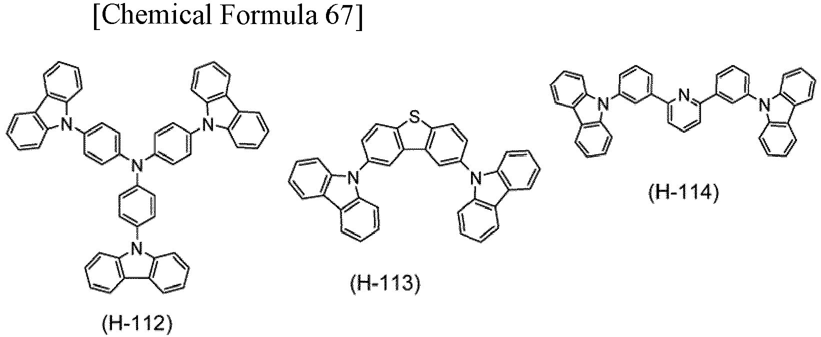

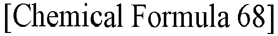

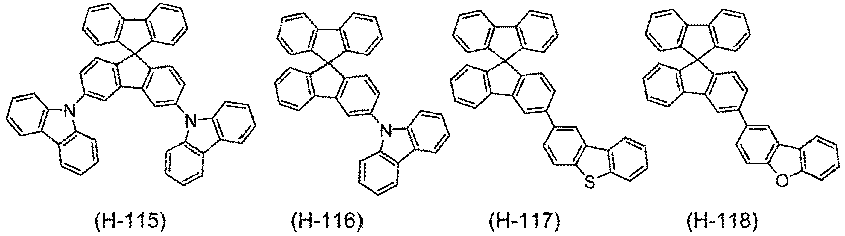

### [Polymer Host]

Examples of the polymer compound used for the host material include a polymer compound that serves as a hole transporting material (described later) and a polymer compound that serves as an electron transporting material (described later).

Polymer compound compounds that are preferable as the host material (hereinafter referred to as "polymer host") will now be described.

The polymer host is preferably a polymer compound comprising a constitutional unit represented by formula (Y).

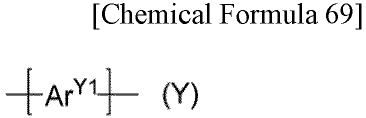

Ar^{Y1} represents an arylene group, a divalent heterocyclic group, or a divalent group in which at least one arylene group and at least one divalent heterocyclic group are directly bonded to each other, and these groups each may have a substituent.

The arylene group represented by Ar^{Y1} is more preferably an arylene group represented by formula (A-1), (A-2), (A-6) to (A-10), (A-19), or (A-20, and still more preferably a group represented by formula (A-1), (A-2), (A-7), (A-9), or (A-19), and these groups each may have a substituent.

More preferably, the divalent heterocyclic group represented by Ar^{Y1} is a group represented by formula (AA-1) to (AA-4), (AA-10) to (AA-15), (AA-18) to (AA-21), (AA-33), or (AA-34), and still more preferably a group represented by formula (AA-4), (AA-10), (AA-12), (AA-14), or (AA-33), and these groups each may have a substituent.

The more preferable range and still more preferable range of the arylene group and divalent heterocyclic group in the divalent group represented by Ar^{Y1} in which at least one arylene group and at least one divalent heterocyclic group are directly bonded to each other are respectively the same as the more preferable range and still more preferable range of the arylene group and divalent heterocyclic group represented by Ar^{Y1} described above.

Examples of the "divalent group in which at least one arylene group and at least one divalent heterocyclic group are directly bonded to each other" include groups represented by the following formulas, and these groups each may have a substituent. 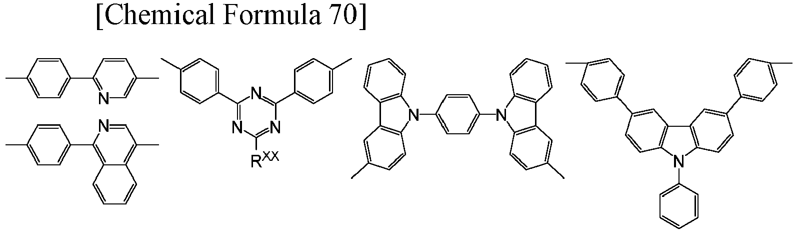 (Wherein R^{XX} represents a hydrogen atom, an alkyl group, a cycloalkyl group, an aryl group, or a monovalent heterocyclic group, and these groups each may have a substituent.)

R^{XX} is preferably an alkyl group, a cycloalkyl group, or an aryl group, and these groups each may have a substituent.

The optional substituent of the group represented by Ar^{Y1} is preferably an alkyl group, a cycloalkyl group, or an aryl group, and these groups each may further have a substituent.

Examples of the constitutional unit represented by formula (Y) include constitutional units represented by formulas (Y-1) to (Y-10), and from the viewpoint of the luminance lifetime of the light emitting device according to the present embodiment, are preferably a constitutional unit represented by formulas (Y-1) to (Y-3). From the viewpoint of electron transportability, a constitutional unit represented by formulas (Y-4) to (Y-7) is preferable, and from the viewpoint of hole transportability, a constitutional unit represented by formulas (Y-8) to (Y-10) is preferable. 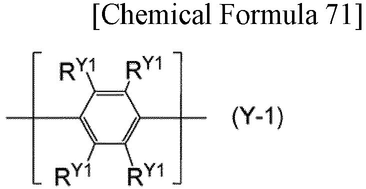 (Wherein R^{Y1} represents a hydrogen atom, an alkyl group, a cycloalkyl group, an alkoxy group, a cycloalkoxy group, an aryl group, or a monovalent heterocyclic group, and these groups each may have a substituent; and the plurality of R^{Y1} may be the same or different and adjacent R^{Y1} may be bonded to each other to form a ring together with the carbon atom to which they are bonded.)

R^{Y1} is preferably a hydrogen atom, an alkyl group, a cycloalkyl group, or an aryl group, and these groups each may have a substituent.

The constitutional unit represented by formula (Y-1) is preferably a constitutional unit represented by formula (Y-1'). 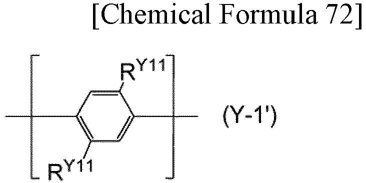 (Wherein R^{Y11} represents an alkyl group, a cycloalkyl group, an alkoxy group, a cycloalkoxy group, an aryl group, or a monovalent heterocyclic group, and these groups each may have a substituent; and the plurality of R^{Y11} may be the same or different.)

R^{Y11} is preferably an alkyl group, a cycloalkyl group, or an aryl group, and more preferably an alkyl group or a cycloalkyl group, and these groups each may have a substituent. 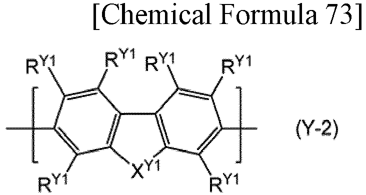 (Wherein R^{Y1} represents the same meaning as described above; X^{Y1} represents a group represented by -C(R^{Y2})₂-, -C(R^{Y2})=C(R^{Y2})-, or C(R^{Y2})₂-C(R^{Y2})₂-; R^{Y2} represents a hydrogen atom, an alkyl group, a cycloalkyl group, an alkoxy group, a cycloalkoxy group, an aryl group, or a monovalent heterocyclic group, and these groups each may have a substituent; and the plurality of R^{Y2} may be the same or different, and R^{Y2} may be bonded to another R^{Y2} to form a ring together with the carbon atom to which they are bonded.)

R^{Y2} is preferably an alkyl group, a cycloalkyl group, an aryl group, or a monovalent heterocyclic group, and more preferably an alkyl group, a cycloalkyl group, or an aryl group, and these groups each may have a substituent.

In X^{Y1}, the combination of the two R^{Y2} groups in the group represented by -C(R^{Y2})₂- is preferably a combination in which both groups are alkyl groups or cycloalkyl groups, a combination in which both groups are aryl groups, a combination in which both groups are monovalent heterocyclic groups, or a combination in which one group is an alkyl group or a cycloalkyl group and the other group is an aryl group or a monovalent heterocyclic group, and more preferably is a combination in which one group is an alkyl group or a cycloalkyl group and the other group is an aryl group, and these groups each may have a substituent. Two present R^{Y2} groups may be bonded to each other to form a ring together with the atoms to which they are bonded. When R^{Y2} forms a ring, the group represented by -C(R^{Y2})₂- is preferably a group represented by formulas (Y-A1) to (Y-A5), and more preferably a group represented by formula (Y-A4), and these groups each may have a substituent.

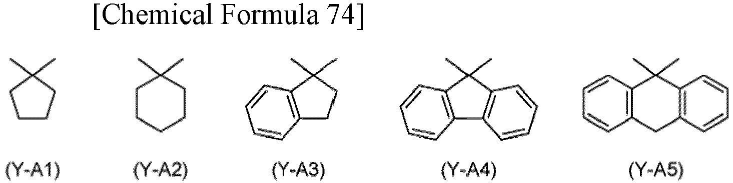

In X^{Y1}, the combination of the two R^{Y2} groups in the group represented by -C(R^{Y2})=C(R^{Y2})- is preferably a combination in which both groups are alkyl groups or cycloalkyl groups or a combination in which one group is an alkyl group or a cycloalkyl group and the other group is an aryl group, and these groups each may have a substituent.

In X^{Y1}, the four R^{Y2} in the group represented by -C(R^{Y2})₂-C(R^{Y2})₂- are preferably an optionally substituted alkyl group or cycloalkyl group. The plurality of R^{Y2} may be bonded to each other to form a ring together with the atoms to which they are bonded, and when R^{Y2} forms a ring, a group represented by -C(R^{Y2})₂-C(R^{Y2})₂- is preferably a group represented by formulas (Y-B1) to (Y-B5), and more preferably a group represented by formula (Y-B3), and these groups each may have a substituent. 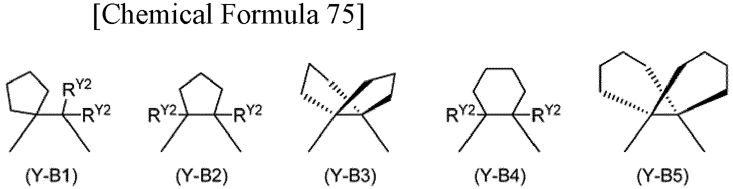 (Wherein R^{Y2} represents the same meaning as described above.)

The constitutional unit represented by formula (Y-2) is preferably a constitutional unit represented by formula (Y-2'). 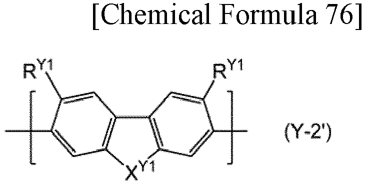 (Wherein R^{Y1} and X^{Y1} represent the same meanings as described above.) 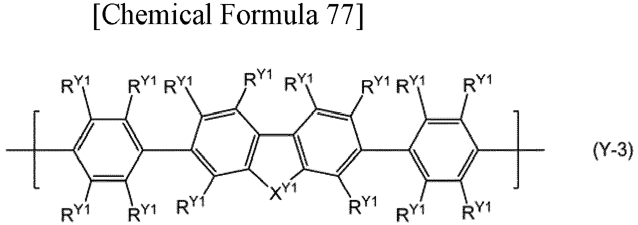 (Wherein R^{Y1} and X^{Y1} represent the same meanings as described above.)

The constitutional unit represented by formula (Y-3) is preferably a constitutional unit represented by formula (Y-3'). 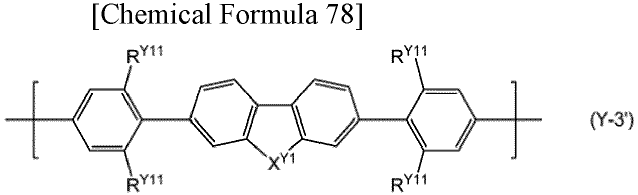 (Wherein R^{Y11} and X^{Y1} represent the same meanings as described above.) 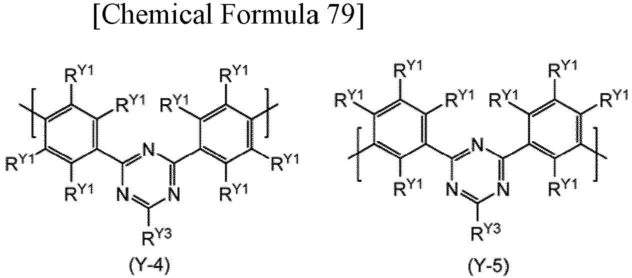 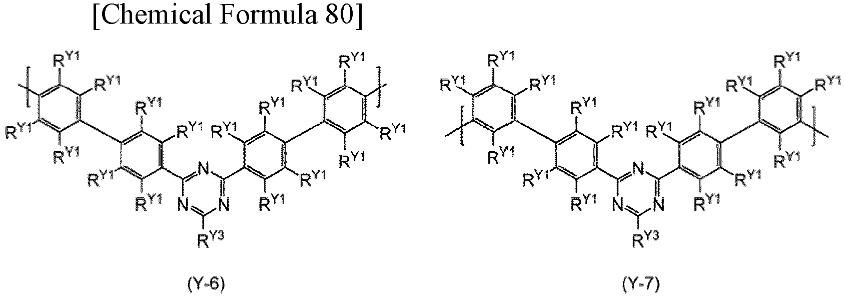 (Wherein R^{Y1} represents the same meaning as described above; R^{Y3} represents a hydrogen atom, an alkyl group, a cycloalkyl group, an alkoxy group, a cycloalkoxy group, an aryl group, or a monovalent heterocyclic group, and these groups each may have a substituent.)

R^{Y3} is preferably an alkyl group, a cycloalkyl group, an alkoxy group, a cycloalkoxy group, an aryl group, or a monovalent heterocyclic group, and more preferably an aryl group, and these groups each may have a substituent.

The constitutional unit represented by formula (Y-4) is preferably a constitutional unit represented by formula (Y-4'), and the constitutional unit represented by formula (Y-6) is preferably a constitutional unit represented by formula (Y-6'). 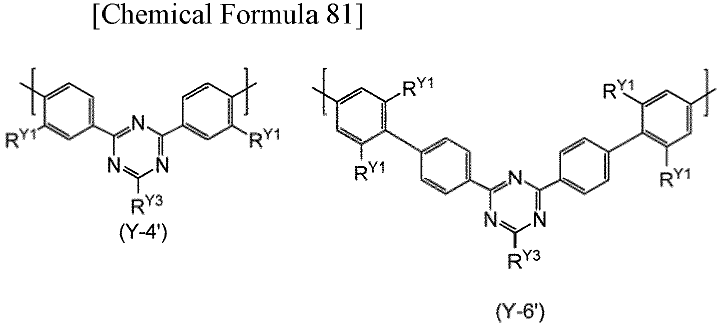 (Wherein R^{Y1} and R^{Y3} represent the same meanings as described above.) 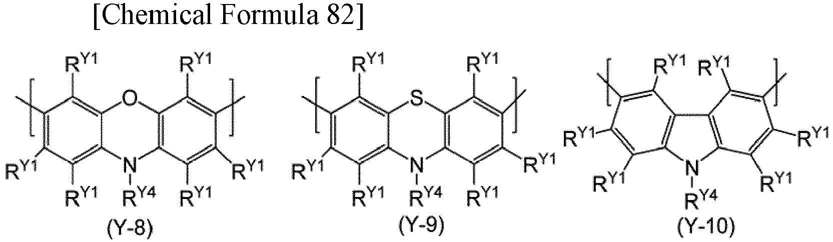 (Wherein R^{Y1} represents the same meaning as described above; R^{Y4} represents a hydrogen atom, an alkyl group, a cycloalkyl group, an alkoxy group, a cycloalkoxy group, an aryl group, or a monovalent heterocyclic group, and these groups each may have a substituent.)

R^{Y4} is preferably an alkyl group, a cycloalkyl group, an alkoxy group, a cycloalkoxy group, an aryl group, or a monovalent heterocyclic group, and more preferably an aryl group. These groups each may have a substituent.

Examples of the constitutional unit represented by formula (Y) include constitutional units composed of arylene groups represented by formulas (Y-101) to (Y-121), constitutional units composed of divalent heterocyclic groups represented by formulas (Y-201) to (Y-206), and constitutional units composed of a divalent group represented by formulas (Y-300) to (Y-304) in which at least one arylene group and at least one divalent heterocyclic group are directly bonded to each other, and preferably constitutional units composed of arylene groups represented by formulas (Y-101) to (Y-121), constitutional units composed of divalent heterocyclic groups represented by formulas (Y-201) to (Y-206), and constitutional units composed of a divalent group represented by formulas (Y-301) to (Y-304) in which at least one arylene group and at least one divalent heterocyclic group are directly bonded to each other.

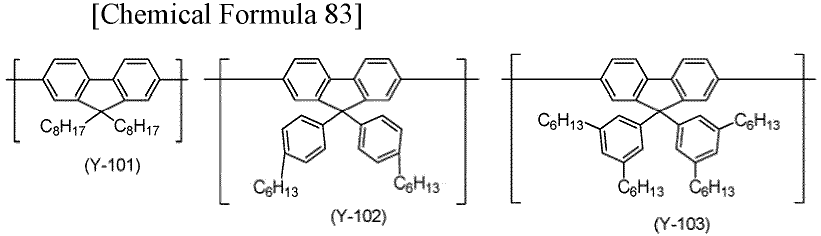

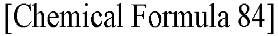

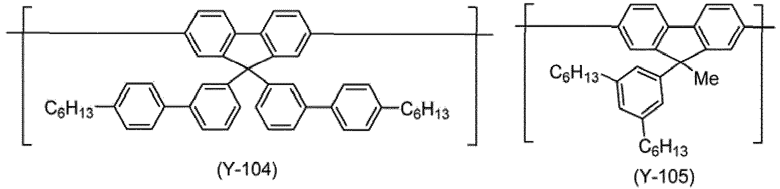

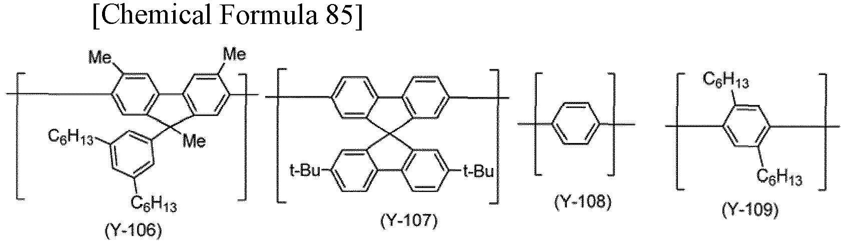

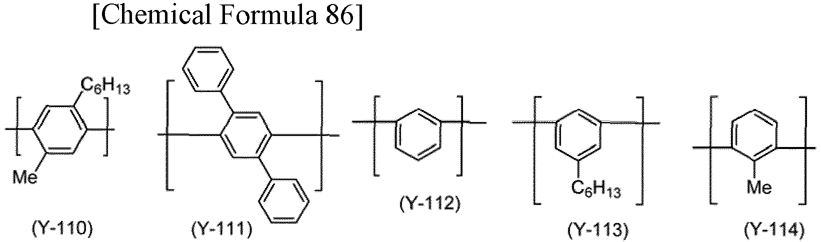

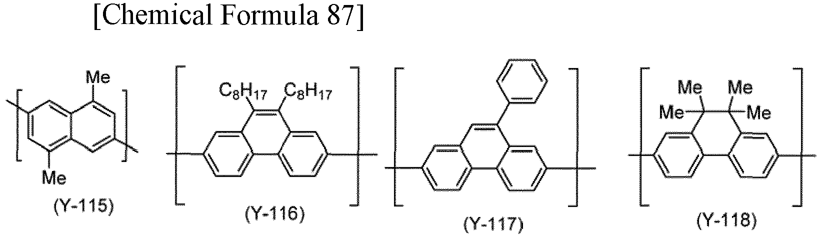

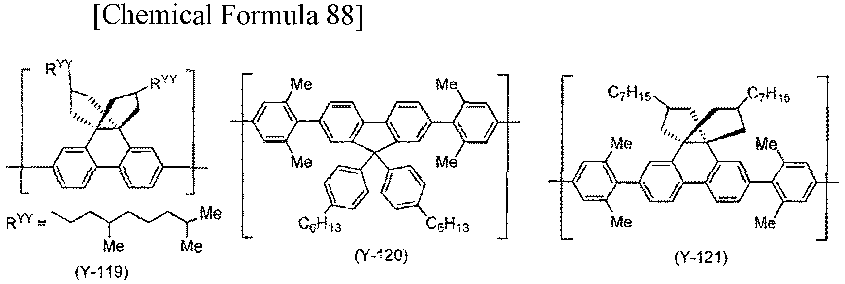

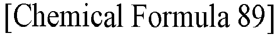

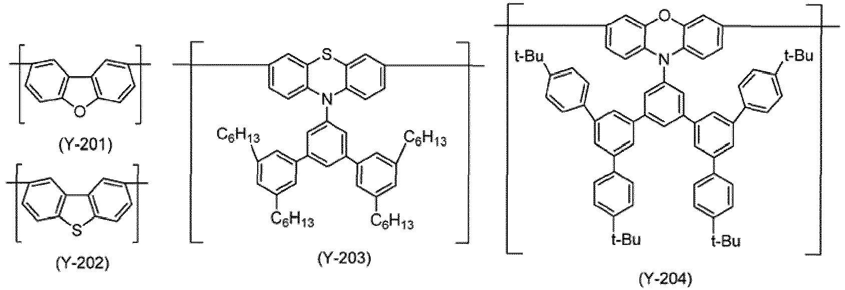

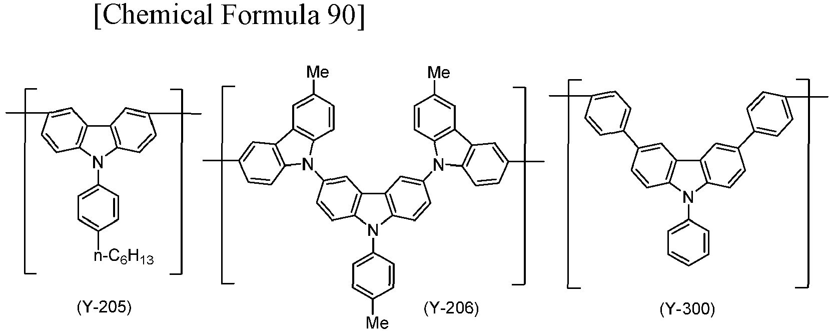

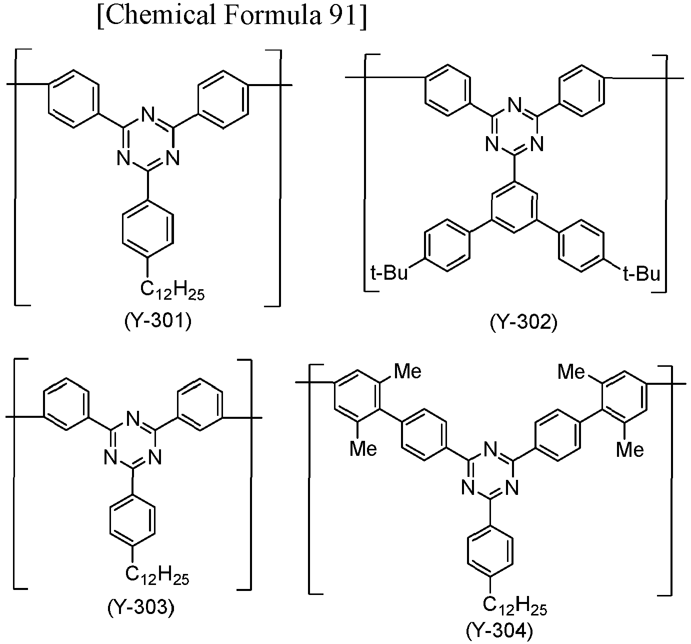

To achieve a better luminance lifetime of the light emitting device according to the present embodiment, the content of the constitutional unit represented by formula (Y) in which Ar^{Y1} is an arylene group is preferably 0.5 to 90 mol%, and more preferably 30 to 80 mol%, based on the total amount of constitutional units contained in the polymer host.

To achieve better charge transportability of the light emitting device according to the present embodiment, the content of the constitutional unit represented by formula (Y) in which Ar^{Y1} is a divalent heterocyclic group or a divalent group in which at least one arylene group and at least one divalent heterocyclic group are directly bonded to each other is preferably 0.5 to 40 mol%, and more preferably 3 to 30 mol%, based on the total amount of constitutional units contained in the polymer host.

Only one constitutional unit represented by formula (Y) may be contained or two or more of them may be contained in the polymer host.

To achieve better hole transportability, it is preferable that the polymer host further comprises a constitutional unit represented by formula (X). 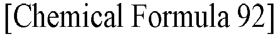 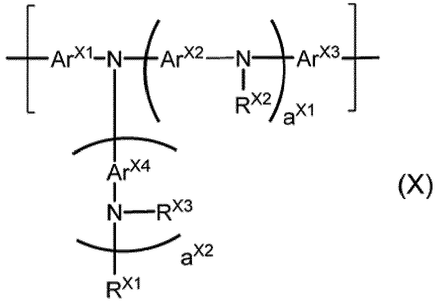 (Wherein,
a^{X1} and a^{X2} each independently represent an integer of 0 or more,
Ar^{X1} and Ar^{X3} each independently represent an arylene group or a divalent heterocyclic group, and these groups each may have a substituent,
Ar^{X2} and Ar^{X4} each independently represent an arylene group, a divalent heterocyclic group, or a divalent group in which at least one arylene group and at least one divalent heterocyclic group are directly bonded to each other, and these groups each may have a substituent; and when there are a plurality of Ar^{X2} and Ar^{X4}, they may be the same or different at each occurrence,
R^{X1}, R^{X2}, and R^{X3} each independently represent a hydrogen atom, an alkyl group, a cycloalkyl group, an aryl group, or a monovalent heterocyclic group, and these groups each may have a substituent; and when there are a plurality of R^{X2} and R^{X3}, they may be the same or different at each occurrence.)
a^{X1} is preferably 2 or less, and more preferably 1, because the luminance lifetime of the light emitting device according to the present embodiment is better.

a^{X2} is preferably 2 or less, and more preferably 0, because the luminance lifetime of the light emitting device according to the present embodiment is better.

R^{X1}, R^{X2} and R^{X3} are preferably an alkyl group, a cycloalkyl group, an aryl group, or a monovalent heterocyclic group, and more preferably an aryl group, and these groups each may have a substituent.

The arylene group represented by Ar^{X1} and Ar^{X3} is more preferably a group represented by formula (A-1) or (A-9), and still more preferably a group represented by formula (A-1), and these groups each may have a substituent.

The divalent heterocyclic group represented by Ar^{X1} and Ar^{X3} is more preferably a group represented by formula (AA-1), (AA-2), or (AA-7) to (AA-26), and these groups each may have a substituent.

Ar^{X1} and Ar^{X3} are preferably an arylene group which may have a substituent.

The arylene group represented by Ar^{X2} and Ar^{X4} is more preferably an arylene group represented by formula (A-1), (A-6), (A-7), (A-9) to (A-11), or (A-19), and these groups each may have a substituent.

The more preferable range of the divalent heterocyclic group represented by Ar^{X2} and Ar^{X4} is the same as the more preferable range of the divalent heterocyclic group represented by Ar^{X1} and Ar^{X3}.

The more preferable range and still more preferable range of the arylene group and the divalent heterocyclic group in the divalent group represented by Ar^{X2} and Ar^{X4} in which at least one arylene group and at least one divalent heterocyclic group are directly bonded to each other are respectively the same as the more preferable range and still more preferable range of the arylene group and the divalent heterocyclic group represented by Ar^{X1} and Ar^{X3}.

Examples of the divalent group represented by Ar^{X2} and Ar^{X4} in which at least one arylene group and at least one divalent heterocyclic group are directly bonded to each other include the same divalent groups represented by Ar^{Y1} of formula (Y) in which at least one arylene group and at least one divalent heterocyclic group are directly bonded to each other.

Ar^{X2} and Ar^{X4} are preferably an arylene group which may have a substituent.

The optional substituent of the groups represented by Ar^{X1} to Ar^{X4} and R^{X1} to R^{X3} is preferably an alkyl group, a cycloalkyl group, or an aryl group, and these groups each may further have a substituent.

The constitutional unit represented by formula (X) is preferably a constitutional unit represented by formulas (X-1) to (X-7), more preferably a constitutional unit represented by formulas (X-1) to (X-6), and still more preferably a constitutional unit represented by formulas (X-3) to (X-6). 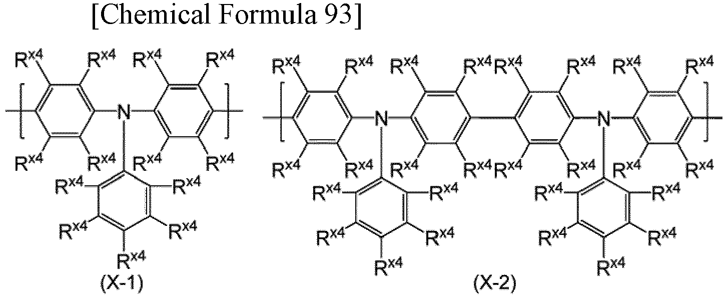 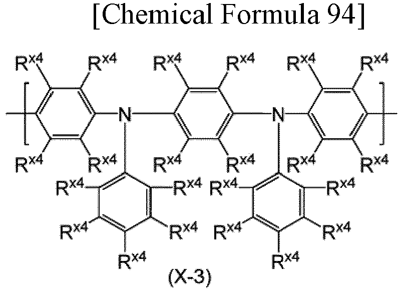 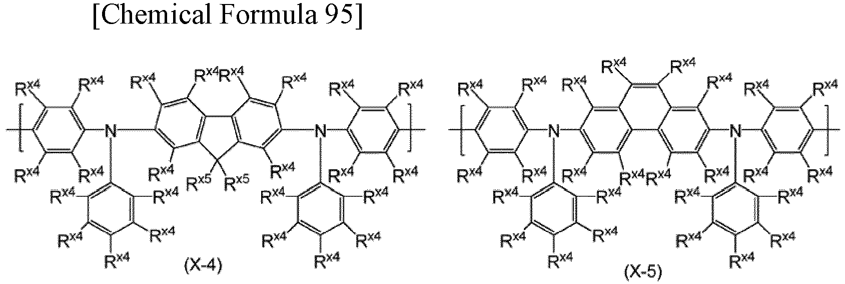 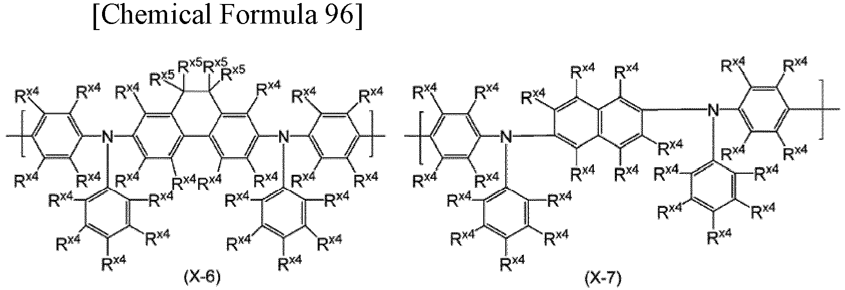 (Wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent heterocyclic group, or a cyano group, and these groups each may have a substituent; the plurality of R^{X4} may be the same or different; and the plurality of R^{X5} may be the same or different, and adjacent R^{X5} may be bonded to each other to form a ring together with the carbon atom to which they are bonded.)

To achieve better hole transportability, the content of the constitutional unit represented by formula (X) is preferably 0.1 to 50 mol%, more preferably 1 to 40 mol%, and still more preferably 5 to 30 mol%, based on the total amount of constitutional units contained in the polymer host.

Examples of the constitutional unit represented by formula (X) include constitutional units represented by formulas (X1-1) to (X1-11). The constitutional unit represented by formula (X) is preferably a constitutional unit represented by formulas (X1-3) to (X1-10).

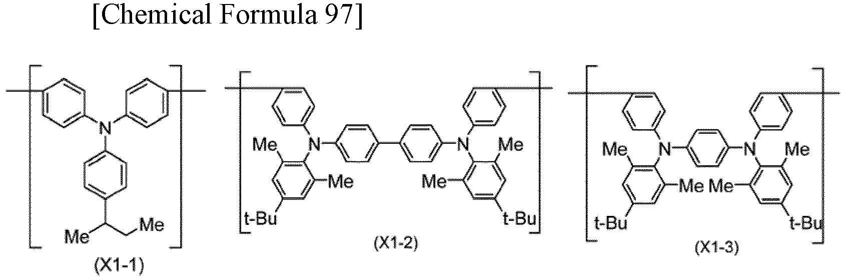

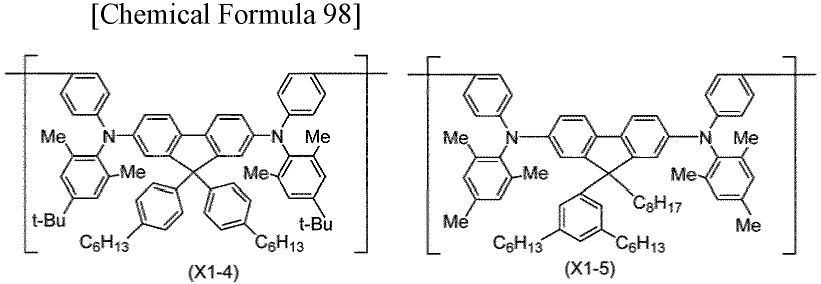

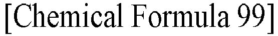

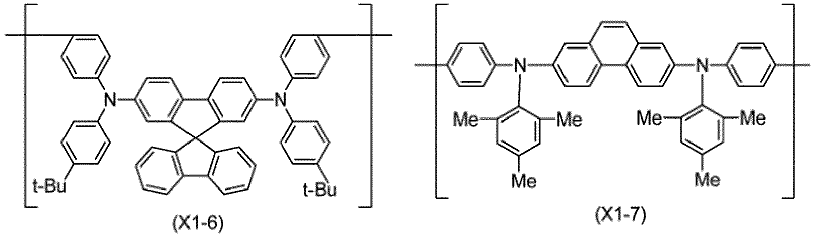

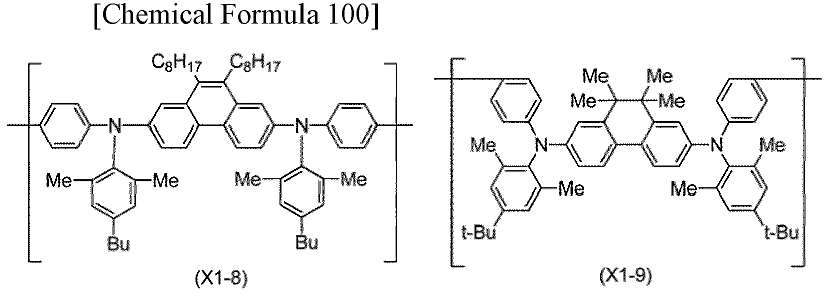

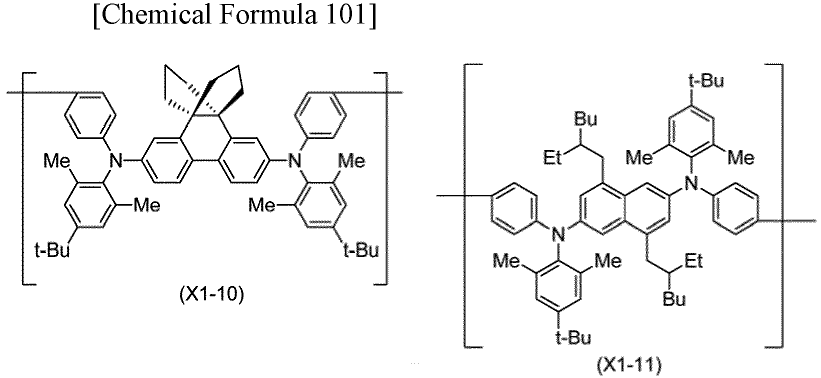

In the polymer host, only one constitutional unit represented by formula (X) may be contained or two or more of them may be contained.

Examples of the polymer host include the polymer compounds (P-1) to (P-6) in Table 1.

**[Table 1]**

| Polymer Compound | Constitutional units and Molar Ratios Thereof | | | | |
|---|---|---|---|---|---|
| | Formula (Y) | | | Formula (X) | Other |
| | Formula (Y-1) to (Y-3) | Formula (Y-4)to (Y-7) | Formula (Y-8)to (Y-10) | Formula (X-1) to (Y-7) | |
| | p | q | r | s | t |
| (P-1) | 0.1-99.9 | 0.1-99.9 | 0 | 0 | 0-30 |
| (P-2) | 0.1-99.9 | 0 | 0.1-99.9 | 0 | 0-30 |
| (P-3) | 0.1-99.8 | 0.1-99.8 | 0 | 0.1-99.8 | 0-30 |
| (P-4) | 0.1-99.8 | 0.1-99.8 | 0.1-99.8 | 0 | 0-30 |
| (P-5) | 0.1-99.8 | 0 | 0.1-99.8 | 0.1-99.8 | 0-30 |
| (P-6) | 0.1-99.7 | 0.1-99.7 | 0.1-99.7 | 0.1-99.7 | 0-30 |

In Table 1, p, q, r, s, and t represent the molar ratio of each constitutional unit, p + q + r + s + t = 100 and 100 ≥ p + q + r + s ≥ 70, the heading "Other" means a constitutional unit other than the constitutional unit represented by formula (Y) and the constitutional unit represented by formula (X).

The polymer host may be any of a block copolymer, a random copolymer, an alternating copolymer, and a graft copolymer, or may even be some other form, but it is preferable that the polymer host is a copolymer obtained by copolymerizing a plurality of raw material monomers.

### [Method for Producing Polymer host]

The polymer host can be produced, for example, by using a known polymerization method described in Chem. Rev., Vol. 109, pp. 897-1091 (2009). Examples of such a method include a polymerization method by a coupling reaction using a transition metal catalyst, such as in a Suzuki reaction, a Yamamoto reaction, a Buchwald reaction, a Stille reaction, a Negishi reaction, or a Kumada reaction.

In the polymerization method, examples of the method for charging the monomers may include a method in which all the monomers are charged all at once into the reaction system, a method in which a part of the monomers is charged and made to react, and then the remaining monomers are charged all at once, continuously, or in several stages, and a method in which the monomers are charged continuously or in several stages.

Examples of the transition metal catalyst include a palladium catalyst, and a nickel catalyst.

Workup is carried out by known methods, for example, a method in which water-soluble impurities are removed by liquid separation and a method in which a lower alcohol such as methanol is added to a reaction liquid after a polymerization reaction, and deposited sediments are filtered out and then dried, used singly or in combination. When the purity of the polymer host is low, the polymer host can be purified by a common method, for example, recrystallization, reprecipitation, continuous extraction with a Soxhlet extractor, and column chromatography.

### [First Light Emitting Layer Composition]

The first light emitting layer may be a layer formed using a composition (hereinafter also referred to as "first light emitting layer composition") comprising the metal complex represented by formula (1) and at least one material selected from the group consisting of the above-mentioned host material, hole transporting material, hole injecting material, electron transporting material, electron injecting material, light emitting material (which is different from the metal complex represented by formula (1)), and an antioxidant.

Then, "formed using" means that the first light emitting layer is formed using the first light emitting layer composition. The metal complex represented by formula (1) in the first light emitting layer composition may be contained in the first light emitting layer as it is, or in an intramolecularly, an intermolecularly, or an intramolecularly and intermolecularly crosslinked state. More specifically, the first light emitting layer may comprise the first light emitting layer composition and/or a crosslinked product of the first light emitting layer composition.

### [Hole Transporting Material]

The hole transporting material is classified into a low molecular weight compound and a polymer compound, and a polymer compound is preferable. The hole transporting material may have a crosslinkable group.

Examples of the low molecular weight compounds include aromatic amine compounds such as triphenylamine and derivatives thereof, N,N'-di-1-naphthyl-N,N'-diphenylbenzidine (a-NPD), and N,N'-diphenyl-N,N'-di(m-tolyl)benzidine (TPD).

Examples of the polymer compounds include polyvinylcarbazole and derivatives thereof; and polyarylene having an aromatic amine structure in a side chain or main chain and derivatives thereof. The polymer compound may be a compound to which an electron accepting site is bound. Examples of the electron accepting moiety include fullerene, tetrafluorotetracyanoquinodimethane, tetracyanoethylene, and trinitrofluorenone, and fullerene is preferable.

When the first light emitting layer composition comprises the hole transporting material, the amount of the hole transporting material blended is, based on 100 parts by mass of the metal complex represented by formula (1), usually 1 to 400 parts by mass, and preferably 5 to 150 parts by mass.

One hole transporting material may be used alone, or two or more hole transporting materials may be used in combination.

### [Electron Transporting Material]

The electron transporting materials are classified into a low molecular weight compound and a polymer compound. The electron transporting material may have a crosslinkable group.

Examples of the low molecular weight compound include metal complexes having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, and diphenoquinone, and derivatives of these.

Examples of the polymer compound include polyphenylene, polyfluorene, and derivatives thereof. The polymer compound may be doped with a metal.

When the first light emitting layer composition comprises the electron transporting material, the amount of the electron transporting material blended is, based on 100 parts by mass of the metal complex represented by formula (1), usually 1 to 400 parts by mass, and preferably 5 to 150 parts by mass.

One electron transporting material may be used alone, or two or more hole transporting materials may be used in combination.

### [Hole Injecting Material and Electron Injecting Material]

The hole injecting material and the electron injecting material are each classified into a low molecular weight compound and a polymer compound. The hole injecting material and the electron injecting material may have a crosslinkable group.

Examples of the low molecular weight compound include metal phthalocyanines such as copper phthalocyanine; carbon; metal oxides of, for example, molybdenum or tungsten; and metal fluorides such as lithium fluoride, sodium fluoride, cesium fluoride, and potassium fluoride.

Examples of the polymer compound include conductive polymers such as polyaniline, polythiophene, polypyrrole, polyphenylenevinylene, polythienylenevinylene, polyquinoline, and polyquinoxaline, and derivatives of these; and polymers comprising an aromatic amine structure in the main chain or side chain.

When the first light emitting layer composition comprises the hole injecting material and the electron injecting material, the amounts of the hole injecting material and the electron injecting material are respectively, based on 100 parts by mass of the metal complex represented by formula (1), usually 1 to 400 parts by mass, and preferably 5 to 150 parts by mass.

One of each of the electron transporting material and the hole transporting material may be used alone, or two or more of each of the electron transporting material and the hole transporting material may be used in combination.

### [Ion Doping]

When the hole injecting material or the electron injecting material comprises a conductive polymer, the electrical conductivity of the conductive polymer is preferably 1 × 10⁻⁵ S/cm to 1 × 10³ S/cm. The conductive polymer can be doped with an appropriate amount of ions in order to set the electrical conductivity of the conductive polymer in such a range.

The type of ion to be doped is an anion for the hole injecting material and a cation for the electron injecting material. Examples of the anion include polystyrenesulfonic acid ions, alkylbenzenesulfonic acid ions, and camphorsulfonic acid ions. Examples of the cation include lithium ions, sodium ions, potassium ions, and tetrabutylammonium ions.

One type of ion to be doped may be used alone, or two or more types of ion to be doped may be used.

### [Light Emitting Material]

A light emitting material (different from the metal complex represented by formula (1)) is classified into a low molecular weight compound and a polymer compound. The light emitting material may have a crosslinkable group.

Examples of the low molecular weight compound include naphthalene and derivatives thereof, anthracene and derivatives thereof, and perylene and derivatives thereof.

Examples of the polymer compound include polymer compounds comprising a phenylene group, a naphthalenediyl group, an anthracenediyl group, a fluorenediyl group, a phenanthrenediyl group, a dihydrophenanthrenediyl group, a group represented by formula (X), a carbazolediyl group, a phenoxazinediyl group, a phenothiazinediyl group, and a pirenediyl group.

The light emitting material preferably comprises a metal complex. Examples of the metal complex include a metal complex shown below, a metal complexes represented by formula (2) (described later), a polymer compound of the second light emitting layer (described later), and a crosslinked product of a polymer compound of the second light emitting layer (described later), preferably a metal complex represented by formula (2) (described later), a polymer compound of the second light emitting layer (described later), or the crosslinked product of a polymer compound of the second light emitting layer (described later), and more preferably a metal complex represented by formula (2) (described later).

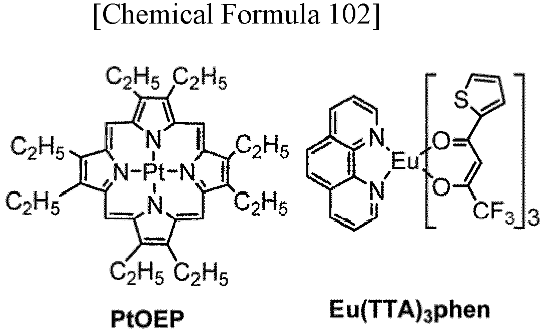

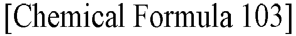

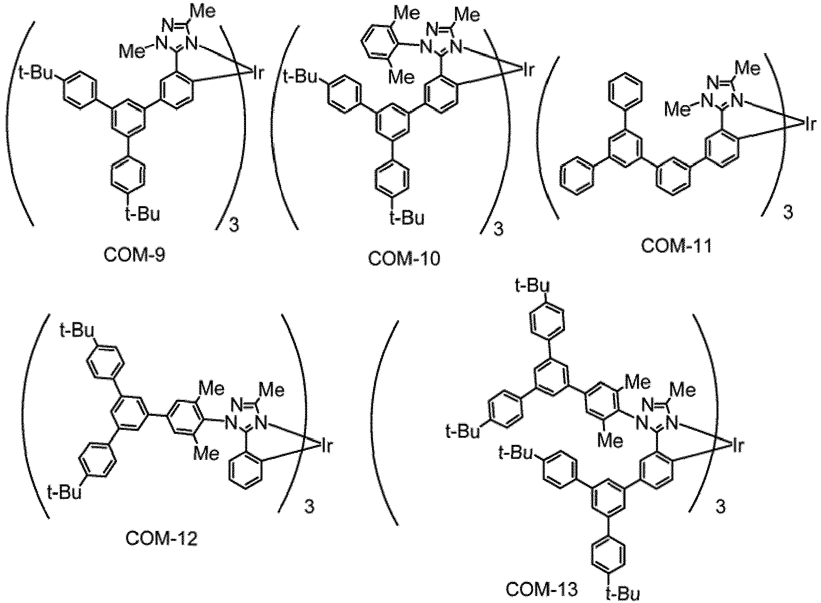

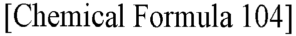

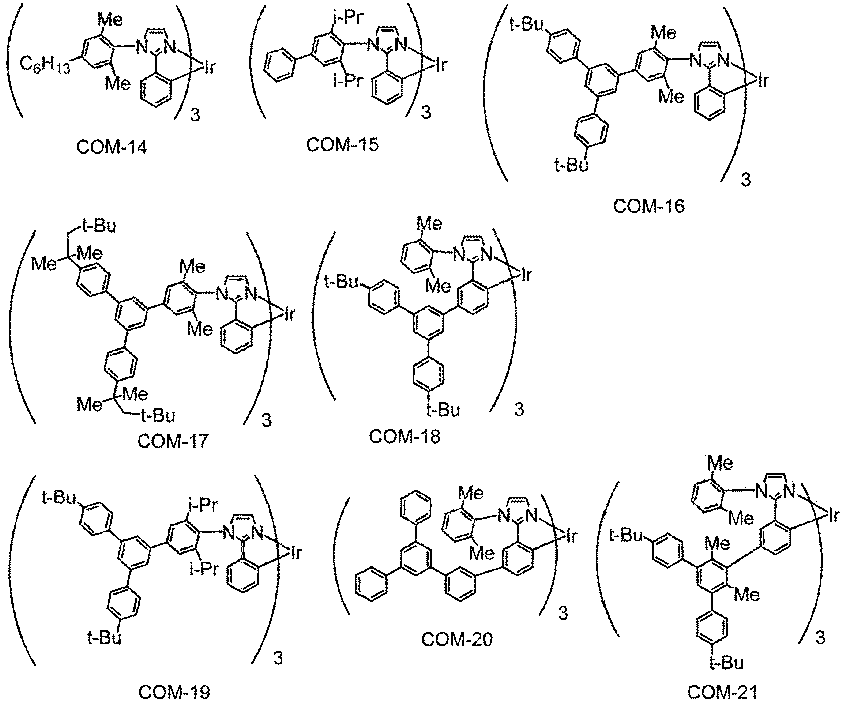

When the first light emitting layer composition comprises a light emitting material, the amount of the light emitting material blended is, based on 100 parts by mass of the metal complex represented by formula (1), usually 1 to 400 parts by mass, and preferably 5 to 150 parts by mass.

One light emitting material may be used alone, or two or more light emitting materials may be used in combination.

### [Antioxidant]

An antioxidant may be any compound that is soluble in the same solvent as the metal complex and that does not inhibit light emission and charge transporting. Examples of the antioxidant include a phenol type antioxidant and a phosphorus type antioxidant.

When the first light emitting layer composition comprises an antioxidant, the amount of the antioxidant blended is, based on 100 parts by mass of the metal complex represented by formula (1), usually 0.001 to 10 parts by mass.

One antioxidant may be used alone, or two or more antioxidants may be used in combination.

### [Ink of First Light Emitting Layer]

A composition comprising the metal complex represented by formula (1) and a solvent (hereinafter also referred to as "ink of the first light emitting layer") can be suitably used in a coating method such as spin coating, casting, micro gravure coating, gravure coating, bar coating, roll coating, wire bar coating, dip coating, spray coating, screen printing, flexographic printing, an offset printing method, ink jet printing, capillary coating, and nozzle coating.

The viscosity of the ink of the first light emitting layer may be adjusted according to the type of coating method. When a solution of an ink jet printing method is applied in a printing method that employs an ejection apparatus, the viscosity is preferably 1 to 30 mPa·s at 25°C in order to prevent clogging and curved flight during ejection.

The solvent contained in the ink of the first light emitting layer is preferably a solvent capable of dissolving or uniformly dispersing the solid content in the ink. Examples of the solvent include chlorinated solvents such as 1,2-dichloroethane, 1,1,2-trichloroethane, chlorobenzene, and o-dichlorobenzene; ether solvents such as THF, dioxane, anisole, and 4-methylanisole; aromatic hydrocarbon solvents such as toluene, xylene, mesitylene, ethylbenzene, n-hexylbenzene, and cyclohexylbenzene; aliphatic hydrocarbon solvents such as cyclohexane, methylcyclohexane, n-pentane, n-hexane, n-heptane, n-octane, n-nonane, n-decane, n-dodecane, and bicyclohexyl; ketone solvents such as acetone, methyl ethyl ketone, cyclohexanone, and acetophenone; ester solvents such as ethyl acetate, butyl acetate, ethyl cellosolve acetate, methyl benzoate, and phenyl acetate; polyhydric alcohol solvents such as ethylene glycol, glycerin, and 1,2-hexanediol; alcohol solvents such as isopropyl alcohol and cyclohexanol; and sulfoxide solvents such as dimethylsulfoxide; amide solvents such as N-methyl-2-pyrrolidone and N,N-dimethylformamide. One solvent may be used alone, or two or more solvents may be used in combination.

In the ink of the first light emitting layer, the amount of the solvent blended is, based on 100 parts by mass of the metal complex represented by formula (1), usually 1000 to 100000 parts by mass, and preferably 2000 to 20000 parts by mass.

The ink of the first light emitting layer may comprise components other than the metal complex represented by formula (1) and the solvent. For example, the ink of the first light emitting layer may further comprise at least one material selected from the group consisting of the above-mentioned host material, hole transporting material, hole injecting material, electron transporting material, electron injecting material, light emitting material (which is different from the metal complex represented by formula (1)), and antioxidant.

### <Second Light Emitting Layer>

Next, the second light emitting layer contained in the light emitting device according to the present embodiment will be described.

The second light emitting layer is usually formed using a light emitting material. Examples of the light emitting material used for the second light emitting layer, for example, include a light emitting material that may be contained in the above-mentioned first light emitting layer composition. The light emitting material used for the second light emitting layer is preferably at least one selected from the group consisting of a metal complex represented by formula (2), a polymer compound (hereinafter also referred to as "polymer compound of the second light emitting layer") comprising a constitutional unit (hereinafter also referred to as "metal complex constitutional unit") having a group formed by removing from a metal complex represented by formula (2) one or more hydrogen atoms directly bonded to a carbon atom or a hetero atom constituting the metal complex, and a crosslinked product of a polymer compound of the second light emitting layer, and more preferably at least one selected from the group consisting of a polymer compound of the second light emitting layer and a crosslinked product thereof.

More specifically, the second light emitting layer preferably comprises at least one selected from the group consisting of a metal complex represented by formula (2), a polymer compound of the second light emitting layer, and a crosslinked body of a polymer compound of the second light emitting layer, and more preferably at least one selected from the group consisting of a polymer compound of the second light emitting layer and a crosslinked product thereof.

The light emitting material may be contained in the second light emitting layer as it is, or in an intramolecularly, an intermolecularly, or an intramolecularly and intermolecularly crosslinked state. More specifically, the second light emitting layer may comprise a light emitting material and/or a crosslinked product of the light emitting material.

The second light emitting layer may comprise a single light emitting material or two or more light emitting materials.

The content of the light emitting material in the second light emitting layer may be in a range in which the second light emitting layer exhibits a function as a light emitting layer. For example, the content of the light emitting material may be, based on the total amount of the second light emitting layer, 0.01 to 100% by mass, preferably 1 to 100% by mass, more preferably 10 to 100% by mass, and still more preferably 50 to 100% by mass.

Examples of the method for forming the second light emitting layer include a vacuum evaporation method, a coating method typified by spin coating and an ink jet printing, and a coating method is preferable.

When the second light emitting layer is formed by a coating method, it is preferable to use an ink of the second light emitting layer, which is described later. After the second light emitting layer is formed, the light emitting material contained in the second light emitting layer can be crosslinked by heating or irradiating with light. When the light emitting material is contained in the second light emitting layer in a crosslinked state (i.e., in the case of a crosslinked product of the light emitting material), the second light emitting layer is practically insoluble in solvents. As a result, the second light emitting layer can be suitably used for lamination of the light emitting device.

### [Metal Complex Represented by Formula (2)]

The metal complex represented by formula (2) is a metal complex constituted by M², which is a central metal, a ligand whose number is defined by the suffix n³, and a ligand whose number is defined by the suffix n⁴.

M² is preferably an iridium atom or a platinum atom, and more preferably an iridium atom, because the luminance lifetime of the light emitting device according to the present embodiment is better.

When M² is a rhodium atom or an iridium atom, n³ is preferably 2 or 3, and more preferably 3.

When M² is a palladium atom or a platinum atom, n³ is preferably 2.

E⁴ is preferably a carbon atom.

The ring L¹ is preferably a 6-membered aromatic heterocyclic ring having 1 or more and 4 or less nitrogen atoms as constituent atoms, more preferably a 6-membered aromatic heterocyclic ring having 1 or more and 2 or less nitrogen atoms as constituent atoms, and these rings each may have a substituent.

Examples of the ring L¹ include a pyridine ring, a diazabenzene ring, a quinoline ring, and an isoquinoline ring, a pyridine ring, a pyrimidine ring, a quinoline ring, or an isoquinoline ring is preferable, and a pyridine ring, a quinoline ring, or an isoquinoline ring is more preferable, and these rings each may have a substituent.

The ring L² is preferably a 5- or 6-membered aromatic hydrocarbon ring or a 5- or 6-membered aromatic heterocyclic ring, more preferably a 6-membered aromatic hydrocarbon ring or a 6-membered aromatic heterocyclic ring, and still more preferably a 6-membered aromatic hydrocarbon ring, and these rings each may have a substituent. When the ring L² is a 6-membered aromatic heterocyclic ring, E4 is preferably a carbon atom.

Examples of the ring L² include a benzene ring, a naphthalene ring, a fluorene ring, a phenanthrene ring, an indene ring, a pyridine ring, a diazabenzene ring, a pyrrole ring, a furan ring, and a thiophene ring, preferably a benzene ring, a naphthalene ring, a fluorene ring, a pyridine ring, or a pyrimidine ring, more preferably a benzene ring, a pyridine ring, or a pyrimidine ring, and still more preferably a benzene ring, and these rings each may have a substituent.

Examples of the optional substituents of the ring L¹ and the ring L² preferably include an alkyl group, a cycloalkyl group, an alkoxy group, a cycloalkoxy group, an aryl group, an aryloxy group, a monovalent heterocyclic group, a substituted amino group, or a halogen atom, more preferably an alkyl group, a cycloalkyl group, an aryl group, a monovalent heterocyclic group, or a substituted amino group, still more preferably an alkyl group, a cycloalkyl group, an aryl group, or a monovalent heterocyclic group, and particularly preferably an aryl group or a monovalent heterocyclic group, and these groups each may further have a substituent.

The examples and preferable ranges of the substituent that the optional substituents of the ring L¹ and the ring L² may further have are the same as the examples and preferable ranges of the optional substituents of R^{11A} and R^{12A}.

When there are a plurality of optional substituents of the ring L¹, they may be the same or different and may be bonded to each other to form a ring together with the atoms to which they are bonded.

When there are a plurality of optional substituents of the ring L², they may be the same or different and may be bonded to each other to form a ring together with the atoms to which they are bonded.

The optional substituents of the ring L¹ and the optional substituent of the ring L² may be bonded to each other to form a ring together with the atoms to which they are bonded.

The examples and preferable ranges of the aryl group in the optional substituents of the ring L¹ and the ring L² are the same as the examples and preferable ranges of the aryl group in R^{11A} and R^{12A}.

The examples and preferable ranges of the monovalent heterocyclic group in the optional substituents of the ring L¹ and the ring L² are the same as the examples and preferable ranges of the monovalent heterocyclic group in R^{11A} and R^{12A}.

The examples and preferable ranges of the substituted amino group in the optional substituents of the ring L¹ and the ring L² are the same as the examples and preferable ranges of the substituted amino group in R^{11A} and R^{12A}.

The optional substituents of the ring L¹ and the ring L² are preferably a group represented by formula (D-A), (D-B) or (D-C), more preferably a group represented by formula (D-A) or (D-B), and still more preferably a group represented by formula (D-A), because the luminance lifetime of the light emitting device according to the present embodiment is better.

In the groups represented by formulas (D-A) and (D-B) in the optional substituents of the ring L¹ and the ring L², G^{DA} is preferably a group represented by formulas (GDA-11) to (GDA-15), more preferably a group represented by formulas (GDA-11) to (GDA-14), and still more preferably a group represented by formula (GDA-11) or (GDA-14).

In the optional substituents of the ring L¹ and ring L², the group represented by formula (D-A) is preferably a group represented by formulas (D-A1) to (D-A4), more preferably a group represented by formula (D-A1), (D-A3), or (D-A4), and still more preferably a group represented by formula (D-A1) or (D-A3).

In the optional substituents of the ring L¹ and the ring L², the group represented by formula (D-B) is preferably a group represented by formulas (D-B1) to (D-B3), and more preferably a group represented by formula (D-B1) or (D-B3).

In the optional substituents of the ring L¹ and ring L², the group represented by formula (D-C) is preferably a group represented by formulas (D-C1) to (D-C4), more preferably a group represented by formulas (D-C1) to (D-C3), and still more preferably a group represented by formula (D-C1) or (D-C2).

To achieve a better luminance lifetime of the light emitting device according to the present embodiment, it is preferable that at least one of the ring L¹ and the ring L² has a substituent.

### [Anionic Bidentate Ligand]

Examples of the anionic bidentate ligand represented by A³-G²-A⁴ include ligands represented by the following formulas. 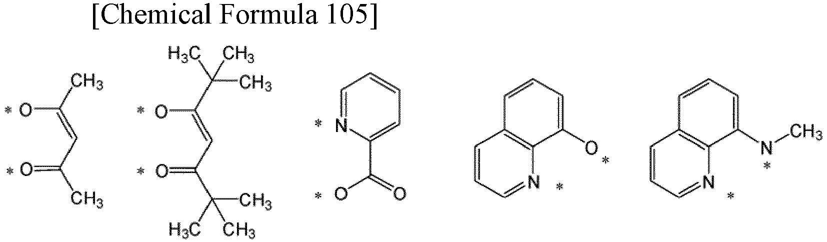 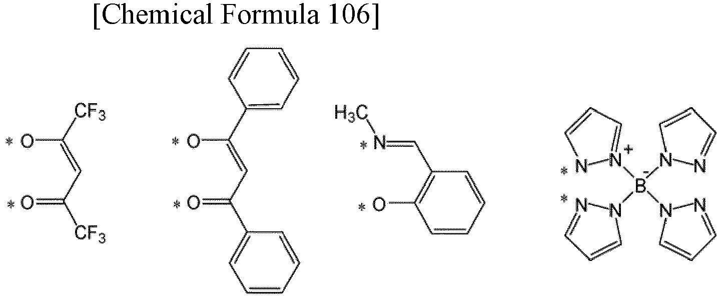 (Wherein, * represents a site that binds to M².)

The anionic bidentate ligand represented by A³-G²-A⁴ may be a ligand represented by the following formulas. 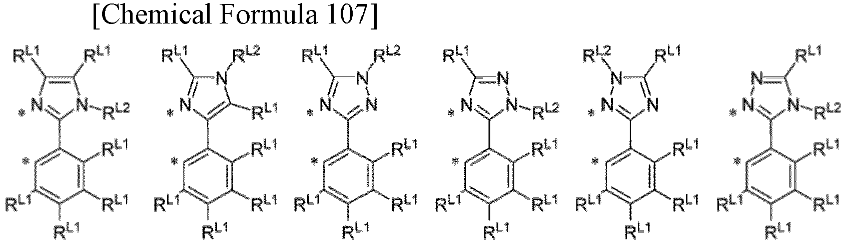
(Wherein, * represents a site that binds to M², and
R^{L1} and R^{L2} represent the same meanings as described above.)

R^{L1} is preferably a hydrogen atom, an alkyl group, a cycloalkyl group, or a fluorine atom, and more preferably a hydrogen atom or an alkyl group, and these groups each may have a substituent.

R^{L2} is preferably an alkyl group, a cycloalkyl group, an aryl group, or a monovalent heterocyclic group, more preferably an aryl group or a monovalent heterocyclic group, and still more preferably an aryl group, and these group each may have a substituent.

To achieve a better luminance lifetime of the light emitting device according to the present embodiment, the metal complex represented by formula (2) is preferably a metal complex represented by formula (2-B).

R^{11B}, R^{12B}, R^{13B}, R^{14B}, R^{21B}, R^{22B}, R^{23B}, and R^{24B} are preferably a hydrogen atom, an alkyl group, a cycloalkyl group, an aryl group, a monovalent heterocyclic group, or a substituted amino group, more preferably a hydrogen atom, an alkyl group, a cycloalkyl group, or a group represented by formula (D-A), (D-B), or (D-C), still more preferably a hydrogen atom or a group represented by formula (D-A), (D-B), or (D-C), particularly preferably a hydrogen atom or a group represented by formula (D-A) or (D-B), and especially preferably a hydrogen atom or a group represented by formula (D-A), and these groups each may have a substituent.

The examples and preferable ranges of the aryl group, the monovalent heterocyclic group, and the substituted amino group in R^{11B}, R^{12B} , R^{13B}, R^{14B}, R^{21B}, R^{22B}, R^{23B}, and R^{24B} are each the same as the examples and preferable ranges of the aryl group, the monovalent heterocyclic group, and the substituted amino group in the optional substituents of the ring L¹ and the ring L².

The examples and preferable ranges of the optional substituent of R^{11B}, R^{12B}, R^{13B}, R^{14B}, R^{21B}, R^{22B}, R^{23B}, and R^{24B} are the same as the examples and preferable ranges of the substituent that the optional substituents of the ring L¹ and the ring L² may further have.

When the ring L^{1B} is a pyrimidine ring, a pyrimidine ring in which E^{11B} is a nitrogen atom is preferable.

The ring L^{1B} is preferably a pyridine ring.

When the ring L^{2B} is a pyridine ring, a pyridine ring in which E^{21B} is a nitrogen atom, a pyridine ring in which E^{22B} is a nitrogen atom, or a pyridine ring in which E^{23B} is a nitrogen atom is preferable, and a pyridine ring in which E^{22B} is a nitrogen atom is more preferable.

When the ring L^{2B} is a pyrimidine ring, a pyrimidine ring in which E^{21B} and E^{23B} are nitrogen atoms or a pyrimidine ring in which E^{22B} and E^{24B} are nitrogen atoms is preferable, and a pyrimidine ring in which E^{22B} and E^{24B} are nitrogen atoms is more preferable.

The ring L^{2B} is preferably a benzene ring.

To achieve a better luminance lifetime of the light emitting device according to the present embodiment, at least one of R^{11B}, R^{12B}, R^{13B}, R^{14B}, R^{21B}, R^{22B}, R^{23B}, and R^{24B} is preferably, an alkyl group, a cycloalkyl group, an alkoxy group, a cycloalkoxy group, an aryl group, an aryloxy group, a monovalent heterocyclic group, a substituted amino group, or a halogen atom, more preferably, an alkyl group, a cycloalkyl group, an aryl group, a monovalent heterocyclic group, or a substituted amino group, still more preferably a hydrogen atom, an alkyl group, a cycloalkyl group, or a group represented by formula (D-A), (D-B) or (D-C), particularly preferably a hydrogen atom or a group represented by formula (D-A), (D-B), or (D-C), especially preferably a hydrogen atom or a group represented by formula (D-A) or (D-B), and even more especially preferably a hydrogen atom or a group represented by formula (D-A), and these groups each may have a substituent.

When at least one of R^{11B}, R^{12B}, R^{13B}, R^{14B}, R^{21B}, R^{22B}, R^{23B}, and R^{24B} is an alkyl group, a cycloalkyl group, an alkoxy group, a cycloalkoxy group, an aryl group, an aryloxy group, a monovalent heterocyclic group, a substituted amino group, or a halogen atom, at least one of R^{12B}, R^{13B}, R^{22B}, and R^{23B} is preferably an alkyl group, a cycloalkyl group, an alkoxy group, a cycloalkoxy group, an aryl group, an aryloxy group, a monovalent heterocyclic group, a substituted amino group, or a halogen atom, and more preferably R^{13B} or R^{22B} is an alkyl group, a cycloalkyl group, an alkoxy group, a cycloalkoxy group, an aryl group, an aryloxy group, a monovalent heterocyclic group, a substituted amino group, or a halogen atom, and these groups each may have a substituent.

To achieve a better luminance lifetime of the light emitting device according to the present embodiment, the metal complex represented by formula (2-B) is preferably a metal complex represented by formula (2-B1), a metal complex represented by formula (2-B2), a metal complex represented by formula (2-B3), a metal complex represented by formula (2-B4), or a metal complex represented by formula (2-B5), more preferably a metal complex represented by formula (2-B1), a metal complex represented by formula (2-B2), or a metal complex represented by formula (2-B3), and still more preferably a metal complex represented by formula (2-B1) or a metal complex represented by formula (2-B3).

R^{15B}, R^{16B}, R^{17B}, and R^{18B} are preferably a hydrogen atom, an alkyl group, a cycloalkyl group, an alkoxy group, a cycloalkoxy group, an aryl group, a monovalent heterocyclic group, or a substituted amino group, more preferably a hydrogen atom, an alkyl group, a cycloalkyl group, or an aryl group, still more preferably a hydrogen atom or an alkyl group, and particularly preferably a hydrogen atom, and these groups each may have a substituent.

The examples and preferable ranges of the aryl group, the monovalent heterocyclic group, and the substituted amino group in R^{15B}, R^{16B}, R^{17B}, and R^{18B} are each the same as the examples and preferable ranges of the aryl group, the monovalent heterocyclic group, and the substituted amino group in the optional substituents of the ring L¹ and the ring L².

The examples and preferable ranges of the optional substituent of R^{15B}, R^{16B}, R^{17B}, and R^{18B} are the same as the examples and preferable ranges of the substituent that the optional substituents of the ring L¹ and the ring L² may further have.

Examples of the metal complex represented by formula (2) include a metal complex represented by the following formulas.

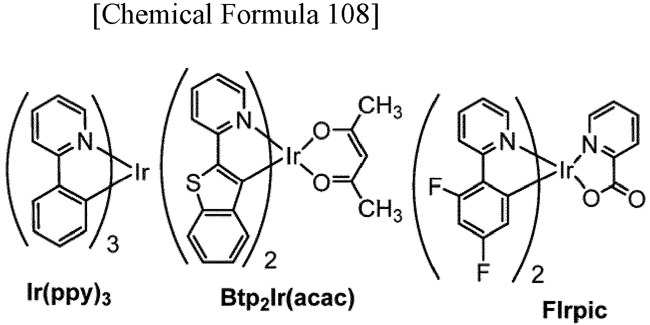

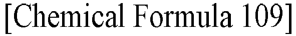

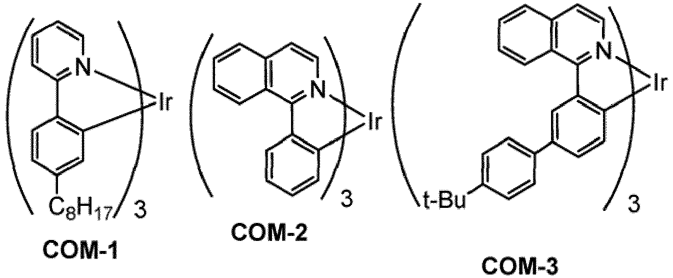

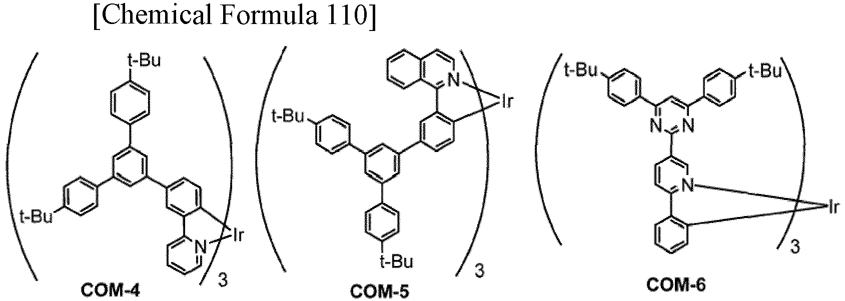

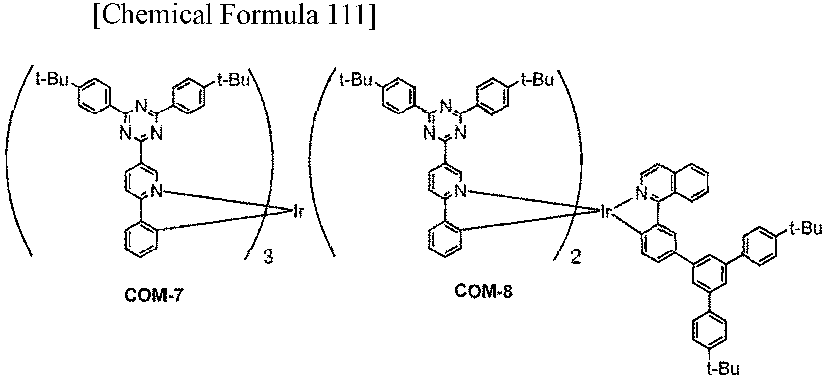

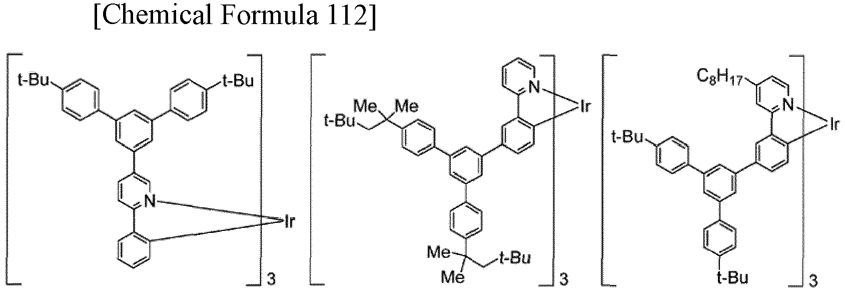

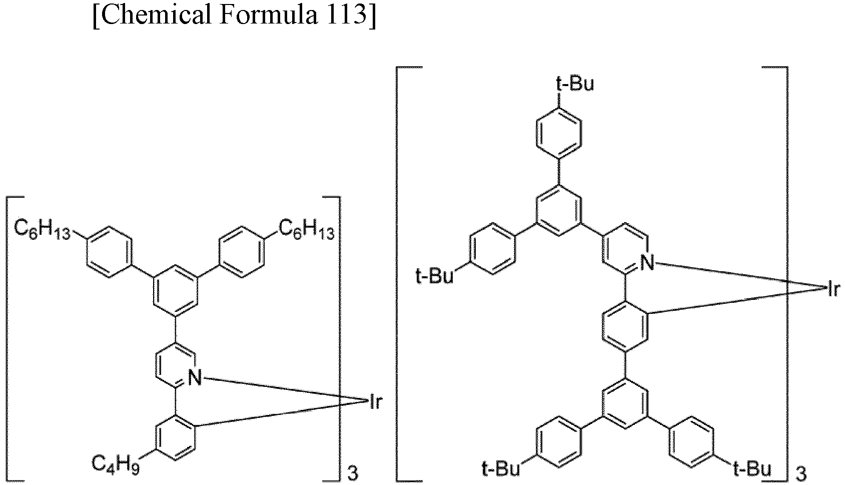

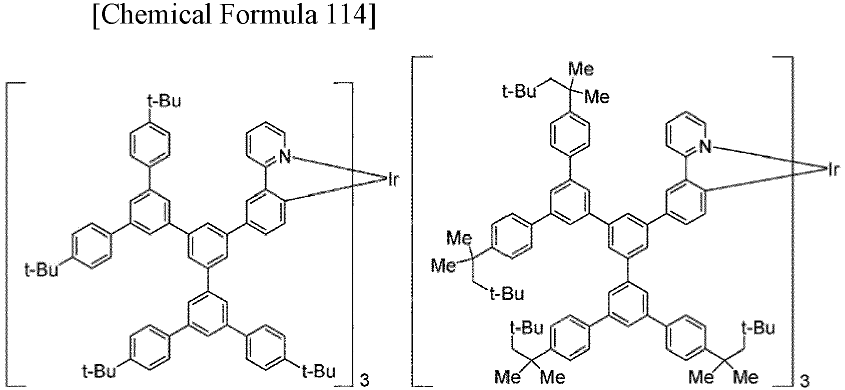

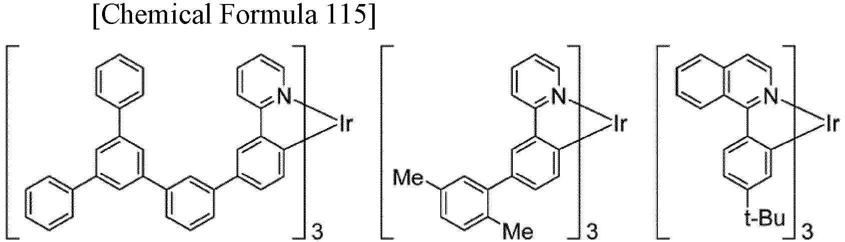

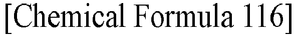

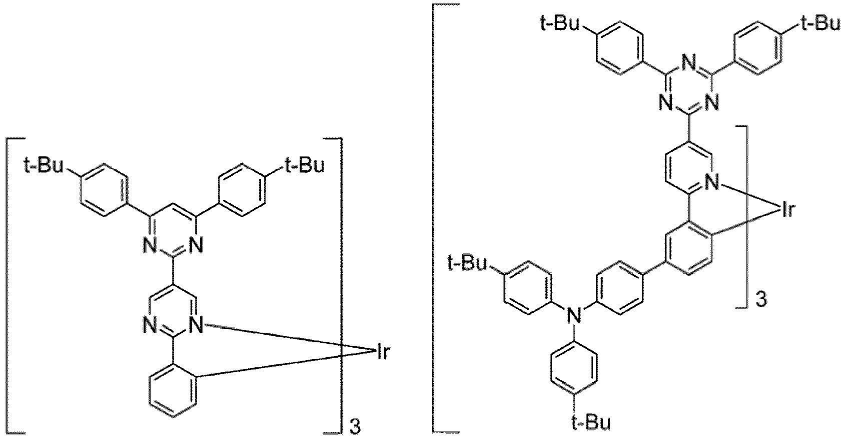

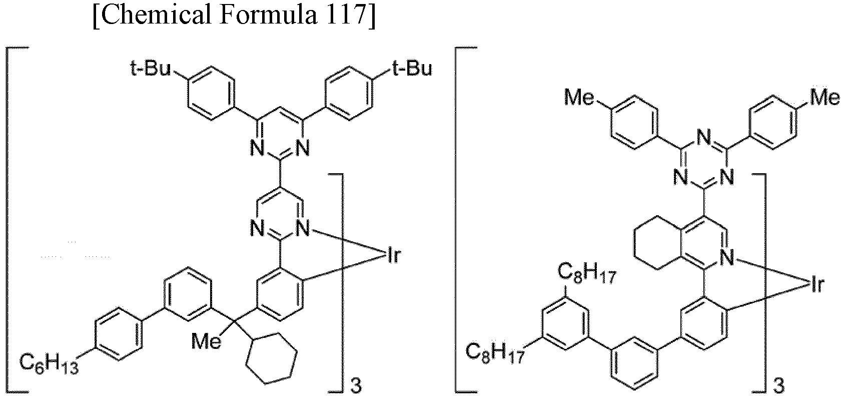

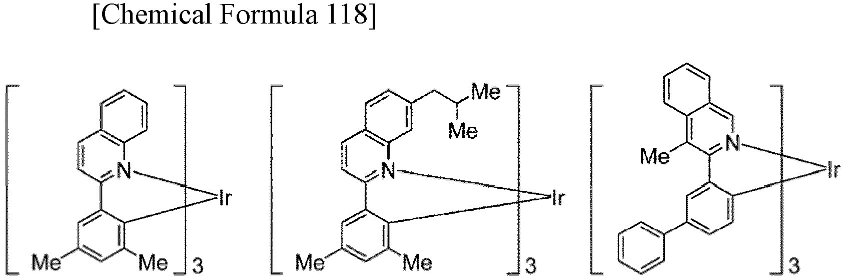

The metal complex represented by formula (2) and the triplet emission complex in the above-mentioned first light emitting layer composition can be obtained from Aldrich, Luminescence Technology Corp., American Dye Source, for example.

These complexes can also be obtained by, for example, synthesizing them according to the methods described in the "Journal of the American Chemical Society, Vol. 107, 1431-1432 (1985)", "Journal of the American Chemical Society, Vol. 106, 6647-6653 (1984)", Japanese Unexamined Patent Publication No. 2004-530254, Japanese Unexamined Patent Publication No. 2008-179617, Japanese Unexamined Patent Publication No. 2011-105701, Japanese Unexamined Patent Publication No. 2007-504272, International Publication No. 2006/121811, and Japanese Unexamined Patent Publication No. 2013-147450.

### [Polymer Compound of Second Light Emitting Layer]

To achieve a better luminance lifetime and facilitate synthesis of the light emitting device according to the present embodiment, the metal complex constitutional unit is preferably a constitutional unit comprising a group formed by removing from a metal complex represented by formula (2) one or more and five or less hydrogen atoms directly bonded to a carbon atom or a hetero atom constituting the metal complex, more preferably a constitutional unit comprising a group formed by removing from a metal complex represented by formula (2) one or more and three or less hydrogen atoms directly bonded to a carbon atom or a hetero atom constituting the metal complex, still more preferably a constitutional unit represented by formula (1B), a constitutional unit represented by formula (2B), a constitutional unit represented by formula (3B), or a constitutional unit represented by formula (4B), particularly preferably a constitutional unit represented by formula (1B), a constitutional unit represented by formula (2B), or a constitutional unit represented by formula (3B), and especially preferably a constitutional unit represented by formula (3B).

### [Constitutional unit Represented by Formula (1B)]

R^{A} is preferably an aryl group or a monovalent heterocyclic group, and more preferably an aryl group, and these groups each may have a substituent.

R^{B} is preferably a hydrogen atom, an alkyl group, a cycloalkyl group, an aryl group, or a monovalent heterocyclic group, more preferably a hydrogen atom, an alkyl group, a cycloalkyl group, or an aryl group, still more preferably a hydrogen atom or an alkyl group, and particularly preferably a hydrogen atom, and these groups each may have a substituent.

L^{C} is preferably -C(R^{B})₂-, an arylene group or a divalent heterocyclic group, more preferably -C(R^{B})₂- or an arylene group, still more preferably an arylene group, and particularly preferably a group represented by formula (A-1) or (A-2), and these groups each may have a substituent.

The examples and preferable ranges of the arylene group and the divalent heterocyclic group represented by L^{C} are each the same as the examples and preferable ranges of the arylene group and divalent heterocyclic group represented by Ar^{Y1} described above.

The examples and preferable ranges of the optional substituents of R^{A}, R^{B}, and L^{C} are the same as the examples and preferable ranges of the optional substituent of the group represented by Ar^{Y1} described above.

In general, n^{c1} is an integer of 0 to 10, preferably an integer of 0 to 5, more preferably an integer of 0 to 2, still more preferably 0 or 1, and particularly preferably 0.

When the polymer compound of the second light emitting layer is a polymer compound comprising a constitutional unit represented by formula (1B), the constitutional unit represented by formula (1B) is a terminal constitutional unit.

"Terminal constitutional unit" means a constitutional unit at the end of the polymer compound. The terminal constitutional unit is preferably a constitutional unit derived from a terminal blocking agent in the production of the polymer compound.

More preferably, M^{1B} is a group represented by formula (BM-1). 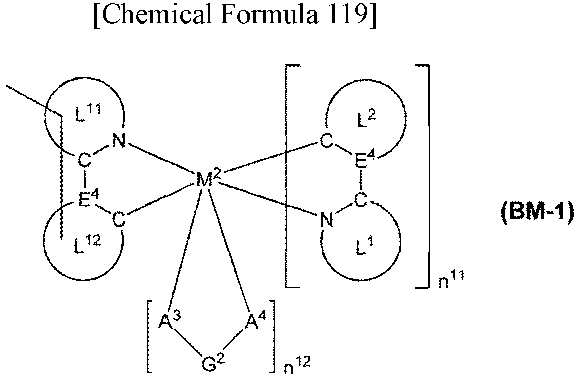 (Wherein,
M², E⁴, the ring L¹, the ring L², and A³-G²-A⁴ represent the same meanings as described above,
the ring L¹¹ represents a 6-membered aromatic heterocyclic ring, and these rings each may have a substituent; and when there are a plurality of such substituents, those substituents may be the same or different and may be bonded to each other to form a ring together with the atoms to which they are bonded,
the ring L¹² represents an aromatic hydrocarbon ring or an aromatic heterocyclic ring, and these rings each may have a substituent; and when there are a plurality of such substituents, those substituents may be the same or different and may be bonded to each other to form a ring together with the atoms to which they are bonded,
provided that one of the ring L¹¹ and the ring L¹² has one bond, and
n¹¹ and n¹² each independently represent an integer of 0 or more; n¹¹ + n¹² is 1 or 2; and when M² is a rhodium atom or an iridium atom, n¹¹ + n¹² is 2, and when M² is a palladium atom or a platinum atom, n¹¹ + n¹² is 1.)

When M² is a rhodium atom or an iridium atom, n¹¹ is more preferably 2.

When M² is a palladium atom or a platinum atom, n¹¹ is preferably 1.

When the ring L¹¹ does not have a bond, the definition, examples, and preferable range of the ring L¹¹ are the same as the definition, examples and preferable range of the ring L¹ described above.

When the ring L¹¹ has a bond, the definition, examples, and preferable range of the ring portion excluding the bond of the ring L¹¹ are the same as the definition, examples, and preferable range of the ring L¹ described above.

When the ring L¹² does not have a bond, the definition, examples and preferable range of the ring L¹² are the same as the definition, examples and preferable range of the ring L² described above.

When the ring L¹² has a bond, the definition, examples and preferable range of the ring portion excluding the bond of the ring L¹² are the same as the definition, examples and preferable range of the ring L² described above.

The definitions, examples and preferable ranges of the optional substituents of the ring L¹¹ and the ring L¹² are the same as the definitions, examples, and preferable ranges of the optional substituents of the ring L¹ and ring L² described above.

### [Constitutional unit Represented by Formula (2B)]

L^{d} is preferably -C(R^{B})₂-, an arylene group, or a divalent heterocyclic group, more preferably an arylene group or a divalent heterocyclic group, still more preferably an arylene group, and particularly preferably a group represented by formula (A-1) or (A-2), and these groups each may have a substituent.

L^{e} is preferably -C(R^{B})₂-, an arylene group, or a divalent heterocyclic group, more preferably -C(R^{B})₂- or an arylene group, still more preferably an arylene group, and particularly preferably a group represented by formula (A-1) or (A-2), and these groups each may have a substituent.

The examples and preferable ranges of the arylene group and the divalent heterocyclic group represented by L^{d} and L^{e} are each the same as the examples and preferable ranges of the arylene group and divalent heterocyclic group represented by Ar^{Y1} described above.

In general, n^{d1} and n^{e1} are an integer of 0 to 10, preferably an integer of 0 to 5, more preferably an integer of 0 to 2, still more preferably 0 or 1, and particularly preferably 0.

Ar^{1M} is preferably a group obtained by removing, from a benzene ring, a naphthalene ring, a fluorene ring, a phenanthrene ring, a dihydrophenanthrene ring, a pyridine ring, a diazabenzene ring, a triazine ring, a carbazole ring, a phenoxazine ring, or a phenothiazine ring, three hydrogen atoms directly bonded to a carbon atom or a hetero atom constituting the ring, more preferably a group obtained by removing, from a benzene ring, a naphthalene ring, a fluorene ring, a phenanthrene ring, or a dihydrophenanthrene ring, three hydrogen atoms directly bonded to a carbon atom constituting the ring, still more preferably a group obtained by removing, from a benzene ring or a fluorene ring, three hydrogen atoms directly bonded to a carbon atom constituting the ring, and particularly more preferably a group obtained by removing, from a benzene ring, three hydrogen atoms directly bonded to a carbon atom constituting the ring, and these groups each may have a substituent.

The examples and preferable ranges of the optional substituents of L^{d}, L^{e}, and Ar^{1M} are each the same as the examples and preferable ranges of the optional substituents of the group represented by Ar^{Y1} described above.

### [Constitutional unit Represented by Formula (3B)]

M^{2B} is a more preferably group represented by formula (BM-2) or (BM-3), and still more preferably a group represented by formula (BM-2). 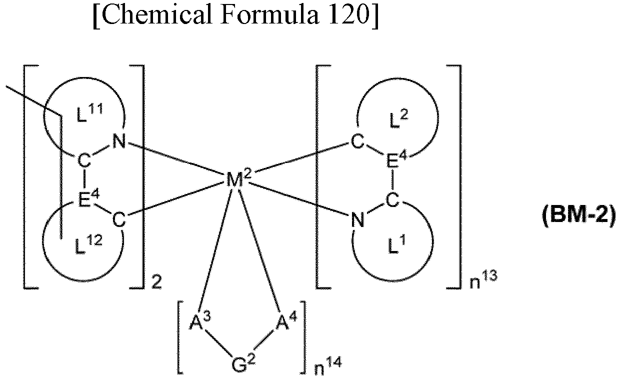 (Wherein,
M², E⁴, the ring L¹, the ring L², the ring L¹¹, the ring L¹², and A³⁻G²⁻A ⁴ represent the same meanings as described above; the plurality of the ring L¹¹ may be the same or different; and the plurality of the ring L¹² may be the same or different, and
n¹³ and n¹⁴ each independently represent an integer of 0 or more; n¹³ + n¹⁴ is 0 or 1; and when M² is a rhodium atom or an iridium atom, n¹³ + n¹⁴ is 1, and when M² is a palladium atom or a platinum atom, n¹³ + n¹⁴ is 0.)

When M² is a rhodium atom or an iridium atom, n¹³ is preferably 1. 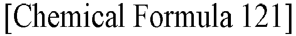 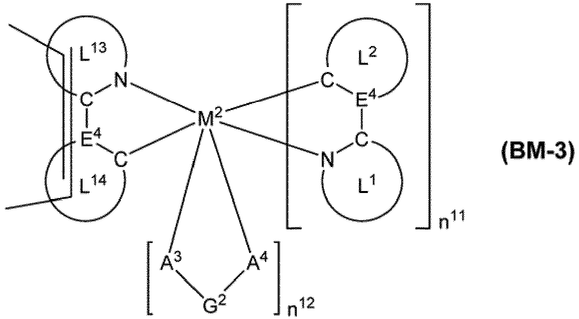 (Wherein,
M², E⁴, the ring L¹, the ring L², A³-G²-A⁴, n¹¹, and n¹² represent the same meanings as described above,
the ring L¹³ represents a 6-membered aromatic heterocyclic ring, and these rings each may have a substituent; and when there are a plurality of such substituents, those substituents may be the same or different and may be bonded to each other to form a ring together with the atoms to which they are bonded,
the ring L¹⁴ represents an aromatic hydrocarbon ring or an aromatic heterocyclic ring, and these rings each may have a substituent; and when there are a plurality of such substituents, those substituents may be the same or different and may be bonded to each other to form a ring together with the atoms to which they are bonded,
provided that one of the ring L¹³ and the ring L¹⁴ has two bonds, or the ring L¹³ and the ring L¹⁴ each have one bond.)

When the ring L¹³ does not have a bond, the definition, examples, and preferable range of the ring L¹³ are the same as the definition, examples and preferable range of the ring L¹ described above.

When the ring L¹³ has a bond, the definition, examples, and preferable range of the ring portion excluding the bond of the ring L¹³ are the same as the definition, examples, and preferable range of the ring L¹ described above.

When the ring L¹⁴ does not have a bond, the definition, examples and preferable range of the ring L¹⁴ are the same as the definition, examples and preferable range of the ring L² described above.

When the ring L¹⁴ has a bond, the definition, examples and preferable range of the ring portion excluding the bond of the ring L¹⁴ are the same as the definition, examples and preferable range of the ring L² described above.

The definitions, examples and preferable ranges of the optional substituents of the ring L¹³ and the ring L¹⁴ are the same as the definitions, examples, and preferable ranges of the optional substituents of the ring L¹ and ring L² described above.

Each of the ring L¹³ and the ring L¹⁴ preferably has one bond.

### [Constitutional unit Represented by Formula (4B)]

M^{3B} is preferably a group represented by formula (BM-4). 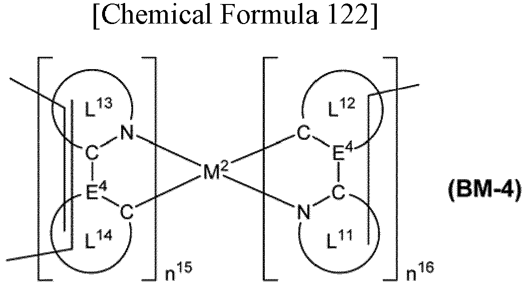 (Wherein,
M², E⁴, the ring L¹¹, the ring L¹², the ring L¹³, and the ring L¹⁴ represent the same meanings as described above, and
n¹⁵ represents 0 or 1; n¹⁶ represents 1 or 3; when M² is a rhodium atom or an iridium atom, n¹⁵ is 0 and n¹⁶ is 3, and, when M² is a palladium atom or a platinum atom, n¹⁵ is 1 and n¹⁶ is 1.)

Examples of the metal complex constitutional unit include the constitutional units represented by formulas (1G-1) to (1G-13), (2G-1) to (2G-16), (3G-1) to (3G-23), or (4G-1) to (4G-6). 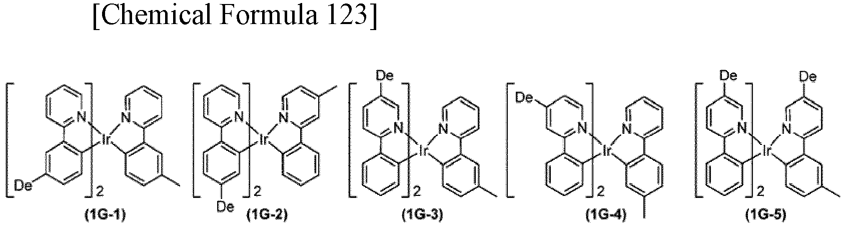 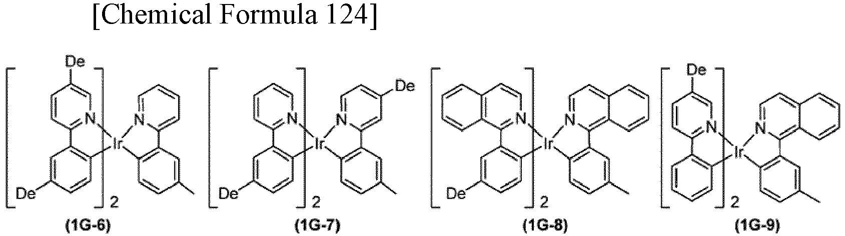 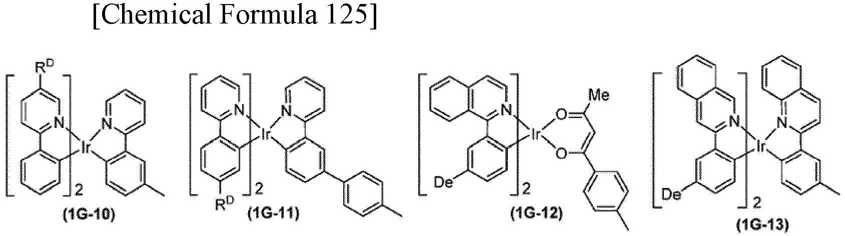 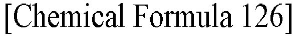 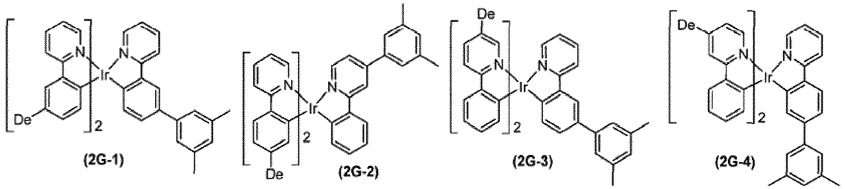 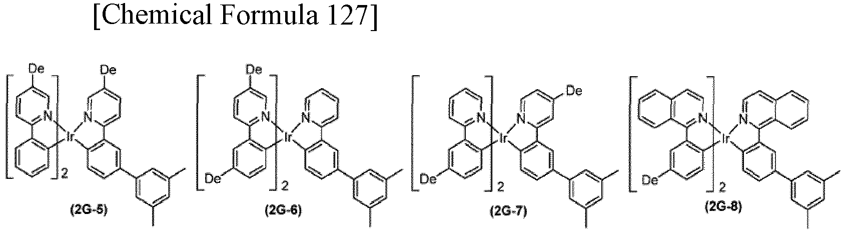 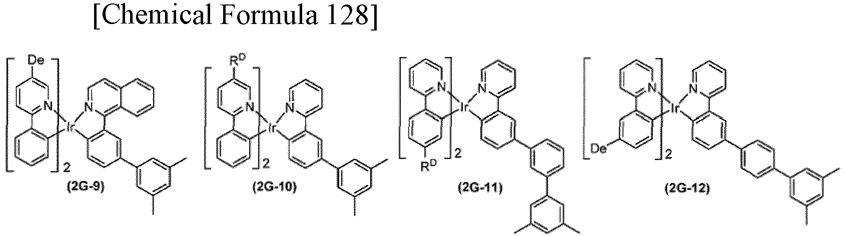 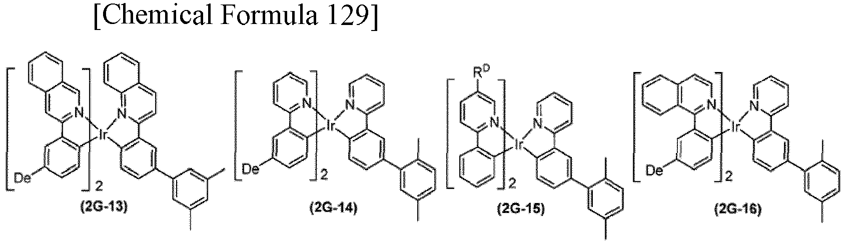 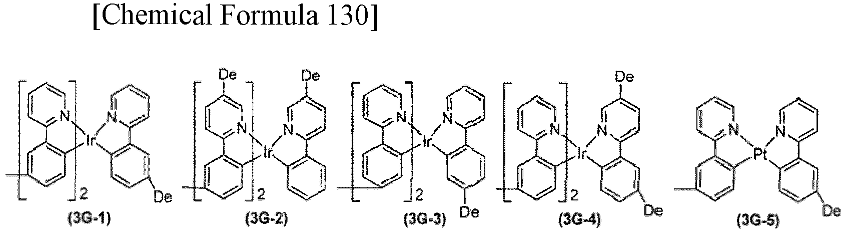 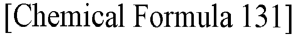 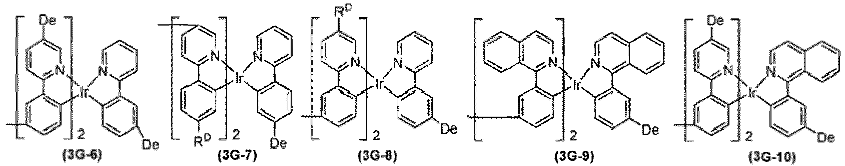 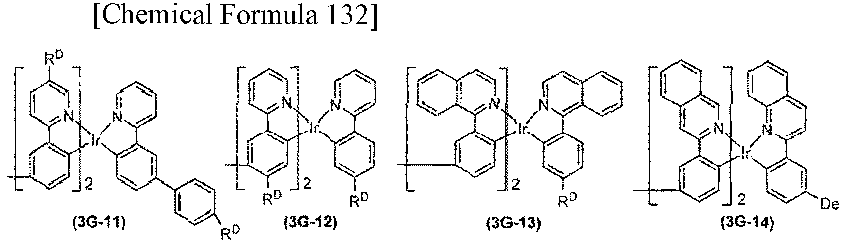 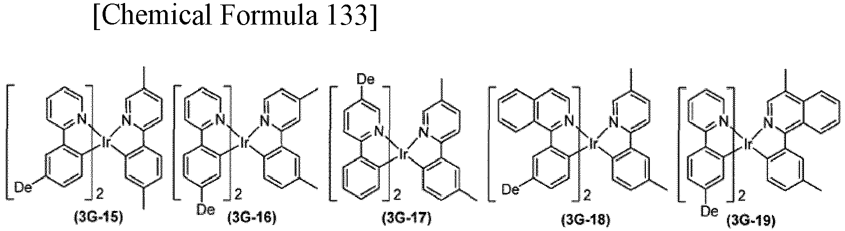 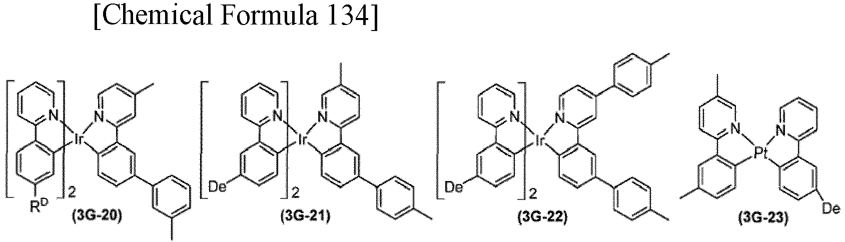 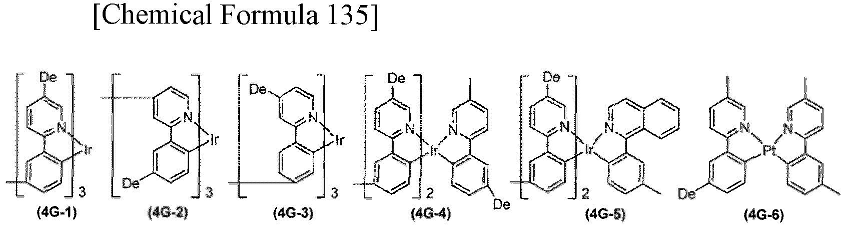
(Wherein, R^{D} represents the same meaning as described above, and
D^{e} represents a group represented by formula (D-A), (D-B), or (D-C).)

To achieve a better luminance lifetime of the light emitting device according to the present embodiment, the content of the metal complex constitutional unit is preferably 0.01 to 50 mol%, more preferably 0.1 to 30 mol%, still more preferably 0.5 to 10 mol%, and particularly preferably 1 to 5 mol%, based on the total amount of constitutional units contained in the polymer compound of the second light emitting layer.

To achieve better hole transportability, the polymer compound of the second light emitting layer preferably further comprises a constitutional unit represented by formula (X).

The definition, examples, and preferable range of the constitutional unit represented by formula (X) that the polymer compound of the second light emitting layer may conmprise are the same as the definition, examples, and preferable range of the constitutional unit represented by formula (X) that the above-mentioned polymer host may comprise.

When the polymer compound of the second light emitting layer comprises a constitutional unit represented by formula (X), the content of the constitutional unit represented by formula (X) contained in the polymer compound of the second light emitting layer is preferably 1 to 80 mol%, more preferably 10 to 60 mol%, and still more preferably 20 to 40 mol%, based on the total amount of constitutional units contained in the polymer compound of the second light emitting layer.

Only one constitutional unit represented by formula (X) may be contained or two or more of them may be contained in the polymer compound of the second light emitting layer.

To achieve a better luminance lifetime of the light emitting device according to the present embodiment, the polymer compound of the second light emitting layer preferably further comprises a constitutional unit represented by formula (Y).

The definition, examples, and preferable range of the constitutional unit represented by formula (Y) that the polymer compound of the second light emitting layer may comprise are the same as the definition, examples, and preferable range of the constitutional unit represented by formula (Y) that the above-mentioned polymer host may comprise.

When the polymer compound of the second light emitting layer comprises a constitutional unit represented by formula (Y), and Ar^{Y1} is an arylene group, to achieve a better luminance lifetime of the light emitting device according to the present embodiment, the content of the constitutional unit represented by formula (Y) contained in the polymer compound of the second light emitting layer is preferably 0.5 to 90 mol%, and more preferably 30 to 80 mol%, based on the total amount of constitutional units contained in the polymer compound of the second light emitting layer.

When the polymer compound of the second light emitting layer comprises a constitutional unit represented by formula (Y), and Ar^{Y1} is a divalent heterocyclic group or a divalent group in which at least one arylene group and at least one divalent heterocyclic group are directly bonded to each other, to achieve better charge transportability of the light emitting device according to the present embodiment, the content of the constitutional unit represented by formula (Y) contained in the polymer compound of the second light emitting layer is preferably 0.5 to 40 mol%, and more preferably 3 to 30 mol%, based on the total amount of constitutional units contained in the polymer compound of the second light emitting layer.

Only one constitutional unit represented by formula (Y) may be contained or two or more of them may be contained in the polymer compound of the second light emitting layer.

The polymer compound of the second light emitting layer can be formed by a coating method of the light emitting device according to the present embodiment. Further, it is preferable to further comprise a crosslinkable constitutional unit having a crosslinkable group, as this allows the light emitting device to be laminated.

Only one crosslinkable constitutional unit having a crosslinkable group may be contained or two or more of them may be contained in the polymer compound of the second light emitting layer.

As described above, the polymer compound of the second light emitting layer preferably further comprises at least one constitutional unit selected from the group consisting of a crosslinkable constitutional unit having a crosslinkable group, a constitutional unit represented by formula (X), and a constitutional unit represented by formula (Y), more preferably further comprises at least two constitutional unit selected from the group consisting of a crosslinkable constitutional unit having a crosslinkable group, a constitutional unit represented by formula (X), and a constitutional unit represented by formula (Y), and still more preferably further comprises a crosslinkable constitutional unit having a crosslinkable group, a constitutional unit represented by formula (X), and a constitutional unit represented by formula (Y).

### [Crosslinkable Constitutional unit Having Crosslinkable Group]

In the crosslinkable constitutional unit having a crosslinkable group, to achieve a better luminance lifetime of the light emitting device according to the present embodiment, the crosslinkable group is preferably a crosslinkable group selected from the group of crosslinkable group A, more preferably a crosslinkable group represented by formula (XL-1), (XL-3), (XL-9), (XL-16), or (XL-17), more preferably a crosslinkable group represented by formula (XL-1), (XL-16), or (XL-17), and particularly preferably a crosslinkable group represented by formula (XL-1) or (XL-17).

The crosslinkable constitutional unit having a crosslinkable group that may be contained in the polymer compound of the second light emitting layer is preferably a constitutional unit represented by the following formula (3) or a constitutional unit represented by the following formula (4). This crosslinkable constitutional unit may also be a constitutional unit represented by the following.

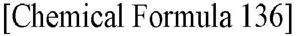

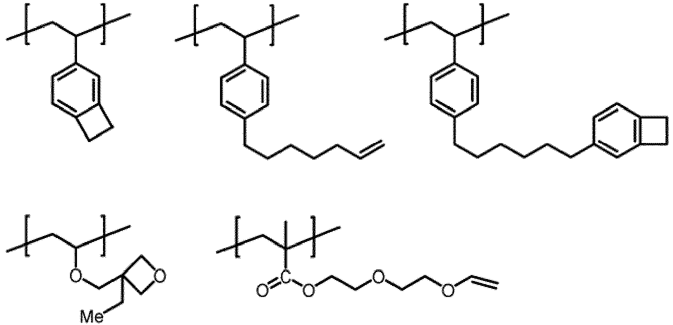

The crosslinkable constitutional unit having a crosslinkable group that may be contained in the polymer compound of the second light emitting layer is preferably be a constitutional unit represented by formula (3) or a constitutional unit represented by formula (4).

### [Constitutional unit Represented by Formula (3)]

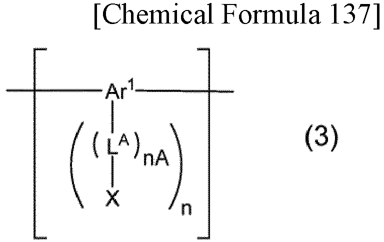

(Wherein,
nA represents an integer of 0 to 5, and n represents an integer of 1 to 4,
Ar¹ represents an aromatic hydrocarbon group or a heterocyclic group, and these groups each may have a substituent,
L^{A} represents an alkylene group, a cycloalkylene group, an arylene group, a divalent heterocyclic group, a group represented by -NR'-, an oxygen atom, or a sulfur atom, and these groups each may have a substituent; R' represents a hydrogen atom, an alkyl group, a cycloalkyl group, an aryl group, or a monovalent heterocyclic group, and these groups each may have a substituent; and when there are a plurality of L^{A}, they may be the same or different; and
X represents a crosslinkable group of any one of formulas (XL-1) to (XL-17); and when there are a plurality of X, they may be the same or different.)

To achieve a better luminance lifetime of the light emitting device according to the present embodiment, nA is preferably an integer of 0 to 3, more preferably an integer of 0 to 2, still more preferably 0 or 1, and particularly preferably 1.

To achieve a better luminance lifetime of the light emitting device according to the present embodiment, n is preferably 1 or 2, and more preferably 2.

To achieve a better luminance lifetime of the light emitting device according to the present embodiment, Ar¹ is preferably an aromatic hydrocarbon group that may have a substituent.

The aromatic hydrocarbon group represented by Ar¹ usually has 6 to 60 carbon atoms, preferably 6 to 30 carbon atoms, and more preferably 6 to 18 carbon atoms, not including the carbon atoms of the substituent.

The arylene group moiety excluding the n substituents of the aromatic hydrocarbon group represented by Ar¹ is preferably a group represented by formulas (A-1) to (A-20), more preferably a group represented by formula (A-1), (A-2), (A-6) to (A-10), (A-19), or (A-20), and still more preferably a group represented by formula (A-1), (A-2), (A-7), (A-9), or (A-19), and these groups each may have a substituent.

The heterocyclic group represented by Ar¹ usually has 2 to 60 carbon atoms, preferably 3 to 30 carbon atoms, and more preferably 4 to 18 carbon atoms, not including the carbon atoms of the substituent.

The divalent heterocyclic group moiety excluding the n substituents of the heterocyclic group represented by Ar¹ is preferably a group represented by formulas (AA-1) to (AA-34).

The aromatic hydrocarbon group and the heterocyclic group represented by Ar¹ each may have a substituent. The substituent is preferably an alkyl group, a cycloalkyl group, an alkoxy group, a cycloalkoxy group, an aryl group, an aryloxy group, a halogen atom, a monovalent heterocyclic group, or a cyano group.

The alkylene group represented by L^{A} usually has 1 to 20 carbon atoms, preferably 1 to 15 carbon atoms, and more preferably 1 to 10 carbon atoms, not including the carbon atoms of the substituent. The cycloalkylene group represented by L^{A} usually has 3 to 20 carbon atoms, not including the carbon atoms of the substituent.

The alkylene group and the cycloalkylene group each may have a substituent, and examples thereof include a methylene group, an ethylene group, a propylene group, a butylene group, a hexylene group, a cyclohexylene group, and an octylene group.

The alkylene group and the cycloalkylene group represented by L^{A} each may have a substituent. The optional substituents of the alkylene group and the cycloalkylene group are preferably an alkyl group, a cycloalkyl group, an alkoxy group, a cycloalkoxy group, a halogen atom, and a cyano group.

The arylene group represented by L^{A} may have a substituent. The arylene group is preferably a phenylene group or a fluorenediyl group, and more preferably an m-phenylene group, a p-phenylene group, a fluorene-2,7-diyl group, or a fluorene-9,9-diyl group. The optional substituent of the arylene group is preferably an alkyl group, a cycloalkyl group, an alkoxy group, a cycloalkoxy group, an aryl group, an aryloxy group, a monovalent heterocyclic group, a halogen atom, a cyano group, and a crosslinkable group selected from the group of crosslinkable group A.

To facilitate synthesis of the polymer compound of the second light emitting layer, L^{A} is preferably an arylene group or an alkylene group, and more preferably a phenylene group, a fluorenediyl group, or an alkylene group, and these groups each may have a substituent.

To achieve better crosslinkable properties of the polymer compound of the second light emitting layer, the crosslinkable group represented by X is preferably a crosslinkable group represented by formula (XL-1), (XL-3), (XL-7) to (XL-10), (XL-16), or (XL-17), more preferably a crosslinkable group represented by formula (XL-1), (XL-3), (XL-9,) (XL-16), or (XL-17), still more preferably a crosslinkable group represented by formula (XL-1), (XL-16), or (XL-17), and particularly preferably a crosslinkable group represented by formula (XL-1) or (XL-17).

To achieve better crosslinking properties of the polymer compound of the second light emitting layer, the content of the constitutional unit represented by formula (3) is preferably 0.5 to 80 mol%, more preferably 1 to 60 mol%, still more preferably 3 to 40 mol%, and particularly preferably 5 to 20 mol%, based on the total amount of constitutional units contained in the polymer compound of the second light emitting layer.

Only one constitutional unit represented by formula (3) may be contained or two or more of them may be contained in the polymer compound of the second light emitting layer.

### [Constitutional unit Represented by Formula (4)]

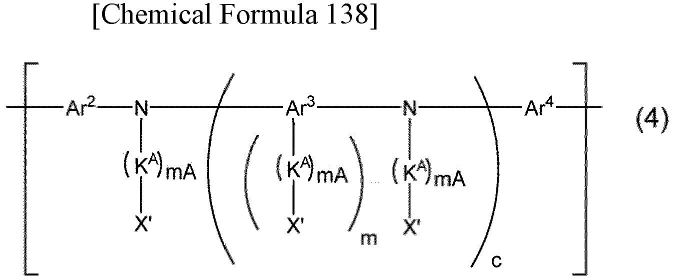

(Wherein,
mA represents an integer of 0 to 5, m represents an integer of 1 to 4, and c represents 0 or 1; and when there are a plurality of mA, they may be the same or different,
Ar³ represents an aromatic hydrocarbon group, a heterocyclic group, or a group in which at least one aromatic hydrocarbon ring and at least one heterocyclic ring are directly bonded to each other, and these groups each may have a substituent,
Ar² and Ar⁴ each independently represent an arylene group or a divalent heterocyclic group, and these groups each may have a substituent,
Ar², Ar³, and Ar⁴ may each be bonded either directly or via an oxygen atom or a sulfur atom to a group other than the group bonded to the nitrogen atom to which that group is bonded to form a ring,
K^{A} represents an alkylene group, a cycloalkylene group, an arylene group, a divalent heterocyclic group, a group represented by -NR"-, an oxygen atom, or a sulfur atom, and these groups each may have a substituent; R" represents a hydrogen atom, an alkyl group, a cycloalkyl group, an aryl group, or a monovalent heterocyclic group, and these groups each may have a substituent; and when there are a plurality of K^{A}, they may be the same or different,
X' represents a crosslinkable group represented by any one of formulas (XL-1) to (XL-17), a hydrogen atom, an alkyl group, a cycloalkyl group, an aryl group, or a monovalent heterocyclic group, and these groups each may have a substituent; provided that at least one X' is a crosslinkable group represented by any one of formulas (XL-1) to (XL-17).)

To achieve a better luminance lifetime of the light emitting device according to the present embodiment, mA is preferably 0 or 1, and more preferably 0.

To achieve a better luminance lifetime of the light emitting device according to the present embodiment, m is preferably 0.

To facilitate synthesis of the polymer compound of the second light emitting layer, and achieve a better luminance lifetime of the light emitting device according to the present embodiment, c is preferably 0.

To achieve a better luminance lifetime of the light emitting device according to the present embodiment, Ar³ is preferably an aromatic hydrocarbon group which may have a substituent.

The definition and examples of the arylene group moiety excluding the m substituents of the aromatic hydrocarbon group represented by Ar³ are the same as the definition and examples of the arylene group represented by Ar^{X2} in the above-mentioned formula (X).

The definition and examples of the divalent heterocyclic group moiety excluding the m substituents of the heterocyclic group represented by Ar³ are the same as the definition and examples of the divalent heterocyclic group moiety represented by Ar^{X2} in the above-mentioned formula (X).

The definition and examples of the divalent group excluding the m substituents of the group represented by Ar³ in which at least one aromatic hydrocarbon ring and at least one heterocyclic ring are directly bonded to each other are the same as the definition and examples of the divalent group represented by Ar^{X2} in the above-mentioned formula (X) in which at least one arylene group and at least one divalent heterocyclic group are directly bonded to each other.

To achieve a better luminance lifetime of the light emitting device according to the present embodiment, Ar² and Ar⁴ are preferably arylene groups which may have a substituent.

The definition and examples of the arylene group represented by Ar² and Ar⁴ are the same as the definition and examples of the arylene group represented by Ar^{X1} and Ar^{X3} in the above formula (X).

The definition and examples of the divalent heterocyclic group represented by Ar² and Ar⁴ are the same as the definition and examples of the divalent heterocyclic group represented by Ar^{X1} and Ar^{X3} in the above formula (X).

The groups represented by Ar², Ar³, and Ar⁴ each may have a substituent. Preferable examples of the substituent include an alkyl group, a cycloalkyl group, an alkoxy group, a cycloalkoxy group, an aryl group, an aryloxy group, a halogen atom, a monovalent heterocyclic group and a cyano group.

The definitions and examples of the alkylene group, the cycloalkylene group, the arylene group, and the divalent heterocyclic group represented by K^{A} are each the same as the definitions and examples of the alkylene group, the cycloalkylene group, the arylene group, and the divalent heterocyclic group represented by L^{A}

To facilitate the synthesis of the polymer compound of the second light emitting layer, K^{A} is preferably a phenylene group or a methylene group, and these groups each may have a substituent.

The definitions and examples of the crosslinkable group represented by X' are the same as the definition and examples of the crosslinkable group represented by X described above.

To achieve better hole transportability of the polymer compound of the second light emitting layer and better crosslinking properties of the polymer compound of the second light emitting layer, the content of the constitutional unit represented by formula (4) is preferably 0.5 to 80 mol%, more preferably 1 to 60 mol%, still more preferably 3 to 40 mol%, and particularly preferably 5 to 20 mol%, based on the total amount of constitutional units contained in the polymer compound of the light emitting layer.

Only one constitutional unit represented by formula (4) may be contained or two or more of them may be contained in the polymer compound of the second light emitting layer.

Examples of constitutional unit represented by formula (3) include constitutional units represented by formulas (3-1) to (3-30), and examples of the constitutional unit represented by formula (4) include constitutional units represented by formulas (4-1) to (4-9). Among these, to achieve better crosslinkable properties of the polymer compound of the second light emitting layer, such constitutional unit is preferably a constitutional unit represented by formulas (3-1) to (3-30), more preferably a constitutional unit represented by formulas (3-1) to (3-15), (3-19), (3-20), (3-23), (3-25), or (3-30), still more preferably a constitutional unit represented by formulas (3-1) to (3-13) or (3-30), and particularly preferable a constitutional unit represented by formulas (3-1) to (3-9) or (3-30).

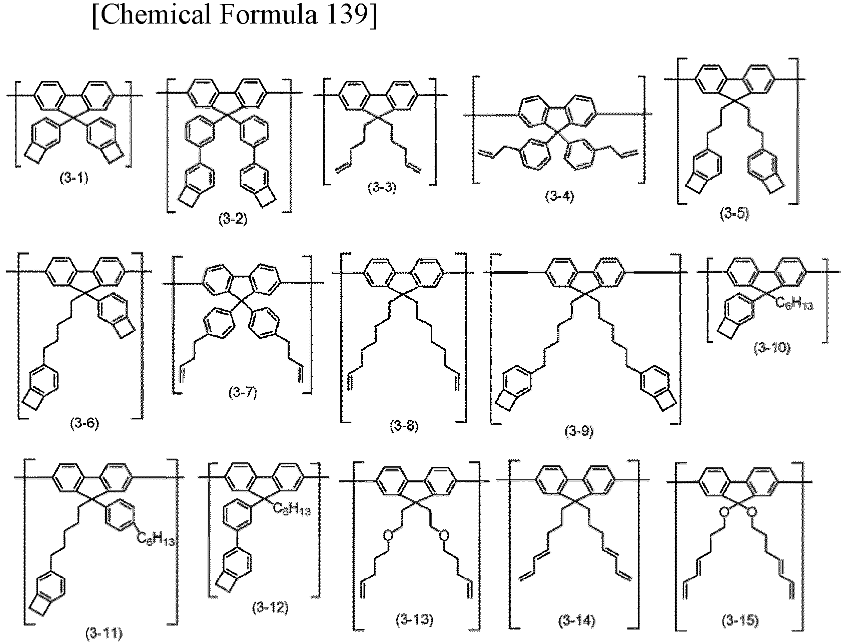

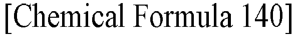

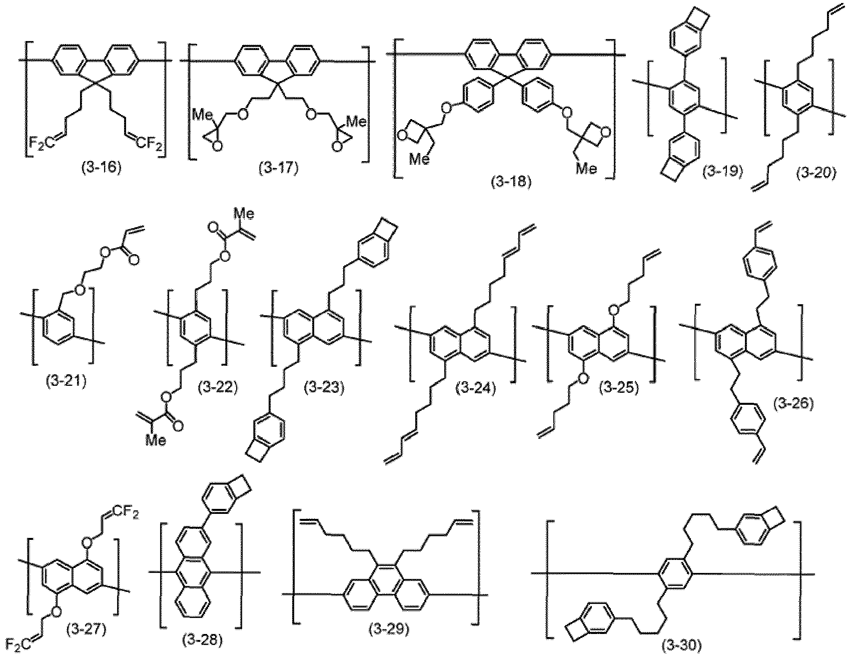

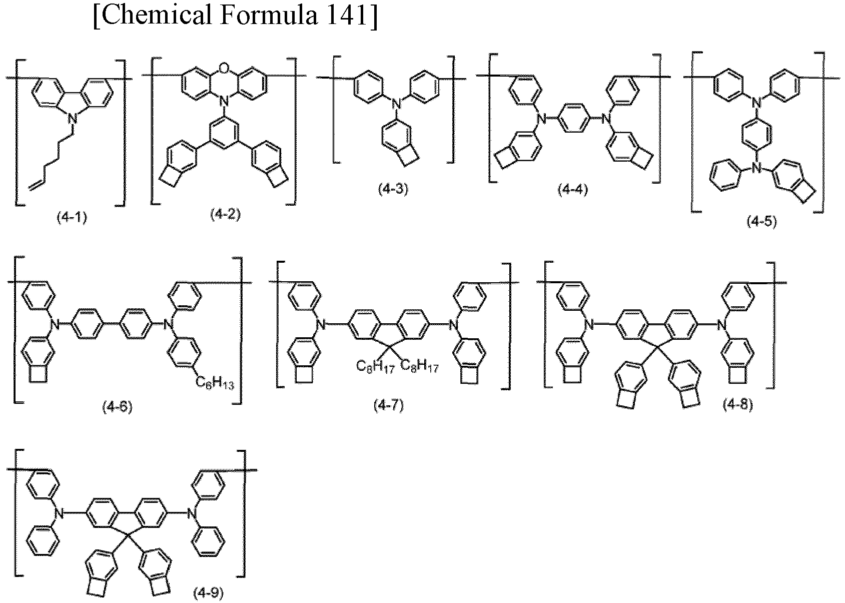

Examples of the polymer compound of the second light emitting layer include polymer compounds P-7 to P-20 shown in Table 1. In Table 1, the heading "Other" means a constitutional unit other than the constitutional unit of the metal complex and the constitutional units represented by formulas (3), (4), (X), and (Y).

**[Table 2]**

| Polymer Compound | Constitutional units and Molar Ratios Thereof | | | | | |
|---|---|---|---|---|---|---|
| | Metal Complex Constitutional unit | Formula (3) | Formula (4) | Formula (X) | Formula (Y) | Other |
| | p' | q' | r' | s' | t' | u' |
| P-7 | 70-100 | 0 | 0 | 0 | 0 | 0-30 |
| P-8 | 0.1-99.9 | 0.1-99.9 | 0 | 0 | 0 | 0-30 |
| P-9 | 0.1-99.9 | 0 | 0.1-99.9 | 0 | 0 | 0-30 |
| P-10 | 0.1-99.9 | 0 | 0 | 0.1-99.9 | 0 | 0-30 |
| P-11 | 0.1-99.9 | 0 | 0 | 0 | 0.1-99.9 | 0-30 |
| P-12 | 0.1-99.8 | 0.1-99.8 | 0.1-99.8 | 0 | 0 | 0-30 |
| P-13 | 0.1-99.8 | 0.1-99.8 | 0 | 0.1-99.8 | 0 | 0-30 |
| P-14 | 0.1-99.8 | 0.1-99.8 | 0 | 0 | 0.1-99.8 | 0-30 |
| P-15 | 0.1-99.8 | 0 | 0.1-99.8 | 0.1-99.8 | 0 | 0-30 |
| P-16 | 0.1-99.8 | 0 | 0.1-99.8 | 0 | 0.1-99.8 | 0-30 |
| P-17 | 0.1-99.8 | 0 | 0 | 0.1-99.8 | 0.1-99.8 | 0-30 |
| P-18 | 0.1-99.7 | 0.1-99.7 | 0.1-99.7 | 0.1-99.7 | 0 | 0-30 |
| P-19 | 0.1-99.7 | 0.1-99.7 | 0.1-99.7 | 0 | 0.1-99.7 | 0-30 |
| P-20 | 0.1-99.6 | 0.1-99.6 | 0.1-99.6 | 0.1-99.6 | 0.1-99.6 | 0-30 |

[In table 2, p', q', r', s', t', and u' represent the molar ratio (mol%) of the respective constitutional unit, p'+ q' + r'+ s' + t' + u' = 100, and 70 ≤ p' + q' + r' + s' + t' ≤ 100.]

The polymer compound of the second light emitting layer may be either a block copolymer, a random copolymer, an alternating copolymer, or a graft copolymer, or may even be some other form. However, this polymer compound is preferably a copolymer obtained by copolymerizing a plurality of raw material monomers.

### [Method for Producing Polymer compound of Second Light Emitting Layer]

The polymer compound of the second light emitting layer can be produced by a method similar to the above-mentioned method for producing the polymer host.

In addition, synthesis can be performed according to the methods described in Japanese Unexamined Patent Publication No. 2003-171659, International Publication No. 2006/003000, Japanese Unexamined Patent Publication No. 2010-43243, Japanese Unexamined Patent Publication No. 2011-105701, International Publication No. 2013/021180, Japanese Unexamined Patent Publication No. 2015-174931, and Japanese Unexamined Patent Publication No. 2015-174932 as the methods other than those described above.

### [Composition Ratio of Second Light Emitting Layer]

The second light emitting layer may be a layer formed using a composition (hereinafter also referred to as "second light emitting layer composition") comprising a light emitting material and at least one material selected from the group consisting of a host material, a hole transporting material, a hole injecting material, an electron transporting material, an electron injecting material, and an antioxidant.

Here, "formed using" means that the second light emitting layer is formed using the second light emitting layer composition. The light emitting material in the second light emitting layer composition may be contained in the second light emitting layer as it is, or in an intramolecularly, an intermolecularly, or an intramolecularly and intermolecularly crosslinked state. More specifically, the second light emitting layer may comprise the second light emitting layer composition and/or a crosslinked product of the second light emitting layer composition.

In the second light emitting layer composition, the examples and preferable ranges of the host material, the hole transporting material, the electron transporting material, the hole injecting material, and the electron injecting material are each the same as the examples and preferable ranges of the host material, the hole transporting material, the electron transporting material, the hole injecting material, and the electron injecting material of the first light emitting layer composition.

In the second light emitting layer composition, the amount of the host material blended is, based on a total of 100 parts by mass of the light emitting material and the host material, usually 50 to 99.9 parts by mass, preferably 60 to 99.9 parts by mass, and more preferably 70 to 95 parts by mass.

In the second light emitting layer composition, the amount of each of the hole transporting material, the electron transporting material, the hole injecting material, and the electron injecting material blended is, based on 100 parts by mass of the light emitting material, usually 1 to 400 parts by mass, and preferably 5 to 150 parts by mass.

In the second light emitting layer composition, the examples and preferable range of the antioxidant are the same as the examples and preferable range of the antioxidant of the first light emitting layer composition. Further, in the second light emitting layer composition, the amount of the antioxidant blended is, based on 100 parts by mass of the light emitting material, usually 0.001 to 10 parts by mass.

### [Ink of Second First Light Emitting Layer]

Similar to the ink of the first light emitting layer, a composition (hereinafter also referred to as "ink of the second light emitting layer") comprising the light emitting material and a solvent can be suitably used in a coating method such as spin coating, casting, micro gravure coating, gravure coating, bar coating, roll coating, wire bar coating, dip coating, spray coating, screen printing, flexographic printing, an offset printing method, ink jet printing, capillary coating, and nozzle coating.

The preferable range of the viscosity of the ink of the second light emitting layer is the same as the preferable range of the viscosity of the ink of the first light emitting layer.

The examples and preferable range of the solvent contained in the ink of the second light emitting layer are the same as the examples and preferable range of the solvent contained in the ink of the first light emitting layer.

In the ink of the second light emitting layer, the amount of the solvent blended is, based on 100 parts by mass of the polymer compound of the second light emitting layer, usually 1000 to 100000 parts by mass, and preferably 2000 to 20000 parts by mass.

The ink of the second light emitting layer may comprise components other than the light emitting material and the solvent. For example, the ink of the second light emitting layer may further comprise at least one material selected from the group consisting of a host material, a hole transporting material, a hole injecting material, an electron transporting material, an electron injecting material, and an antioxidant.

### <Layer Structure of Light Emitting Device>

The light emitting device according to the present embodiment comprises an anode, a cathode, a first light emitting layer provided between the anode and the cathode, and a second light emitting layer provided between the anode and the cathode. The light emitting device according to the present embodiment may also comprise layers other than of the anode, the cathode, the first light emitting layer, and the second light emitting layer.

In the light emitting device according to the present embodiment, to achieve a better luminance lifetime of the light emitting device according to the present embodiment, the first light emitting layer and the second light emitting layer are preferably adjacent to each other.

In the light emitting device according to the present embodiment, to achieve a better luminance lifetime of the light emitting device according to the present embodiment, the second light emitting layer is preferably a layer provided between the anode and the first light emitting layer.

In the light emitting device according to the present embodiment, the emission color can be adjusted, even to a white color, by adjusting the ratio between the content of the metal complex represented by formula (1) used for forming the first light emitting layer and the content of the light emitting material used for forming the second light emitting layer.

The emission color of the light emitting device can be confirmed by determining the chromaticity coordinates (CIE chromaticity coordinates) by measuring the emission chromaticity of the light emitting device. A white emission color means, for example, that the X chromaticity coordinate is within a range of 0.20 to 0.55, and the Y chromaticity coordinate is within the range of 0.20 to 0.55. It is preferable that the X chromaticity coordinate is within a range of 0.25 to 0.51 and the Y chromaticity coordinate is within a range of 0.25 to 0.51.

From the viewpoint of adjusting the emission color of the light emitting device according to the present embodiment (in particular, adjusting the emission color to white), the maximum peak wavelength of the emission spectrum of the metal complex represented by formula (1) is usually 380 nm or more and less than 495 nm, preferably 400 nm or more and 490 nm or less, more preferably 420 nm or more and 485 nm or less, and still more preferably 450 nm or more and 480 nm or less.

From the viewpoint of adjusting the emission color of the light emitting device according to the present embodiment (in particular, adjusting the emission color to white), the emission spectrum of the light emitting material used to form the second light emitting layer usually has a maximum peak wavelength at 495 nm or more and less than 750 nm, preferably has a maximum wavelength at 500 nm or more and 700 nm or less, more preferably has a maximum wavelength at 570 nm or more and 680 nm or less, and still more preferably has a maximum wavelength at 590 nm or more and 640 nm or less.

From the viewpoint of adjusting the emission color of the light emitting device according to the present embodiment (in particular, adjusting the emission color to white), the maximum peak wavelength of the emission spectrum of the metal complex represented by formula (2) is usually 495 nm or more and less than 750 nm, and preferably 500 nm or more and 700 nm or less.

From the viewpoint of adjusting the emission color of the light emitting device according to the present embodiment (in particular, adjusting the emission color to white), when the light emitting material contained in the second light emitting layer is a metal complex represented by formula (2), the maximum peak wavelength of the emission spectrum of the metal complex represented by formula (2) is usually 495 nm or more and less than 750 nm, preferably 500 nm or more and 700 nm or less, more preferably 570 nm or more and 680 nm or less, and still more preferably 590 nm or more and 640 nm or less.

From the viewpoint of adjusting the emission color of the light emitting device according to the present embodiment (in particular, adjusting the emission color to white), when the light emitting material contained in the second light emitting layer is the polymer compound of the second light emitting layer, the maximum peak wavelength of the emission spectrum of the metal complex represented by formula (2) contained in the polymer compound of the second light emitting layer is usually 495 nm or more and less than 750 nm, preferably 500 nm or more and 700 nm or less, more preferably 570 nm or more and 680 nm or less, and still more preferably 590 nm or more and 640 nm or less.

From the viewpoint of adjusting the emission color of the light emitting device according to the present embodiment (in particular, adjusting the emission color to white), when the light emitting material contained in the second light emitting layer is a crosslinked product of the polymer compound of the second light emitting layer, the maximum peak wavelength of the emission spectrum of the metal complex represented by formula (2) contained in the crosslinked product of the polymer compound of the second light emitting layer is usually 495 nm or more and less than 750 nm, preferably 500 nm or more and 700 nm or less, more preferably 570 nm or more and 680 nm or less, and still more preferably 590 nm or more and 640 nm or less.

From the viewpoint of adjusting the emission color of the light emitting device according to the present embodiment (in particular, adjusting the emission color to white), the first light emitting layer contained in the light emitting device according to the present embodiment is preferably a layer formed using a composition further comprising a light emitting material (hereinafter also referred to as "third light emitting material") that has a maximum wavelength in the emission spectrum at 380 nm or more and less than 750 nm.

The examples and preferable range of the third light emitting material are the same as the examples and preferable range of the light emitting material which may be contained in the composition of the first light emitting layer.

From the viewpoint of adjusting the emission color of the light emitting device according to the present embodiment (in particular, adjusting the emission color to white), the emission spectrum of the third light emitting material preferably has a maximum peak wavelength at 495 nm or more and less than 750 nm, more preferably has a maximum wavelength at 500 nm or more and 700 nm or less, still more preferably has a maximum wavelength at 500 nm or more and less than 570 nm, and particularly preferably has a maximum wavelength at 505 nm or more and 560 nm or less.

From the viewpoint of adjusting the emission color of the light emitting device according to the present embodiment (in particular, adjusting the emission color to white), when the third light emitting material is a metal complex represented by formula (2), the maximum peak wavelength of the emission spectrum of the metal complex represented by formula (2) is usually 495 nm or more and less than 750 nm, preferably 500 nm or more and 700 nm or less, more preferably 500 nm or more and less than 570 nm, and still more preferably 505 nm or more and 560 nm or less.

From the viewpoint of adjusting the emission color of the light emitting device according to the present embodiment (in particular, adjusting the emission color to white), when the third light emitting material is the polymer compound of the second light emitting layer, the maximum peak wavelength of the emission spectrum of the metal complex represented by formula (2) contained in the polymer compound of the second light emitting layer is usually 495 nm or more and less than 750 nm, preferably 500 nm or more and 700 nm or less, more preferably 500 nm or more and less than 570 nm, and still more preferably 505 nm or more and 560 nm or less.

From the viewpoint of adjusting the emission color of the light emitting device according to the present embodiment (in particular, adjusting the emission color to white), when the third light emitting material is a crosslinked product of the polymer compound of the second light emitting layer, the maximum peak wavelength of the emission spectrum of the metal complex represented by formula (2) contained in the crosslinked product of the polymer compound of the second light emitting layer is usually 495 nm or more and less than 750 nm, preferably 500 nm or more and 700 nm or less, more preferably 500 nm or more and less than 570 nm, and still more preferably 505 nm or more and 560 nm or less.

From the viewpoint of adjusting the emission color of the light emitting device according to the present embodiment (in particular, adjusting the emission color to white), the second light emitting layer of the light emitting device according to the present embodiment is preferably a layer formed using two or more light emitting materials.

When the second light emitting layer is a layer formed using two or more light emitting materials, from the viewpoint of adjusting the emission color of the light emitting device according to the present embodiment (in particular, adjusting the emission color to white), the maximum wavelengths of the emission spectra of at least two light emitting materials are preferably different from each other, and the difference is preferably 10 to 200 nm, more preferably 20 to 150 nm, and still more preferably 40 to 120 nm.

When the second light emitting layer is a layer formed using two or more light emitting materials, and, the maximum wavelengths of the emission spectra of the at least two light emitting materials are different, from the viewpoint of adjusting the emission color (in particular, adjusting the emission color to white), the combination of the at least two light emitting materials is preferably a combination of a light emitting material having a maximum wavelength at 500 nm or more and less than 570 nm and a light emitting material having a maximum wavelength at 570 nm or more and 680 nm or less, and more preferably a combination of a light emitting material having a maximum wavelength at 505 nm or more and 560 nm or less and a light emitting material having a maximum wavelength at 590 nm or more and 640 nm or less.

The maximum peak wavelength and the maximum wavelength of the emission spectrum of the metal complex and the light emitting material can be evaluated by dissolving the metal complex or the light emitting material in an organic solvent, such as xylene, toluene, chloroform, or tetrahydrofuran, to prepare a dilute solution (1 × 10⁻⁶ to 1 × 10⁻³ % by mass), and measuring the PL spectrum of the dilute solution at room temperature. As the organic solvent for dissolving the metal complex or the light emitting material, xylene is preferable.

In the light emitting device according to the present embodiment, when the second light emitting layer is a layer provided between the anode and the first light emitting layer, to achieve a better luminance lifetime of the light emitting device according to the present embodiment, it is preferable to further comprise at least one layer selected from the group consisting of a hole injecting layer and a hole transporting layer between the anode and the second light emitting layer. In addition, when the second light emitting layer is a layer provided between the anode and the first light emitting layer, to achieve a better luminance lifetime of the light emitting device according to the present embodiment, it is preferable to further comprise at least one layer selected from the group consisting of an electron injecting layer and an electron transporting layer between the cathode and the first light emitting layer.

In the light emitting device according to the present embodiment, when the second light emitting layer is a layer provided between the cathode and the first light emitting layer, to achieve a better luminance lifetime of the light emitting device according to the present embodiment, it is preferable to further comprise at least one layer selected from the group consisting of a hole injecting layer and a hole transporting layer between the anode and the first light emitting layer. In addition, when the second light emitting layer is a layer provided between the cathode and the first light emitting layer, to achieve a better luminance lifetime of the light emitting device according to the present embodiment, it is preferable to further comprise at least one layer selected from the group consisting of an electron injecting layer and an electron transporting layer between the cathode and the second light emitting layer.

Examples of specific layer structures of the light emitting device according to the present embodiment include the layer structures represented by the following (D1) to (D18). The light emitting device according to the present embodiment usually has a substrate, but the light emitting device may also be laminated from the anode on a substrate, or laminated from the cathode on a substrate.

(D1) anode/second light emitting layer/first light emitting layer/cathode
(D2) anode/first light emitting layer/second light emitting layer/cathode
(D3) anode/hole injecting layer/second light emitting layer/first light emitting layer/cathode
(D4) anode/hole transporting layer/second light emitting layer/first light emitting layer/cathode
(D5) anode/second light emitting layer/first light emitting layer/electron transporting layer/cathode
(D6) anode/second light emitting layer/first light emitting layer/electron injecting layer/cathode
(D7) anode/second light emitting layer/first light emitting layer/electron transporting layer/electron injecting layer/cathode
(D8) anode/hole injecting layer/second light emitting layer/first light emitting layer/electron transporting layer/cathode
(D9) anode/hole injecting layer/ second light emitting layer/first light emitting layer/electron injecting layer/cathode
(D10) anode/hole injecting layer/second light emitting layer/first light emitting layer/electron transporting layer/electron injecting layer/cathode
(D11) anode/hole transporting layer/second light emitting layer/first light emitting layer/electron transporting layer/cathode
(D12) anode/hole transporting layer/second light emitting layer/first light emitting layer/electron injecting layer/cathode
(D13) anode/hole transporting layer/second light emitting layer/first light emitting layer/electron transporting layer/electron injecting layer/cathode
(D14) anode/hole injecting layer/hole transporting layer/second light emitting layer/first light emitting layer/cathode
(D15) anode/hole injecting layer/hole transporting layer/second light emitting layer/first light emitting layer/electron transporting layer/cathode
(D16) anode/hole injecting layer/hole transporting layer/second light emitting layer/first light emitting layer/electron transporting layer/electron injecting layer/cathode
(D17) anode/hole injecting layer/first light emitting layer/second light emitting layer/electron transporting layer/electron injecting layer/cathode
(D18) anode/hole injecting layer/hole transporting layer/first light emitting layer/second light emitting layer/electron transporting layer/electron injecting layer/cathode

In the above (D1) to (D18), "/" means that the layers before and after the "/" are laminated adjacently. Specifically, "second light emitting layer/first light emitting layer" means that the second light emitting layer and the first light emitting layer are laminated adjacent to each other.

To achieve a better luminance lifetime of the light emitting device according to the present embodiment, a layer structure represented by the above (D3) to (D16) is preferable.

To improve adhesion between the electrodes and the other layers and to improve charge injection from the electrodes, the light emitting device according to the present embodiment may be provided with an insulating layer adjacent to the electrodes. In addition, to improve adhesion at the interfaces and to prevent components from two adjacent layers from mixing, in the light emitting device according to the present embodiment, a thin buffer layer may be inserted at the interfaces between the hole transporting layer, the electron transporting layer, the first light emitting layer, and the second light emitting layer. The order and number of layers to be laminated and the thickness of each layer may be adjusted in consideration of external quantum efficiency and device life.

Next, the configuration of the light emitting device according to the present embodiment will be described in detail.

### [Substrate]

The light emitting device according to the present embodiment may have a substrate on the side opposite to the light emitting layer side of the anode or on the side opposite to the light emitting layer side of the cathode. The substrate, which forms the electrodes, may be any substrate that does not chemically change when forming an organic layer (e.g., the first light emitting layer, the second light emitting layer, the hole transporting layer, the hole injecting layer, the electron transporting layer, the electron injecting layer). Substrates made of, for example, glass, plastic, a polymer film, a metal film, silicon, or the like, or a substrate formed by laminating such materials, is used.

In the light emitting device according to the present embodiment, two or more layers of an anode, a hole injecting layer, a hole transporting layer, an electron transporting layer, an electron injecting layer, and a cathode may be provided, as necessary.

When there are a plurality of anodes, hole injecting layers, hole transporting layers, electron transporting layers, electron injecting layers and cathodes are present, these may each be the same or different at each occurrence.

The thickness of the anode, the hole injecting layer, the hole transporting layer, the second light emitting layer, the first light emitting layer, the electron transporting layer, the electron injecting layer, and the cathode is usually 1 nm to 1 µm, preferably 2 nm to 500 nm, and more preferably 5 nm to 150 nm.

### [Electron Transporting Layer]

The electron transporting layer is a layer comprising an electron transporting material. Preferable examples of the electron transporting material include the electron transporting material which may be contained in the composition of the first light emitting layer and a polymer compound (hereinafter also referred to as "polymer compound of the electron transporting layer") comprising at least one constitutional unit selected from the group consisting of a constitutional unit represented by formula (ET-1) and a constitutional unit represented by formula (ET-2), and the polymer compound of the electron transporting layer is preferable. 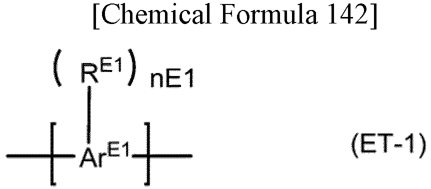 (Wherein,
nE1 represents an integer of 1 or more,
Ar^{E1} represents an aromatic hydrocarbon group or a heterocyclic group, and these groups each may have a substituent other than R^{E1}, and
R^{E1} represents a group represented by formula (ES-1); when there are a plurality of R^{E1}, they may be the same or different.)
-R^{E3}-{(Q^{E1})_{nE3}-Y^{E1}(ME¹)_{aE1}(Z^{E1})_{bE1}}_{mE1} (ES-1)

(Wherein,
nE3 represents an integer of 0 or more, aE1 represents an integer of 1 or more, bE1 represents an integer of 0 or more, and mE1 represents an integer of 1 or more; when there are a plurality of nE3, aE1, and bE1, they may be the same or different at each occurrence; when R^{E3} is a single bond, mE1 is 1; and aE1 and bE1 are selected so that the charge of the group represented by formula (ES-1) is zero,
R^{E3} represents a single bond, a hydrocarbon group, a heterocyclic group or O-R^{E3}' (R^{E3}' represents a hydrocarbon group or a heterocyclic group), and these groups each may have a substituent,
Q^{E1} represents an alkylene group, a cycloalkylene group, an arylene group, an oxygen atom, or a sulfur atom, and these groups each may have a substituent; and when there are a plurality of Q^{E1}, they may be the same or different,
Y^{E1} represents -CO₂⁻, -SO₃⁻, -SO₂⁻, or PO₃²⁻; and when there are a plurality of Y^{E1}, they may be the same or different,
M^{E1} represents an alkali metal cation, an alkali earth metal cation, or an ammonium cation, and the ammonium cation may have a substituent; when there are a plurality of M^{E1}, they may be the same or different, and
Z^{E1} represents F⁻, Cl⁻, Br⁻, I⁻, OH⁻, B(R^{E4})₄⁻, R^{E4}SO₃⁻, R^{E4}COO⁻, NOs⁻, SO₄²⁻, HSO₄⁻, PO₄³⁻, HPO₄²⁻, H₂PO₄⁻, BF₄⁻, or PF₆-; R^{E4} represents an alkyl group, a cycloalkyl group, or an aryl group, and these groups each may have a substituent; and when there are a plurality of Z^{E1}, they may be the same or different.)
nE1 is usually an integer of 1 to 4, and preferably 1 or 2.

Preferable examples of the aromatic hydrocarbon group or heterocyclic group represented by Ar^{E1} are a group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group, or a 2,7-carbazolediyl group, nE1 atoms of hydrogen directly bonded to the atoms constituting the ring, and Ar^{E1} may have a substituent other than R^{E1}.

Examples of the optional substituent other than R^{E1} of Ar^{E1} include a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, a cycloalkynyl group, a carboxyl group, and a group represented by formula (ES-3).

-O-(C_{n'}H_{2n'}O)ₙₓ-C_{m'}H_{2m'+1} (ES-3)

(Wherein n', m', and nx each independently represent an integer of 1 or more.)

nE3 is usually an integer of 0 to 10, preferably an integer of 0 to 8, and more preferably an integer of 0 to 2.

aE1 is usually an integer of 1 to 10, preferably an integer of 1 to 5, and more preferably 1 or 2.

bE1 is usually an integer of 0 to 10, preferably an integer of 0 to 4, and more preferably 0 or 1.

mE1 is usually an integer of 1 to 5, preferably 1 or 2, and more preferably 1.

When R^{E3} is -O-R^{E3'}, the group represented by formula (ES-1) is a group represented by the following formula.

-O-R^{E3'}-{(Q^{E1})_{nE3}-Y^{E1}(M^{E1})_{aE1}(Z^{E1})_{bE1}}_{mE1}

R^{E3} is preferably a hydrocarbon group or a heterocyclic group, more preferably an aromatic hydrocarbon group or an aromatic heterocyclic group, and still more preferably an aromatic hydrocarbon group.

Examples of the optional substituent of R^{E3} include an alkyl group, a cycloalkyl group, an aryl group, a monovalent heterocyclic group, and a group represented by formula (ES-3), and a group represented by formula (ES-3) is preferable.

Q^{E1} is preferably an alkylene group, an arylene group, or an oxygen atom, and more preferably an alkylene group or an oxygen atom.

Y^{E1} is preferably -CO₂⁻, -SO₂⁻, or PO₃²⁻, and more preferably -CO₂-.

Examples of the alkali metal cation represented by M^{E1} include Li⁺, Na⁺, K⁺, Rb⁺, and Cs⁺, and K⁺, Rb⁺, or Cs⁺ is preferable and Cs⁺ is more preferable.

Examples of the alkali earth metal cation represented by M^{E1} include Be²⁺, Mg²⁺, Ca²⁺, Sr²⁺, Ba²⁺, and Mg²⁺, Ca²⁺, Sr²⁺, and Ba²⁺ are preferable, and Ba²⁺ is more preferable.

Preferable examples of M^{E1} include an alkali metal cation or an alkali earth metal cation, and an alkali metal cation is more preferable.

Z^{E1} is preferably F⁻, Cl⁻, Br⁻, I⁻, OH⁻, B(R^{E4})₄⁻, R^{E4}SO₃⁻, R^{E4}COO⁻, or NO₃⁻, and more preferably F⁻, Cl⁻, Br⁻, I⁻, OH⁻, R^{E4}SO₃⁻, or R^{E4}COO⁻. R^{E4} is preferably an alkyl group.

Examples of the group represented by formula (ES-1) include groups represented by the following formulas. 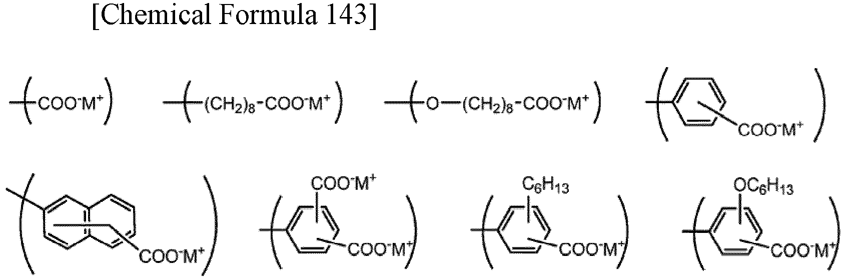 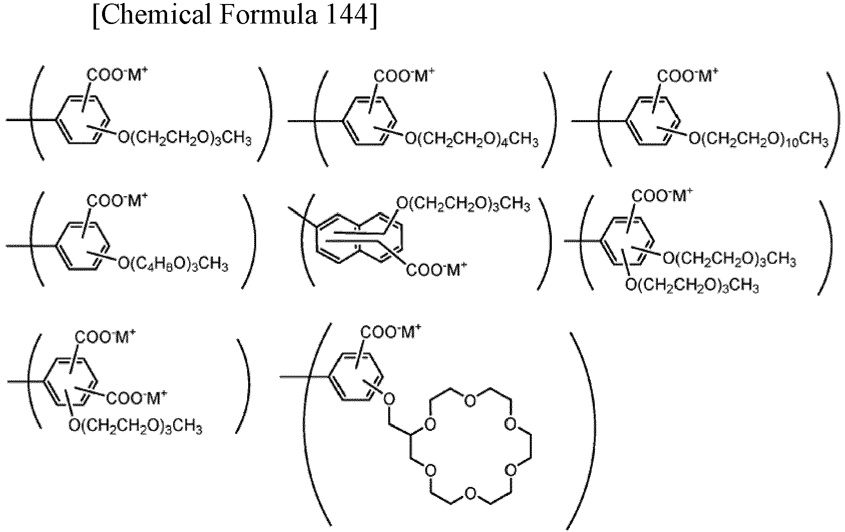 (Wherein, M⁺ represents Li⁺, Na⁺, K⁺, Cs⁺, or N(CH³)₄⁺; and when there are a plurality of M⁺, they may be the same or different.) 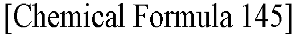 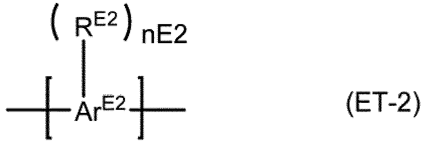 (Wherein,
nE2 represents an integer of 1 or more,
Ar^{E2} represents an aromatic hydrocarbon group or a heterocyclic group, and these groups each may have a substituent other than R^{E2}, and
R^{E2} represents a group represented by formula (ES-2); when there are a plurality of R^{E2}, they may be the same or different.)

-R^{E5}-{(Q^{E2})_{nE4}-Y^{E2}(M^{E2})_{aE2}(Z^{E2})_{bE2}}_{mE2} (ES-2)

(Wherein,
nE4 represents an integer of 0 or more, aE2 represents an integer of 1 or more, bE2 represents an integer of 0 or more, and mE2 represents an integer of 1 or more; when there are a plurality of nE4, aE2, and bE2, they may be the same or different at each occurrence; when R^{E5} is a single bond, mE2 is 1; and aE2 and bE2 are selected so that the charge of the group represented by formula (ES-2) is zero,
R^{E5} represents a single bond, a hydrocarbon group, a heterocyclic group or O-R^{E5}' (R^{E5}' represents a hydrocarbon group or a heterocyclic group), and these groups each may have a substituent,
Q^{E2} represents an alkylene group, a cycloalkylene group, an arylene group, an oxygen atom, or a sulfur atom, and these groups each may have a substituent; and when there are a plurality of Q^{E2}, they may be the same or different,
Y^{E2} represents -C⁺R^{E6}₂, -N⁺R^{E6}₃, -P⁺R^{E6}₃, -S⁺R^{E6}₂, or -I+R^{E6}₂; R^{E6} represents a hydrogen atom, an alkyl group, a cycloalkyl group, or an aryl group, and these groups each may have a substituent: the plurality of R^{E6} may be the same or different; and when there are a plurality of Y^{E2}, they may be the same or different,
M^{E2} represents F⁻, Cl⁻, Br⁻, I⁻, OH⁻, B(R^{E7})₄⁻, R^{E7}SO₃⁻, R^{E7}COO⁻, BF₄⁻, SbCl6⁻, or SbF₆⁻; R^{E7} represents an alkyl group, a cycloalkyl group, or an aryl group, and these groups each may have a substituent,
when there are a plurality of M^{E2}, they may be the same or different, and
Z^{E2} represents an alkali metal cation or an alkali earth metal cation; and when there are a plurality of Z^{E2}, they may be the same or different.)
nE2 is usually an integer of 1 to 4, and preferably 1 or 2.

Preferable examples of the aromatic hydrocarbon group or heterocyclic group represented by Ar^{E2} are a group remaining after removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group, or a 2,7-carbazolediyl group, nE2 atoms of hydrogen directly bonded to the atoms constituting the ring, and Ar^{E2} may have a substituent other than R^{E2}.

The examples of the optional substituent other than R^{E2} of Ar^{E2} are the same as the examples of the optional substituent other than R^{E1} of Ar^{E1}.

nE4 is usually an integer of 0 to 10, preferably an integer of 0 to 8, and more preferably an integer of 0 to 2.

aE2 is usually an integer of 1 to 10, preferably an integer of 1 to 5, and more preferably 1 or 2.

bE2 is usually an integer of 0 to 10, preferably an integer of 0 to 4, and more preferably 0 or 1.

mE2 is usually an integer of 1 to 5, preferably 1 or 2, and more preferably 1.

When R^{E5} is -O-R^{E5'}, the group represented by formula (ES-2) is a group represented by the following formula.

-O-R^{E5'}-{(Q^{E1})_{nE3}-Y^{E1}(M^{E1})_{aE1(}Z^{E1})_{bE1}}_{mE1}

R^{E5} is preferably a hydrocarbon group or a heterocyclic group, more preferably an aromatic hydrocarbon group or an aromatic heterocyclic group, and still more preferably an aromatic hydrocarbon group.

Examples of the optional substituent of R^{E5} include an alkyl group, a cycloalkyl group, an aryl group, a monovalent heterocyclic group, and a group represented by formula (ES-3), and a group represented by formula (ES-3) is preferable.

Q^{E2} is preferably an alkylene group, an arylene group, or an oxygen atom, and more preferably an alkylene group or an oxygen atom.

Y^{E2} is preferably -C⁺R^{E6}₂, -N⁺R^{E6}₃, -P⁺R^{E6}₃, or -S⁺R^{E6}₂, and more preferably -N⁺R^{E6}₃. R^{E6} is preferably a hydrogen atom, an alkyl group, or an aryl group, and more preferably a hydrogen atom or an alkyl group.

M^{E2} is preferably F⁻, Cl⁻, Br⁻, I⁻, B(R^{E7})₄⁻, R^{E7}SO₃⁻, R^{E7}COO⁻, BF₄⁻, or SbP₆⁻, and more preferably Br⁻, I⁻, B(R^{E7})₄⁻, R^{E7}COO⁻, or SbF₆⁻. R^{E7} is preferably an alkyl group.

Examples of the alkali metal cation represented by Z^{E2} include Li⁺, Na⁺, K⁺, Rb⁺, and Cs⁺, and Li⁺, Na⁺, or K⁺ is preferable.

Examples of the alkali earth metal cation represented by Z^{E2} include Be²⁺, Mg²⁺, Ca²⁺, Sr²⁺, and Ba²⁺, and Mg²⁺ or Ca²⁺ is more preferable.

Z^{E2} is preferably an alkali metal cation.

Examples of the group represented by formula (ES-2) include groups represented by the following formulas. 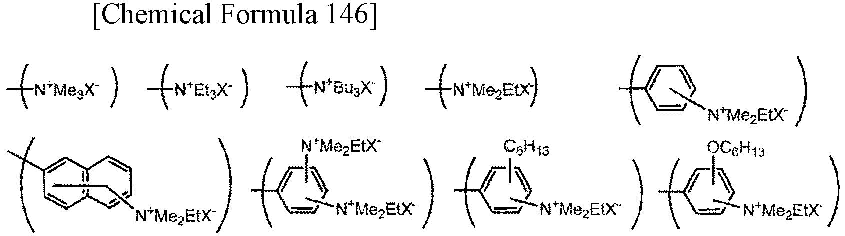 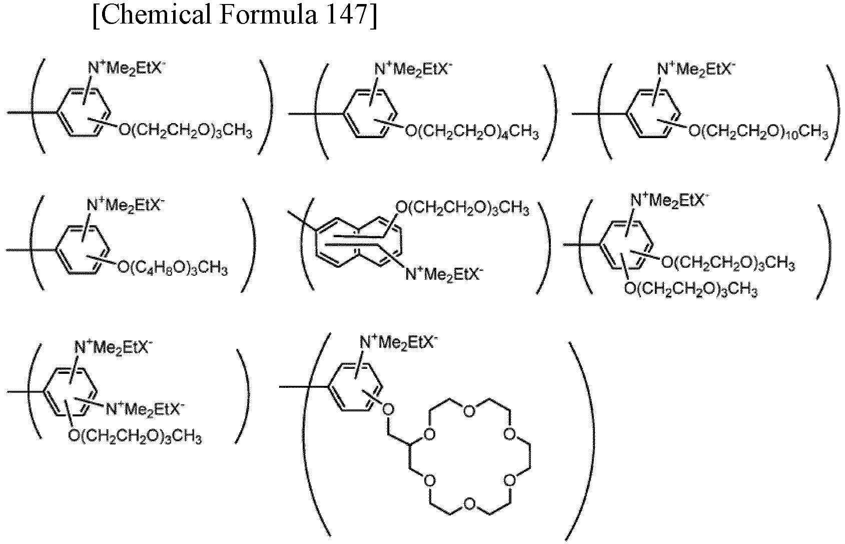 (Wherein, X⁻ represents F⁻, Cl⁻, Br⁻, I⁻, B(C₆H₅)₄⁻, CH₃COO⁻, or CF₃SO₃⁻; and when there are a plurality of X⁻, they may be the same or different.)

Examples of the constitutional unit represented by formula (ET-1) or (ET-2) include the constitutional units represented by formulas (ET-31) to (ET-38).

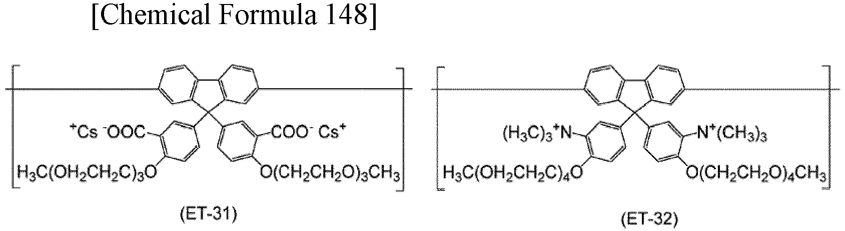

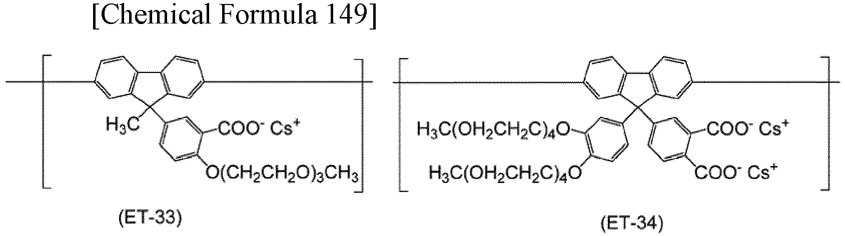

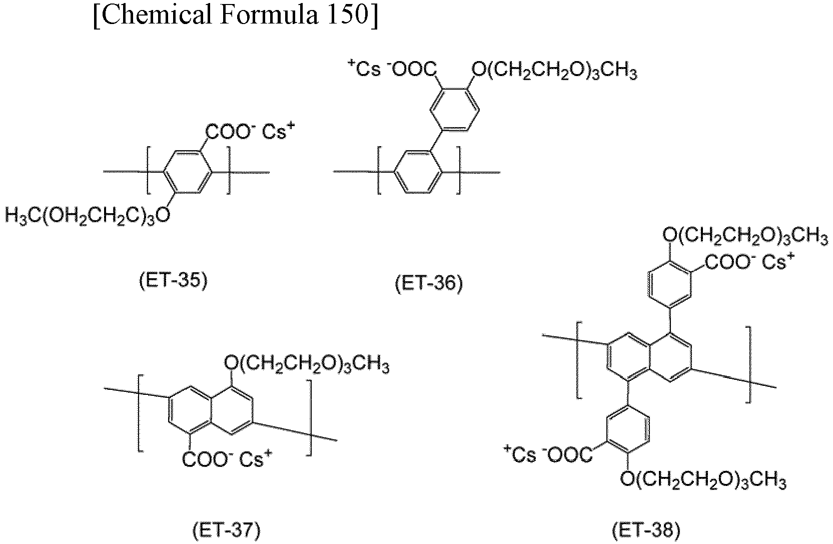

The polymer compound of the electron transporting layer can be synthesized according to the methods described in, for example, Japanese Unexamined Patent Publication No. 2009-239279, Japanese Unexamined Patent Publication No. 2012-033845, Japanese Unexamined Patent Publication No. 2012-216821, Japanese Unexamined Patent Publication No. 2012-216822, and Japanese Unexamined Patent Publication No. 2012-216815.

When the material used for forming the hole injecting layer (described later), the material used for forming the hole transporting layer (described later), the material used for forming the second light emitting layer, the material used for forming the first light emitting layer, the material used for forming the electron transporting layer, and the material used for forming electron injecting layer (described later) dissolve during the production of the light emitting device in the solvent used when forming a layer adjacent to the hole injecting layer, hole transporting layer, second light emitting layer, first light emitting layer, electron transporting layer, and electron injecting layer, respectively, it is preferable to avoid dissolution of those materials in the solvent. Preferable methods for avoiding dissolution of the materials include: i) a method in which materials having a crosslinkable group are used, or ii) a method in which a difference in solubility from that of the adjacent layer. In the method i), it is possible to prevent the layer from dissolving by forming the layer using a material having a crosslinkable group and then crosslinking the crosslinkable group.

In the case of laminating the electron transporting layer on the first light emitting layer by utilizing a difference in solubility, the electron transporting layer can be laminated by using a solution having a low solubility in the first light emitting layer.

In the case of laminating the electron transporting layer on the second light emitting layer by utilizing a difference in solubility, an electron transporting layer can be laminated by using a solution having a low solubility in the second light emitting layer.

The solvent to be used in the case of laminating the electron transporting layer on the first light emitting layer or the second light emitting layer by utilizing a difference in solubility is preferably water, an alcohol, an ether, an ester, a nitrile compound, a nitro compound, a fluorinated alcohol, a thiol, a sulfide, a sulfoxide, a thioketone, an amide, or a carboxylic acid. Specific examples of the solvent include methanol, ethanol, 2-propanol, 1-butanol, tert-butyl alcohol, acetonitrile, 1,2-ethanediol, N,N-dimethylformamide, dimethylsulfoxide, acetic acid, nitromethane, propylene carbonate, pyridine, carbon disulfide, and a mixed solvent of these solvents. In the case where a mixed solvent is used, the mixed solvent may be a mixed solvent of one or more solvents selected from water, an alcohol, an ether, an ester, a nitrile compound, a nitro compound, a fluorinated alcohol, a thiol, a sulfide, a sulfoxide, a thioketone, an amide, and a carboxylic acid and one or more solvents selected from a chlorinated solvent, an aromatic hydrocarbon solvent, an aliphatic hydrocarbon solvent, and a ketone solvent.

### [Hole Injecting Layer and Electron Injecting Layer]

The hole injecting layer is a layer comprising a hole injecting material. Examples of the hole injecting material include the hole injecting material that may be contained in the first light emitting layer composition. One hole injecting material may be contained alone, or two or more hole injecting materials may be contained in combination.

The electron injecting layer is a layer comprising an electron injecting material. Examples of the electron injecting material include the electron injecting material that may be contained in the first light emitting layer composition. One electron injecting material may be contained alone, or two or more electron injecting materials may be contained in combination.

### [Hole Transporting Layer]

The hole transporting layer is a layer comprising a hole transporting material. Examples of the hole transporting material include the hole transporting material that may be contained in the first light emitting layer composition. One hole transporting material may be contained alone, or two or more hole transporting materials may be contained in combination.

### [Electrodes]

Examples of the material of the anode include conductive metal oxides and translucent metals. The anode material is preferably indium oxide, zinc oxide, or tin oxide; a conductive compound such as indium tin oxide (ITO) or indium zinc oxide; a complex of silver, palladium, and copper (APC); NESA, gold, platinum, silver, or copper.

Examples of the material of the cathode include metals such as lithium, sodium, potassium, rubidium, cesium, beryllium, magnesium, calcium, strontium, barium, aluminum, zinc, and indium; alloys of two or more of those metals; alloys of one or more of those metals with one or more of silver, copper, manganese, titanium, cobalt, nickel, tungsten, and tin; and graphite and graphite intercalation compounds. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

In the light emitting device according to the present embodiment, usually, at least one of the anode and the cathode is transparent or translucent. It is preferable that the anode be transparent or translucent.

Examples of a method for forming the anode and the cathode include vacuum deposition, sputtering, ion plating, plating, and lamination.

### [Method for Producing Light Emitting Device]

In the case of using a low molecular weight compound in the light emitting device according to the present embodiment, examples of the method for forming the various layers, such as the first light emitting layer, the second light emitting layer, the hole transporting layer, the electron transporting layer, the hole injecting layer, and the electron injecting layer, include vacuum evaporation from powder and a film formation method from solution or a melted state. In the case of using a polymer compound, examples of the production method include a film formation method from solution or a melted state.

The first light emitting layer can be formed using the ink of the first light emitting layer and the second light emitting layer can be formed using the ink of the second light emitting layer. The hole transporting layer, the electron transporting layer, the hole injecting layer, and the electron injecting layer can be formed by a coating method, typified by spin coating and ink jet printing, using an ink comprising the hole transporting material, electron transporting material, hole injecting material and electron injecting material as described above, respectively.

The light emitting device according to the present embodiment can be produced by sequentially laminating each layer on a substrate.

In the light emitting device according to the present embodiment, when the second light emitting layer is a layer provided between the anode and the first light emitting layer, the light emitting device according to the present embodiment can be produced by, for example, forming the anode on a substrate, optionally forming the hole injecting layer and/or hole transporting layer on the anode, forming the second light emitting layer on the anode or on the hole injecting layer or the hole transporting layer, forming the first light emitting layer on the second light emitting layer, optionally forming the electron transporting layer and/or an electron injecting layer on the first light emitting layer, and then forming the cathode on the first light emitting layer or on the electron transporting layer or the electron injecting layer.

Further, in the light emitting device according to the present embodiment, when the second light emitting layer is a layer provided between the anode and the first light emitting layer, the light emitting device according to the present embodiment can be produced by, for example, forming the cathode on a substrate, optionally forming the electron injecting layer and/or electron transporting layer on the cathode, forming the first light emitting layer on the cathode or on the electron injecting layer or the electron transporting layer, forming the second light emitting layer on the first light emitting layer, optionally forming the hole transporting layer and/or hole injecting layer on the second light emitting layer, and forming the anode on the second light emitting layer or on the hole transporting layer or hole injecting layer.

In the light emitting device according to the present embodiment, when the second light emitting layer is a layer provided between the cathode and the first light emitting layer, the light emitting device according to the present embodiment can be produced by, for example, forming the anode on a substrate, optionally forming the hole injecting layer and/or hole transporting layer on the anode, forming the first light emitting layer on the anode or on the hole injecting layer or the hole transporting layer, forming the second light emitting layer on the first light emitting layer, optionally forming the electron transporting layer and/or an electron injecting layer on the second light emitting layer, and then forming the cathode on the second light emitting layer or on the electron transporting layer or the electron injecting layer.

Further, in the light emitting device according to the present embodiment, when the second light emitting layer is a layer provided between the cathode and the first light emitting layer, the light emitting device according to the present embodiment can be produced by, for example, forming the cathode on a substrate, optionally forming the electron injecting layer and/or electron transporting layer on the cathode, forming the second light emitting layer on the cathode or on the electron injecting layer or the electron transporting layer, forming the first light emitting layer on the second light emitting layer, optionally forming the hole transporting layer and/or hole injecting layer on the first light emitting layer, and forming the anode on the first light emitting layer or on the hole transporting layer or hole injecting layer.

### [Light emitting device Applications]

To obtain planar light emission using a light emitting device, a planar anode and a planar cathode may be arranged so as to overlap each other. Examples of methods for obtaining patterned light emission include a method in which a mask having a patterned window is disposed on the surface of a planar light emitting device, a method in which a layer that is not intended to emit light is formed very thickly so as to substantially prevent light emission, and a method in which the anode or the cathode, or both electrodes, are formed in a pattern shape. By forming a pattern by any of these methods and arranging such that several electrodes can be independently switched ON/OFF, a segment type display device capable of displaying, for instance, numerals and letters is obtained. To obtain a dot matrix display device, the anodes and the cathodes are formed in a striped shape so as to be orthogonal to each other. Partial color display and multi-color display can be achieved by a method in which a plurality of polymer compounds having different emission colors are used for separate paining or a method in which a color filter or a fluorescence conversion filter are used. A dot matrix display device can be driven passively, or can be driven actively in combination with, for example, TFT. These display devices can be used, for example, as a display in computers, television sets, and mobile terminals. A planar light emitting device can be suitably used as a planar light source for a backlight in a liquid crystal display or as a planar illumination light source. When a flexible substrate is used, the light emitting device can also be used as a curved light source and a curved display.

### Examples

The present invention will now be described in more detail by the following Examples, but the present invention is not limited to these Examples.

In the Examples, the polystyrene-equivalent number-average molecular weight (Mn) and the polystyrene-equivalent weight-average molecular weight (Mw) of the polymer compounds were determined by any one of the below size-exclusion chromatography (SEC) columns using tetrahydrofuran for the mobile phase. The SEC measurement conditions were as follows.

The polymer compound to be measured was dissolved at a concentration of about 0.05% by mass in tetrahydrofuran, and 10 µL of the solution was injected into the SEC column. The mobile phase flow rate was 0.6 mL/min. A TSK guard column Super AW-H, a TSKgel Super AWM-H, or a TSKgel Super AW 3000 (all manufactured by Tosoh Corporation) were each connected in series and used for the column. A UV-VIS detector (trade name: UV-8320 GPC, manufactured by Tosoh Corporation) was used as the detector.

LC-MS was measured by the following method.

The measurement sample was dissolved in chloroform or tetrahydrofuran so as to have a concentration of about 2 mg/mL, and about 1 µL was injected into an LC-MS (trade name: 1100 LC-MSD, manufactured by Agilent). The LC-MS mobile phase was flowed at a rate of 0.2 mL/min while varying the ratio of acetonitrile and tetrahydrofuran. An L-column 2 ODS (3 µm) (manufactured by the Chemicals Evaluation and Research Institute, inner diameter: 2.1 mm, length: 100 mm, particle diameter 3 µm) was used for the column.

TLC-MS was measured by the following method.

The measurement sample was dissolved in a solvent of either toluene, tetrahydrofuran, or chloroform at an arbitrary concentration, and the solution was coated on a TLC plate for DART (trade name: YSK5-100, manufactured by Techno Applications), and then measurement was carried out using TLC-MS (trade name: JMS-T100TD (The AccuTOF TLC), manufactured by JEOL Ltd.). The helium gas temperature during the measurement was adjusted in the range of 200 to 400°C.

NMR was measured by the following method.

A measurement sample of 5 to 10 mg was dissolved in about 0.5 mL of deuterated chloroform (CDCl₃), heavy tetrahydrofuran, heavy dimethyl sulfoxide, heavy acetone, heavy N,N-dimethylformamide, heavy toluene, heavy methanol, heavy ethanol, heavy 2-propanol, or heavy methylene chloride, and measured using an NMR apparatus (trade name: INOVA 300 or MERCURY 400 VX, manufactured by Agilent).

As an index of the purity of the compound, the value of the high-performance liquid chromatography (HPLC) area percentage was used. Unless noted otherwise, this value is the value at UV=254 nm in the HPLC apparatus (product name: LC-20A, manufactured by Shimadzu Corporation). At this time, the compound to be measured was dissolved in tetrahydrofuran or chloroform so as to have a concentration of 0.01 to 0.2% by mass, and 1 to 10 µL was injected into the HPLC apparatus in accordance with the concentration. For the HPLC mobile phase, the ratio of acetonitrile/tetrahydrofuran was varied between 100/0 to 0/100 (volume ratio) while flowing at a flow rate of 1.0 mL/min. As the column, a Kaseisorb LC ODS 2000 (manufactured by Tokyo Chemical Industry) or an ODS column having equivalent performance was used. For the detector, a photodiode array detector (trade name: SPD-M20A, manufactured by Shimadzu Corporation) was used.

In this Example, the maximum peak wavelength and the maximum wavelength of the emission spectrum of the metal complex and the compound were measured at room temperature by a spectrophotometer (FP-6500, manufactured by JASCO Corporation). A xylene solution in which the metal complex or compound was dissolved in xylene at a concentration of about 0.8 × 10⁻⁴ % by mass was used as the sample. For the excitation light, UV light with a wavelength of 325 nm was used.

### <Synthesis Example 1> Compounds CM1 to CM8 and Compound HM-1

Compound CM1 was synthesized according to the methods described in Japanese Unexamined Patent Publication No. 2010-189630.

Compound CM2 was synthesized according to the methods described in Japanese Unexamined Patent Publication No. 2008-106241.

Compound CM3 was synthesized according to the methods described in Japanese Unexamined Patent Publication No. 2010-215886.

Compound CM4 was synthesized according to the methods described in International Publication No. 2002/045184.

Compound CM5 was synthesized according to the methods described in International Publication No. 2011/049241.

Compounds CM6, CM7, and CM8 were synthesized according to the methods described in International Publication No. 2013/146806.

Compound HM-1 was purchased from the company Luminescence Technology.

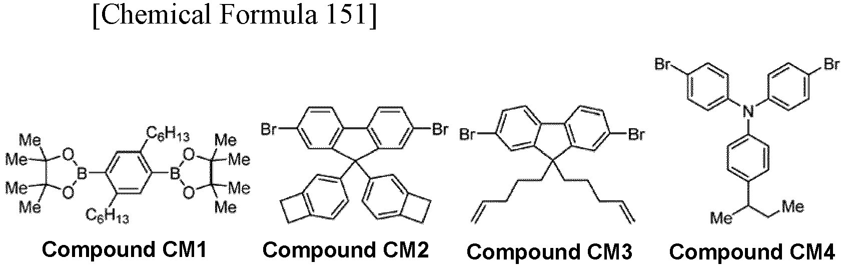

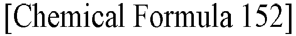

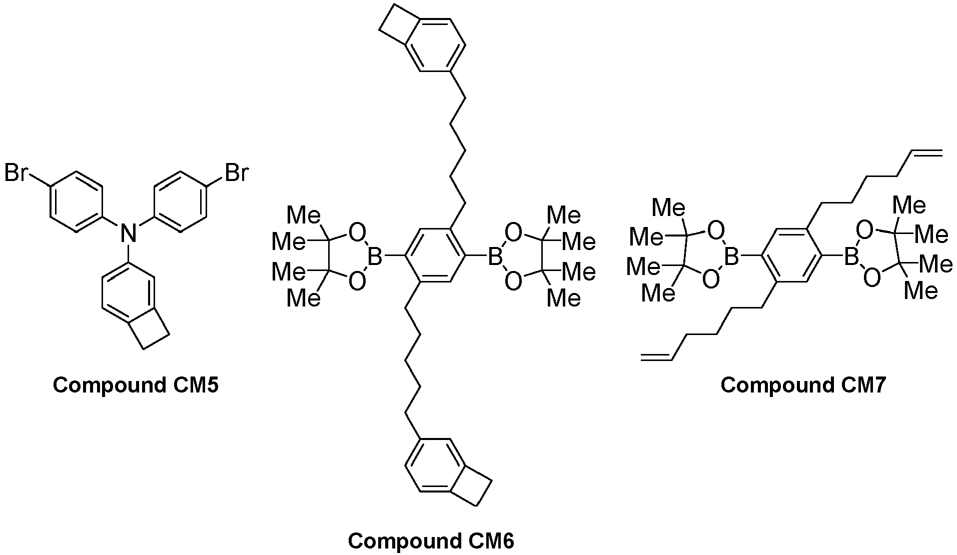

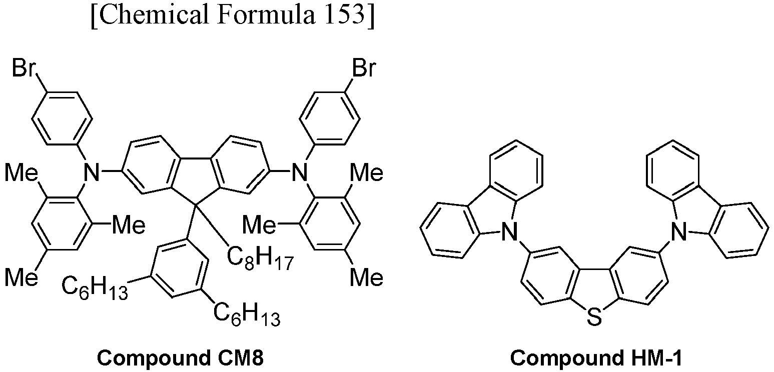

### <Synthesis Example 2> Synthesis of Metal Complexes RM1 to RM4 and GM1

Metal complex RM1 was synthesized according to the methods described in International Publication No. 2009/157424.

Metal complexes RM2 and RM4 were synthesized according to the methods described in International Publication No. 2011/105701.

Metal complex RM3 was synthesized according to the methods described in Japanese Unexamined Patent Publication No. 2008-179617.

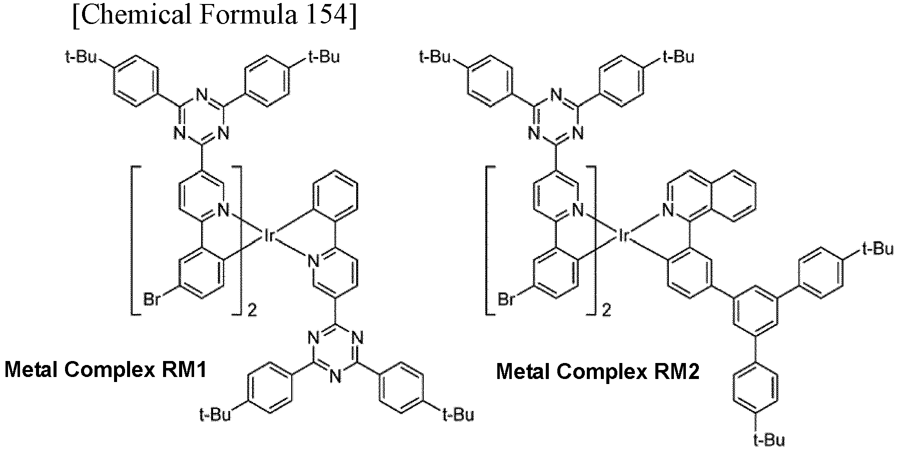

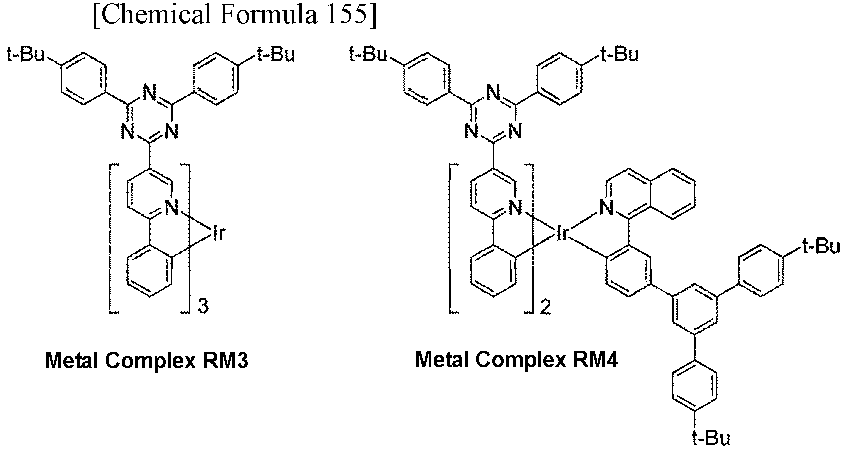

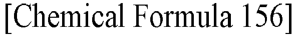

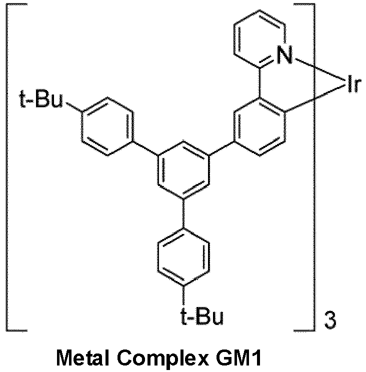

The maximum peak wavelength of the emission spectrum of metal complex RM3 was 594 nm.

The maximum peak wavelength of the emission spectrum of metal complex RM4 was 611 nm.

The maximum peak wavelength of the emission spectrum of metal complex GM1 was 514 nm.

### <Synthesis Example 3> Synthesis of Metal Complexes MC3 and MC6

Metal complexes MC3 and MC6 were synthesized according to the methods described in Japanese Unexamined Patent Publication No. 2013-147551.

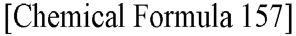

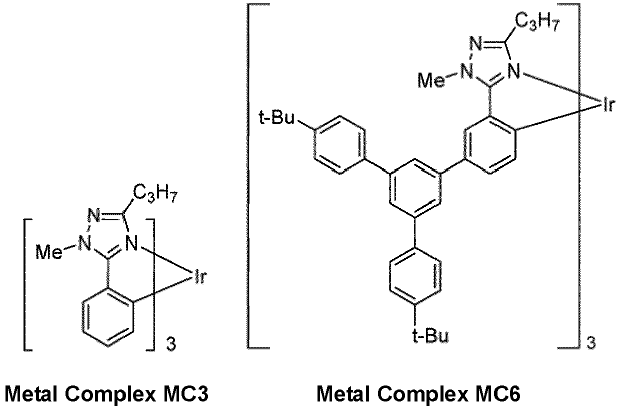

The maximum peak wavelength of the emission spectrum of metal complex MC3 was 450 nm.

The maximum peak wavelength of the emission spectrum of metal complex MC6 was 475 nm.

### <Synthesis Example 4> Synthesis of Metal Complex MC1

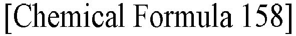

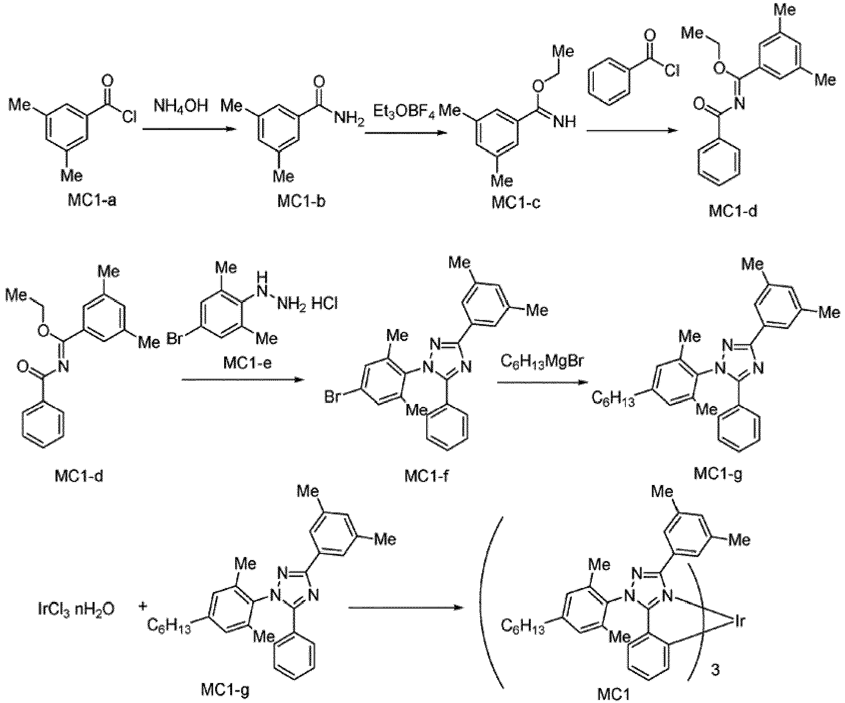

The atmosphere within a reaction vessel was replaced with argon gas, then the reaction vessel was charged with compound MC1-a (33.7 g) and dichloromethane (400 mL), and placed in an ice bath to cool. The reaction vessel was then charged with a 25% by mass solution of aqueous ammonia (40.8 g), and the reaction vessel was stirred for 1 hour while cooling in an ice bath. Then, the reaction vessel was charged with ion-exchanged water (200 mL) and dichloromethane (150 mL), and the organic layer was extracted. The obtained organic layer was dried over anhydrous magnesium sulfate, then heptane (400 mL) was added, and the dichloromethane was concentrated under reduced pressure to obtain a solution containing a white solid. The obtained solution containing the white solid was filtered, and then the resultant white solid was dried under reduced pressure to obtain compound MC1-b (27.8 g, yield 93%) as a white solid. The HPLC area percentage value of compound MC1-b was 99.3%. The required amount of compound MC1-b was obtained by repeating this operation.

TLC/MS (DART, positive): m/z = 150 [M+H]⁺

The atmosphere within a reaction vessel was replaced with argon gas and then the reaction vessel was charged with compound MC1-b (34.3 g) and dichloromethane (1.38 L). Then, the reaction vessel was charged with a solution of triethyloxonium tetrafluoroborate (1 mol/L, 276 mL) in dichloromethane, and the mixture was stirred at room temperature for 34 hours. Then, the reaction vessel was charged with an aqueous sodium hydrogen carbonate solution (1 mol/L, 352 mL), and the mixture was stirred at room temperature for 30 minutes. After extracting the organic layer of the obtained reaction solution, the resultant organic layer was washed with saturated brine (300 mL) to obtain an organic layer. Heptane (200 mL) was added to the obtained organic layer, and then the dichloromethane was concentrated under reduced pressure to obtain a solution containing a white solid. The obtained solution containing the white solid was filtered, and then the resultant filtrate was concentrated to obtain compound MC1-c (33.6 g, yield 82%) as a yellow oily substance. The HPLC area percentage value of compound MC1-c was 98.0%.

TLC/MS (DART, positive): m/z = 178 [M+H]⁺

The atmosphere within a reaction vessel was replaced with argon gas, then the reaction vessel was charged with compound MC1-c (33.5 g), benzoyl chloride (26.6 g), and chloroform (570 mL). Next, the reaction vessel was charged with triethylamine (26.4 mL), and the mixture was stirred for 66 hours at room temperature. The obtained reaction solution was concentrated under reduced pressure, ion-exchanged water (210 mL) and chloroform (210 mL) were added to the obtained residue, and the organic layer was extracted. The obtained organic layer was washed with saturated brine (150 mL), dried over anhydrous magnesium sulfate, and then concentrated under reduced pressure to obtain compound MC1-d (54.2 g, yield 88%) as an orange oily substance. The HPLC area percentage value of compound MC1-d was 86.0%.

TLC/MS (DART, positive): m/z = 282 [M+H]⁺

¹H-NMR (300 MHz, CDCl₃-d₁): δ (ppm) = 8.01-7.98 (m, 2H), 7.56-7.51 (m, 1H), 7.46-7.41 (m, 2H), 7.19 (s, 2H), 7.03 (s, 1H), 4.48-4.41 (m, 2H), 2.23 (s, 6H), 1.48 (t, 3H).

The atmosphere within a reaction vessel was replaced with argon gas, then the reaction vessel was charged with compound MC1-e (55.8 g) and toluene (925 mL), and the reaction vessel was placed in an ice bath to cool. Then, the reaction vessel was charged with an aqueous sodium hydroxide solution (1 mol/L, 222 mL), and the mixture was stirred for 30 minutes while cooling in an ice bath. The organic layer of the obtained reaction solution was extracted to obtain a toluene solution as an organic layer.

The atmosphere of a separately-prepared reaction vessel was replaced with argon gas, then the reaction vessel was charged with compound MC1-d (52.0 g) and chloroform (925 mL), and placed in an ice bath to cool. Then, the reaction vessel was charged with the above-obtained toluene solution, the mixture was stirred for 7 hours while cooling in an ice bath, and then stirred at room temperature for 100 hours. Ion-exchanged water (500 mL) was added to the obtained reaction solution, the organic layer was extracted, and the obtained organic layer was concentrated under reduced pressure. The resultant residue was purified by silica gel column chromatography (mixed solvent of chloroform and hexane), then recrystallized from a mixed solvent of chloroform and heptane, and then dried under reduced pressure at 50°C to obtain compound MC1-f (17.6 g, yield 22%) as a white solid. The HPLC area percentage value of compound MC1-f was 99.5% or more. The required amount of compound MC1-f was obtained by repeating this operation.

TLC/MS (DART, positive): m/z = 432 [M+H]⁺

¹H-NMR (300 MHz, CD₂Cl₂-d₂): δ (ppm) = 7.84 (s, 2H), 7.56-7.54 (m, 2H), 7.43-7.32 (m, 5H), 7.09 (s, 1H), 2.40 (s, 6H), 1.99 (s, 6H).

The atmosphere within a reaction vessel was replaced with argon gas, then the reaction vessel was charged with compound MC1-f (17.3 g), cyclopentyl methyl ether (240 mL), and [1,1'-bis(diphenylphosphino)ferrocene]palladium(II) dichloride (98 mg), and the temperature was increased to 50°C. Then, the reaction vessel was charged with a solution of hexyl magnesium bromide (2 mol/L, 40 mL) in diethyl ether, and the mixture was stirred at 50°C for 2 hours. Then, the reaction vessel was charged with an aqueous hydrochloric acid solution (1 mol/L, 80 mL), and the organic layer was extracted. The obtained organic layer was washed twice with ion-exchanged water (100 mL), dried over anhydrous magnesium sulfate, filtered and the resultant filtrate was concentrated under reduced pressure to obtain an oily substance. Toluene and activated carbon were added to the obtained oily substance, and the resultant mixture was stirred at 50°C for 30 minutes. Then, the mixture was filtered through a filter lined with silica gel and Celite, and the resultant filtrate was concentrated under reduced pressure to obtain a solid. The obtained solid was purified by silica gel column chromatography (mixed solvent of hexane and ethyl acetate) and then recrystallized from methanol. Then, the recrystallized product was dried under reduced pressure at 50°C to obtain compound MC1-g (12.1 g, yield 69%) as a white solid. The HPLC area percentage value of compound MC1-g was 99.5% or more.

TLC/MS (DART, positive): m/z = 438 [M+H]⁺

¹H-NMR (300 MHz, CD₂Cl₂-d₂) δ (ppm) = 7.92 (s, 2H), 7.65-7.62 (m, 2H), 7.48-7.35 (m, 3H), 7.15 (s, 1H), 7.09 (s, 2H), 2.70 (t, 2H), 2.46 (s, 6H), 2.03 (s, 6H), 1.77-1.67 (m, 2H), 1.46-1.36 (m, 6H), 1.00-0.95 (m, 3H).

The atmosphere within a reaction vessel was replaced with argon gas, then the reaction vessel was charged with iridium chloride n-hydrate (2.50 g), compound MC1-g (6.43 g), ion-exchanged water (28 mL), and 2-ethoxyethanol (112 mL), and the mixture was stirred under reflux for 25 hours. Then, toluene was added and the mixture was washed with ion-exchanged water. The organic layer of the obtained washing solution was extracted, and the obtained organic layer was concentrated under reduced pressure to obtain a solid. The obtained solid was purified by silica gel column chromatography (mixed solvent of toluene and methanol) to obtain a solid (4.82 g).

The atmosphere of a separately-prepared reaction vessel was replaced with argon gas, then the reaction vessel was charged with the solid obtained above (4.81 g), silver trifluoromethanesulfonate (1.43 g), compound MC1-g (4.81 g), and tridecane (1.1 mL), and the mixture was heated and stirred at 150°C for 15 hours. Then, toluene was added, and the mixture was filtered through a filter lined with silica gel and Celite, and the obtained filtrate was washed with ion-exchanged water to obtain an organic layer. The obtained organic layer was concentrated under reduced pressure to obtain a solid. The obtained solid was purified by silica gel column chromatography (mixed solvent of hexane and toluene) and then recrystallized from a mixed solvent of ethyl acetate and ethanol.

Then, the recrystallized product was dried under reduced pressure at 50°C to give metal complex MC1 (2.32 g, yield 35%) as a yellow solid. The HPLC area percentage value of metal complex MC1 was 99.5% or more.

LC-MS (APCI, positive): m/z = 1502.8 [M+H]⁺

¹H-NMR (300 MHz, CD₂Cl₂-d₂) δ (ppm) = 7.96 (s, 6H), 7.07 (s, 6H), 6.91 (s, 3H), 6.60 (t, 3H), 6.51 (t, 3H), 6.41 (d, 3H), 6.29 (d, 3H), 2.70 (t, 6H), 2.09 (s, 18H), 1.85 (s, 9H), 1.76-1.67 (m, 6H), 1.60 (s, 9H), 1.44-1.35 (m, 18H), 1.00-0.95 (m, 9H).

The maximum peak wavelength of the emission spectrum of metal complex MC1 was 453 nm.

### <Synthesis Example 5> Synthesis of Metal Complex MC2

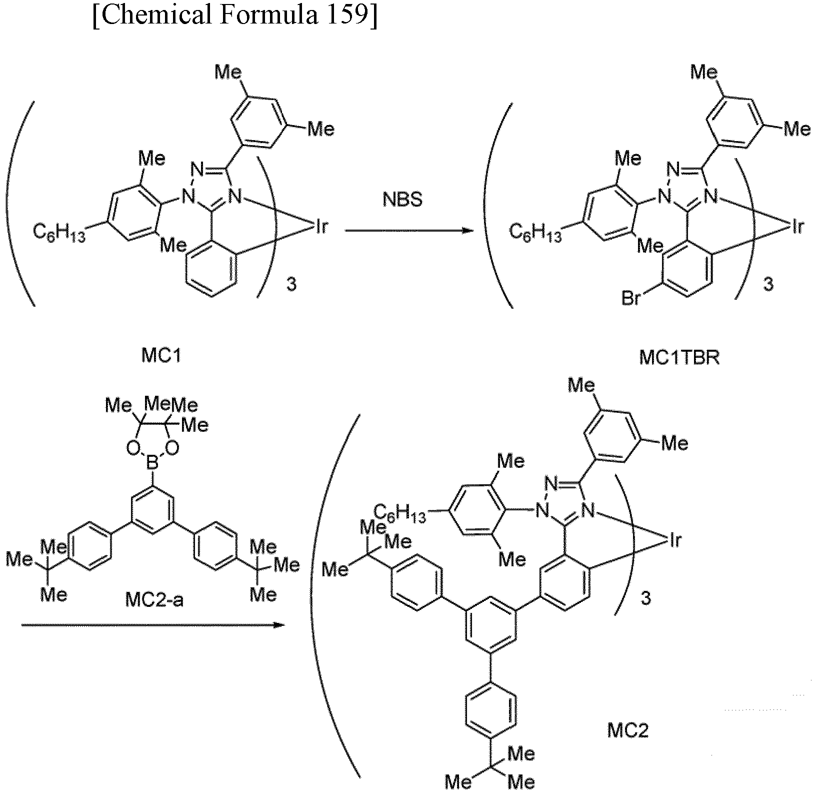

The atmosphere within a reaction vessel was replaced with argon gas, then the reaction vessel was charged with metal complex MC1 (0.50 g), dichloromethane (25 mL), and N-bromosuccinimide (203 mg), and the mixture was stirred at room temperature for 27.5 hours. Then, the reaction vessel was charge with a 10% by mass solution of aqueous sodium sulfite (4.20 g), then ion-exchanged water (8.40 mL) was added, and the mixture was stirred at room temperature for 30 minutes. An organic layer was extracted from the obtained reaction solution, and the obtained organic layer was filtered with a filter lined with silica gel. Methanol was added to the resultant filtrate to cause a precipitate to form. The obtained precipitate was filtered and vacuum dried at 50°C to obtain metal complex MC1 TBR (0.55 g, yield 95%) as a yellow solid. The HPLC area percentage value of metal complex MC1 TBR was 99.5% or more.

LC-MS (APCI, positive): m/z = 1736.5 [M+H]⁺

¹H-NMR (300 MHz, CD₂Cl₂-d₂) δ (ppm) = 7.94 (s, 6H), 7.71 (d, 6H), 6.94 (s, 3H), 6.73-6.70 (m, 3H), 6.29 (d, 3H), 6.25 (d, 3H), 2.72 (t, 6H), 2.10 (s, 18H), 1.84 (s, 9H), 1.77-1.67 (m, 6H), 1.57 (s, 9H), 1.45-1.34 (m, 18H), 0.99-0.94 (m, 9H).

The atmosphere within a reaction vessel was replaced with argon gas, then the reaction vessel was charged with metal complex MC1 TBR (0.50 g), compound MC2-a (0.44 g), toluene (30 mL), tris(dibenzylideneacetone)dipalladium(0) (7.9 mg), and 2-dicyclohexylphosphino-2',6'-dimethoxybiphenyl (8.5 mg), and the temperature was increased to 80°C. Then, the reaction vessel was charged with a 20% by mass solution of aqueous tetraethylammonium hydroxide (4.2 mL), and the mixture was stirred under reflux for 6 hours. Then, toluene was added, and the organic layer was extracted. The obtained organic layer was washed with ion-exchanged water, dried over anhydrous magnesium sulfate, filtered through a filter lined with silica gel and Celite, and the obtained filtrate was concentrated under reduced pressure to obtain a solid. The obtained solid was purified by silica gel column chromatography (mixed solvent of hexane and toluene) to give metal complex MC2 (0.54 g, yield 74%) as a yellow solid. The HPLC area percentage value of metal complex MC2 was 99.5% or more.

LC-MS (APCI, positive): m/z = 2523.5 [M+H]⁺

¹H-NMR (300 MHz, CD₂Cl₂-d₂) δ (ppm) = 8.05 (s (br), 6H), 7.70-7.50 (m, 27H), 7.38 (s (br), 6H), 7.13-7.01 (m, 9H), 6.95 (s, 3H), 6.82 (s (br), 3H), 6.65 (s (br), 3H), 2.25 (t, 6H), 2.11 (s, 18H), 2.02 (s, 9H) 1.71-1.64 (m, 9H), 1.48-1.20 (m, 78H), 0.96-0.86 (m, 9H).

The maximum peak wavelength of the emission spectrum of metal complex MC2 was 470 nm.

### <Synthesis Example 6> Synthesis of Metal Complex MC5 (Synthesis Example 6-1) Synthesis of Metal Complex MC4

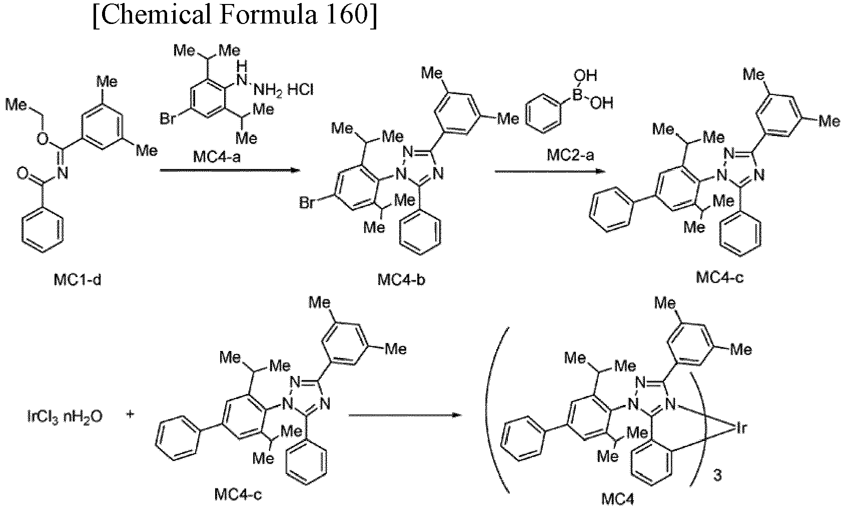

The atmosphere within a reaction vessel was replaced with argon gas, then the reaction vessel was charged with compound MC4-a (13.1 g) and tert-butyl methyl ether (110 mL), and the reaction vessel was placed in an ice bath to cool. Then, the reaction vessel was charged with an aqueous sodium hydroxide solution (1 mol/L, 125 mL), and the mixture was stirred for 30 minutes while cooling in an ice bath. The organic layer of the obtained reaction solution was extracted to obtain a tert-butyl methyl ether solution as an organic layer.

The atmosphere of a separately-prepared reaction vessel was replaced with argon gas, then the reaction vessel was charged with compound MC1-d (11.0 g) and chloroform (220 mL), and placed in an ice bath to cool. Then, the reaction vessel was charged with the above-obtained tert-butyl methyl ether solution, the mixture was stirred for 7 hours while cooling in an ice bath, and then stirred at room temperature for 110 hours. Ion-exchanged water (330 mL) was added to the obtained reaction solution, the organic layer was extracted, and the obtained organic layer was concentrated under reduced pressure. The resultant residue was purified by silica gel column chromatography (mixed solvent of chloroform and hexane), then, recrystallized from a mixed solvent of chloroform and heptane, and then, dried under reduced pressure at 50°C to obtain compound MC4-b (10.2 g, yield 55%) as a white solid. The HPLC area percentage value of compound MC4-b was 99.5% or more. The required amount of compound MC4-b was obtained by repeating this operation.

LC-MS (ESI, positive): m/z = 488.2 [M+H]⁺

¹H-NMR (CD₂Cl₂, 300 MHz): δ (ppm) = 7.92 (s, 2H), 7.66-7.62 (m, 2H), 7.52 (s, 2H), 7.52-7.36 (m, 3H), 7.16 (s, 1H), 2.57-2.46 (m, 8H), 1.20 (d, 6H), 0.97 (d, 6H).

The atmosphere within a reaction vessel was replaced with argon gas, then the reaction vessel was charged with compound MC4-b (10.2 g), compound MC2-a (2.8 g), bis[tri(2-methoxyphenyl)phosphine]palladium(II) dichloride (92.1 mg), toluene (102 mL), and a 20% by mass solution of aqueous tetraethylammonium hydroxide (36.9 g), and the mixture was stirred under reflux for 4 hours. Then, toluene was added, and the organic layer was extracted. The obtained organic layer was washed with ion-exchanged water to obtain an organic layer. The obtained organic layer was dried over anhydrous sodium sulfate, then silica gel (10 g) was added and the mixture was filtered. The obtained filtrate was concentrated under reduced pressure to obtain a solid. The obtained solid was recrystallized from a mixed solvent of heptane and chloroform. Then, the recrystallized product was dried under reduced pressure at 50°C to obtain compound MC4-c (8.55 g, yield 84%) as a white solid. The HPLC area percentage value of compound MC4-c was 99.5% or more.

LC-MS (ESI, positive): m/z = 486.3 [M+H]⁺

¹H-NMR (CD₂Cl₂, 300 MHz): δ (ppm) = 7.96 (s, 2H), 7.75 (t, 4H), 7.60-7.55 (m, 4H), 7.51-7.41 (m, 4H), 7.17 (s, 1H), 2.63-2.58 (m, 2H), 2.47 (d, 6H), 1.27 (d, 6H), 1.05 (d, 6H).

The atmosphere within a reaction vessel was replaced with argon gas, then the reaction vessel was charged with iridium chloride n-hydrate (1.96 g), compound MC4-c (5.61 g), ion-exchanged water (20 mL), and digylme (80 mL), and the mixture was heated and stirred at 150°C for 18 hours. Then, toluene was added and the mixture was washed with ion-exchanged water to obtain an organic layer. The obtained organic layer was concentrated under reduced pressure to obtain a solid. The obtained solid was purified by silica gel column chromatography (mixed solvent of toluene and methanol). The purified product was then dried under reduced pressure at 50°C to obtain a solid (5.16 g).

The atmosphere of a separately-prepared reaction vessel was replaced argon gas, then the reaction vessel was charged with the solid obtained above (4.5 g), silver trifluoromethanesulfonate (1.93 g), compound MC4-c (2.78 g), digylme (4.5 mL), decane (4.5 mL), and 2,6-lutidine (1.1 mL), and the mixture was heated and stirred at 160°C for 31 hours. Then, dichloromethane was added, and the mixture was filtered through a filter lined with Celite. The obtained filtrate was washed with ion-exchanged water to obtain an organic layer. The obtained organic layer was dried over anhydrous magnesium sulfate, then silica gel (18.6 g) was added and the mixture was filtered, and the obtained filtrate was concentrated under reduced pressure to obtain a solid. The obtained solid was purified by silica gel column chromatography (mixed solvent of cyclohexane and dichloromethane) and then recrystallized from a mixed solvent of toluene and acetonitrile. Then, the recrystallized product was dried under reduced pressure at 50°C to give metal complex MC4 (1.9 g, yield 24%) as a yellow solid. The HPLC area percentage value of metal complex MC4 was 98.9%.

LC-MS (APCI, positive): m/z = 1646.8 [M+H]⁺

¹H-NMR (CD₂Cl₂, 300 MHz): δ (ppm) = 9.12-7.10 (m, 27H), 7.00 (s, 3H), 6.72 (t, 3H), 6.62-6.33 (m, 9H), 2.74-1.67 (m, 24H), 1.25 (d, 9H), 1.15-1.00 (m, 18H), 0.84 (d, 9H).

### (Synthesis Example 6-2) Synthesis of Metal Complex MC5

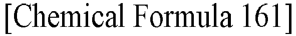

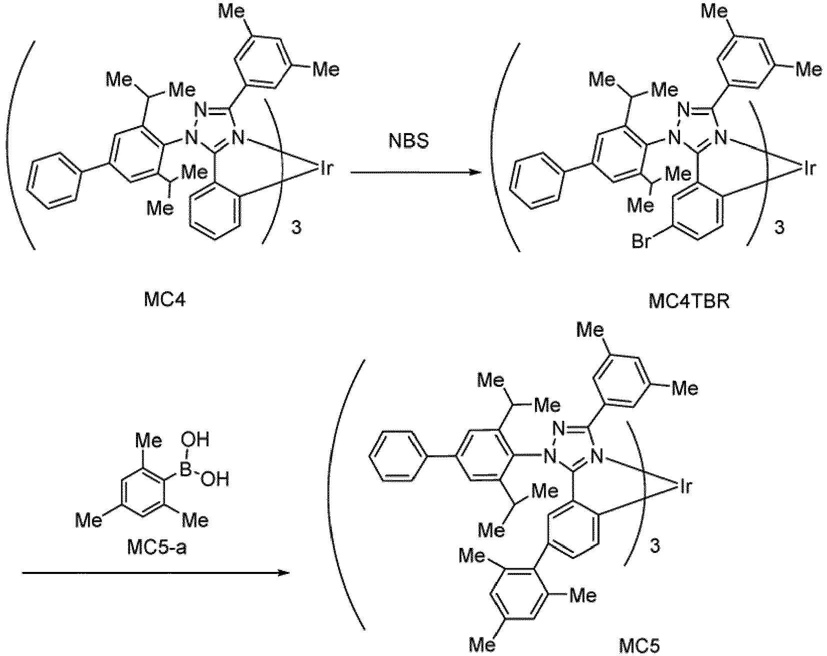

The atmosphere within a reaction vessel was replaced with argon gas, then the reaction vessel was charged with compound MC4 (0.70 g), dichloromethane (35 mL), and N-bromosuccinimide (825 mg), and the mixture was stirred at room temperature for 40 hours. Then, the reaction vessel was charged with a 10% by mass sodium sulfite aqueous solution (7.7 g), then with ion-exchanged water (15 mL), and the mixture was stirred at room temperature for 30 minutes. The organic layer was extracted from the obtained reaction solution, and the obtained organic layer was filtered with a filter lined with silica gel. Ethanol was added to the obtained filtrate to cause a precipitate to form. The obtained precipitate was filtered and vacuum dried at 50°C to obtain metal complex MC4TBR (0.73 g, yield 91%) as a yellow solid. The HPLC area percentage value of metal complex MC4TBR was 96%. The required amount of metal complex MC4TBR was obtained by repeating this operation.

LC-MS (APCI, positive): m/z = 1880.5 [M+H]⁺

¹H-NMR (CD₂Cl₂, 300 MHz): δ (ppm) = 8.25-7.83 (m, 6H), 7.76 (d, 6H), 7.76-7.46 (m, 15H), 7.04 (s, 3H), 6.83 (d, 3H), 6.50 (s, 3H), 6.31 (d, 3H), 2.33-1.85 (m, 24H), 1.25 (d, 9H), 1.12-1.07 (m, 18H), 0.84 (d, 9H).

The atmosphere within a reaction vessel was replaced with argon gas, then the reaction vessel was charged with metal complex MC4TBR (0.60 g), compound MC5-a (0.52 g), toluene (18 mL), and bis(di-tert-butyl(4-dimethylaminophenyl)phosphine)dichloropalladium( II) (6.8 mg), and the temperature was increased to 90°C. Then, the reaction vessel was charged with a 20% by mass tetraethylammonium hydroxide aqueous solution (9.1 mL), and the mixture was stirred under reflux for 19 hours. Then, toluene was added, and the organic layer was extracted. The obtained organic layer was washed with deionized water, dried over anhydrous magnesium sulfate, filtered through a filter lined with silica gel, and the obtained filtrate was concentrated under reduced pressure to obtain a solid. The obtained solid was purified by silica gel column chromatography (mixed solvent of cyclohexane and dichloromethane) and then recrystallized from a mixed solvent of toluene and acetonitrile. Then, the recrystallized product was dried under reduced pressure at 50°C to give metal complex MC5 (0.30 g, yield 47%) as a yellow solid. The HPLC area percentage value of metal complex MC5 was 97.5%.

LC-MS (APCI, positive): m/z = 2001.1 [M+H]⁺

¹H-NMR (CD₂Cl₂, 300 MHz): δ (ppm) = 7.70-7.40 (m, 27H), 7.04 (s, 3H), 6.78 (s, 9H), 6.56-6.52 (m, 3H), 6.21 (s, 3H), 2.43-1.88 (m, 42H), 1.75 (s, 9H), 1.23 (d, 9H), 1.07-1.01 (m, 18H), 0.85 (d, 9H).

The maximum peak wavelength of the emission spectrum of metal complex MC5 was 462 nm.

### (Synthesis Example 7) Synthesis of Metal Complex MC7

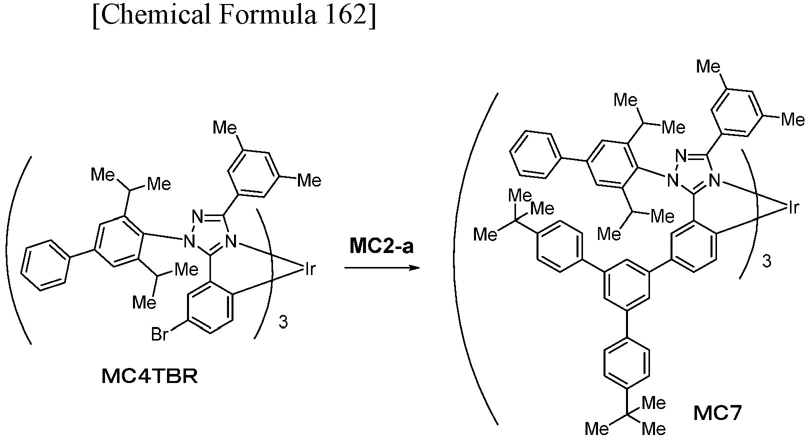

The atmosphere within a reaction vessel was replaced with argon gas, then the reaction vessel was charged with metal complex MC4TBR (0.31 g), compound MC2-a (0.31 g), toluene (9.3 mL), and bis(di-tert-butyl(4-dimethylaminophenyl)phosphine)dichloropalladium( II) (3.5 mg), and the temperature was increased to 90°C. Then, the reaction vessel was charged with a 20% by mass tetraethylammonium hydroxide aqueous solution (2.7 mL), and the mixture was stirred under reflux for 5 hours. Then, toluene was added, and the organic layer was extracted. The obtained organic layer was washed with ion-exchanged water, dried over anhydrous magnesium sulfate, filtered through a filter lined with silica gel, and the obtained filtrate was concentrated under reduced pressure to obtain a solid. The obtained solid was purified by silica gel column chromatography (mixed solvent of cyclohexane and dichloromethane) and then recrystallized from a mixed solvent of dichloromethane and hexane. Then, the recrystallized product was dried under reduced pressure at 50°C to give metal complex MC7 (0.26 g, yield 60%) as a yellow solid. The HPLC area percentage value of metal complex MC7 was 99.5% or more.

LC-MS (APCI, positive): m/z = 2667.5 [M+H]⁺

¹H-NMR (CD₂Cl₂, 300 MHz): δ (ppm) = 8.40-7.32 (m, 60H), 7.15 (d, 3H), 7.05-7.03 (m, 6H), 6.76 (s, 3H), 2.54-2.50 (m, 3H), 2.18-2.13 (m, 18H), 1.38 (s, 54H), 1.31-1.13 (m, 30H), 0.90 (d, 9H).

The maximum peak wavelength of the emission spectrum of metal complex MC7 was 469 nm.

### (Synthesis Example 8) Synthesis of Metal Complex MC8

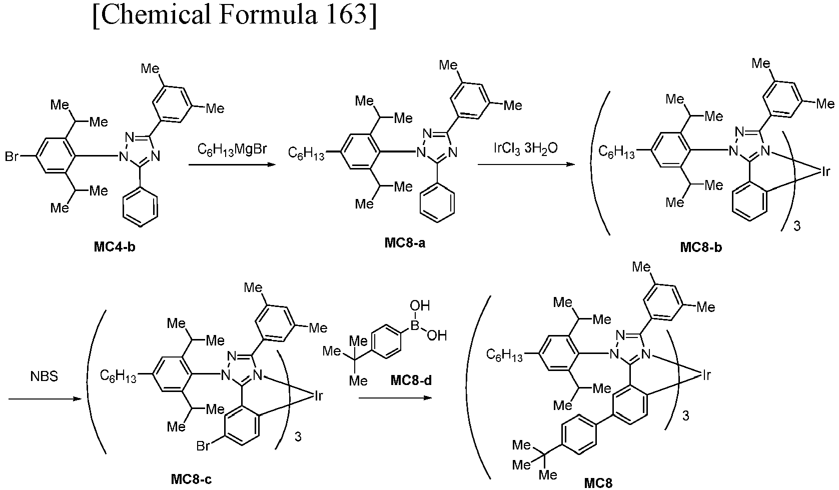

The atmosphere within a reaction vessel was replaced with argon gas, then the reaction vessel was charged with compound MC4-b (17.0 g), cyclopentyl methyl ether (150 mL), and [1,1'-bis(diphenylphosphino)ferrocene]palladium(II) dichloride (172 mg), and the temperature was increased to 50°C. Then, the reaction vessel was charged with a solution of hexyl magnesium bromide (2 mol/L, 35 mL) in diethyl ether, and the mixture was stirred at 50°C for 5 hours. Then, the reaction vessel was charged with an aqueous hydrochloric acid solution (1 mol/L, 35 mL), and the organic layer was extracted. The obtained organic layer was washed twice with ion-exchanged water (85 mL), dried over anhydrous magnesium sulfate, filtered and the resultant filtrate was concentrated under reduced pressure to obtain an oily substance. Toluene and silica gel were added to the obtained oily substance, and the resultant mixture was stirred at room temperature for 30 minutes. Then, the mixture was filtered through a filter lined with Celite, and the resultant filtrate was concentrated under reduced pressure to obtain a solid. The obtained solid was recrystallized from acetonitrile. Then, the recrystallized product was dried under reduced pressure at 50°C to obtain compound MC8-a (13.7 g, yield 80%) as a white solid. The HPLC area percentage value of compound MC8-a was 99.5% or more.

TLC/MS (DART, positive): m/z = 494 [M+H]⁺

¹H-NMR (300 MHz, CD₂Cl₂-d₂) δ (ppm) = 7.92 (s, 2H), 7.67-7.63 (m, 2H), 7.46-7.33 (m, 3H), 7.18 (s, 2H), 7.14 (s, 1H), 2.76 (t, 2H), 2.57-2.46 (m, 8H), 1.77-1.70 (m, 2H), 1.48-1.42 (m, 6H), 1.21-1.19 (m, 6H), 0.98-0.96 (m, 9H).

The atmosphere within a reaction vessel was replaced with argon gas, then the reaction vessel was charged with iridium chloride trihydrate (2.96 g), compound MC8-a (8.65 g), ion-exchanged water (30 mL), and diglyme (74 mL), and the mixture was stirred under reflux for 18 hours. Then, the mixture was cooled to room temperature, toluene was added, and the mixture was washed with ion-exchanged water. The organic layer of the obtained washing solution was extracted, and the obtained organic layer was concentrated under reduced pressure to obtain a solid. The obtained solid was purified by silica gel column chromatography (mixed solvent of toluene and ethanol) to obtain solid MC8-b' (7.51 g).

The atmosphere of a separately-prepared reaction vessel was replaced with argon gas, then the reaction vessel was charged with the solid MC8-b' obtained above (7.40 g), silver trifluoromethanesulfonate (3.19 g), compound MC8-a (4.59 g), 2,6-lutidine (1.66 g), and decane (15 mL), and the mixture was heated and stirred at 150°C for 20 hours. Then, the mixture was cooled to room temperature, toluene was added, and the mixture was filtered through a filter lined with silica gel and Celite, and the obtained filtrate was washed with ion-exchanged water to obtain an organic layer. The obtained organic layer was concentrated under reduced pressure to obtain a solid. The obtained solid was purified by silica gel column chromatography (mixed solvent of dichloromethane and cyclohexane) and then recrystallized from a mixed solvent of toluene and methanol. Then, the recrystallized product was dried under reduced pressure at 50°C to give metal complex MC8-b (1.47 g, yield 14%) as a yellow solid. The HPLC area percentage value of metal complex MC8-b was 99.4%.

LC-MS (APCI, positive): m/z = 1671.0 [M+H]⁺

¹H-NMR (300 MHz, CD₂Cl₂-d₂) δ (ppm) = 8.03 (br, 6H), 7.17 (s, 6H), 6.96 (s, 3H), 6.66 (t, 3H), 6.51-6.41 (m, 6H), 6.32 (d, 3H), 2.76 (t, 6H), 2.23-1.92 (m, 21H), 1.76-1.69 (m, 6H), 1.58 (s, 3H), 1.53-1.42 (m, 18H), 1.16 (d, 9H), 1.01-0.96 (m, 27H), 0.73 (d, 9H).

The atmosphere within a reaction vessel was replaced with argon gas, then the reaction vessel was charged with metal complex MC8-b (1.36 g), dichloromethane (68 mL), and N-bromosuccinimide (1.23 g), and the mixture was stirred at room temperature for 32 hours. Then, the reaction vessel was charged with a 10% by mass solution of aqueous sodium sulfite (8.71 g), then ion-exchanged water (70 mL) was added, and the mixture was stirred at room temperature for 30 minutes. An organic layer was extracted from the obtained reaction solution, and the obtained organic layer was filtered with a filter lined with silica gel. The obtained filtrate was concentrated under reduced pressure to obtain a solid. The obtained solid was dissolved in toluene, and methanol was added to the mixture to cause a precipitate to form. The obtained precipitate was filtered and vacuum dried at 50°C to obtain metal complex MC8-c (1.47 g, yield 95%) as a yellow solid. The HPLC area percentage value of metal complex MC8-c was 99.5% or more.

LC-MS (APCI, positive): m/z = 1903.7 [M+H]⁺

¹H-NMR (300 MHz, CD₂Cl₂-d₂) δ (ppm) = 8.00 (br, 6H), 7.20 (s, 6H), 6.99 (s, 3H), 6.67 (d, 3H), 6.36 (d, 3H), 6.25 (d, 3H), 2.78 (t, 6H), 2.06-1.69 (m, 30H), 1.46-1.41 (m, 18H), 1.16 (d, 9H), 1.03-0.94 (m, 27H), 0.74 (d, 9H).

The atmosphere within a reaction vessel was replaced with argon gas, then the reaction vessel was charged with metal complex MC8-c (1.30 g), compound MC8-d (0.44 g), toluene (65 mL), and (di-tert-butyl(4-dimethylaminophenyl)phosphine)dichloropalladium(II) (16 mg), and the temperature was increased to 80°C. Then, the reaction vessel was charged with a 20% by mass tetrabutylammonium hydroxide aqueous solution (23 mL), and the mixture was stirred under reflux for 36 hours. Then, the mixture was cooled to room temperature, toluene was added, and the organic layer was extracted. The obtained organic layer was washed with ion-exchanged water, dried over anhydrous magnesium sulfate, filtered through a filter lined with silica gel and Celite, and the obtained filtrate was concentrated under reduced pressure to obtain a solid. The obtained solid was purified by silica gel column chromatography (mixed solvent of dichloromethane and cyclohexane) and then recrystallized from a mixed solvent of ethyl acetate and acetonitrile. Then, the recrystallized product was dried under reduced pressure at 50°C to give metal complex MC8 (0.93 g, yield 72%) as a yellow solid. The HPLC area percentage value of metal complex MC8 was 99.5% or more.

LC-MS (APCI, positive): m/z = 2067.3 [M+H]⁺

¹H-NMR (300 MHz, CD₂Cl₂-d₂) δ (ppm) = 8.04 (br, 6H), 7.30-7.26 (m, 12H), 7.06-6.98 (m, 12H), 6.70 (s, 3H), 6.54 (d, 3H), 2.82 (t, 6H), 2.32-1.78 (m, 27H), 1.59-1.42 (m, 21H), 1.34 (s, 27H), 1.20 (d, 9H), 1.10 (d, 9H), 1.04-0.98 (m, 18H), 0.73 (d, 9H).

The maximum peak wavelength of the emission spectrum of metal complex MC8 was 469 nm.

### (Synthesis Example 9) Synthesis of Metal Complex MC9

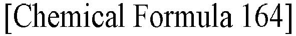

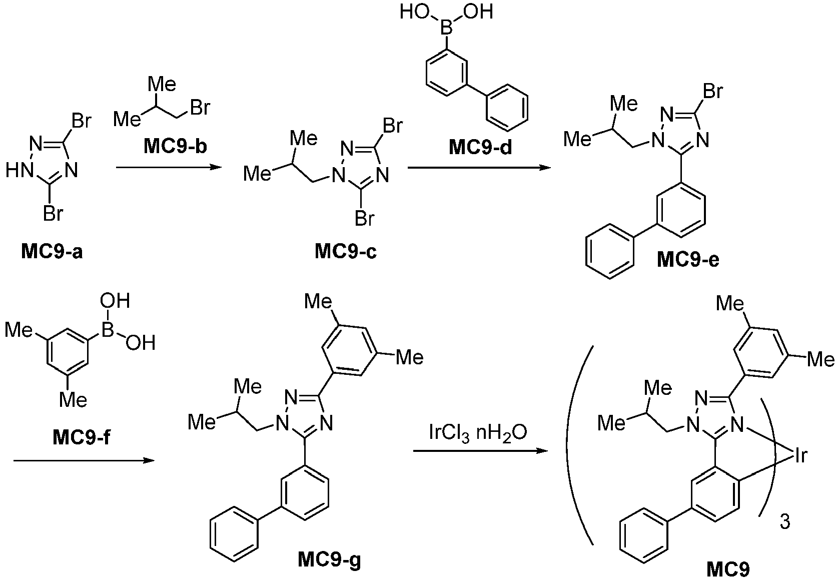

The atmosphere within a reaction vessel was replaced with argon gas, then the reaction vessel was charged with compound MC9-a (100 g), potassium carbonate (110 g), and N,N'-dimethylformamide (500 mL), and the temperature was increased to 90°C. Then, the reaction vessel was charged with a solution of compound MC9-b (109 g) in N,N'-dimethylformamide (100 mL), and the mixture was stirred at 100°C for 1 hour. Then, the mixture was cooled to room temperature, ion-exchanged water and chloroform were added, and the organic layer was extracted. The obtained organic layer was washed with ion-exchanged water, dried over anhydrous magnesium sulfate, then filtered through a filter lined with silica gel, and the obtained filtrate was concentrated under reduced pressure to obtain an oily substance. The resultant obtained oily substance was purified by silica gel column chromatography (mixed solvent of heptane and ethyl acetate), and then dried under reduced pressure at 45°C to obtain compound MC9-c (117 g, yield 94%) as a colorless oily substance. The HPLC area percentage value of compound MC9-c was 99.5% or more. The required amount of compound MC9-c was obtained by repeating this operation.

TLC/MS (DART, positive): m/z = 281.9 [M+H]⁺

¹H-NMR (CD₂Cl₂, 300 MHz): δ (ppm) = 3.94 (d, 2H), 2.32-2.23 (m, 1H), 0.95 (d, 6H).

The atmosphere within a reaction vessel was replaced with argon gas, then the reaction vessel was charged with compound MC9-c (127 g), compound MC9-d (88.9 g), ethanol (380 mL), toluene (1140 mL), and tetrakis(triphenylphosphine)palladium(0) (15.6 g), and the temperature was increased to 55°C. Then, the reaction vessel was charge with an aqueous sodium carbonate solution (2 mol/L, 450 mL), and the mixture was stirred at 70°C for 29 hours. Then, toluene was added to the mixture, and the organic layer was extracted. The obtained organic layer was washed with ion-exchanged water, dried over anhydrous magnesium sulfate, and the obtained solution was then concentrated under reduced pressure to obtain an oily substance. The obtained oily substance was purified a plurality of times by silica gel column chromatography (mixed solvent of toluene and ethyl acetate), and then dried under reduced pressure at 45°C to obtain compound MC9-e (63.2 g, yield 39%) as a colorless oily substance. The HPLC area percentage value of compound MC9-e was 99.5% or more.

TLC/MS (DART, positive): m/z = 356.1 [M+H]⁺

¹H-NMR (CD₂Cl₂, 300 MHz): δ (ppm) = 7.83-7.82 (m, 1H), 7.76-7.74 (m, 1H), 7.63-7.53 (m, 4H), 7.56-7.46 (m, 2H), 7.42-7.39 (m, 1H), 4.03 (d, 2H), 2.38-2.28 (m, 1H), 0.88 (d, 6H).

The atmosphere within a reaction vessel was replaced with argon gas, then the reaction vessel was charged with compound MC9-e (25.0 g), compound MC9-f (11.6 g), ethanol (75 mL), toluene (225 mL), and tetrakis(triphenylphosphine)palladium(0) (2.43 g), and the temperature was increased to 80°C. Then, the reaction vessel was charge with an aqueous sodium carbonate solution (2 mol/L, 70 mL), and the mixture was stirred at 80°C for 16 hours. Then, toluene was added to the mixture, and the organic layer was extracted. The obtained organic layer was washed with ion-exchanged water, dried over anhydrous magnesium sulfate, and the obtained solution was then concentrated under reduced pressure to obtain an oily substance. The obtained oily substance was purified by silica gel column chromatography (mixed solvent of heptane and ethyl acetate), and then dried under reduced pressure at 45°C to obtain compound MC9-g (26.6 g, yield 99%) as a colorless oily substance. The HPLC area percentage value of compound MC9-g was 99.5% or more.

TLC/MS (DART, positive): m/z = 382.2 [M+H]⁺

¹H-NMR (CD₂Cl₂, 300 MHz): δ (ppm) = 7.88-7.87 (m, 1H), 7.82-7.80 (m, 2H), 7.75-7.72 (m, 1H), 7.67-7.56 (m, 4H), 7.49-7.45 (m, 2H), 7.41-7.37 (m, 1H), 7.05-7.04 (m, 1H), 4.06 (d, 2H), 2.42-2.38 (m, 7H), 0.88 (d, 6H).

The atmosphere within a reaction vessel was replaced with argon gas, then the reaction vessel was charged with iridium chloride n-hydrate (1.43 g), compound MC9-g (3.20 g), ion-exchanged water (11 mL), and digylme (35 mL), and the mixture was heated and stirred at 140°C for 18 hours. Then, toluene was added, and the mixture was washed with ion-exchanged water to obtain an organic layer. The obtained organic layer was concentrated under reduced pressure to obtain a solid. The obtained solid was recrystallized from a mixed solvent of tert-butyl methyl ether and heptane to obtain solid MC9' (2.5 g)

The atmosphere of a separately-prepared reaction vessel was replaced with argon gas, then the reaction vessel was charged with the solid MC9' obtained above (1.0 g), silver trifluoromethanesulfonate (0.58 g), compound MC9-g (1.16 g), and 2,6-lutidine (0.9 mL), and the mixture was heated and stirred at 160°C for 12 hours. Then, dichloromethane was added, and the mixture was filtered through a filter lined with Celite. The obtained filtrate was added to acetonitrile, whereby a precipitate formed. The obtained precipitate was filtered to obtain a solid. The obtained solid was dissolved in dichloromethane, silica gel was added and the mixture was filtered. The obtained filtrate was concentrated under reduced pressure, purified by column chromatography (toluene), and recrystallized from a mixed solvent of toluene and methanol. Then, the recrystallized product was dried under reduced pressure at 50°C to give metal complex MC9 (270 mg, yield 20%) as a yellow solid. The HPLC area percentage value of metal complex MC9 was 88%.

LC-MS (APCI, positive): m/z = 1334.6 [M+H]⁺

¹H-NMR (CD₂Cl₂, 300 MHz): δ (ppm) = 7.75 (d, 3H), 7.67-7.64 (m, 6H), 7.49 (t, 6H), 7.39-7.34 (m, 3H), 7.12-7.08 (m, 3H), 6.96 (s, 3H), 6.86-6.83 (m, 3H), 6.50 (s, 6H), 4.53-4.46 (m, 3H), 4.14-4.00 (m, 3H), 2.45-2.32 (m, 3H), 2.23-2.18 (m, 18H), 1.08 (d, 9H), 0.91 (d, 9H).

The maximum peak wavelength of the emission spectrum of metal complex MC9 was 469 nm.

### (Synthesis Example 10) Synthesis of Metal Complex MC10

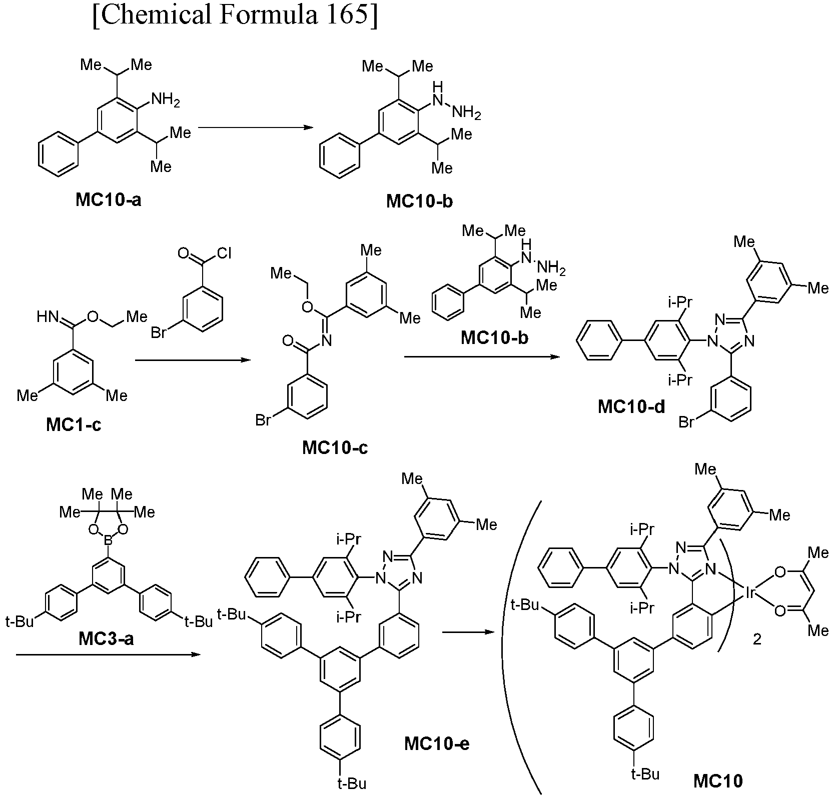

The atmosphere within a reaction vessel was replaced with argon gas, then the reaction vessel was charged with compound MC10-a (140 g) and concentrated hydrochloric acid (1.26 L), and the reaction vessel was placed in an ice bath to cool. Then, the reaction vessel was charged with sodium nitrite (50 g), and stirred for 30 minutes while cooling in an ice bath. Then, tin(II) chloride (400 g) was added, and the mixture was stirred at room temperature for 18 hours. Then, the obtained reaction solution was concentrated under reduced pressure, and the resultant residue was washed with a mixed solvent of hexane and diethyl ether to obtain a solid. Tert-butyl methyl ether and a 10% by mass of aqueous sodium hydroxide solution were added to the obtained solid, and the organic layer was extracted. The obtained organic layer was washed with ion-exchanged water, dried over anhydrous sodium sulfate, and then concentrated under reduced pressure to obtain compound MC10- b (125 g, yield 83%) as a white solid.

The atmosphere within a reaction vessel was replaced with argon gas, then the reaction vessel was charged with compound MC1-c (80 g), 3-bromo benzoyl chloride (100 g), and chloroform, followed by triethylamine (94 mL), and the mixture was stirred at room temperature for 16 hours. The obtained reaction solution was concentrated under reduced pressure, and heptane was added to the resultant residue to obtain a solution containing a white solid. The solution containing the obtained white solid was filtered, and the obtained filtrate was concentrated to obtain compound MC10-c (90 g, yield 55%).

The atmosphere within a reaction vessel was replaced with argon gas, then the reaction vessel was charged with compound MC10-c (90 g), compound MC10-b (56 g), triethylamine (100 mL), and carbon tetrachloride, and the mixture was stirred at 50°C for 3 days. The resultant reaction mixture was purified by silica gel column chromatography (mixed solvent of ethyl acetate and hexane) to obtain compound MC10-d (45 g, yield 32%) as a white solid. The HPLC area percentage value of compound MC10-d was 94.8%. The required amount of compound MC10-d was obtained by repeating this operation.

The atmosphere within a reaction vessel was replaced with argon gas, then the reaction vessel was charged with compound MC10-d (60 g), compound MC3-a (55 g), tris(dibenzylideneacetone)dipalladium(0) (980 mg), 2-dicyclohexylphosphino-2',6'-dimethoxybiphenyl (440 mg), toluene, and a 40% by mass solution of aqueous tetraethylammonium hydroxide (156 g), and the mixture was stirred under reflux for 18 hours. Then, the mixture was cooled to room temperature, the organic layer was extracted, and the obtained organic layer was concentrated under reduced pressure to obtain a solid. The obtained solid was purified by silica gel column chromatography (mixed solvent of hexane and ethyl acetate), and then recrystallized from a mixed solvent of toluene and acetonitrile. Then, the recrystallized product was dried under reduced pressure at 50°C to give compound MC10-e (85 g, yield 97%) as a white solid. The HPLC area percentage value of compound MC10-e was 99.5% or more.

LC-MS (ESI, positive): m/z = 826.5 [M+H]⁺

¹H-NMR (CD₂Cl₂, 300 MHz): δ (ppm) = 8.00 (t, 1H), 7.96 (s, 2H), 7.87-7.82 (m, 3H), 7.68-7.46 (m, 18H), 7.17 (s, 1H), 2.71-2.62 (m, 2H), 2.47 (s, 6H), 1.42 (s, 18H), 1.29 (d, 6H), 1.07 (s, 6H).

The atmosphere within a reaction vessel was replaced with argon gas, then the reaction vessel was charged with iridium chloride n-hydrate (6.38 g), compound MC10-e (31.1 g), ion-exchanged water (51 mL), and diglyme (151 mL), and the mixture was stirred under reflux for 36 hours. Then, toluene was added and the mixture was washed with ion-exchanged water. The organic layer of the obtained washing solution was extracted, and the obtained organic layer was concentrated under reduced pressure to obtain a solid. The obtained solid was purified by silica gel column chromatography (mixed solvent of toluene and ethanol) to obtain solid MC10' (28.5 g).

The atmosphere of a separately-prepared reaction vessel was replaced with argon gas, then the reaction vessel was charged with the solid MC10' obtained above (0.6 g), acetylacetone (0.96 g), sodium carbonate (0.34 g), and 2-ethoxyethanol (18 mL), and the mixture was stirred at 120°C for 2 hours to cause a precipitate to form. The resultant precipitate was filtered, washed with 2-ethoxyethanol (30 mL), ion-exchanged water (30 mL), and methanol (30 mL) in this order to obtain a solid. The obtained solid was dissolved in dichloromethane (5 mL), then filtered through a filter lined with silica gel (3 g), and the obtained filtrate was concentrated under reduced pressure to obtain a solid. The obtained solid was recrystallized from ethyl acetate, and then further recrystallized from a mixed solvent of toluene and acetonitrile. Then, the recrystallized product was dried under reduced pressure at 50°C to give metal complex MC10 (0.40 g, yield 65%) as a yellow solid. The HPLC area percentage value of metal complex MC10 was 97.9%.

LC-MS (ESI, positive): m/z = 1980.0 [M+K]⁺

¹H-NMR (300 MHz, CD₂Cl₂-d₂) δ (ppm) = 7.78 (d, 4H), 7.69-7.65 (m, 10H), 7.53-7.50 (m, 18H), 7.36-7.30 (m, 12H), 7.07-7.04 (m, 4H), 4.71 (s, 1H), 3.15-3.06 (m, 2H), 2.86-2.77 (m, 2H), 2.25 (s, 12H), 1.46-1.26 (m, 66H).

The maximum peak wavelength of the emission spectrum of metal complex MC10 was 472 nm.

### <Synthesis Example P1> Synthesis of Polymer compound HTL-1

(Step 1) The atmosphere within a reaction vessel was replaced with an inert gas, then the reaction vessel was charged with compound CM1 (1.51 g), compound CM4 (0.884 g), compound CM5 (0.259 g), compound CM3 (0.139 g), metal complex RM2 (0.350 g), dichlorobis[tris(2-methoxyphenyl)phosphine]palladium (2.6 mg), and toluene (50 ml), and the mixture was heated to 105°C.
(Step 2) A 20% by mass solution of aqueous tetraethylammonium hydroxide (10.6 g) was added dropwise to the obtained reaction solution, and the mixture was refluxed for 7 hours.
(Step 3) Then, phenylboronic acid (73.9 mg), a 20% by mass solution of aqueous tetraethylammonium hydroxide (10.6 g), and dichlorobis[tris(2-methoxyphenyl)phosphine]palladium (2.7 mg) were added, and the mixture was refluxed for 18 hours.
(Step 4) Then, an aqueous sodium diethyldithiacarbamate solution was added, and the mixture was stirred at 80°C for 2 hours. The obtained reaction solution was cooled, then washed twice with 3.6% by mass hydrochloric acid, twice with 2.5% by mass aqueous ammonia, and six times with ion-exchanged water in that order, and the resultant solution was dropped into methanol, which caused a precipitate to form. The resultant precipitate was dissolved in toluene and purified by passing through an alumina column and a silica gel column in that order. The obtained solution was dropped into methanol, the mixture was stirred, and a precipitate formed. The obtained precipitate was collected by filtration and dried to obtain 1.68 g of polymer compound HTL-1. The Mn of the polymer compound HTL-1 was 6.0 × 10⁴, and the Mw was 4.9 × 10⁵.

The polymer compound HTL-1 was a copolymer having, based on the theoretical values obtained from the amounts of the charged raw materials, a molar ratio among the constitutional unit derived from compound CM1, the constitutional unit derived from compound CM4, the constitutional unit derived from compound CM5, the constitutional unit derived from compound CM3, and the constitutional unit derived from metal complex RM2 of 50:32:10:5:3.

The emission spectrum of the polymer compound HTL-1 had a maximum wavelength at 399 nm and 614 nm, and the maximum peak wavelength of the emission spectrum of the polymer compound HTL-1 was 399 nm.

### <Synthesis Example P2> Synthesis of Polymer compound HTL-2

1.71 g of Polymer compound HTL-2 was obtained in the same manner as for the synthesis of polymer compound HTL-1, except that in (step 1) of the synthesis of polymer compound HTL-1, "the atmosphere within a reaction vessel was replaced with an inert gas, then the reaction vessel was charged with compound CM1 (1.50 g), compound CM4 (0.884 g), compound CM5 (0.259 g), compound CM3 (0.139 g), metal complex RM1 (0.333 g), dichlorobis[tris(2-methoxyphenyl)phosphine]palladium (2.7 mg), and toluene (50 ml), and the mixture was heated to 105°C". The Mn of polymer compound HTL-2 was 3.3 × 10⁴ and the Mw was 2.4 × 10⁵.

The polymer compound HTL-2 was a copolymer having, based on the theoretical values obtained from the amounts of the charged raw materials, a molar ratio among the constitutional unit derived from compound CM1, the constitutional unit derived from compound CM4, the constitutional unit derived from compound CM5, the constitutional unit derived from compound CM3, and the constitutional unit derived from metal complex RM1 of 50:32:10:5:3.

The emission spectrum of the polymer compound HTL-2 had a maximum wavelength at 399 nm and 599 nm, and the maximum peak wavelength of the emission spectrum of the polymer compound HTL-2 was 399 nm.

### <Synthesis Example P3> Synthesis of Polymer compound HTL-3

Polymer compound HTL-3 was synthesized according to the methods described in Japanese Unexamined Patent Publication No. 2015-110751 using compound CM1, compound CM2, compound CM3, and compound CM4. The Mn of polymer compound HTL-3 was 5.9 × 10⁴ and the Mw was 2.5 × 10⁵.

The polymer compound HTL-3 was a copolymer having, based on the theoretical values obtained from the amounts of the charged raw materials, a molar ratio among the constitutional unit derived from compound CM1, the constitutional unit derived from compound CM2, the constitutional unit derived from compound CM3, and the constitutional unit derived from compound CM4 of 50:5:5:40.

### <Synthesis Example P4> Synthesis of Polymer compound HTL-4

(Step 1) The atmosphere within a reaction vessel was replaced with an inert gas, then the reaction vessel was charged with compound CM6 (2.52 g), compound CM7 (0.470 g), compound CM8 (4.90 g), metal complex RM1 (0.530 g), dichlorobis(tris-o-methoxyphenylphosphine)palladium (4.2 mg), and toluene (158 ml), and the mixture was heated to 100°C.
(Step 2) A 20% by mass solution of aqueous tetraethylammonium hydroxide (16 mL) was added dropwise to the reaction solution, and the mixture was refluxed for 8 hours.
(Step 3) After the reaction, phenylboronic acid (116 mg), dichlorobis(tris-o-methoxyphenylphosphine)palladium (4.2 mg) were added, and the mixture was refluxed for 15 hours.
(Step 4) Then, an aqueous sodium diethyldithiacarbamate solution was added, and the mixture was stirred at 85°C for 2 hours. The reaction solution was cooled, then washed with 3.6% by mass hydrochloric acid, 2.5% by mass aqueous ammonia, and water, and the resultant solution was dropped into methanol, which caused a precipitate to form. The resultant precipitate was dissolved in toluene and purified by passing through an alumina column and a silica gel column in that order. The obtained solution was dropped into methanol, the mixture was stirred, and the obtained precipitate was collected by filtration and dried to obtain 6.02 g of polymer compound HTL-4. The Mn of the polymer compound HTL-4 was 3.8 × 10⁴, and the Mw was 4.5 × 10⁵.

The polymer compound HTL-4 was a copolymer having, based on the theoretical values obtained from the amounts of the charged raw materials, a molar ratio among the constitutional unit derived from compound CM6, the constitutional unit derived from compound CM7, the constitutional unit derived from compound CM8, and the constitutional unit derived from metal complex RM1 of 40:10:47:3.

The emission spectrum of the polymer compound HTL-4 had a maximum wavelength at 404 nm and 600 nm, and the maximum peak wavelength of the emission spectrum of the polymer compound HTL-4 was 404 nm.

### <Synthesis Example P5> Synthesis of Polymer compound HTL-5

(Step 1) The atmosphere within a reaction vessel was replaced with an inert gas, then the reaction vessel was charged with compound CM6 (0.800 g), compound CM7 (0.149 g), compound CM8 (1.66 g), dichlorobis(tris-o-methoxyphenylphosphine)palladium (1.4 mg), and toluene (45 ml), and the mixture was heated to 100°C.
(Step 2) A 20% by mass solution of aqueous tetraethylammonium hydroxide (16 mL) was added dropwise to the reaction solution, and the mixture was refluxed for 7 hours.
(Step 3) After the reaction, 2-ethyl phenylboronic acid (90 mg)and dichlorobis(tris-o-methoxyphenylphosphine)palladium (1.3 mg) were added, and the mixture was refluxed for 17.5 hours.
(Step 4) Then, an aqueous sodium diethyldithiacarbamate solution was added, and the mixture was stirred at 85°C for 2 hours. The reaction solution was cooled, then washed with 3.6% by mass hydrochloric acid, 2.5% by mass aqueous ammonia, and water, and the resultant solution was dropped into methanol, which caused a precipitate to form. The resultant precipitate was dissolved in toluene and purified by passing through an alumina column and a silica gel column in that order. The obtained solution was dropped into methanol, the mixture was stirred, and the obtained precipitate was collected by filtration and dried to obtain 1.64 g of polymer compound HTL-5. The Mn of the polymer compound HTL-5 was 3.5 × 10⁴, and the Mw was 2.2 × 10⁵.

The polymer compound HTL-5 was a copolymer having, based on the theoretical values obtained from the amounts of the charged raw materials, a molar ratio among the constitutional unit derived from compound CM6, the constitutional unit derived from compound CM7, and the constitutional unit derived from compound CM8 of 40:10:50.

### <Synthesis Example P6> Synthesis of Polymer Compound ETL-1

(Step 1) The atmosphere within a reaction vessel was replaced with an inert gas, then the reaction vessel was charged with compound CM4 (9.23 g), synthesized in accordance with the method described in Japanese Unexamined Patent Publication No. 2012-33845, compound CM1 (4.58 g), dichlorobis(tris-o-methoxyphenylphosphine)palladium (8.6 mg), methyltrioctylammonium chloride (trade name: Aliquat 336 (R), manufactured by Sigma-Aldrich) (0.098 g), and toluene (175 mL), and the mixture was heated to 105°C. 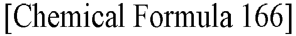 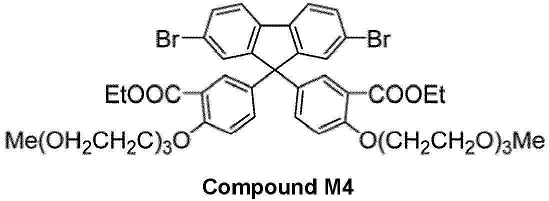
(Step 2) Then, a 12% by mass solution of aqueous sodium carbonate (40.3 mL) was added dropwise to the reaction solution, and the mixture was refluxed for 29 hours.
(Step 3) Then, phenylboronic acid (0.47 g) and dichlorobis(tris-o-methoxyphenylphosphine)palladium (8.7 mg) were added to the reaction solution, and the mixture was refluxed for 14 hours.
(Step 4) Then, an aqueous sodium diethyldithiacarbamate solution was added to the reaction solution, and the mixture was stirred at 80°C for 2 hours. The obtained reaction solution was cooled, then added dropwise to methanol, whereupon a precipitate formed. The precipitate was collected by filtration, washed with methanol and water, and then dried. The resultant solid was dissolved in chloroform and purified by sequentially passing through an alumina column and a silica gel column through which chloroform had been passed in advance. The obtained purified solution was dropped into methanol, the mixture was stirred, which caused a precipitate to form. The precipitate was collected by filtration and dried to obtain a polymer compound ETL-1a (7.15 g). The Mn of the polymer compound ETL-1a was 3.2 × 10⁴, and the Mw was 6.0 × 10⁴.
   The polymer compound ETL-1a was a copolymer having, based on the theoretical values obtained from the amounts of the charged raw materials, a molar ratio between the constitutional unit derived from compound M4 and the constitutional unit derived from compound CM1 of 50:50.
(Step 5) The atmosphere within a reaction vessel was replaced with argon gas, then the reaction vessel was charged with polymer compound ETL-1a (3.1 g), tetrahydrofuran (130 mL), methanol (66 mL), cesium hydroxide monohydrate (2.1 g), and water (12.5 mL), and the mixture was stirred at 60°C for 3 hours.
(Step 6) Then, methanol (220 mL) was added to the reaction solution, and the mixture was stirred for 2 hours. The obtained reaction mixture was concentrated, and then added dropwise into isopropyl alcohol, the mixture was stirred, whereupon a precipitate formed. The precipitate was collected by filtration and dried to obtain polymer compound ETL-1 (3.5 g). Based on ¹H-NMR analysis of the polymer compound ETL-1, it was confirmed that the signal at the ethyl ester site in polymer compound ETL-1 had disappeared and that the reaction was completed.

The polymer compound ETL-1 was a copolymer having, based on the theoretical values obtained from the amounts of the charged raw materials of polymer compound ETL-1a, a molar ratio between the constitutional unit represented by the following formula and the constitutional unit derived from compound CM1 of 50:50.

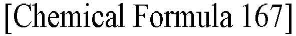

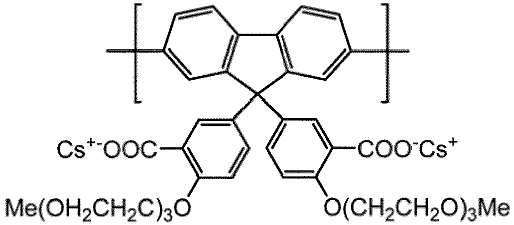

Elemental analysis of polymer compound ETL-1 was carried out by a combustion method and an atomic absorption method.

The elemental analysis values of the polymer compound ETL-1 were C, 54.1% by mass; H, 5.6% by mass; N, <0.3% by mass; Cs, 22.7% by mass (theoretical value: C, 57.29% by mass; H, 5.70% by mass; Cs, 21.49% by mass; O, 15.52% by mass).

### <Example D1> Fabrication and Evaluation of Light Emitting Device D1

### (Formation of Anode and Hole Injection Layer)

An ITO film with a thickness of 45 nm was attached to a glass substrate by a sputtering method to form an anode. On the anode, a polythiophene-sulfonic acid type hole injection material AQ-1200 (manufactured by Plextronics) was spin-coated to form a film with a thickness of 35 nm, and the film was heated on a hot plate at 170°C for 15 minutes under an air atmosphere to form a hole injection layer.

### (Formation of Second Light Emitting Layer)

A polymer compound HTL-1 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere to form a second light emitting layer.

### (Formation of First Light Emitting Layer)

A compound HM-1, a metal complex MC1, and a metal complex GM1 (compound HM-1/metal complex MC1/metal complex GM1=74% by mass/25% by mass/1% by mass) were dissolved at a concentration of 2% by mass in toluene. The resultant toluene solution was spin-coated on the second light emitting layer to form a film with a thickness of 75 nm, and the film was heated at 130°C for 10 minutes under a nitrogen gas atmosphere to form a first light emitting layer.

### (Formation of Electron Transporting Layer)

A polymer compound ETL-1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the first light emitting layer to form a film with a thickness of 10 nm, and the film was heated at 130°C for 10 minutes under a nitrogen gas atmosphere to form an electron transporting layer.

### (Formation of Cathode)

The substrate on which the electron transporting layer was formed was placed in a vapor deposition machine, and the pressure was reduced to 1.0 × 10⁻⁴ Pa or less. Then, as a cathode, sodium fluoride was vapor-deposited to a thickness of about 4 nm on the electron transporting layer, and then aluminum was vapor-deposited to a thickness of about 80 nm on the sodium fluoride layer. After the vapor deposition, sealing was performed using a glass substrate to fabricate a light emitting device D1.

### (Evaluation of Light Emitting Device)

EL emission was observed by applying a voltage to the light emitting device D1. The CIE chromaticity coordinate (x, y) at 1000 cd/m² was (0.50, 0.41).

After setting the current value so that the initial luminance of the light emitting device D1 was 6000 cd/m², the light emitting device D1 was driven at a constant current, and the time until the luminance reached 70% of the initial luminance was measured to be 9.4 hours. The results are shown in Table 3.

### <Example D2> Fabrication and Evaluation of Light Emitting Device D2

A light emitting device D2 was fabricated in the same manner as in Example D1, except that "a compound HM-1, a metal complex MC2, and a metal complex GM1 (compound HM-1/metal complex MC2/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1.

### (Evaluation of Light Emitting Device)

EL emission was observed by applying a voltage to the light emitting device D2. The CIE chromaticity coordinate (x, y) at 1000 cd/m² was (0.45, 0.42).

After setting the current value so that the initial luminance of the light emitting device D2 was 6000 cd/m², the light emitting device D2 was driven at a constant current, and the time until the luminance reached 70% of the initial luminance was measured to be 15.1 hours. The results are shown in Table 3.

### <Example D3> Fabrication and Evaluation of Light Emitting Device D3

A light emitting device D3 was fabricated in the same manner as in Example D1, except that "a compound HM-1, a metal complex MC5, and a metal complex GM1 (compound HM-1/metal complex MC5/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1.

### (Evaluation of Light Emitting Device)

EL emission was observed by applying a voltage to the light emitting device D3. The CIE chromaticity coordinate (x, y) at 1000 cd/m² was (0.46, 0.40).

After setting the current value so that the initial luminance of the light emitting device D3 was 6000 cd/m², the light emitting device D3 was driven at a constant current, and the time until the luminance reached 70% of the initial luminance was measured to be 6.7 hours. The results are shown in Table 3.

### <Example D4> Fabrication and Evaluation of Light Emitting Device D4

A light emitting device D4 was fabricated in the same manner as in Example D1, except that "a compound HM-1, a metal complex MC7, and a metal complex GM1 (compound HM-1/metal complex MC7/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1.

### (Evaluation of Light Emitting Device)

EL emission was observed by applying a voltage to the light emitting device D4. The CIE chromaticity coordinate (x, y) at 1000 cd/m² was (0.48, 0.42).

After setting the current value so that the initial luminance of the light emitting device D4 was 6000 cd/m², the light emitting device D4 was driven at a constant current, and the time until the luminance reached 70% of the initial luminance was measured to be 11.7 hours. The results are shown in Table 3.

### <Example D5> Fabrication and Evaluation of Light Emitting Device D5

A light emitting device D5 was fabricated in the same manner as in Example D1, except that "a compound HM-1, a metal complex MC8, and a metal complex GM1 (compound HM-1/metal complex MC8/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1.

### (Evaluation of Light Emitting Device)

EL emission was observed by applying a voltage to the light emitting device D5. The CIE chromaticity coordinate (x, y) at 1000 cd/m² was (0.45, 0.42).

After setting the current value so that the initial luminance of the light emitting device D5 was 6000 cd/m², the light emitting device D5 was driven at a constant current, and the time until the luminance reached 70% of the initial luminance was measured to be 13.9 hours. The results are shown in Table 3.

### <Example D6> Fabrication and Evaluation of Light Emitting Device D6

A light emitting device D6 was fabricated in the same manner as in Example D1, except that "a compound HM-1, a metal complex MC9, and a metal complex GM1 (compound HM-1/metal complex MC9/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1.

### (Evaluation of Light Emitting Device)

EL emission was observed by applying a voltage to the light emitting device D6. The CIE chromaticity coordinate (x, y) at 1000 cd/m² was (0.48, 0.41).

After setting the current value so that the initial luminance of the light emitting device D5 was 6000 cd/m², the light emitting device D5 was driven at a constant current, and the time until the luminance reached 70% of the initial luminance was measured to be 8.0 hours. The results are shown in Table 3.

### <Comparative Example CD1> Fabrication and Evaluation of Light Emitting Device CD 1

A light emitting device CD1 was fabricated in the same manner as in Example D1, except that "a compound HM-1, a metal complex MC3, and a metal complex GM1 (compound HM-1/metal complex MC3/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1.

### (Evaluation of Light Emitting Device)

EL emission was observed by applying a voltage to the light emitting device CD1. The CIE chromaticity coordinate (x, y) at 1000 cd/m² was (0.46, 0.42).

After setting the current value so that the initial luminance of the light emitting device CD1 was 6000 cd/m², the light emitting device CD1 was driven at a constant current, and the time until the luminance reached 70% of the initial luminance was measured to be 0.8 hours. The results are shown in Table 3.

### <Comparative Example CD2> Fabrication and Evaluation of Light Emitting Device CD2

A light emitting device CD2 was fabricated in the same manner as in Example D1, except that "a compound HM-1, a metal complex MC6, and a metal complex GM1 (compound HM-1/metal complex MC6/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1.

### (Evaluation of Light Emitting Device)

EL emission was observed by applying a voltage to the light emitting device CD2. The CIE chromaticity coordinate (x, y) at 1000 cd/m² was (0.41, 0.43).

After setting the current value so that the initial luminance of the light emitting device CD1 was 6000 cd/m², the light emitting device CD1 was driven at a constant current, and the time until the luminance reached 70% of the initial luminance was measured to be 1.0 hour. The results are shown in Table 3.

**[Table 3]**

| | Light Emitting Device | Formation of Second Light Emitting Layer | Formation of First Light Emitting Layer | | Luminance Lifetime (time) |
|---|---|---|---|---|---|
| | | Material | Material | Material Ratio (% by mass) | |
| Example D1 | D1 | HTL-1 | HM-1/MC1/GM1 | 74/25/1 | 9.4 |
| Example D2 | D2 | HTL-1 | HM-1/MC2/GM1 | 74/25/1 | 15.1 |
| Example D3 | D3 | HTL-1 | HM-1/MC5/GM1 | 74/25/1 | 6.7 |
| Example D4 | D4 | HTL-1 | HM-1/MC7/GM1 | 74/25/1 | 11.7 |
| Example D5 | D5 | HTL-1 | HM-1/MC8/GM1 | 74/25/1 | 13.9 |
| Example D6 | D6 | HTL-1 | HM-1/MC9/GM1 | 74/25/1 | 8.0 |
| Comparative Example CD1 | CD1 | HTL-1 | HM-1/MC3/GM1 | 74/25/1 | 0.8 |
| Comparative Example CD2 | CD2 | HTL-1 | HM-1/MC6/GM1 | 74/25/1 | 1.0 |

### <Example D7> Fabrication and Evaluation of Light Emitting Device D7

A light emitting device D7 was fabricated in the same manner as in Example D1, except that "polymer compound HTL-2" was used in place of "polymer compound HTL-1" in the (Formation of Second Light Emitting Layer) of Example D1.

### (Evaluation of Light Emitting Device)

EL emission was observed by applying a voltage to the light emitting device D7. The CIE chromaticity coordinate (x, y) at 1000 cd/m² was (0.51, 0.42).

After setting the current value so that the initial luminance of the light emitting device D7 was 6000 cd/m², the light emitting device D7 was driven at a constant current, and the time until the luminance reached 80% of the initial luminance was measured to be 7.9 hours. The results are shown in Table 4.

### <Example D8> Fabrication and Evaluation of Light Emitting Device D8

A light emitting device D8 was fabricated in the same manner as in Example D2, except that "polymer compound HTL-2" was used in place of "polymer compound HTL-1" in the (Formation of Second Light Emitting Layer) of Example D2.

### (Evaluation of Light Emitting Device)

EL emission was observed by applying a voltage to the light emitting device D8. The CIE chromaticity coordinate (x, y) at 1000 cd/m² was (0.49, 0.43).

After setting the current value so that the initial luminance of the light emitting device D8 was 6000 cd/m², the light emitting device D8 was driven at a constant current, and the time until the luminance reached 80% of the initial luminance was measured to be 10.3 hours. The results are shown in Table 4.

### <Example D9> Fabrication and Evaluation of Light Emitting Device D9

A light emitting device D9 was fabricated in the same manner as in Example D3, except that "polymer compound HTL-2" was used in place of "polymer compound HTL-1" in the (Formation of Second Light Emitting Layer) of Example D3.

### (Evaluation of Light Emitting Device)

EL emission was observed by applying a voltage to the light emitting device D9. The CIE chromaticity coordinate (x, y) at 1000 cd/m² was (0.49, 0.42).

After setting the current value so that the initial luminance of the light emitting device D9 was 6000 cd/m², the light emitting device D9 was driven at a constant current, and the time until the luminance reached 80% of the initial luminance was measured to be 4.5 hours. The results are shown in Table 4.

### <Example D10> Fabrication and Evaluation of Light Emitting Device D10

A light emitting device D10 was fabricated in the same manner as in Example D4, except that "polymer compound HTL-2" was used in place of "polymer compound HTL-1" in the (Formation of Second Light Emitting Layer) of Example D4.

### (Evaluation of Light Emitting Device)

EL emission was observed by applying a voltage to the light emitting device D10. The CIE chromaticity coordinate (x, y) at 1000 cd/m² was (0.50, 0.42).

After setting the current value so that the initial luminance of the light emitting device D10 was 6000 cd/m², the light emitting device D10 was driven at a constant current, and the time until the luminance reached 80% of the initial luminance was measured to be 14.8 hours. The results are shown in Table 4.

### <Example D11> Fabrication and Evaluation of Light Emitting Device D11

A light emitting device D11 was fabricated in the same manner as in Example D5, except that "polymer compound HTL-2" was used in place of "polymer compound HTL-1" in the (Formation of Second Light Emitting Layer) of Example D5.

### (Evaluation of Light Emitting Device)

EL emission was observed by applying a voltage to the light emitting device D11. The CIE chromaticity coordinate (x, y) at 1000 cd/m² was (0.47, 0.42).

After setting the current value so that the initial luminance of the light emitting device D11 was 6000 cd/m², the light emitting device D11 was driven at a constant current, and the time until the luminance reached 80% of the initial luminance was measured to be 19.9 hours. The results are shown in Table 4.

### <Example D12> Fabrication and Evaluation of Light Emitting Device D12

A light emitting device D12 was fabricated in the same manner as in Example D6, except that "polymer compound HTL-2" was used in place of "polymer compound HTL-1" in the (Formation of Second Light Emitting Layer) of Example D6.

### (Evaluation of Light Emitting Device)

EL emission was observed by applying a voltage to the light emitting device D12. The CIE chromaticity coordinate (x, y) at 1000 cd/m² was (0.50, 0.43).

After setting the current value so that the initial luminance of the light emitting device D12 was 6000 cd/m², the light emitting device D12 was driven at a constant current, and the time until the luminance reached 80% of the initial luminance was measured to be 11.8 hours. The results are shown in Table 4.

### <Example D13> Fabrication and Evaluation of Light Emitting Device D13

A light emitting device D13 was fabricated in the same manner as in Example D1, except that "a compound HM-1, a metal complex MC10, and a metal complex GM1 (compound HM-1/metal complex MC10/metal complex GM1=74% by mass/25% by mass/1% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1, and that "polymer compound HTL-2" was used in place of "polymer compound HTL-1" in the (Formation of Second Light Emitting Layer) of Example D1.

### (Evaluation of Light Emitting Device)

EL emission was observed by applying a voltage to the light emitting device D13. The CIE chromaticity coordinate (x, y) at 1000 cd/m² was (0.53, 0.45).

After setting the current value so that the initial luminance of the light emitting device D13 was 6000 cd/m², the light emitting device D13 was driven at a constant current, and the time until the luminance reached 80% of the initial luminance was measured to be 3.5 hours. The results are shown in Table 4.

### <Comparative Example CD3> Fabrication and Evaluation of Light Emitting Device CD3

A light emitting device CD3 was fabricated in the same manner as in Comparative Example CD1, except that "polymer compound HTL-2" was used in place of "polymer compound HTL-1" in the (Formation of Second Light Emitting Layer) of Comparative Example CD1.

### (Evaluation of Light Emitting Device)

EL emission was observed by applying a voltage to the light emitting device CD3. The CIE chromaticity coordinate (x, y) at 1000 cd/m² was (0.48, 0.43).

After setting the current value so that the initial luminance of the light emitting device CD3 was 6000 cd/m², the light emitting device CD3 was driven at a constant current, and the time until the luminance reached 80% of the initial luminance was measured to be 0.5 hours. The results are shown in Table 4.

### <Comparative Example CD4> Fabrication and Evaluation of Light Emitting Device CD4

A light emitting device CD4 was fabricated in the same manner as in Comparative Example CD2, except that "polymer compound HTL-2" was used in place of "polymer compound HTL-1" in the (Formation of Second Light Emitting Layer) of Comparative Example CD2.

### (Evaluation of Light Emitting Device)

EL emission was observed by applying a voltage to the light emitting device CD4. The CIE chromaticity coordinate (x, y) at 1000 cd/m² was (0.44, 0.44).

After setting the current value so that the initial luminance of the light emitting device CD3 was 6000 cd/m², the light emitting device CD3 was driven at a constant current, and the time until the luminance reached 80% of the initial luminance was measured to be 0.5 hours. The results are shown in Table 4.

**[Table 4]**

| | Light Emitting Device | Formation of Second Light Emitting Layer | Formation of First Light Emitting Layer | | Luminance Lifetime (time) |
|---|---|---|---|---|---|
| | | Material | Material | Material Ratio (% by mass) | |
| Example D7 | D7 | HTL-2 | HM-1/MC1/GM1 | 74/25/1 | 7.9 |
| Example D8 | D8 | HTL-2 | HM-1/MC2/GM1 | 74/25/1 | 10.3 |
| Example D9 | D9 | HTL-2 | HM-1/MC5/GM1 | 74/25/1 | 4.5 |
| Example D10 | D10 | HTL-2 | HM-1/MC7/GM1 | 74/25/1 | 14.8 |
| Example D11 | D11 | HTL-2 | HM-1/MC8/GM1 | 74/25/1 | 19.9 |
| Example D12 | D12 | HTL-2 | HM-1/MC9/GM1 | 74/25/1 | 11.8 |
| Example D13 | D13 | HTL-2 | HM-1/MC10/GM1 | 74/25/1 | 3.5 |
| Comparative Example CD3 | CD3 | HTL-2 | HM-1/MC3/GM1 | 74/25/1 | 0.5 |
| Comparative Example CD4 | CD4 | HTL-2 | HM-1/MC6/GM1 | 74/25/1 | 0.5 |

### <Example D14> Fabrication and Evaluation of Light Emitting Device D14

A light emitting device D14 was fabricated in the same manner as in Example D8.

After setting the current value so that the initial luminance of the light emitting device D14 was 400 cd/m², the light emitting device D14 was driven at a constant current, and the time until the luminance reached 85% of the initial luminance was measured to be 197.8 hours.

### <Comparative Example CD5> Fabrication and Evaluation of Light Emitting Device CD5

### (Formation of Anode and Hole Injection Layer)

An ITO film with a thickness of 45 nm was attached to a glass substrate by a sputtering method to form an anode. On the anode, a polythiophene-sulfonic acid type hole injection material AQ-1200 (manufactured by Plextronics) was spin-coated to form a film with a thickness of 35 nm, and the film was heated on a hot plate at 170°C for 15 minutes under an air atmosphere to form a hole injection layer.

### (Formation of Hole Transporting Layer)

A polymer compound HTL-3 was dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere to form a hole transporting layer.

### (Formation of First Light Emitting Layer)

A compound HM-1, a metal complex MC2, a metal complex GM1, and a metal complex RM3 (compound HM-1/metal complex MC2/metal complex GM1/metal complex RM3=73.9% by mass/25% by mass/1% by mass/0.1% by mass) were dissolved at a concentration of 2% by mass in toluene. The resultant toluene solution was spin-coated on the hole transporting layer to form a film with a thickness of 75 nm, and the film was heated at 130°C for 10 minutes under a nitrogen gas atmosphere to form a first light emitting layer.

### (Formation of Electron Transporting Layer)

A polymer compound ETL-1 was dissolved at a concentration of 0.25% by mass in 2,2,3,3,4,4,5,5-octafluoro-1-pentanol. The resultant 2,2,3,3,4,4,5,5-octafluoro-1-pentanol solution was spin-coated on the first light emitting layer to form a film with a thickness of 10 nm, and the film was heated at 130°C for 10 minutes under a nitrogen gas atmosphere to form an electron transporting layer.

### (Formation of Cathode)

The substrate on which the electron transporting layer was formed was placed in a vapor deposition machine, and the pressure was reduced to 1.0 × 10⁻⁴ Pa or less. Then, as a cathode, sodium fluoride was vapor-deposited to a thickness of about 4 nm on the electron transporting layer, and then aluminum was vapor-deposited to a thickness of about 80 nm on the sodium fluoride layer. After the vapor deposition, sealing was performed using a glass substrate to fabricate a light emitting device CD5.

### (Evaluation of Light Emitting Device)

EL emission was observed by applying a voltage to the light emitting device CD5. The CIE chromaticity coordinate (x, y) at 1000 cd/m² was (0.34, 0.46).

After setting the current value so that the initial luminance of the light emitting device CD5 was 400 cd/m², the light emitting device CD5 was driven at a constant current, and the time until the luminance reached 85% of the initial luminance was measured to be 19.9 hours. The results are shown in Table 5.

**[Table 5]**

| | Light Emitting Device | Layer Formation | | Formation of First Light Emitting Layer | | Luminance Lifetime (time) |
|---|---|---|---|---|---|---|
| | | Layer | Material | Material | Material Ratio (% by mass) | |
| Example D14 | D14 | Second light emitting layer | HTL-2 | HM-1/MC2/GM1 | 74/25/1 | 197.8 |
| Comparative Example CD5 | CD5 | Hole transporting layer | HTL-3 | HM-1/MC2/GM1/RM3 | 73.9/25/1/0.1 | 19.9 |

### <Example D15> Fabrication and Evaluation of Light Emitting Device D15

A light emitting device D15 was fabricated in the same manner as in Example D4, except that "polymer compound HTL-4" was used in place of "polymer compound HTL-1" in the (Formation of Second Light Emitting Layer) of Example D4.

### (Evaluation of Light Emitting Device)

EL emission was observed by applying a voltage to the light emitting device D15. The CIE chromaticity coordinate (x, y) at 6000 cd/m² was (0.58, 0.40).

After setting the current value so that the initial luminance of the light emitting device D15 was 6000 cd/m², the light emitting device D15 was driven at a constant current, and the time until the luminance reached 70% of the initial luminance was measured to be 12.4 hours. The results are shown in Table 6.

### <Example D16> Fabrication and Evaluation of Light Emitting Device D16

A light emitting device D16 was fabricated in the same manner as in Example D5, except that "polymer compound HTL-4" was used in place of "polymer compound HTL-1" in the (Formation of Second Light Emitting Layer) of Example D5.

### (Evaluation of Light Emitting Device)

EL emission was observed by applying a voltage to the light emitting device D16. The CIE chromaticity coordinate (x, y) at 6000 cd/m² was (0.53, 0.41).

After setting the current value so that the initial luminance of the light emitting device D16 was 6000 cd/m², the light emitting device D16 was driven at a constant current, and the time until the luminance reached 70% of the initial luminance was measured to be 44.9 hours. The results are shown in Table 6.

### <Example D17> Fabrication and Evaluation of Light Emitting Device D17

A light emitting device D17 was fabricated in the same manner as in Example D6, except that "polymer compound HTL-4" was used in place of "polymer compound HTL-1" in the (Formation of Second Light Emitting Layer) of Example D6.

### (Evaluation of Light Emitting Device)

EL emission was observed by applying a voltage to the light emitting device D17. The CIE chromaticity coordinate (x, y) at 6000 cd/m² was (0.53, 0.42).

After setting the current value so that the initial luminance of the light emitting device D17 was 6000 cd/m², the light emitting device D17 was driven at a constant current, and the time until the luminance reached 70% of the initial luminance was measured to be 20.2 hours. The results are shown in Table 6.

### <Example D18> Fabrication and Evaluation of Light Emitting Device D18

A light emitting device D18 was fabricated in the same manner as in Example D4, except that "polymer compound HTL-5 and a metal complex RM3 (polymer compound HTL-5/metal complex RM3=65% by mass/35% by mass)" was used in place of "polymer compound HTL-1" in the (Formation of Second Light Emitting Layer) of Example D4.

### (Evaluation of Light Emitting Device)

EL emission was observed by applying a voltage to the light emitting device D18. The CIE chromaticity coordinate (x, y) at 6000 cd/m² was (0.38, 0.44).

After setting the current value so that the initial luminance of the light emitting device D18 was 6000 cd/m², the light emitting device D18 was driven at a constant current, and the time until the luminance reached 70% of the initial luminance was measured to be 13.3 hours. The results are shown in Table 6.

### <Example D19> Fabrication and Evaluation of Light Emitting Device D19

A light emitting device D19 was fabricated in the same manner as in Example D1, except that "a compound HM-1 and a metal complex MC7 (compound HM-1/metal complex MC7=75% by mass/25% by mass)" was used in place of "a compound HM-1, a metal complex MC1, and a metal complex GM1 (compound HM-1/metal complex MC1/metal complex GM1=74% by mass/25% by mass/1% by mass)" in the (Formation of First Light Emitting Layer) of Example D1, and that "polymer compound HTL-4" was used in place of "polymer compound HTL-1" in the (Formation of Second Light Emitting Layer) of Example D1.

### (Evaluation of Light Emitting Device)

EL emission was observed by applying a voltage to the light emitting device D19. The CIE chromaticity coordinate (x, y) at 6000 cd/m² was (0.58, 0.39).

After setting the current value so that the initial luminance of the light emitting device D19 was 6000 cd/m², the light emitting device D19 was driven at a constant current, and the time until the luminance reached 70% of the initial luminance was measured to be 8.6 hours. The results are shown in Table 6.

### <Example D20> Fabrication and Evaluation of Light Emitting Device D20

A light emitting device D20 was fabricated in the same manner as in Example D19, except that "polymer compound HTL-5 and a metal complex RM3 (polymer compound HTL-5/metal complex RM3=65% by mass/35% by mass)" was used in place of "polymer compound HTL-4" in the (Formation of Second Light Emitting Layer) of Example D19.

### (Evaluation of Light Emitting Device)

EL emission was observed by applying a voltage to the light emitting device D20. The CIE chromaticity coordinate (x, y) at 6000 cd/m² was (0.34, 0.35).

After setting the current value so that the initial luminance of the light emitting device D20 was 6000 cd/m², the light emitting device D20 was driven at a constant current, and the time until the luminance reached 70% of the initial luminance was measured to be 7.6 hours. The results are shown in Table 6.

### <Comparative Example CD6> Fabrication and Evaluation of Light Emitting Device CD6

A light emitting device CD6 was fabricated in the same manner as in Comparative Example CD5, except that "a compound HM-1, a metal complex MC7, and a metal complex RM3 (compound HM-1/metal complex MC7/metal complex RM3=74% by mass/25% by mass/1% by mass)" was used in place of "a compound HM-1, a metal complex MC2, a metal complex GM1, and a metal complex RM3 (compound HM-1/metal complex MC2/metal complex GM1/metal complex RM3=73.9% by mass/25% by mass/1% by mass/0.1% by mass)" in the (Formation of First Light Emitting Layer) of Comparative Example CD5, and that "polymer compound HTL-5" was used in place of "polymer compound HTL-3" in the (Formation of Hole Transporting Layer) of Comparative Example CD5.

### (Evaluation of Light Emitting Device)

EL emission was observed by applying a voltage to the light emitting device CD6. The CIE chromaticity coordinate (x, y) at 6000 cd/m² was (0.52, 0.40).

After setting the current value so that the initial luminance of the light emitting device CD6 was 6000 cd/m², the light emitting device CD6 was driven at a constant current, and the time until the luminance reached 70% of the initial luminance was measured to be 3.8 hours. The results are shown in Table 6.

**[Table 6]**

| | Light Emitting Device | Layer Formation | | | Formation of First Light Emitting Layer | | Luminance Lifetime (time) |
|---|---|---|---|---|---|---|---|
| | | Layer | Material | Material Ratio (% by mass) | Material | Material Ratio (% by mass) | |
| Example D15 | D15 | Second light emitting layer | HTL-4 | 100 | HM-1/MC7/GM1 | 74/25/1 | 12.4 |
| Example D16 | D16 | Second light emitting layer | HTL-4 | 100 | HM-1/MC8/GM1 | 74/25/1 | 44.9 |
| Example D17 | D17 | Second light emitting layer | HTL-4 | 100 | HM-1/MC9/GM1 | 74/25/1 | 20.2 |
| Example D18 | D18 | Second light emitting layer | HTL-5/RM3 | 65/35 | HM-1/MC7/GM1 | 74/25/1 | 13.3 |
| Example D19 | D19 | Second light emitting layer | HTL-4 | 100 | HM-1/MC7 | 75/25 | 8.6 |
| Example D20 | D20 | Second light emitting layer | HTL-5/RM3 | 65/35 | HM-1/MC7 | 75/25 | 7.6 |
| Comparative Example CD6 | CD6 | Hole transporting layer | HTL-5 | 100 | HM-1/MC7/RM3 | 74/25/1 | 3.8 |

### Industrial Applicability

According to the present invention, a light emitting device which shows an excellent luminance lifetime can be provided.

## Claims

1. A light emitting device, comprising:
an anode;
a cathode;
a first light emitting layer provided between the anode and the cathode; and
a second light emitting layer provided between the anode and the cathode,
wherein the first light emitting layer comprises a metal complex represented by formula (1) 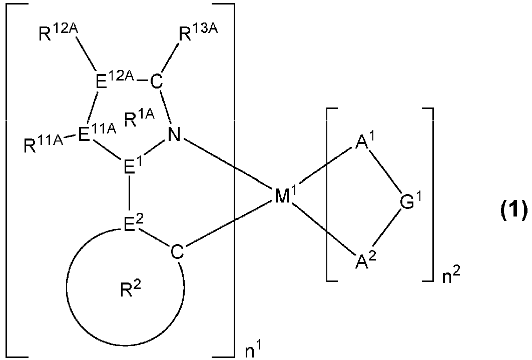 wherein
M¹ represents a rhodium atom, a palladium atom, an iridium atom or a platinum atom,
n¹ represents an integer of 1 or more, n² represents an integer of 0 or more, and n¹ + n² is 2 or 3,
when M¹ is a rhodium atom or an iridium atom, n¹ + n² is 3, and when M¹ is a palladium atom or a platinum atom, n¹ + n² is 2,
the ring R^{1A} represents a triazole ring or a diazole ring constituted of a nitrogen atom, E¹, E^{11A}, E^{12A}, and a carbon atom,
the ring R² represents an aromatic hydrocarbon ring or an aromatic heterocyclic ring, and these rings each may have a substituent; when there are a plurality of the substituents, they may be the same or different and may be bonded to each other to form a ring together with the atoms to which they are bonded; and when there are a plurality of the ring R², they may be the same or different,
E¹ represents a carbon atom, and E², E^{11A}, and E^{12A} each independently represent a nitrogen atom or a carbon atom; when there are a plurality of E², E^{11A} and E^{12A}, they may be the same or different at each occurrence,
R^{11A} and R^{12A} each independently represent a hydrogen atom, an alkyl group, a cycloalkyl group, an alkoxy group, a cycloalkoxy group, an aryl group, an aryloxy group, a monovalent heterocyclic group, a substituted amino group, or a halogen atom, and these groups each may have a substituent; when there are a plurality of R^{11A} and R^{12A}, they may be the same or different at each occurrence; R^{11A} and R^{12A} may be bonded to each other to form a ring together with the atoms to which they are bonded; and R^{11A} and an optional substituent of the ring R² may be bonded to each other to form a ring together with the atoms to which they are bonded,
when E^{11A} is a nitrogen atom, R^{11A} may be present or absent, and when E^{12A} is a nitrogen atom, R^{12A} may be present or absent,
R^{13A} represents an aryl group, a monovalent heterocyclic group, or a substituted amino group, and these groups each may have a substituent; when there are a plurality of R^{13A}, they may be the same or different; and R^{12A} and R^{13A} may be bonded to each other to form a ring together with the atoms to which they are bonded, and
A¹-G¹-A² represents an anionic bidentate ligand, A¹ and A² each independently represent a carbon atom, an oxygen atom or a nitrogen atom, and these atoms each may be atoms constituting a ring; G¹ represents a single bond or an atomic group constituting the bidentate ligand together with A¹ and A²; and when there are a plurality of A¹-G¹-A², they may be the same or different).

2. The light emitting device according to claim 1, wherein the second light emitting layer comprises a metal complex represented by formula (2): 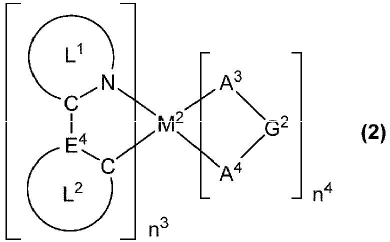 wherein
M² represents a rhodium atom, a palladium atom, an iridium atom or a platinum atom,
n³ represents an integer of 1 or more, n⁴ represents an integer of 0 or more, and n³ + n⁴ is 2 or 3; when M² is a rhodium atom or an iridium atom, n³ + n⁴ is 3; and when M² is a palladium atom or a platinum atom, n³ + n⁴ is 2,
E⁴ represents a carbon atom or a nitrogen atom,
the ring L¹ represents a 6-membered aromatic heterocyclic ring, which may have a substituent; when there are a plurality of the substituents, they may be the same or different and may be bonded to each other to form a ring together with the atoms to which they are bonded; and when there are a plurality of the ring L¹, they may be the same or different,
the ring L² represents an aromatic hydrocarbon ring or an aromatic heterocyclic ring, and these rings each may have a substituent; when there are a plurality of the substituents, they may be the same or different and may be bonded to each other to form a ring together with the atoms to which they are bonded; and when there are a plurality of the ring L², they may be the same or different,
an optional substituent of the ring L¹ and an optional substituent of the ring L² may be bonded to each other to form a ring together with the atoms to which they are bonded,
at least one of the ring L¹ and the ring L² has a substituent, and
A³-G²-A⁴ represents an anionic bidentate ligand, A³ and A⁴ each independently represent a carbon atom, an oxygen atom or a nitrogen atom, and these atoms each may be atoms constituting a ring; G² represents a single bond or an atomic group constituting the bidentate ligand together with A³ and A⁴; and when there are a plurality of A³-G²-A⁴, they may be the same or different).

3. The light emitting device according to claim 1, wherein the second light emitting layer comprises at least one selected from the group consisting of:
a polymer compound comprising a constitutional unit having a group formed by removing from a metal complex represented by formula (2) one or more hydrogen atoms directly bonded to a carbon atom or a heteroatom constituting the metal complex; and
a crosslinked product of the polymer compound 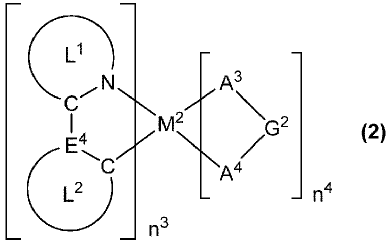 wherein
M² represents a rhodium atom, a palladium atom, an iridium atom or a platinum atom,
n³ represents an integer of 1 or more, n⁴ represents an integer of 0 or more, and n³ + n⁴ is 2 or 3; when M² is a rhodium atom or an iridium atom, n³ + n⁴ is 3; and when M² is a palladium atom or a platinum atom, n³ + n⁴ is 2,
E⁴ represents a carbon atom or a nitrogen atom,
the ring L¹ represents a 6-membered aromatic heterocyclic ring, which may have a substituent; when there are a plurality of the substituents, they may be the same or different and may be bonded to each other to form a ring together with the atoms to which they are bonded; and when there are a plurality of the ring L¹, they may be the same or different,
the ring L² represents an aromatic hydrocarbon ring or an aromatic heterocyclic ring, and these rings each may have a substituent; when there are a plurality of the substituents, they may be the same or different and may be bonded to each other to form a ring together with the atoms to which they are bonded; and when there are a plurality of the ring L², they may be the same or different,
an optional substituent of the ring L¹ and an optional substituent of the ring L² may be bonded to each other to form a ring together with the atoms to which they are bonded, and
A³-G²-A⁴ represents an anionic bidentate ligand, A³ and A⁴ each independently represent a carbon atom, an oxygen atom or a nitrogen atom, and these atoms each may be atoms constituting a ring; G² represents a single bond or an atomic group constituting the bidentate ligand together with A³ and A⁴; and when there are a plurality of A³-G²-A⁴, they may be the same or different.

4. The light emitting device according to claim 3, wherein the constitutional unit is a constitutional unit represented by formula (1B), a constitutional unit represented by formula (2B), a constitutional unit represented by formula (3B), or a constitutional unit represented by formula (4B): 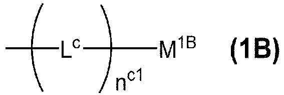 wherein
M^{1B} represents a group formed by removing from the metal complex represented by the formula (2) one hydrogen atom directly bonded to a carbon atom or a heteroatom constituting the metal complex,
L^{C} represents an oxygen atom, a sulfur atom, -N(R^{A})-, -C(R^{B})₂-, -C(R^{B})=C(R^{B})-, -C≡C-, an arylene group, or a divalent heterocyclic group, and these groups each may have a substituent; R^{A} represents a hydrogen atom, an alkyl group, a cycloalkyl group, an aryl group, or a monovalent heterocyclic group, and these groups each may have a substituent; R^{B} represents a hydrogen atom, an alkyl group, a cycloalkyl group, an alkoxy group, a cycloalkoxy group, an aryl group, or a monovalent heterocyclic group, and these groups each may have a substituent; the plurality of R^{B} may be the same or different and may be bonded to each other to form a ring together with the carbon atom to which they are bonded; and when there are a plurality of L^{C}, they may be the same or different, and
n^{c1} represents an integer of 0 or more; 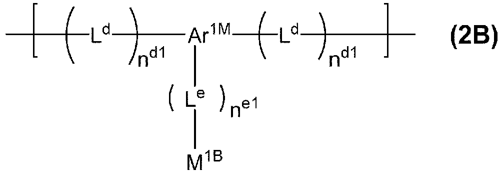
wherein
M^{1B} represents the same meaning as described above,
L^{d} and L^{e} each independently represent an oxygen atom, a sulfur atom, -N(R^{A})-, -C(R^{B})₂-, -C(R^{B})=C(R^{B})-, -C≡C-, an arylene group, or a divalent heterocyclic group, and these groups each may have a substituent; R^{A} and R^{B} represent the same meaning as described above; and when there are a plurality of L^{d} and L^{e}, they may be the same or different at each occurrence,
n^{d1} and n^{e1} each independently represent an integer of 0 or more, and the plurality of n^{d1} may be the same or different, and
Ar^{1M} represents an aromatic hydrocarbon group or a heterocyclic group, and these groups each may have a substituent; 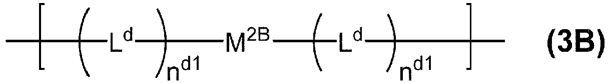
wherein
L^{d} and n^{d1} represent the same meaning as described above, and
M^{2B} represents a group obtained by removing from the metal complex represented by the formula (2) two hydrogen atoms directly bonded to a carbon atom or a heteroatom constituting the metal complex. 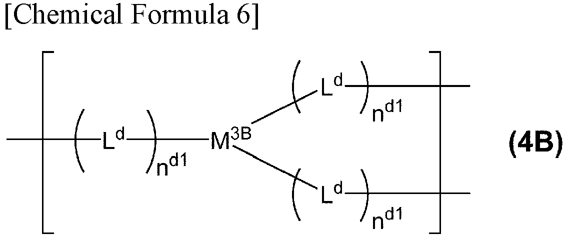
(wherein,
L^{d} and n^{d1} represent the same meaning as described above, and
M^{3B} represents a group obtained by removing from the metal complex represented by the formula (2) three hydrogen atoms directly bonded to a carbon atom or a heteroatom constituting the metal complex).

5. The light emitting device according to any one of claims 2 to 4, wherein the metal complex represented by formula (2) is a metal complex represented by formula (2-B), preferably a metal complex represented by formula (2-B1), a metal complex represented by formula (2-B2), a metal complex represented by formula (2-B3), a metal complex represented by formula (2-B4), or a metal complex represented by formula (2-B5): 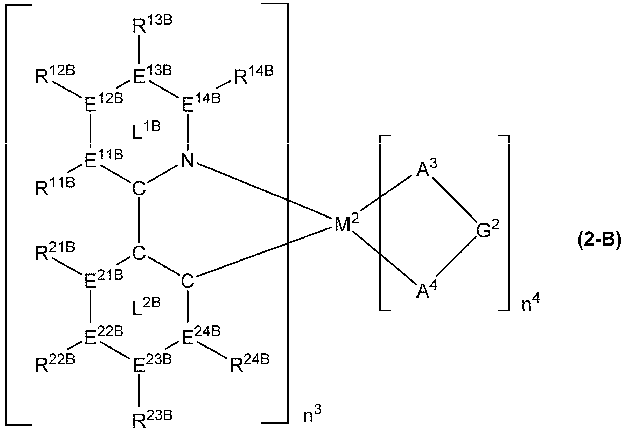 wherein
M², n³, n⁴, and A³-G²-A⁴ represent the same meaning as described above,
E^{11B}, E^{12B}, E^{13B}, E^{14B}, E^{21B}, E^{22B}, E^{23B}, and E^{24B} each independently represent a nitrogen atom or a carbon atom; when there are a plurality of E^{11B}, E^{12B}, E^{13B}, E^{14B}, E^{21B}, E^{22B}, E^{23B}, and E^{24B}, they may be the same or different at each occurrence; when E^{11B} is a nitrogen atom, R^{11B} is absent; when E^{12B} is a nitrogen atom, R^{12B} is absent, when E^{13B} is a nitrogen atom, R^{13B} is absent; when E^{14B} is a nitrogen atom, R^{14B} is absent; when E^{21B} is a nitrogen atom, R^{21B} is absent; when E^{22B} is a nitrogen atom, R^{22B} is absent; when E^{23B} is a nitrogen atom, R^{23B} is absent; and when E^{24B} is a nitrogen atom, R^{24B} is absent,
R^{11B}, R^{12B}, R^{13B}, R^{14B}, R^{21B}, R^{22B}, R^{23B} , and R^{24B} each independently represent a hydrogen atom, an alkyl group, a cycloalkyl group, an alkoxy group, a cycloalkoxy group, an aryl group, an aryloxy group, a monovalent heterocyclic ring, a substituted amino group, or a halogen atom, and these groups each may have a substituent; when there are a plurality of R^{11B}, R^{12B}, R^{13B}, R^{14B}, R^{21B}, R^{22B}, R^{23B}, and R^{24B}, they may be the same or different at each occurrence; and R^{11B} and R^{12B}, R^{12B} and R^{13B} , R^{13B} and R^{14B}, R^{11B} and R^{21B}, R^{21B} and R^{22B}, R^{22B} and R^{23B}, and R^{23B} and R^{24B} each may be bonded to each other to form a ring together with the atoms to which they are bonded,
the ring L^{1B} represents a pyridine ring or a pyrimidine ring constituted of a nitrogen atom, a carbon atom, E^{11B}, E^{12B}, E^{13B} and E^{14B}, and
the ring L^{2B} represents a benzene ring, a pyridine ring, or a pyrimidine ring constituted of two carbon atoms, E^{21B}, E^{22B}, E^{23B}, and E^{24B}; 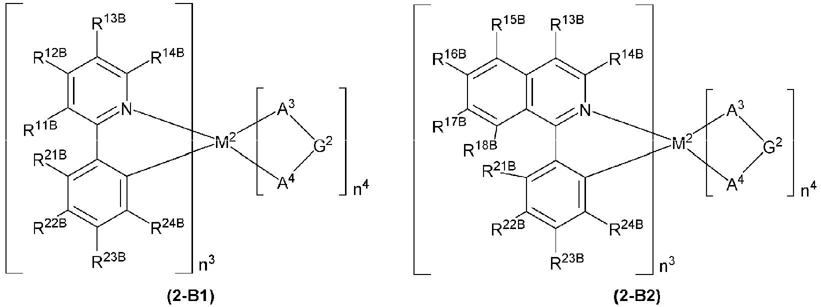 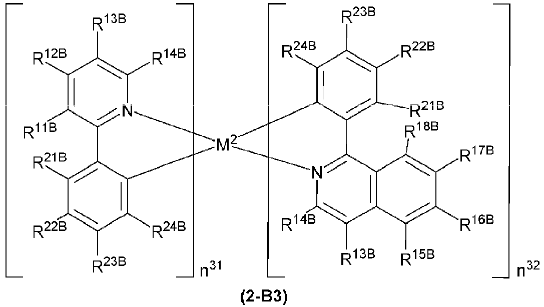 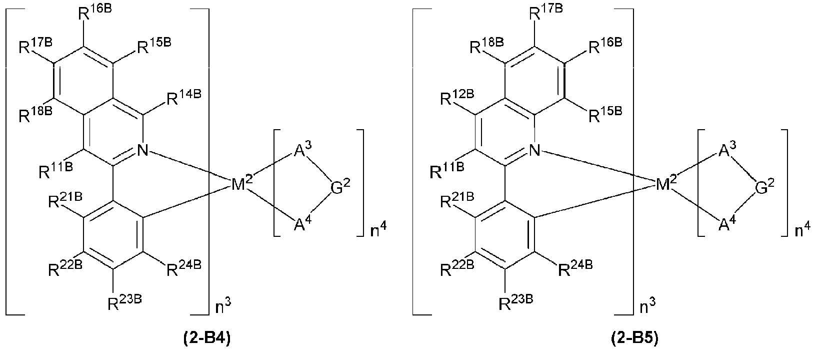
wherein
M², n³, n⁴, A³-G²-A⁴, R^{11B}, R^{12B}, R^{13B}, R^{14B}, R^{21B}, R^{22B}, R^{23B}, and R^{24B} represent the same meanings as described above,
n³¹ and n³² each independently represent an integer of 1 or more, and n³¹ + n³² is 2 or 3; when M² is a rhodium atom or an iridium atom, n³¹ + n³² is 3; and when M² is a palladium atom or a platinum atom, n³¹ + n³² is 2, and
R^{15B}, R^{16B}, R^{17B}, and R^{18B} each independently represent a hydrogen atom, an alkyl group, a cycloalkyl group, an alkoxy group, a cycloalkoxy group, an aryl group, an aryloxy group, a monovalent heterocyclic group, a substituted amino group, or a halogen atom, and these groups each may have a substituent; when there are a plurality of R^{15B}, R^{16B}, R^{17B}, and R^{18B}, they may be the same or different at each occurrence; R^{15B} and R^{16B}, R^{16B} and R^{17B}, and R^{17B} and R^{18B} each may be bonded to each other to form a ring together with the atoms to which they are bonded.

6. The light emitting device according to any one of claims 1 to 5, wherein the metal complex represented by formula (1) is a metal complex represented by formula (1-A): 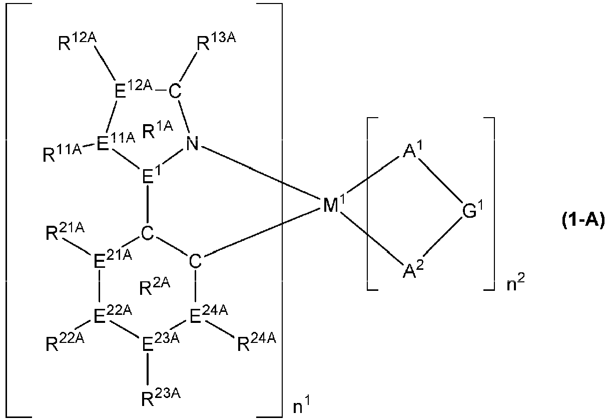 wherein
M¹, n¹, n², ring R^{1A}, E¹, E^{11A} E^{12A}, R^{11A} R^{12A}, R^{13A}, and A¹-G¹-A² represent the same meanings as described above,
the ring R^{2A} represents a benzene ring, a pyridine ring, or a pyrimidine ring constituted of two carbon atoms, E^{21A}, E^{22A}, E^{23A}, and E^{24A},
E^{21A} , E^{22A}, E^{23A}, and E^{24A}, each independently represent a nitrogen atom or a carbon atom; when there are a plurality of E^{21A}, E^{22A}, E^{23A}, and E^{24A}, they may be the same or different at each occurrence; when E^{21A} is a nitrogen atom, R^{21A} is absent; when E^{22A} is a nitrogen atom, R^{22A} is absent; when E^{23A} is a nitrogen atom, R^{23A} is absent; and when E^{24A}, is a nitrogen atom, R^{24A} is absent, and
R^{21A}, R^{22A}, R^{23A}, and R^{24A} each represent a hydrogen atom, an alkyl group, a cycloalkyl group, an alkoxy group, a cycloalkoxy group, an aryl group, an aryloxy group, a monovalent heterocyclic group, a substituted amino group, or a halogen atom, and these groups each may have a substituent; when there are a plurality of R^{21A}, R^{22A}, R^{23A}, and R^{24A}, they may be the same or different at each occurrence; R^{21A} and R^{22A} may be bonded to each other to form a ring together with the atoms to which they are bonded; R^{22A} and R^{23A} may be bonded to each other to form a ring together with the atoms to which they are bonded; R^{23A} and R^{24A} may be bonded to each other to form a ring together with the atoms to which they are bonded; and R^{11A} and R^{21A} may be bonded to each other to form a ring together with the atoms to which they are bonded.

7. The light emitting device according to claim 6, wherein the metal complex represented by formula (1-A) is a metal complex represented by formula (1-A1), a metal complex represented by formula (1-A2), a metal complex represented by formula (1-A3), or a metal complex represented by formula (1-A4): 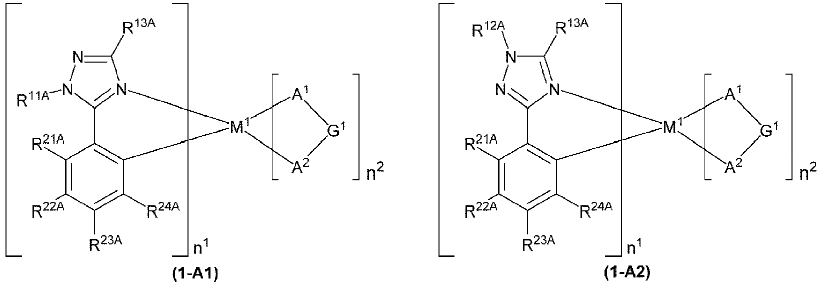 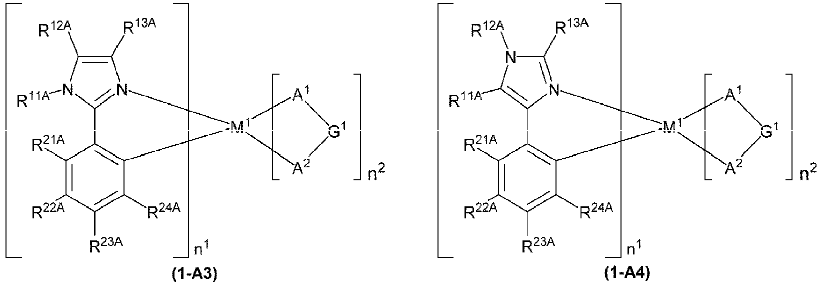 wherein M¹, n¹, n², R^{11A}, R^{12A}, R^{13A}, R^{21A}, R^{22A}, R^{23A}, R^{24A}, and A¹-G¹-A² represent the same meanings as described above.

8. The light emitting device according to any one of claims 1 to 7, wherein R^{13A} is an aryl group which may have a substituent.

9. The light emitting device according to any one of claims 1 to 8, wherein the first light emitting layer further comprises a compound represented by formula (H-1): 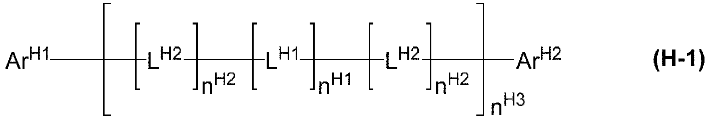 wherein
Ar^{H1} and Ar^{H2} each independently represent an aryl group or a monovalent heterocyclic group, and these groups each may have a substituent,
n^{H1} and n^{H2} each independently represent 0 or 1; when there are a plurality of n^{H1}, they may be the same or different; and the plurality of n^{H2} may be the same or different;
n^{H3} represents an integer of 0 or more,
L^{H1} represents an arylene group, a divalent heterocyclic group, or a group represented by -[C(R^{H11})₂]n^{H11_}, and these groups each may have a substituent; when there are a plurality of L^{H1}, they may be the same or different; n^{H11} represents an integer of 1 or more and 10 or less; R^{H11} represents a hydrogen atom, an alkyl group, a cycloalkyl group, an alkoxy group, a cycloalkoxy group, an aryl group, or a monovalent heterocyclic group, and these groups each may have a substituent; and the plurality of R^{H11} may be the same or different and may be bonded to each other to form a ring together with the carbon atom to which they are bonded, and
L^{H2} represents a group represented by -N(-L^{H21}-R^{H21})-; when there are a plurality of L^{H2}, they may be the same or different; L^{H21} represents a single bond, an arylene group, or a divalent heterocyclic group, and these groups each may have a substituent; R^{H21} represents a hydrogen atom, an alkyl group, a cycloalkyl group, an aryl group, or a monovalent heterocyclic group, and these groups each may have a substituent.

10. The light emitting device according to any one of claims 1 to 9, wherein the first light emitting layer and the second light emitting layer are adjacent to each other.

11. The light emitting device according to any one of claims 1 to 10, wherein the second light emitting layer is provided between the anode and the first light emitting layer.

12. The light emitting device according to claim 2, wherein at least one selected from the group consisting of the ring L¹ and the ring L² has as a substituent a group represented by formula (D-A), (D-B) or (D-C): 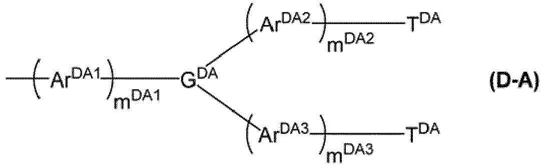 wherein
m^{DA1}, m^{DA2}, and m^{DA3} each independently represent an integer of 0 or more,
G^{DA} represents a nitrogen atom, an aromatic hydrocarbon group, or a heterocyclic group, and these groups each may have a substituent,
Ar^{DA1}, Ar^{DA2}, and Ar^{DA3} each independently represent an arylene group or a divalent heterocyclic group, and these groups each may have a substituent; and when there are a plurality of Ar^{DA1}, Ar^{DA2}, and Ar^{DA3}, they may be the same or different at each occurrence, and
T^{DA} represents an aryl group or a monovalent heterocyclic group, and these groups each may have a substituent; and the plurality of T^{DA} may be the same or different; 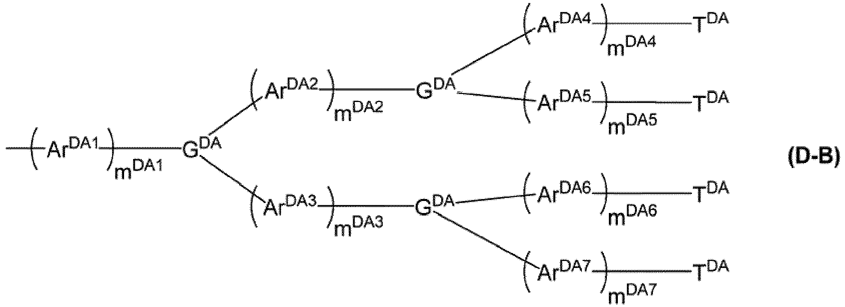
wherein
m^{DA1}, m^{DA2}, m^{DA3}, m^{DA4}, m^{DA5}, m^{DA6}, and m^{DA7} each independently represent an integer of 0 or more,
G^{DA} represents a nitrogen atom, an aromatic hydrocarbon group, or a heterocyclic group, and these groups each may have a substituent; the plurality of G^{DA} may be the same or different,
AR^{DA1}, Ar^{DA2}, Ar^{DA3}, Ar^{DA4}, Ar^{DA5}, Ar^{DA6}, and Ar^{DA7} each independently represent an arylene group or a divalent heterocyclic group, and these groups each may have a substituent; and when there are a plurality of Ar^{DA1}, Ar^{DA2}, Ar^{DA3}, Ar^{DA4}, Ar^{DA5}, Ar^{DA6}, and Ar^{DA7}, they may be the same or different at each occurrence, and
T^{DA} represents an aryl group or a monovalent heterocyclic group, and these groups each may have a substituent; the plurality of T^{DA} may be the same or different; 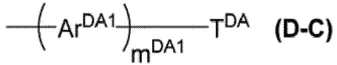
wherein
m^{DA1} represents an integer of 0 or more,
Ar^{DA1} represents an arylene group or a divalent heterocyclic group, and these groups each may have a substituent; and when there are a plurality of Ar^{DA1}, they may be the same or different, and
T^{DA} represents an aryl group or a monovalent heterocyclic group, and these groups each may have a substituent.

13. The light emitting device according to claim 3, wherein at least one selected from the group consisting of the ring L¹ and the ring L² has as a substituent a group represented by formula (D-A), (D-B) or (D-C): 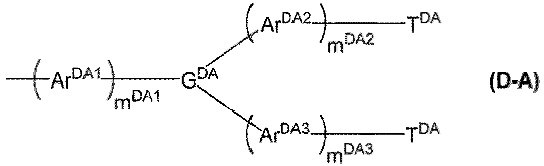 wherein
m^{DA1}, m^{DA2}, and m^{DA3} each independently represent an integer of 0 or more,
G^{DA} represents a nitrogen atom, an aromatic hydrocarbon group, or a heterocyclic group, and these groups each may have a substituent,
Ar^{DA1}, Ar^{DA2}, and Ar^{DA3} each independently represent an arylene group or a divalent heterocyclic group, and these groups each may have a substituent; and when there are a plurality of Ar^{DA1}, Ar^{DA2}, and Ar^{DA3}, they may be the same or different at each occurrence, and
T^{DA} represents an aryl group or a monovalent heterocyclic group, and these groups each may have a substituent; and the plurality of T^{DA} may be the same or different; 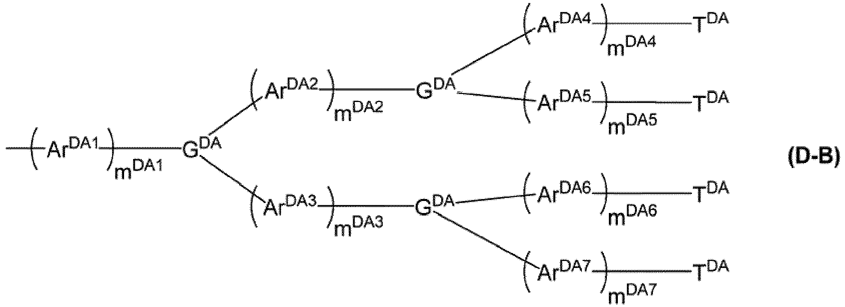
wherein
m^{DA1}, m^{DA2}, m^{DA3}, m^{DA4}, m^{DA5}, m^{DA6}, and m^{DA7} each independently represent an integer of 0 or more,
G^{DA} represents a nitrogen atom, an aromatic hydrocarbon group, or a heterocyclic group, and these groups each may have a substituent; the plurality of G^{DA} may be the same or different,
AR^{DA1}, Ar^{DA2}, Ar^{DA3}, Ar^{DA4}, Ar^{DA5}, Ar^{DA6}, and Ar^{DA7} each independently represent an arylene group or a divalent heterocyclic group, and these groups each may have a substituent; and when there are a plurality of Ar^{DA1}, Ar^{DA2}, Ar^{DA3}, Ar^{DA4}, Ar^{DA5}, Ar^{DA6}, and Ar^{DA7}, they may be the same or different at each occurrence, and
T^{DA} represents an aryl group or a monovalent heterocyclic group, and these groups each may have a substituent; the plurality of T^{DA} may be the same or different; 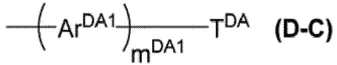
wherein
m^{DA1} represents an integer of 0 or more,
Ar^{DA1} represents an arylene group or a divalent heterocyclic group, and these groups each may have a substituent; and when there are a plurality of Ar^{DA1}, they may be the same or different, and
T^{DA} represents an aryl group or a monovalent heterocyclic group, and these groups each may have a substituent.

14. The light emitting device according to claim 5, wherein at least one selected from the group consisting of R^{11B}, R^{12B}, R^{13B}, R^{14B}, R^{21B}, R^{22B}, R^{23B}, and R^{24B} is a group represented by formula (D-A), (D-B) or (D-C): 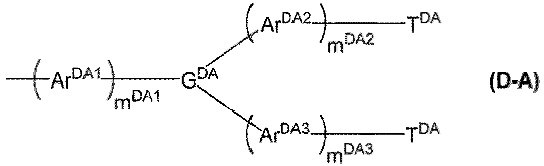 wherein
m^{DA1}, m^{DA2}, and m^{DA3} each independently represent an integer of 0 or more,
G^{DA} represents a nitrogen atom, an aromatic hydrocarbon group, or a heterocyclic group, and these groups each may have a substituent,
Ar^{DA1}, Ar^{DA2}, and Ar^{DA3} each independently represent an arylene group or a divalent heterocyclic group, and these groups each may have a substituent; and when there are a plurality of Ar^{DA1}, Ar^{DA2}, and Ar^{DA3}, they may be the same or different at each occurrence, and
T^{DA} represents an aryl group or a monovalent heterocyclic group, and these groups each may have a substituent; and the plurality of T^{DA} may be the same or different; 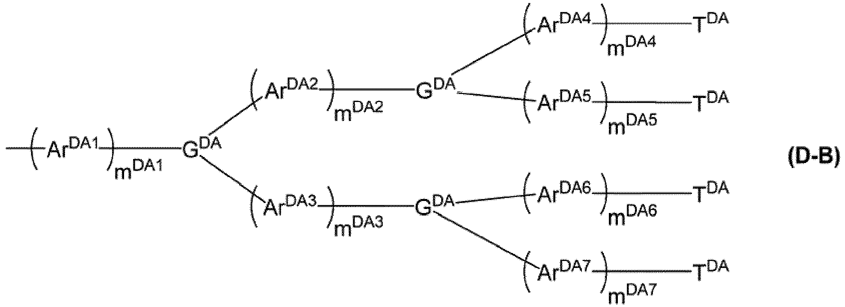
wherein
m^{DA1}, m^{DA2}, m^{DA3}, m^{DA4}, m^{DA5}, m^{DA6}, and m^{DA7} each independently represent an integer of 0 or more,
G^{DA} represents a nitrogen atom, an aromatic hydrocarbon group, or a heterocyclic group, and these groups each may have a substituent; the plurality of G^{DA} may be the same or different,
AR^{DA1}, Ar^{DA2}, Ar^{DA3}, Ar^{DA4}, Ar^{DA5}, Ar^{DA6}, and Ar^{DA7} each independently represent an arylene group or a divalent heterocyclic group, and these groups each may have a substituent; and when there are a plurality of Ar^{DA1}, Ar^{DA2}, Ar^{DA3}, Ar^{DA4}, Ar^{DA5}, Ar^{DA6}, and Ar^{DA7}, they may be the same or different at each occurrence, and
T^{DA} represents an aryl group or a monovalent heterocyclic group, and these groups each may have a substituent; the plurality of T^{DA} may be the same or different; 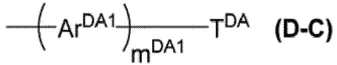
wherein
m^{DA1} represents an integer of 0 or more,
Ar^{DA1} represents an arylene group or a divalent heterocyclic group, and these groups each may have a substituent; and when there are a plurality of Ar^{DA1}, they may be the same or different, and
T^{DA} represents an aryl group or a monovalent heterocyclic group, and these groups each may have a substituent.

## Patentansprüche

1. Lichtemittierende Vorrichtung, die umfasst:
eine Anode;
eine Kathode;
eine erste lichtemittierende Schicht zwischen der Anode und der Kathode; und
eine zweite lichtemittierende Schicht zwischen der Anode und der Kathode,
wobei die erste lichtemittierende Schicht einen Metallkomplex umfasst, der durch Formel (1) 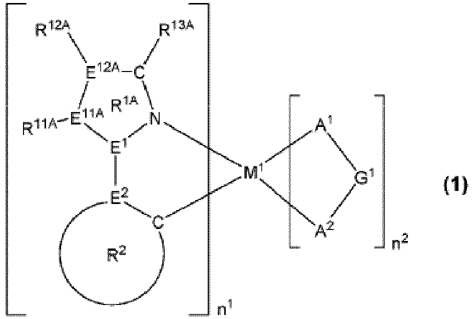 dargestellt ist, wobei:
M¹ ein Rhodiumatom, ein Palladiumatom, ein Iridiumatom oder ein Platinatom darstellt,
n¹ eine ganze Zahl von 1 oder höher darstellt, n² eine ganze Zahl von 0 oder höher darstellt und n¹ + n² 2 oder 3 ist,
wenn M¹ ein Rhodiumatom oder ein Iridiumatom ist, n¹ + n² 3 ist, und wenn M¹ ein Palladiumatom oder ein Platinatom ist, n¹ + n² 2 ist,
der Ring R^{1A} einen Triazolring oder einen Diazolring darstellt, der aus einem Stickstoffatom, E¹, E^{11A}, E^{12A} und einem Kohlenstoffatom gebildet ist,
der Ring R² einen aromatischen Kohlenwasserstoffring oder einen aromatischen heterocyclischen Ring darstellt und diese Ringe jeweils einen Substituenten aufweisen können; wenn mehrere der Substituenten vorhanden sind, diese gleich oder verschieden sein und aneinander gebunden sein können, um gemeinsam mit den Atomen, an die sie angebunden sind, einen Ring zu bilden; und wenn mehrere des Rings R² vorhanden sind, diese gleich oder verschieden sein können,
E¹ ein Kohlenstoffatom darstellt und E², E^{11A} und E^{12A} jeweils unabhängig ein Stickstoffatom oder ein Kohlenstoffatom darstellen; wenn mehrere von E², E^{11A} und E^{12A} vorhanden sind, diese bei jedem Vorkommen gleich oder verschieden sein können,
R^{11A} und R^{12A} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, eine substituierte Aminogruppe oder ein Halogenatom darstellen und diese Gruppen jeweils einen Substituenten aufweisen können; wenn mehrere von R^{11A} und R^{12A} vorhanden sind, diese bei jedem Vorkommen gleich oder verschieden sein können; R^{11A} und R^{12A} aneinander gebunden sein können, um gemeinsam mit den Atomen, an die sie angebunden sind, einen Ring zu bilden; und R^{11A} und ein optionaler Substituent des Rings R² aneinander gebunden sein können, um gemeinsam mit den Atomen, an die sie angebunden sind, einen Ring zu bilden,
wenn E^{11A} ein Stickstoffatom ist, R^{11A} vorhanden oder nicht vorhanden sein kann, und wenn E^{12A} ein Stickstoffatom ist, R^{12A} vorhanden oder nicht vorhanden sein kann,
R^{13A} eine Arylgruppe, eine einwertige heterocyclische Gruppe oder eine substituierte Aminogruppe darstellt und diese Gruppe jeweils einen Substituenten aufweisen können; wenn mehrere von R^{13A} vorhanden sind, diese gleich oder verschieden sein können; und R^{12A} und R^{13A} aneinander gebunden sein können, um gemeinsam mit den Atomen, an die sie angebunden sind, einen Ring zu bilden, und
A¹-G¹-A² einen anionischen zweizähnigen Liganden darstellt, A¹ und A² jeweils unabhängig ein Kohlenstoffatom, ein Sauerstoffatom oder ein Stickstoffatom darstellen und diese Atome jeweils Atome sein können, die einen Ring bilden; G¹ eine Einfachbindung oder eine Atomgruppe darstellt, die gemeinsam mit A¹ und A² den zweizähnigen Liganden bildet; und wenn mehrere von A¹-G¹-A² vorhanden sind, diese gleich oder verschieden sein können).

2. Lichtemittierende Vorrichtung nach Anspruch 1, wobei die zweite lichtemittierende Schicht einen Metallkomplex umfasst, der durch Formel (2): 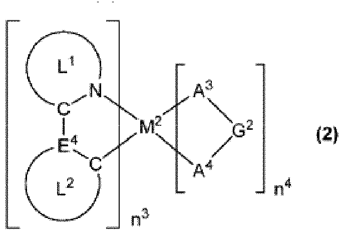 dargestellt ist, wobei:
M² ein Rhodiumatom, ein Palladiumatom, ein Iridiumatom oder ein Platinatom darstellt,
n³ eine ganze Zahl von 1 oder höher darstellt, n⁴ eine ganze Zahl von 0 oder höher darstellt und n³ + n⁴ 2 oder 3 ist; wenn M² ein Rhodiumatom oder ein Iridiumatom ist, n³ + n⁴ 3 ist; und wenn M² ein Palladiumatom oder ein Platinatom ist, n³ + n⁴ 2 ist,
E⁴ ein Kohlenstoffatom oder ein Stickstoffatom darstellt,
der Ring L¹ einen 6-gliedrigen aromatischen heterocyclischen Ring darstellt, der einen Substituenten aufweisen kann; wenn mehrere der Substituenten vorhanden sind, diese gleich oder verschieden sein und aneinander gebunden sein können, um gemeinsam mit den Atomen, an die sie angebunden sind, einen Ring zu bilden; und wenn mehrere des Rings L¹ vorhanden sind, diese gleich oder verschieden sein können,
der Ring L² einen aromatischen Kohlenwasserstoffring oder einen aromatischen heterocyclischen Ring darstellt und diese Ringe jeweils einen Substituenten aufweisen können; wenn mehrere der Substituenten vorhanden sind, diese gleich oder verschieden sein und aneinander gebunden sein können, um gemeinsam mit den Atomen, an die sie angebunden sind, einen Ring zu bilden; und wenn mehrere des Rings L² vorhanden sind, diese gleich oder verschieden sein können,
ein optionaler Substituent des Rings L¹ und ein optionaler Substituent des Rings L² aneinander gebunden sein können, um gemeinsam mit den Atomen, an die sie angebunden sind, einen Ring zu bilden,
der Ring L¹ und/oder der Ring L² einen Substituenten aufweist und
A³-G²-A⁴ einen anionischen zweizähnigen Liganden darstellt, A³ und A⁴ jeweils unabhängig ein Kohlenstoffatom, ein Sauerstoffatom oder ein Stickstoffatom darstellen und diese Atome jeweils Atome sein können, die einen Ring bilden; G² eine Einfachbindung oder eine Atomgruppe darstellt, die gemeinsam mit A³ und A⁴ den zweizähnigen Liganden bildet; und wenn mehrere von A³-G²-A⁴ vorhanden sind, diese gleich oder verschieden sein können).

3. Lichtemittierende Vorrichtung nach Anspruch 1, wobei die zweite lichtemittierende Schicht zumindest eines umfasst, das aus der Gruppe ausgewählt ist, bestehend aus:
einer Polymerverbindung, die eine konstitutive Einheit mit einer Gruppe umfasst, die durch Entfernen eines oder mehrerer Wasserstoffatome aus einem durch Formel (2) dargestellten Metallkomplex gebildet wird, die direkt an ein Kohlenstoffatom oder ein Heteroatom gebunden sind, das den Metallkomplex bildet; und
einem vernetzten Produkt der Polymerverbindung 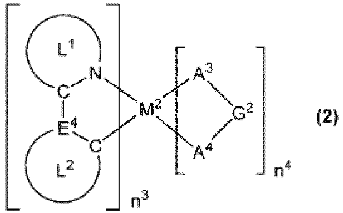 wobei:
M² ein Rhodiumatom, ein Palladiumatom, ein Iridiumatom oder ein Platinatom darstellt,
n³ eine ganze Zahl von 1 oder höher darstellt, n⁴ eine ganze Zahl von 0 oder höher darstellt und n³ + n⁴ 2 oder 3 ist; wenn M² ein Rhodiumatom oder ein Iridiumatom ist, n³ + n⁴ 3 ist; und wenn M² ein Palladiumatom oder ein Platinatom ist, n³ + n⁴ 2 ist,
E⁴ ein Kohlenstoffatom oder ein Stickstoffatom darstellt,
der Ring L¹ einen 6-gliedrigen aromatischen heterocyclischen Ring darstellt, der einen Substituenten aufweisen kann; wenn mehrere der Substituenten vorhanden sind, diese gleich oder verschieden sein und aneinander gebunden sein können, um gemeinsam mit den Atomen, an die sie angebunden sind, einen Ring zu bilden; und wenn mehrere des Rings L¹ vorhanden sind, diese gleich oder verschieden sein können,
der Ring L² einen aromatischen Kohlenwasserstoffring oder einen aromatischen heterocyclischen Ring darstellt und diese Ringe jeweils einen Substituenten aufweisen können;
wenn mehrere der Substituenten vorhanden sind, diese gleich oder verschieden sein und aneinander gebunden sein können, um gemeinsam mit den Atomen, an die sie angebunden sind, einen Ring zu bilden; und wenn mehrere des Rings L² vorhanden sind, diese gleich oder verschieden sein können,
ein optionaler Substituent des Rings L¹ und ein optionaler Substituent des Rings L² aneinander gebunden sein können, um gemeinsam mit den Atomen, an die sie angebunden sind, einen Ring zu bilden, und
A³-G²-A⁴ einen anionischen zweizähnigen Liganden darstellt, A³ und A⁴ jeweils unabhängig ein Kohlenstoffatom, ein Sauerstoffatom oder ein Stickstoffatom darstellen und diese Atome jeweils Atome sein können, die einen Ring bilden; G² eine Einfachbindung oder eine Atomgruppe darstellt, die gemeinsam mit A³ und A⁴ den zweizähnigen Liganden bildet; und wenn mehrere von A³-G²-A⁴ vorhanden sind, diese gleich oder verschieden sein können.

4. Lichtemittierende Vorrichtung nach Anspruch 3, wobei die konstitutive Einheit eine durch Formel (1B) dargestellte konstitutive Einheit, eine durch Formel (2B) dargestellte konstitutive Einheit, eine durch Formel (3B) dargestellte konstitutive Einheit oder eine durch Formel (4B) dargestellte konstitutive Einheit ist: 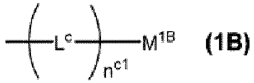 wobei:
M^{1B} eine Gruppe darstellt, die durch Entfernen eines Wasserstoffatoms aus dem durch Formel (2) dargestellten Metallkomplex gebildet ist, das direkt an ein Kohlenstoffatom oder ein Heteroatom gebunden ist, das den Metallkomplex bildet;
L^{c} ein Sauerstoffatom, ein Schwefelatom, -N(R^{A})-, -C(R^{B})₂-, -C(R^{B})=C(R^{B})-, -C≡C-, eine Arylengruppe oder eine zweiwertige heterocyclische Gruppe darstellt und diese Gruppen jeweils einen Substituenten aufweisen können; R^{A} ein Wasserstoffatom, eine Alkylgruppe, eine Cycloalkylgruppe, eine Arylgruppe oder eine einwertige heterocyclische Gruppe darstellt und diese Gruppe jeweils einen Substituenten aufweisen können; R^{B} ein Wasserstoffatom, eine Alkylgruppe, eine Cycloalkylgruppe, eine Alkoxygruppe, eine Cycloalkoxygruppe, eine Arylgruppe oder eine einwertige heterocyclische Gruppe darstellt und diese Gruppen jeweils einen Substituenten aufweisen können; die mehreren von R^{B} gleich oder verschieden sein und aneinander gebunden sein können, um gemeinsam mit dem Kohlenstoffatom, an das sie angebunden sind, einen Ring zu bilden; und wenn mehrere von L^{c} vorhanden sind, diese gleich oder verschieden sein können, und
n^{c1} eine ganze Zahl von 0 oder höher darstellt; 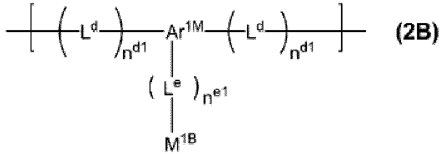
wobei:
M^{1B} die gleiche Bedeutung wie oben beschrieben hat,
L^{d} und L^{e} jeweils unabhängig ein Sauerstoffatom, ein Schwefelatom, -N(R^{A})-, - C(R^{B})₂-, -C(R^{B})=C(R^{B})-, -C=C-, eine Arylengruppe oder eine zweiwertige heterocyclische Gruppe darstellen und diese Gruppen jeweils einen Substituenten aufweisen können; R^{A} und R^{B} die gleiche Bedeutung wie oben beschrieben haben; und wenn mehrere von L^{d} und L^{e} vorhanden sind, diese bei jedem Vorkommen gleich oder verschieden sein können,
n^{d1} und n^{e1} jeweils unabhängig eine ganze Zahl von 0 oder höher darstellen, und die mehreren von n^{d1} gleich oder verschieden sein können, und
Ar^{1M} eine aromatische Kohlenwasserstoffgruppe oder eine heterocyclische Gruppe darstellt und diese Gruppen jeweils einen Substituenten aufweisen können; 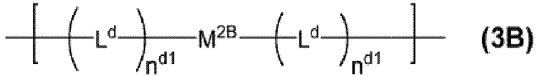
wobei:
L^{d} und n^{d1} die gleiche Bedeutung wie oben beschrieben haben und
M^{2B} eine Gruppe darstellt, die durch Entfernen von zwei Wasserstoffatomen aus dem durch Formel (2) dargestellten Metallkomplex erhalten wurde, die direkt an ein Kohlenstoffatom oder ein Heteroatom gebunden sind, das den Metallkomplex bildet. 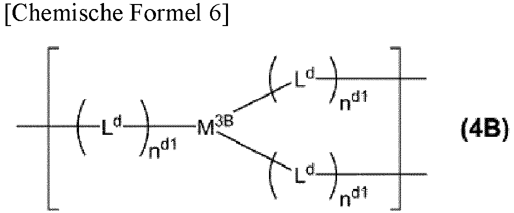
(wobei:
L^{d} und n^{d1} die gleiche Bedeutung wie oben beschrieben haben und
M^{3B} eine Gruppe darstellt, die durch Entfernen von drei Wasserstoffatomen aus dem durch Formel (2) dargestellten Metallkomplex erhalten wurde, die direkt an ein Kohlenstoffatom oder ein Heteroatom gebunden sind, das den Metallkomplex bildet).

5. Lichtemittierende Vorrichtung nach einem der Ansprüche 2 bis 4, wobei der durch Formel (2) dargestellte Metallkomplex ein durch Formel (2-B) dargestellter Metallkomplex ist, vorzugsweise ein durch Formel (2-B1) dargestellter Metallkomplex, ein durch Formel (2-B2) dargestellter Metallkomplex, ein durch Formel (2-B3) dargestellter Metallkomplex, ein durch Formel (2-B4) dargestellter Metallkomplex oder ein durch Formel (2-B5) dargestellter Metallkomplex: 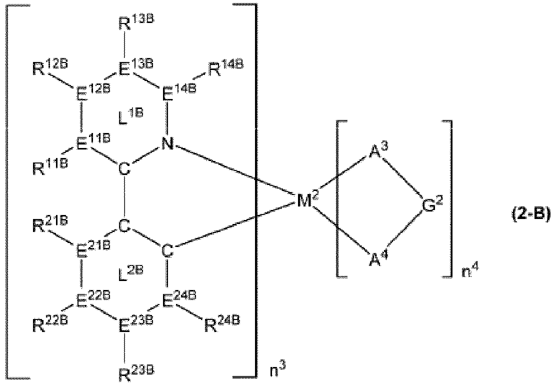 wobei:
M², n³, n⁴ und A³-G²-A⁴ die gleiche Bedeutung wie oben beschrieben haben,
E^{11B}, E^{12B}, E^{13B}, E^{14B}, E^{21B}, E^{22B}, E^{23B} und E^{24B} jeweils unabhängig ein Stickstoffatom oder ein Kohlenstoffatom darstellen; wenn mehrere von E^{11B}, E^{12B}, E^{13B}, E^{14B}, E^{21B}, E^{22B}, E^{23B} und E^{24B} vorhanden sind, diese bei jedem Vorkommen gleich oder verschieden sein können; wenn E^{11B} ein Stickstoffatom ist, R^{11B} nicht vorhanden ist; wenn E^{12B} ein Stickstoffatom ist, R^{12B} nicht vorhanden ist; wenn E^{13B} ein Stickstoffatom ist, R^{13B} nicht vorhanden ist; wenn E^{14B} ein Stickstoffatom ist, R^{14B} nicht vorhanden ist; wenn E^{21B} ein Stickstoffatom ist, R^{21B} nicht vorhanden ist; wenn E^{22B} ein Stickstoff ist, R^{22B} nicht vorhanden ist; wenn E^{23B} ein Stickstoffatom ist, R^{23B} nicht vorhanden ist; und wenn E^{24B} ein Stickstoffatom ist, R^{24B} nicht vorhanden ist,
R^{11B}, R^{12B}, R^{13B}, R^{14B}, R^{21B}, R^{22B}, R^{23B} und R^{24B} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, einen einwertigen heterocyclischen Ring, eine substituierte Aminogruppe oder ein Halogenatom darstellen und diese Gruppen jeweils einen Substituenten aufweisen können; wenn mehrere von R^{11B}, R^{12B}, R^{13B}, R^{14B}, R^{21B}, R^{22B}, R^{23B} und R^{24B} vorhanden sind, diese bei j edem Vorkommen gleich oder verschieden sein können; und R^{11B} und R^{12B}, R^{12B} und R^{13B}, R^{13B} und R^{14B}, R^{11B} und R^{21B}, R^{21B} und R^{22B}, R^{22B} und R^{23B} und R^{23B} und R^{24B} jeweils aneinander gebunden sein können, um gemeinsam mit den Atomen, an die sie angebunden sind, einen Ring zu bilden,
der Ring L^{1B} einen Pyridinring oder einen Pyrimidinring darstellt, der aus einem Stickstoffatom, einem Kohlenstoffatom, E^{11B}, E^{12B}, E^{13B} und E^{14B} gebildet ist, und
der Ring L^{2B} einen Benzolring, einen Pyridinring oder einen Pyrimidinring darstellt, der aus zwei Kohlenstoffatomen, E^{21B}, E^{22B}, E^{23B} und E^{24B} gebildet ist; 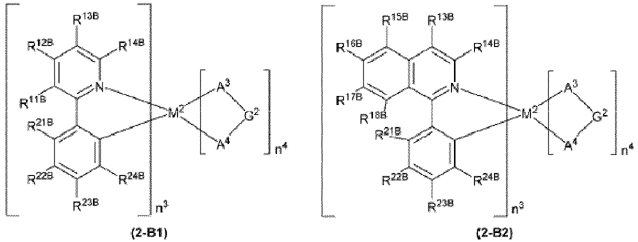 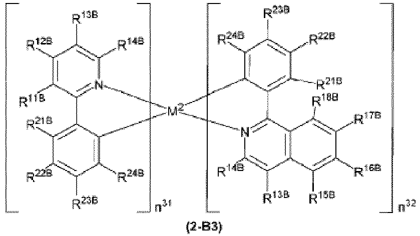 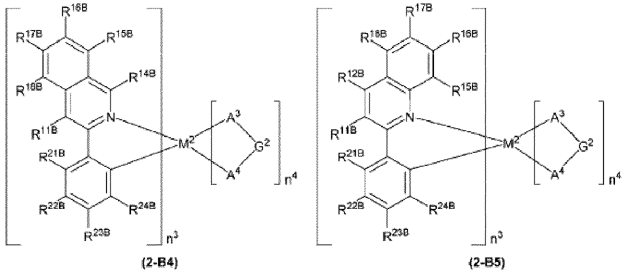
wobei:
M², n³, n⁴, A³-G²-A⁴, R^{11B}, R^{12B}, R^{13B}, R^{14B}, R^{21B}, R^{22B}, R^{23B} und R^{24B} die gleiche Bedeutung wie oben beschrieben haben,
n³¹ und n³² jeweils unabhängig eine ganze Zahl von 1 oder höher darstellen und n³¹ + n³² 2 oder 3 ist; wenn M² ein Rhodiumatom oder ein Iridiumatom ist, n³¹ + n³² 3 ist; und wenn M² ein Palladiumatom oder ein Platinatom ist, n³¹ + n³² 2 ist, und
R^{15B}, R^{16B}, R^{17B} und R^{18B} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, eine substituierte Aminogruppe oder ein Halogenatom darstellen und diese Gruppen jeweils einen Substituenten aufweisen können; wenn mehrere von R^{15B}, R^{16B}, R^{17B} und R^{18B} vorhanden sind, diese bei jedem Vorkommen gleich oder verschieden sein können; R^{15B} und R^{16B}, R^{16B} und R^{17B} und R^{17B} und R^{18B} jeweils aneinander gebunden sein können, um gemeinsam mit den Atomen, an die sie angebunden sind, einen Ring zu bilden.

6. Lichtemittierende Vorrichtung nach einem der Ansprüche 1 bis 5, wobei der durch Formel (1) dargestellte Metallkomplex ein durch Formel (1-A) dargestellter Metallkomplex ist: 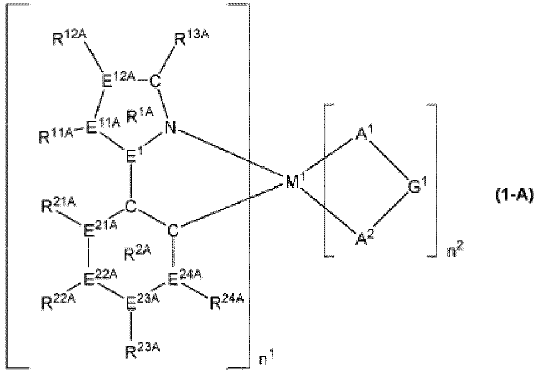 wobei:
M¹, n¹, n², Ring R^{1A}, E¹, E^{11A}, E^{12A}, R^{11A}, R^{12A}, R^{13A} und A¹-G¹-A² die gleiche Bedeutung wie oben beschrieben haben,
der Ring L^{2A} einen Benzolring, einen Pyridinring oder einen Pyrimidinring darstellt, der aus zwei Kohlenstoffatomen, E^{21A}, E^{22A}, E^{23A} und E^{24A} gebildet ist,
E^{21A}, E^{22A}, E^{23A} und E^{24A} jeweils unabhängig ein Stickstoffatom oder ein Kohlenstoffatom darstellen; wenn mehrere von E^{21A}, E^{22A}, E^{23A} und E^{24A} vorhanden sind, diese bei jedem Vorkommen gleich oder verschieden sein können; wenn E^{21A} ein Stickstoffatom ist, R^{21A} nicht vorhanden ist; wenn E^{22A} ein Stickstoffatom ist, R^{22A} nicht vorhanden ist; wenn E^{23A} ein Stickstoffatom ist, R^{23A} nicht vorhanden ist; und wenn E^{24A} ein Stickstoffatom ist, R^{24A} nicht vorhanden ist, und
R^{21A}, R^{22A}, R^{23A} und R^{24A} jeweils unabhängig ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, eine substituierte Aminogruppe oder ein Halogenatom darstellen und diese Gruppen jeweils einen Substituenten aufweisen können; wenn mehrere von R^{21A}, R^{22A}, R^{23A} und R^{24A} vorhanden sind, diese bei jedem Vorkommen gleich oder verschieden sein können; R^{21A} und R^{22A} aneinander gebunden sein können, um gemeinsam mit den Atomen, an die sie angebunden sind, einen Ring zu bilden; R^{22A} und R^{23A} aneinander gebunden sein können, um gemeinsam mit den Atomen, an die sie angebunden sind, einen Ring zu bilden; R^{23A} und R^{24A} aneinander gebunden sein können, um gemeinsam mit den Atomen, an die sie angebunden sind, einen Ring zu bilden; und R^{11A} und R^{21A} aneinander gebunden sein können, um gemeinsam mit den Atomen, an die sie angebunden sind, einen Ring zu bilden.

7. Lichtemittierende Vorrichtung nach Anspruch 6, wobei der durch Formel (1-A) dargestellte Metallkomplex ein durch Formel (1-A1) dargestellter Metallkomplex, ein durch Formel (1-A2) dargestellter Metallkomplex, ein durch Formel (1-A3) dargestellter Metallkomplex oder ein durch Formel (1-A4) dargestellter Metallkomplex ist: 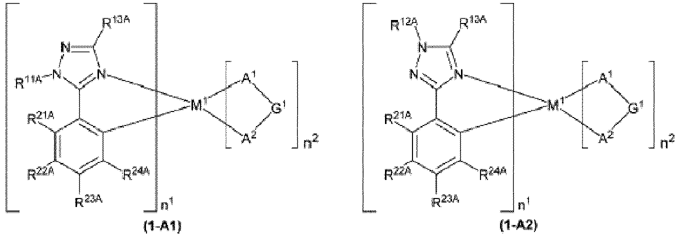 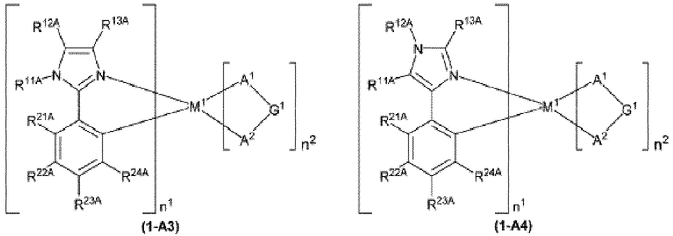 wobei M¹, n¹, n², R^{11A}, R^{12A}, R^{13A}, R^{21A}, R^{22A}, R^{23A}, R^{24A} und A¹-G¹-A² die gleiche Bedeutung wie oben beschrieben haben.

8. Lichtemittierende Vorrichtung nach einem der Ansprüche 1 bis 7, wobei R^{13A} eine Arylgruppe ist, die einen Substituenten aufweisen kann.

9. Lichtemittierende Vorrichtung nach einem der Ansprüche 1 bis 8, wobei die erste lichtemittierende Schicht ferner eine durch Formel (H-1) dargestellte Verbindung umfasst: 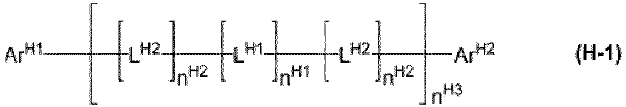 wobei:
Ar^{H1} und Ar^{H2} jeweils unabhängig eine Arylgruppe oder eine einwertige heterocyclische Gruppe darstellen und diese Gruppen jeweils einen Substituenten aufweisen können,
n^{H1} und n^{H2} jeweils unabhängig 0 oder 1 darstellen; wenn mehrere von n^{H1} vorhanden sind, diese gleich oder verschieden sein können; und die mehreren von n^{H2} gleich oder verschieden sein können;
n^{H3} eine ganze Zahl von 0 oder höher darstellt,
L^{H1} eine Arylengruppe, eine zweiwertige heterocyclische Gruppe oder eine durch - [C(R^{H11})2]n^{H11}- dargestellte Gruppe darstellt und diese Gruppe jeweils einen Substituenten aufweisen können; wenn mehrere von L^{H1} vorhanden sind, diese gleich oder verschieden sein können; n^{H11} eine ganze Zahl von 1 oder höher und 10 oder weniger darstellt; R^{H11} ein Wasserstoffatom, eine Alkylgruppe, eine Cycloalkylgruppe, eine Alkoxygruppe, eine Cycloalkoxygruppe, eine Arylgruppe oder eine einwertige heterocyclische Gruppe darstellt und diese Gruppen jeweils einen Substituenten aufweisen können; und die mehreren von R^{H11} gleich oder verschieden sein und aneinander gebunden sein können, um gemeinsam mit dem Kohlenstoffatom, an das sie angebunden sind, einen Ring zu bilden, und
L^{H2} eine durch -N(-L^{H21}-R^{H21})- dargestellte Gruppe darstellt; wenn mehrere von L^{H2} vorhanden sind, diese gleich oder verschieden sein können; L^{H21} eine Einfachbindung, eine Arylengruppe oder eine zweiwertige heterocyclische Gruppe darstellt und diese Gruppen jeweils einen Substituenten aufweisen können; R^{H21} ein Wasserstoffatom, eine Alkylgruppe, eine Cycloalkylgruppe, eine Arylgruppe oder eine einwertige heterocyclische Gruppe darstellt und diese Gruppen jeweils einen Substituenten aufweisen können.

10. Lichtemittierende Vorrichtung nach einem der Ansprüche 1 bis 9, wobei die erste lichtemittierende Schicht und die zweite lichtemittierende Schicht einander benachbart vorliegen.

11. Lichtemittierende Vorrichtung nach einem der Ansprüche 1 bis 10, wobei die zweite lichtemittierende Schicht zwischen der Anode und der ersten lichtemittierenden Schicht vorgesehen ist.

12. Lichtemittierende Vorrichtung nach Anspruch 2, wobei zumindest eines, das aus der Gruppe ausgewählt ist, bestehend aus dem Ring L¹ und dem Ring L², eine durch Formel (DA), (D-B) oder (D-C) dargestellte Gruppe als Substituent aufweist: 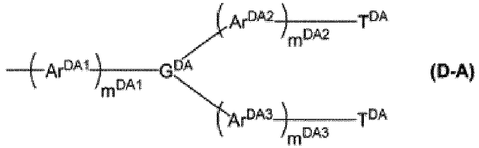 wobei:
m^{DA1}, m^{DA2} und m^{DA3} jeweils unabhängig eine ganze Zahl von 0 oder höher darstellen,
G^{DA} ein Stickstoffatom, eine aromatische Kohlenwasserstoffgruppe oder eine heterocyclische Gruppe darstellt und diese Gruppen jeweils einen Substituenten aufweisen können,
Ar^{DA1}, Ar^{DA2} und Ar^{DA3} jeweils unabhängig eine Arylengruppe oder eine zweiwertige heterocyclische Gruppe darstellen und diese Gruppen jeweils einen Substituenten aufweisen können; und wenn mehrere von Ar^{DA1}, Ar^{DA2} und Ar^{DA3} vorhanden sind, diese bei jedem Vorkommen gleich oder verschieden sein können, und
T^{DA} eine Arylgruppe oder eine einwertige heterocyclische Gruppe darstellt und diese Gruppen jeweils einen Substituenten aufweisen können; und die mehreren von T^{DA} gleich oder verschieden sein können; 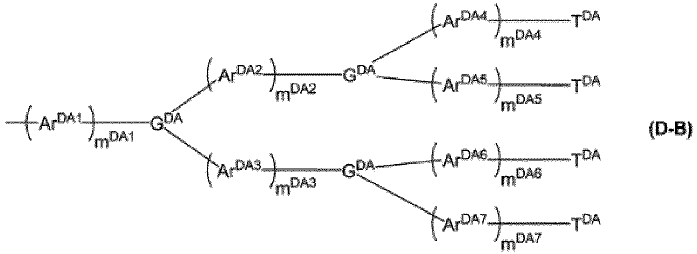
wobei:
m^{DA1}, m^{DA2}, m^{DA3}, m^{DA4}, m^{DA5}, m^{DA6} und m^{DA7} jeweils unabhängig eine ganze Zahl von 0 oder höher darstellen,
G^{DA} ein Stickstoffatom, eine aromatische Kohlenwasserstoffgruppe oder eine heterocyclische Gruppe darstellt und diese Gruppen jeweils einen Substituenten aufweisen können; die mehreren von G^{DA} gleich oder verschieden sein können,
Ar^{DA1}, Ar^{DA2}, Ar^{DA3}, Ar^{DA4}, Ar^{DA5}, Ar^{DA6} und Ar^{DA7} jeweils unabhängig eine Arylengruppe oder eine zweiwertige heterocyclische Gruppe darstellen und diese Gruppen jeweils einen Substituenten aufweisen; und wenn mehrere von Ar^{DA1}, Ar^{DA2}, Ar^{DA3}, Ar^{DA4}, Ar^{DA5}, Ar^{DA6} und Ar^{DA7} vorhanden sind, diese bei jedem Vorkommen gleich oder verschieden sein können, und
T^{DA} eine Arylgruppe oder eine einwertige heterocyclische Gruppe darstellt und diese Gruppen jeweils einen Substituenten aufweisen können; die mehreren von T^{DA} gleich oder verschieden sein können; 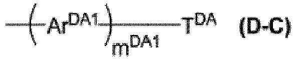
wobei:
m^{DA1} eine ganze Zahl von 0 oder höher darstellt,
Ar^{DA1} eine Arylengruppe oder eine zweiwertige heterocyclische Gruppe darstellt und diese Gruppen jeweils einen Substituenten aufweisen können; und wenn mehrere von Ar^{DA1} vorhanden sind, diese gleich oder verschieden sein können, und
T^{DA} eine Arylgruppe oder eine einwertige heterocyclische Gruppe darstellt und diese Gruppen jeweils einen Substituenten aufweisen können.

13. Lichtemittierende Vorrichtung nach Anspruch 3, wobei zumindest eines, das aus der Gruppe ausgewählt ist, bestehend aus dem Ring L¹ und dem Ring L², eine durch Formel (DA), (D-B) oder (D-C) dargestellte Gruppe als Substituent aufweist: 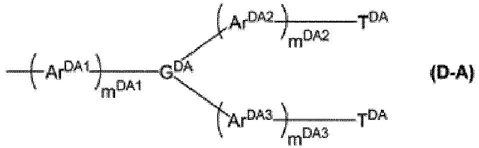 wobei:
m^{DA1}, m^{DA2} und m^{DA3} jeweils unabhängig eine ganze Zahl von 0 oder höher darstellen,
G^{DA} ein Stickstoffatom, eine aromatische Kohlenwasserstoffgruppe oder eine heterocyclische Gruppe darstellt und diese Gruppen jeweils einen Substituenten aufweisen können,
Ar^{DA1}, Ar^{DA2} und Ar^{DA3} jeweils unabhängig eine Arylengruppe oder eine zweiwertige heterocyclische Gruppe darstellen und diese Gruppen jeweils einen Substituenten aufweisen können; und wenn mehrere von Ar^{DA1}, Ar^{DA2} und Ar^{DA3} vorhanden sind, diese bei jedem Vorkommen gleich oder verschieden sein können, und
T^{DA} eine Arylgruppe oder eine einwertige heterocyclische Gruppe darstellt und diese Gruppen jeweils einen Substituenten aufweisen können; und die mehreren von T^{DA} gleich oder verschieden sein können; 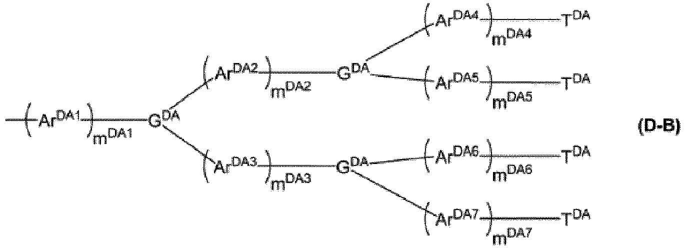
wobei:
m^{DA1}, m^{DA2}, m^{DA3}, m^{DA4}, m^{DA5}, m^{DA6} und m^{DA7} jeweils unabhängig eine ganze Zahl von 0 oder höher darstellen,
G^{DA} ein Stickstoffatom, eine aromatische Kohlenwasserstoffgruppe oder eine heterocyclische Gruppe darstellt und diese Gruppen jeweils einen Substituenten aufweisen können; die mehreren von G^{DA} gleich oder verschieden sein können,
Ar^{DA1}, Ar^{DA2}, Ar^{DA3}, Ar^{DA4}, Ar^{DA5}, Ar^{DA6} und Ar^{DA7} jeweils unabhängig eine Arylengruppe oder eine zweiwertige heterocyclische Gruppe darstellen und diese Gruppen jeweils einen Substituenten aufweisen; und wenn mehrere von Ar^{DA1}, Ar^{DA2}, Ar^{DA3}, Ar^{DA4}, Ar^{DA5}, Ar^{DA6} und Ar^{DA7} vorhanden sind, diese bei jedem Vorkommen gleich oder verschieden sein können, und
T^{DA} eine Arylgruppe oder eine einwertige heterocyclische Gruppe darstellt und diese Gruppen jeweils einen Substituenten aufweisen können; die mehreren von T^{DA} gleich oder verschieden sein können; 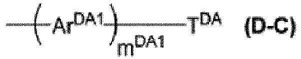
wobei:
m^{DA1} eine ganze Zahl von 0 oder höher darstellt,
Ar^{DA1} eine Arylengruppe oder eine zweiwertige heterocyclische Gruppe darstellt und diese Gruppen jeweils einen Substituenten aufweisen können; und wenn mehrere von Ar^{DA1} vorhanden sind, diese gleich oder verschieden sein können, und
T^{DA} eine Arylgruppe oder eine einwertige heterocyclische Gruppe darstellt und diese Gruppen jeweils einen Substituenten aufweisen können.

14. Lichtemittierende Vorrichtung nach Anspruch 5, wobei zumindest eines, das aus der Gruppe ausgewählt ist, bestehend aus R^{11B}, R^{12B}, R^{13B}, R^{14B}, R^{21B}, R^{22B}, R^{23B} und R^{24B} eine durch Formel (D-A), (D-B) oder (D-C) dargestellte Gruppe ist: 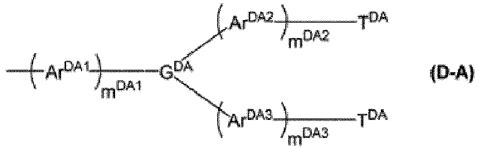 wobei:
m^{DA1}, m^{DA2} und m^{DA3} jeweils unabhängig eine ganze Zahl von 0 oder höher darstellen,
G^{DA} ein Stickstoffatom, eine aromatische Kohlenwasserstoffgruppe oder eine heterocyclische Gruppe darstellt und diese Gruppen jeweils einen Substituenten aufweisen können,
Ar^{DA1}, Ar^{DA2} und Ar^{DA3} jeweils unabhängig eine Arylengruppe oder eine zweiwertige heterocyclische Gruppe darstellen und diese Gruppen jeweils einen Substituenten aufweisen können; und wenn mehrere von Ar^{DA1}, Ar^{DA2} und Ar^{DA3} vorhanden sind, diese bei jedem Vorkommen gleich oder verschieden sein können, und
T^{DA} eine Arylgruppe oder eine einwertige heterocyclische Gruppe darstellt und diese Gruppen jeweils einen Substituenten aufweisen können; und die mehreren von T^{DA} gleich oder verschieden sein können; 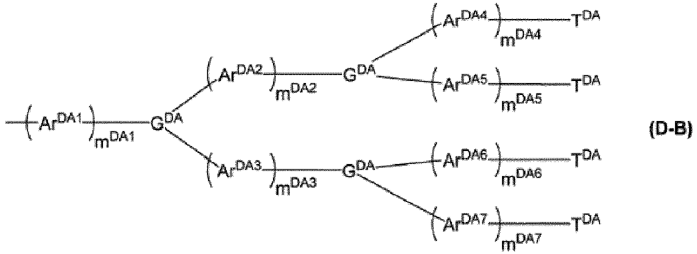
wobei:
m^{DA1}, m^{DA2}, m^{DA3}, m^{DA4}, m^{DA5}, m^{DA6} und m^{DA7} jeweils unabhängig eine ganze Zahl von 0 oder höher darstellen,
G^{DA} ein Stickstoffatom, eine aromatische Kohlenwasserstoffgruppe oder eine heterocyclische Gruppe darstellt und diese Gruppen jeweils einen Substituenten aufweisen können; die mehreren von G^{DA} gleich oder verschieden sein können,
Ar^{DA1}, Ar^{DA2}, Ar^{DA3}, Ar^{DA4}, Ar^{DA5}, Ar^{DA6} und Ar^{DA7} jeweils unabhängig eine Arylengruppe oder eine zweiwertige heterocyclische Gruppe darstellen und diese Gruppen jeweils einen Substituenten aufweisen; und wenn mehrere von Ar^{DA1}, Ar^{DA2}, Ar^{DA3}, Ar^{DA4}, Ar^{DA5}, Ar^{DA6} und Ar^{DA7} vorhanden sind, diese bei jedem Vorkommen gleich oder verschieden sein können, und
T^{DA} eine Arylgruppe oder eine einwertige heterocyclische Gruppe darstellt und diese Gruppen jeweils einen Substituenten aufweisen können; die mehreren von T^{DA} gleich oder verschieden sein können; 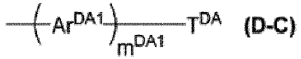
wobei:
m^{DA1} eine ganze Zahl von 0 oder höher darstellt,
Ar^{DA1} eine Arylengruppe oder eine zweiwertige heterocyclische Gruppe darstellt und diese Gruppen jeweils einen Substituenten aufweisen können; und wenn mehrere von Ar^{DA1} vorhanden sind, diese gleich oder verschieden sein können, und
T^{DA} eine Arylgruppe oder eine einwertige heterocyclische Gruppe darstellt und diese Gruppen jeweils einen Substituenten aufweisen können.

## Revendications

1. Dispositif luminescent, comprenant :
une anode ;
une cathode ;
une première couche luminescente prévue entre l'anode et la cathode ; et
une seconde couche luminescente prévu entre l'anode et la cathode,
dans lequel la première couche luminescente comprend un complexe métallique représenté par la formule (1) 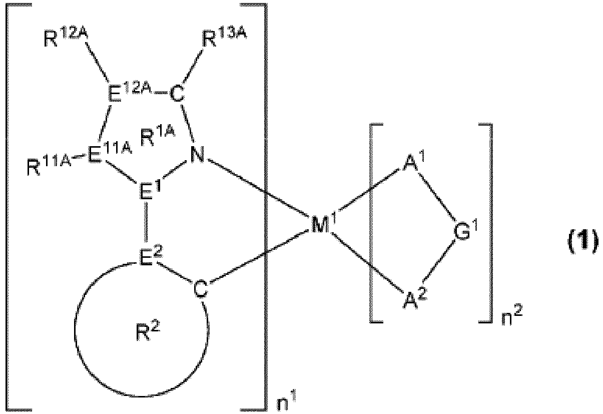 dans lequel
M¹ représente un atome de rhodium, un atome de palladium, un atome d'iridium ou un atome de platine,
n¹ représente un nombre entier relatif d'1 ou plus, n représente un nombre entier relatif de 0 ou plus, et n¹ + n² est 2 ou 3,
lorsque M¹ est un atome de rhodium ou un atome d'iridium, n¹ + n² est 3, et lorsque M¹ est un atome de palladium ou un atome de platine, n¹ + n² est 2,
l'anneau R^{1A} représente un anneau triazole ou un anneau diazole constitué de : un atome d'azote, E¹, E^{11A}, E^{12A} et un atome de carbone,
l'anneau R² représente un anneau hydrocarbure aromatique ou un anneau hétérocyclique aromatique, et ces anneaux peuvent chacun avoir un substituant ; lorsqu'il y a une pluralité des substituants, ils peuvent être les mêmes ou différents et peuvent être liés les uns aux autres pour former un anneau conjointement avec les atomes auxquels ils sont liés ; et lorsqu'il y a une pluralité de l'anneau R², ils peuvent être les mêmes ou différents,
E¹ représente un atome de carbone, et E², E^{11A}, E^{12A} représentent chacun indépendamment un atome d'azote ou un atome de carbone ; lorsqu'il y a une pluralité de E², de E^{11A}, de E^{12A}, ils peuvent être les mêmes ou différents dans chaque cas,
R^{11A} et R^{12A} représentent chacun indépendamment un atome d'hydrogène, un groupe alkyle, un groupe cycloalkyle, un groupe alkoxy, un groupe cycloalkoxy, un groupe aryle, un groupe aryloxy, un groupe hétérocyclique monovalent, un groupe amino substitué, ou un atome d'halogène, et ces groupes peuvent chacun avoir un substituant ; lorsqu'il y a une pluralité de : R^{11A} et R^{12A}, ils peuvent être les mêmes ou différents dans chaque cas ; R^{11A} et R^{12A} peuvent être liés l'un à l'autre pour former un anneau conjointement avec les atomes auxquels ils sont liés ; et R^{11A} et un substituant optionnel de l'anneau R² peuvent être liés l'un à l'autre pour former un anneau conjointement avec les atomes auxquels ils sont liés,
lorsque E^{11A} est un atome d'azote, R^{11A} peut être présent ou absent, et lorsque E^{12A} est un atome d'azote, R^{12A} peut être présent ou absent,
R^{13A} représente un groupe aryle, un groupe hétérocyclique monovalent, ou un groupe amino substitué, et ces groupes peuvent chacun avoir un substituant ; lorsqu'il y a une pluralité de R^{13A}, ils peuvent être les mêmes ou différents ; et R^{12A} et R^{13A} peuvent être liés l'un à l'autre pour former un anneau conjointement avec les atomes auxquels ils sont liés, et
A¹-G¹-A² représente un ligand bidenté anionique, A¹ et A² représentent chacun indépendamment un atome de carbone, un atome d'oxygène ou un atome d'azote, et ces atomes peuvent chacun être des atomes constituant un anneau ; G¹ représente une seule liaison ou un groupe atomique constituant le ligand bidenté conjointement avec A¹ et A² ; et, lorsqu'il y a une pluralité de A¹-G¹-A², ils peuvent être les mêmes ou différents.

2. Dispositif luminescent selon la revendication 1, dans lequel la seconde couche luminescente comprend un complexe métallique représenté par la formule (2) : 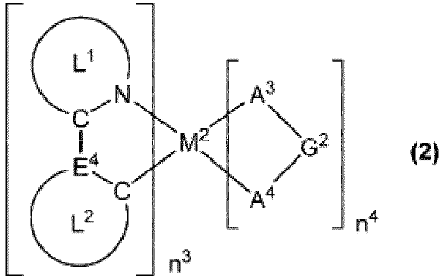 dans lequel
M² représente un atome de rhodium, un atome de palladium, un atome d'iridium ou un atome de platine,
n³ représente un nombre entier relatif d'1 ou plus, n⁴ représente un nombre entier relatif de 0 ou plus, et n³ + n⁴ est 2 ou 3 ; lorsque M² est un atome de rhodium ou un atome d'iridium, n³ + n⁴ est 3 ; et, lorsque M² est un atome de palladium ou un atome de platine, n³ + n⁴ est 2,
E⁴ représente un atome de carbone ou un atome d'azote,
l'anneau L¹ représente un anneau hétérocyclique aromatique à 6 membres, qui peut avoir un substituant ; lorsqu'il y a une pluralité des substituants, ils peuvent être les mêmes ou différents et peuvent être liés les uns aux autres pour former un anneau conjointement avec les atomes auxquels ils sont liés ; et lorsqu'il y a une pluralité de l'anneau L¹, ils peuvent être les mêmes ou différents,
l'anneau L² représente un anneau hydrocarbure aromatique ou un anneau hétérocyclique aromatique, et ces anneaux peuvent chacun avoir un substituant ; lorsqu'il y a une pluralité des substituants, ils peuvent être les mêmes ou différents et peuvent être liés les uns aux autres pour former un anneau conjointement avec les atomes auxquels ils sont liés ; et lorsqu'il y a une pluralité de l'anneau L², ils peuvent être les mêmes ou différents,
un substituant optionnel de l'anneau L¹ et un substituant optionnel de l'anneau L² peuvent être liés l'un à l'autre pour former un anneau conjointement avec les atomes auxquels ils sont liés,
au moins un de l'anneau L¹ et de l'anneau L² a un substituant, et
A³-G²-A⁴ représente un ligand bidenté anionique, A³ et A⁴ représentent chacun indépendamment un atome de carbone, un atome d'oxygène ou un atome d'azote, et ces atomes peuvent chacun être des atomes constituant un anneau ; G² représente une seule liaison ou un groupe atomique constituant le ligand bidenté conjointement avec A³ et A⁴ ; et, lorsqu'il y a une pluralité de A³-G²-A⁴, ils peuvent être les mêmes ou différents.

3. Dispositif luminescent selon la revendication 1, dans lequel la seconde couche luminescente comprend au moins un sélectionné parmi le groupe constitué de :
un composé polymère comprenant une unité constitutive ayant un groupe formé en enlevant, à partir d'un complexe métallique représenté par la formule (2), un ou plusieurs atomes d'hydrogène directement liés à un atome de carbone ou un hétéroatome constituant le complexe métallique ; et
un produit réticulé du composé polymère 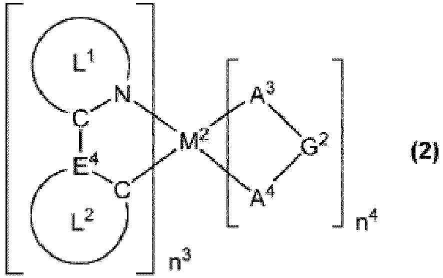 dans lequel
M² représente un atome de rhodium, un atome de palladium, un atome d'iridium ou un atome de platine,
n³ représente un nombre entier relatif d'1 ou plus, n⁴ représente un nombre entier relatif de 0 ou plus, et n³ + n⁴ est 2 ou 3 ; lorsque M² est un atome de rhodium ou un atome d'iridium, n³ + n⁴ est 3 ; et lorsque M² est un atome de palladium ou un atome de platine, n³ + n⁴ est 2,
E⁴ représente un atome de carbone ou un atome d'azote,
l'anneau L¹ représente un anneau hétérocyclique aromatique à 6 membres, qui peut avoir un substituant ; lorsqu'il y a une pluralité des substituants, ils peuvent être les mêmes ou différents et peuvent être liés les uns aux autres pour former un anneau conjointement avec les atomes auxquels ils sont liés ; et lorsqu'il y a une pluralité de l'anneau L¹, ils peuvent être les mêmes ou différents,
l'anneau L² représente un anneau hydrocarbure aromatique ou un anneau hétérocyclique aromatique, et ces anneaux peuvent chacun avoir un substituant ;
lorsqu'il y a une pluralité des substituants, ils peuvent être les mêmes ou différents et peuvent être liés les uns aux autres pour former un anneau conjointement avec les atomes auxquels ils sont liés ; et lorsqu'il y a une pluralité de l'anneau L², ils peuvent être les mêmes ou différents,
un substituant optionnel de l'anneau L¹ et un substituant optionnel de l'anneau L² peuvent être liés l'un à l'autre pour former un anneau conjointement avec les atomes auxquels ils sont liés, et
A³-G²-A⁴ représente un ligand bidenté anionique, A³ et A⁴ représentent chacun indépendamment un atome de carbone, un atome d'oxygène ou un atome d'azote, et ces atomes peuvent chacun être des atomes constituant un anneau ; G² représente une seule liaison ou un groupe atomique constituant le ligand bidenté conjointement avec A³ et A⁴ ; et lorsqu'il y a une pluralité de A³-G²-A⁴, ils peuvent être les mêmes ou différents.

4. Dispositif luminescent selon la revendication 3, dans lequel l'unité constitutive est une unité constitutive représentée par la formule (1B), une unité constitutive représentée par la formule (2B), une unité constitutive représentée par la formule (3B), ou une unité constitutive représentée par la formule (4B) : 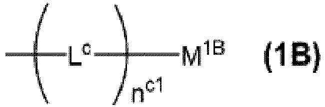 dans lequel
M^{1B} représente un groupe formé en enlevant, à partir du complexe métallique représenté par la formule (2), un atome d'hydrogène directement lié à un atome de carbone ou un hétéroatome constituant le complexe métallique,
L^{C} représente un atome d'oxygène, un atome de soufre, -N(R^{A})-, -C(R^{B})₂-, - C(R^{B})=C(R^{B})-, -C=C-, un groupe arylène, ou un groupe hétérocyclique divalent, et ces groupes peuvent chacun avoir un substituant ; R^{A} représente un atome d'hydrogène, un groupe alkyle, un groupe cycloalkyle, un groupe aryle, ou un groupe hétérocyclique monovalent, et ces groupes peuvent chacun avoir un substituant ; R^{B} représente un atome d'hydrogène, un groupe alkyle, un groupe cycloalkyle, un groupe alkoxy, un groupe cycloalkoxy, un groupe aryle, ou un groupe hétérocyclique monovalent, et ces groupes peuvent chacun avoir un substituant ; la pluralité de R^{B} peuvent être les mêmes ou différents et peuvent être liés les uns aux autres pour former un anneau conjointement avec l'atome de carbone auxquels ils sont liés ; et, lorsqu'il y a une pluralité de L^{C}, ils peuvent être les mêmes ou différents, et
n^{c1} représente un nombre entier relatif de 0 ou plus ; 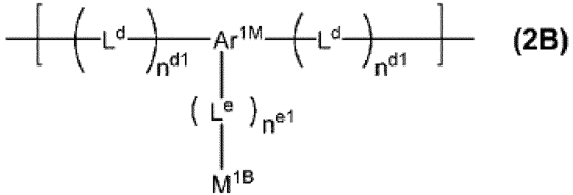
dans lequel
M^{1B} a la même signification que celle décrite ci-dessus,
L^{d} et L^{e} représentent chacun indépendamment un atome d'oxygène, un atome de soufre, -N(R^{A})-, -C(R^{B})₂-, -C(R^{B})=C(R^{B})-, -C=C-, un groupe arylène, ou un groupe hétérocyclique divalent, et ces groupes peuvent chacun avoir un substituant ; R^{A} et R^{B} ont la même signification que celle décrite ci-dessus ; et lorsqu'il y a une pluralité de L^{d} et de L^{e}, ils peuvent être les mêmes ou différents dans chaque cas,
n^{d1} et n^{e1} représentent chacun indépendamment un nombre entier relatif de 0 ou plus, et la pluralité de n^{d1} peuvent être les mêmes ou différents, et
Ar^{1M} représente un groupe hydrocarbure aromatique ou un groupe hétérocyclique, et ces groupes peuvent chacun avoir un substituant ; 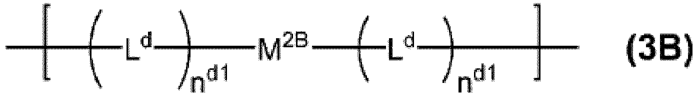
dans lequel
L^{d} et n^{d1} ont la même signification que celle décrite ci-dessus, et
M^{2B} représente un groupe obtenu en enlevant, à partir du complexe métallique représenté par la formule (2), deux atomes d'hydrogène directement liés à un atome de carbone ou un hétéroatome constituant le complexe métallique, 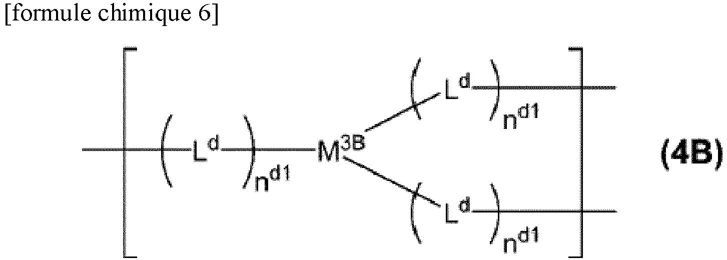
dans lequel,
L^{d} et n^{d1} ont la même signification que celle décrite ci-dessus, et
M^{3B} représente un groupe obtenu en enlevant, à partir du complexe métallique représenté par la formule (2), trois atomes d'hydrogène directement liés à un atome de carbone ou un hétéroatome constituant le complexe métallique.

5. Dispositif luminescent selon l'une quelconque des revendication 2 à 4, dans lequel le complexe métallique représenté par la formule (2) est un complexe métallique représenté par la formule (2-B), de préférence un complexe métallique représenté par la formule (2-B1), un complexe métallique représenté par la formule (2-B2), un complexe métallique représenté par la formule (2-B3), un complexe métallique représenté par la formule (2-B4), ou un complexe métallique représenté par la formule (2-B5) : 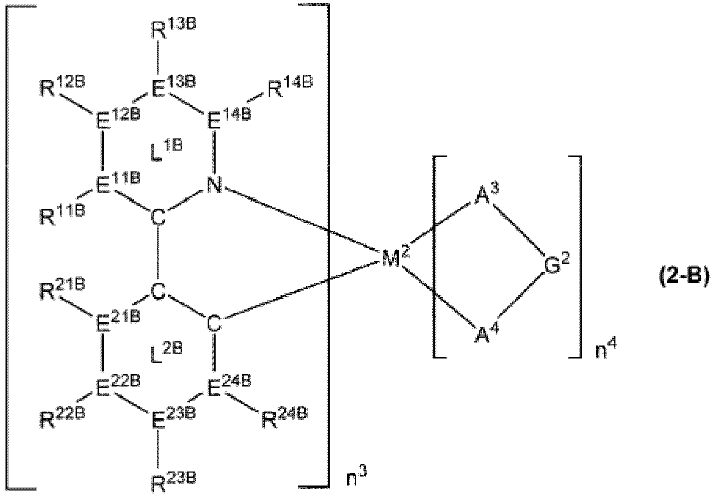 dans lequel
M², n³, n⁴, et A³-G²-A⁴ ont la même signification que celle décrite ci-dessus,
E^{11B}, E^{12B}, E^{13B}, E^{14B}, E^{21B}, E^{22B}, E^{23B} et E^{24B} représentent chacun indépendamment un atome d'azote ou un atome de carbone ; lorsqu'il y a une pluralité de : E^{11B}, E^{12B}, E^{13B}, E^{14B}, E^{21B}, E^{22B}, E^{23B} et E^{24B}, ils peuvent être les mêmes ou différents dans chaque cas ; lorsque E^{11B} est un atome d'azote, R^{11B} est absent; lorsque E^{12B} est un atome d'azote, R^{12B} est absent, lorsque E^{13B} est un atome d'azote, R^{13B} est absent ; lorsque E^{14B} est un atome d'azote, R^{14B} est absent ; lorsque E^{21B} est un atome d'azote R^{21B} est absent ; lorsque E^{22B} est un atome d'azote, R^{22B} est absent ; lorsque E^{23B} est un atome d'azote, R^{23B} est absent ; et lorsque E^{24B} est un atome d'azote, R^{24B} est absent,
R^{11B}, R^{12B}, R^{13B}, R^{14B}, R^{21B}, R^{22B}, R^{23B} et R^{24B} représentent chacun indépendamment un atome d'hydrogène, un groupe alkyle, un groupe cycloalkyle, un groupe alkoxy, un groupe cycloalkoxy, un groupe aryle, un groupe aryloxy, un anneau hétérocyclique monovalent, un groupe amino substitué, ou un atome d'halogène, et ces groupes peuvent chacun avoir un substituant ; lorsqu'il y a une pluralité de : R^{11B}, R^{12B}, R^{13B}, R^{14B}, R^{21B}, R^{22B}, R^{23B} et R^{24B}, ils peuvent être les mêmes ou différents dans chaque cas ; et R^{11B} et R^{12B}, R^{12B} et R^{13B}, R^{13B} et R^{14B}, R^{11B} et R^{21B}, R^{21B} and R^{22B}, R^{22B} et R^{23B}, et R^{23B} et R^{24B} peuvent chacun être liés l'un à l'autre pour former un anneau conjointement avec les atomes auxquels ils sont liés,
l'anneau L^{1B} représente un anneau pyridine ou un anneau pyrimidine constitué de : un atome d'azote, un atome de carbone, E^{11B}, E^{12B}, E^{13B}, et E^{14B}, et
l'anneau L^{2B} représente un anneau benzène, un anneau pyridine, ou un anneau pyrimidine constitué de : deux atomes de carbone, E^{21B}, E^{22B}, E^{23B}, et E^{24B} ; 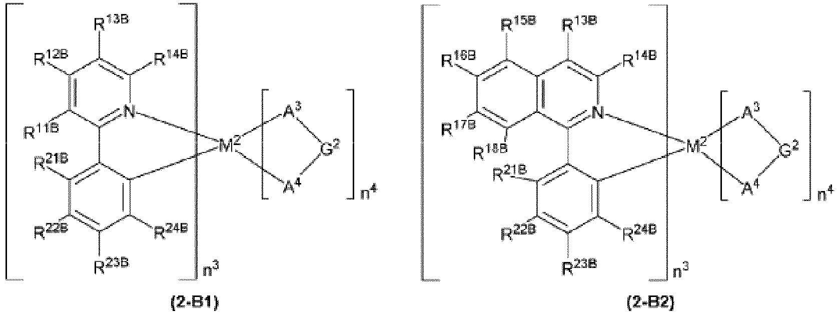 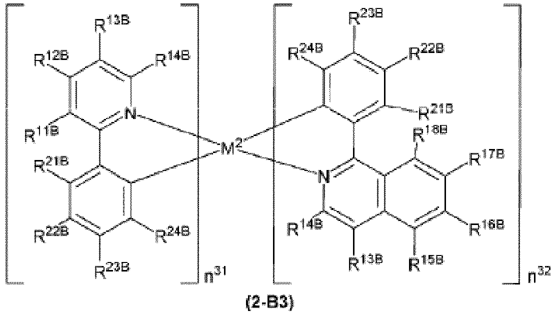 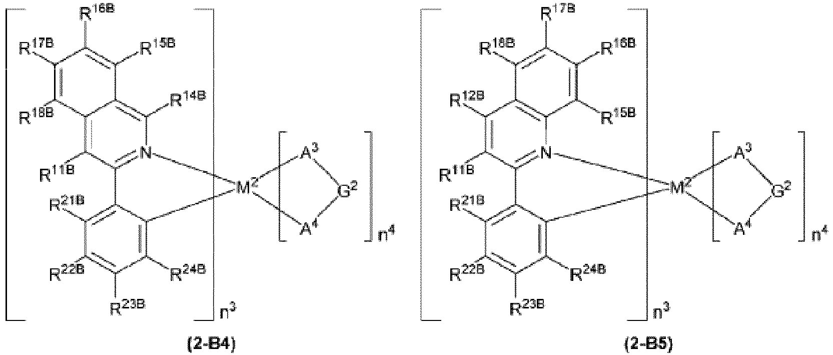
dans lequel
M² , n³, n⁴, A³-G²-A⁴, R^{11B}, R^{12B} R^{13B} R^{14B}, R^{21B}, R^{22B}, R^{23B} et R^{24B} ont les mêmes significations que celles décrites ci-dessus,
n³¹ et n³² représentent chacun indépendamment un nombre entier relatif d'1 ou plus, et n³¹ + n³² est 2 ou 3 ; lorsque M² est un atome de rhodium ou un atome d'iridium, n³¹ + n³² est 3 ; et lorsque M² est un atome de palladium ou un atome de platine, n³¹ + n³² est 2 et
R^{15B}, R^{16B}, R^{17B}, et R^{18B} représentent chacun indépendamment un atome d'hydrogène, un groupe alkyle, un groupe cycloalkyle, un groupe alkoxy, un groupe cycloalkoxy, un groupe aryle, un groupe aryloxy, un groupe hétérocyclique monovalent, un groupe amino substitué, ou un atome d'halogène, et ces groupes peuvent chacun avoir un substituant ; lorsqu'il y a une pluralité de : R^{15B}, R^{16B}, R^{17B}, et R^{18B}, ils peuvent être les mêmes ou différents dans chaque cas ; R^{15B} et R^{16B}, R^{16B} et R^{17B} , et R^{17B} et R^{18B} peuvent chacun être liés l'un à l'autre pour former un anneau conjointement avec les atomes auxquels ils sont liés.

6. Dispositif luminescent selon l'une quelconque des revendication 1 à 5, dans lequel le complexe métallique représenté par la formule (1) est un complexe métallique représenté par la formule (1-A) : 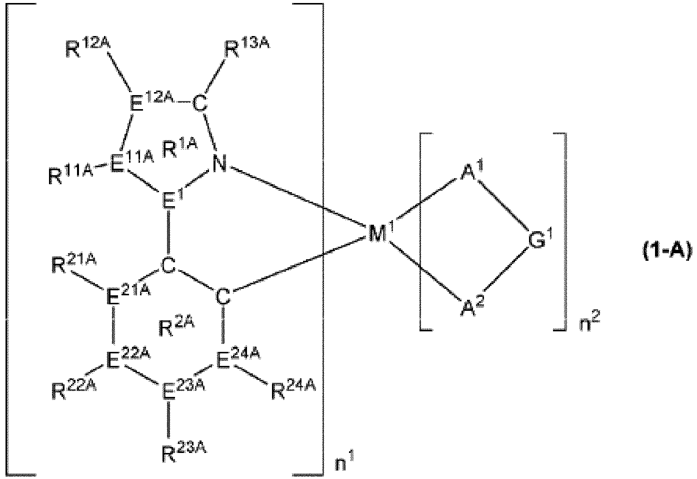 dans lequel
M¹, n¹, n², anneau R^{1A}, E¹, E^{11A}, E^{12A}, R^{11A}, R^{12A}, R^{13A}, et A¹-G¹-A² ont les mêmes significations que celles décrites ci-dessus,
l'anneau R^{2A} représente un anneau benzène, un anneau pyridine, ou un anneau pyrimidine constitué de : deux atomes de carbone, E^{21A}, E^{22A}, E^{23A}, et E^{24A},
E^{21A}, E^{22A}, E^{23A}, et E^{24A} représentent chacun indépendamment un atome d'azote ou un atome de carbone ; lorsqu'il y a une pluralité de : E^{21A}, E^{22A}, E^{23A}, et E^{24A}, ils peuvent être les mêmes ou différents dans chaque cas ; lorsque E^{21A} est un atome d'azote, R^{21A} est absent ; lorsque E^{22A} est un atome d'azote, R^{22A} est absent ; lorsque E^{23A} est un atome d'azote, R^{23A} est absent ; et lorsque E^{24A} est un atome d'azote, R^{24A} est absent, et
R^{21A}, R^{22A}, R^{23A}, et R^{24A} représentent chacun un atome d'hydrogène, un groupe alkyle, un groupe cycloalkyle, un groupe alkoxy, un groupe cycloalkoxy, un groupe aryle, un groupe aryloxy, un groupe hétérocyclique monovalent, un groupe amino substitué, ou un atome d'halogène, et ces groupes peuvent chacun avoir un substituant ; lorsqu'il y a une pluralité de : R^{21A}, R^{22A}, R^{23A}, et R^{24A}, ils peuvent être les mêmes ou différents dans chaque cas ; R^{21A} et R^{22A} peuvent être liés l'un à l'autre pour former un anneau conjointement avec les atomes auxquels ils sont liés ; R^{22A} et R^{23A} peuvent être liés l'un à l'autre pour former un anneau conjointement avec les atomes auxquels ils sont liés ; R^{23A} et R^{24A} peuvent être liés l'un à l'autre pour former un anneau conjointement avec les atomes auxquels ils sont liés ; et R^{11A} et R^{21A} peuvent être liés l'un à l'autre pour former un anneau conjointement avec les atomes auxquels ils sont liés.

7. Dispositif luminescent selon la revendication 6, dans lequel le complexe métallique représenté par la formule (1-A) est un complexe métallique représenté par la formule (1-A1), un complexe métallique représenté par la formule (1-A2), un complexe métallique représenté par la formule (1-A3), ou un complexe métallique représenté par la formule (1-A4) : 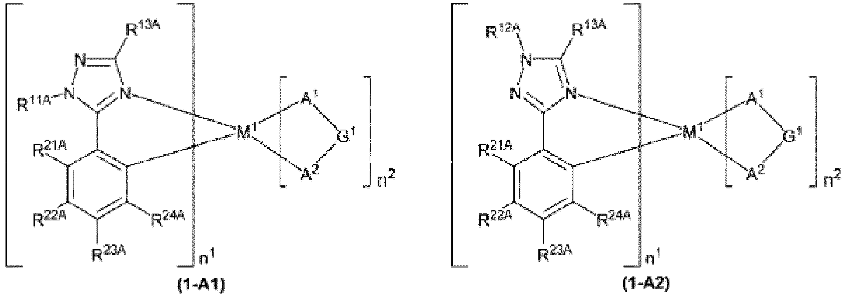 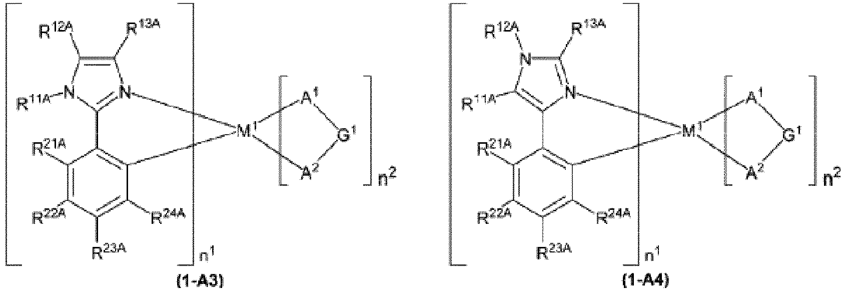 dans lequel M¹, n¹, n², R^{11A}, R^{12A}, R^{13A}, R^{21A}, R^{22A}, R^{23A}, R^{24A}, et A¹-G¹-A² ont les mêmes significations que celles décrites ci-dessus.

8. Dispositif luminescent selon l'une quelconque des revendication 1 à 7, dans lequel R^{13A} est un groupe aryle qui peut avoir un substituant.

9. Dispositif luminescent selon l'une quelconque des revendication 1 à 8, dans lequel la première couche luminescente comprend en outre un composé représenté par la formule (H-1) : 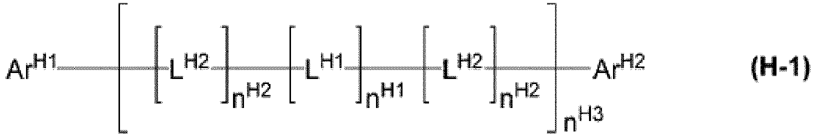 dans lequel
Ar^{H1} et Ar^{H2} représentent chacun indépendamment un groupe aryle ou un groupe hétérocyclique monovalent, et ces groupes peuvent chacun avoir un substituant,
n^{H1} et n^{H2} représentent chacun indépendamment 0 ou 1 ; lorsqu'il y a une pluralité de n^{H1}, ils peuvent être les mêmes ou différents ; et la pluralité de n^{H2} peuvent être les mêmes ou différents ;
n^{H3} représente un nombre entier relatif de 0 ou plus,
L^{H1} représente un groupe arylène, un groupe hétérocyclique divalent, ou un groupe représenté par -[C(R^{H11})₂]n^{H11}-, et ces groupes peuvent chacun avoir un substituant ; lorsqu'il y a une pluralité de L^{H1}, ils peuvent être les mêmes ou différents ; n^{H11} représente un nombre entier relatif d'1 ou plus et de 10 ou moins ; R^{H11} représente un atome d'hydrogène, un groupe alkyle, un groupe cycloalkyle, un groupe alkoxy, un groupe cycloalkoxy, un groupe aryle, ou un groupe hétérocyclique monovalent, et ces groupes peuvent chacun avoir un substituant ; et la pluralité de R^{H11} peuvent être les mêmes ou différents et peuvent être liés les uns aux autres pour former un anneau conjointement avec l'atome de carbone auxquels ils sont liés, et
L^{H2} représente un groupe représenté par -N(-L^{H21}-R^{H21})- ; lorsqu'il y a une pluralité de L^{H2}, ils peuvent être les mêmes ou différents ; L^{H21} représente une seule liaison, un groupe arylène, ou un groupe hétérocyclique divalent, et ces groupes peuvent chacun avoir un substituant ; R^{H21} représente un atome d'hydrogène, un groupe alkyle, un groupe cycloalkyle, un groupe aryle, ou un groupe hétérocyclique monovalent, et ces groupes peuvent chacun avoir un substituant.

10. Dispositif luminescent selon l'une quelconque des revendication 1 à 9,
dans lequel la première couche luminescente et la seconde couche luminescente sont adjacentes l'une à l'autre.

11. Dispositif luminescent selon l'une quelconque des revendication 1 à 10, dans lequel la seconde couche luminescente est prévue entre l'anode et la première couche luminescente.

12. Dispositif luminescent selon la revendication 2, dans lequel au moins un sélectionné parmi le groupe constitué de : l'anneau L¹ et l'anneau L² a, en tant que substituant, un groupe représenté par la formule (D-A), (D-B) ou (D-C) : 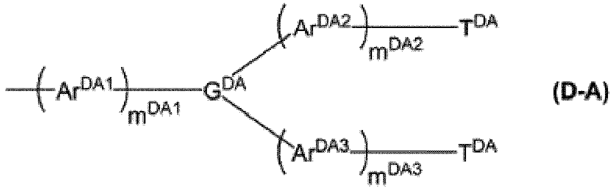 dans lequel
m^{DA1}, m^{DA2}, et m^{DA3} représentent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant,
Ar^{DA1}, Ar^{DA2}, et Ar^{DA3} représentent chacun indépendamment un groupe arylène ou un groupe hétérocyclique divalent, et ces groupes peuvent chacun avoir un substituant ; et lorsqu'il y a une pluralité de : Ar^{DA1}, Ar^{DA2}, et Ar^{DA3}, ils peuvent être les mêmes ou différents dans chaque cas, et
T^{DA} représente un groupe aryle ou un groupe hétérocyclique monovalent, et ces groupes peuvent chacun avoir un substituant ; et la pluralité de T^{DA} peuvent être les mêmes ou différents ; 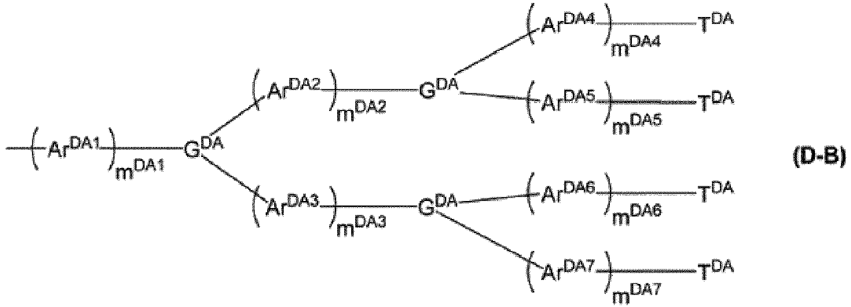
dans lequel
m^{DA1}, m^{DA2}, m^{DA3}, m^{DA4}, m^{DA5}, m^{DA6} et m^{DA7} représentent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant ; la pluralité de G^{DA} peuvent être les mêmes ou différents,
Ar^{DA1}, Ar^{DA2}, Ar^{DA3}, Ar^{DA4}, Ar^{DA5}, Ar^{DA6} et Ar^{DA7} représentent chacun indépendamment un groupe arylène ou un groupe hétérocyclique divalent, et ces groupes peuvent chacun avoir un substituant ; et lorsqu'il y a une pluralité de : Ar^{DA1}, Ar^{DA2}, Ar^{DA3}, Ar^{DA4}, Ar^{DA5}, Ar^{DA6} et Ar^{DA7}, ils peuvent être les mêmes ou différents dans chaque cas, et
T^{DA} représente un groupe aryle ou un groupe hétérocyclique monovalent, et ces groupes peuvent chacun avoir un substituant ; la pluralité de T^{DA} peuvent être les mêmes ou différents ; 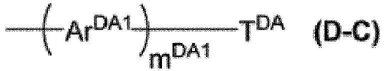
dans lequel
m^{DA1} représente un nombre entier relatif de 0 ou plus,
Ar^{DA1} représente un groupe arylène ou un groupe hétérocyclique divalent, et ces groupes peuvent chacun avoir un substituant ; et lorsqu'il y a une pluralité de Ar^{DA1}, ils peuvent être les mêmes ou différents, et
T^{DA} représente un groupe aryle ou un groupe hétérocyclique monovalent, et ces groupes peuvent chacun avoir un substituant.

13. Dispositif luminescent selon la revendication 3, dans lequel au moins un sélectionné parmi le groupe constitué de : l'anneau L¹ et l'anneau L² a, en tant que substituant, un groupe représenté par la formule (D-A), (D-B) ou (D-C) : 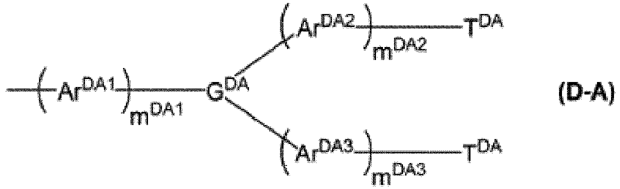 dans lequel
m^{DA1}, m^{DA2}, et m^{DA3} représentent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant,
Ar^{DA1}, Ar^{DA2}, et Ar^{DA3} représentent chacun indépendamment un groupe arylène ou un groupe hétérocyclique divalent, et ces groupes peuvent chacun avoir un substituant ; et lorsqu'il y a une pluralité de : Ar^{DA1}, Ar^{DA2}, et Ar^{DA3}, ils peuvent être les mêmes ou différents dans chaque cas, et
T^{DA} représente un groupe aryle ou un groupe hétérocyclique monovalent, et ces groupes peuvent chacun avoir un substituant ; et la pluralité de T^{DA} peuvent être les mêmes ou différents ; 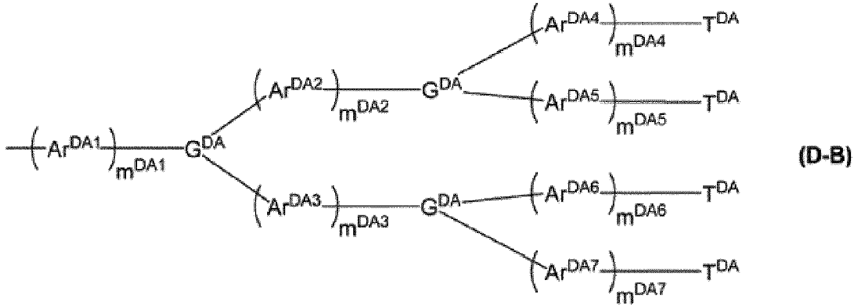
dans lequel
m^{DA1}, m^{DA2}, m^{DA3}, m^{DA4}, m^{DA5}, m^{DA6} et m^{DA7} représentent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant ; la pluralité de G^{DA} peuvent être les mêmes ou différents,
Ar^{DA1}, Ar^{DA2}, Ar^{DA3}, Ar^{DA4}, Ar^{DA5}, Ar^{DA6} et Ar^{DA7} représentent chacun indépendamment un groupe arylène ou un groupe hétérocyclique divalent, et ces groupes peuvent chacun avoir un substituant ; et lorsqu'il y a une pluralité de : Ar^{DA1}, Ar^{DA2}, Ar^{DA3}, Ar^{DA4}, Ar^{DA5}, Ar^{DA6} et Ar^{DA7}, ils peuvent être les mêmes ou différents dans chaque cas, et
T^{DA} représente un groupe aryle ou un groupe hétérocyclique monovalent, et ces groupes peuvent chacun avoir un substituant ; la pluralité de T^{DA} peuvent être les mêmes ou différents ; 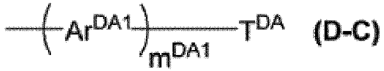
dans lequel
m^{DA1} représente un nombre entier relatif de 0 ou plus,
Ar^{DA1} représente un groupe arylène ou un groupe hétérocyclique divalent, et ces groupes peuvent chacun avoir un substituant ; et lorsqu'il y a une pluralité de Ar^{DA1}, ils peuvent être les mêmes ou différents, et
T^{DA} représente un groupe aryle ou un groupe hétérocyclique monovalent, et ces groupes peuvent chacun avoir un substituant.

14. Dispositif luminescent selon la revendication 5, dans lequel au moins un sélectionné parmi le groupe constitué de : R^{11B}, R^{12B}, R^{13B}, R^{21B}, R^{22B}, R^{23B}, R^{24B} est un groupe représenté par la formule (D-A), (D-B) ou (D-C) : 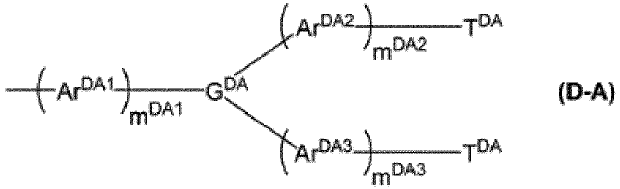 dans lequel
m^{DA1}, m^{DA2}, et m^{DA3} représentent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant,
Ar^{DA1}, Ar^{DA2}, et Ar^{DA3} représentent chacun indépendamment un groupe arylène ou un groupe hétérocyclique divalent, et ces groupes peuvent chacun avoir un substituant ; et, lorsqu'il y a une pluralité de : Ar^{DA1}, Ar^{DA2}, et Ar^{DA3}, ils peuvent être les mêmes ou différents dans chaque cas, et
T^{DA} représente un groupe aryle ou un groupe hétérocyclique monovalent, et ces groupes peuvent chacun avoir un substituant ; et la pluralité de T^{DA} peuvent être les mêmes ou différents ; 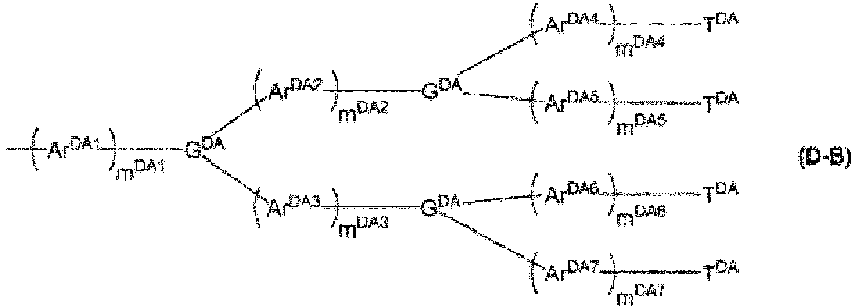
dans lequel
m^{DA1}, m^{DA2}, m^{DA3}, m^{DA4}, m^{DA5}, m^{DA6} et m^{DA7} représentent chacun indépendamment un nombre entier relatif de 0 ou plus,
G^{DA} représente un atome d'azote, un groupe hydrocarbure aromatique, ou un groupe hétérocyclique, et ces groupes peuvent chacun avoir un substituant ; la pluralité de G^{DA} peuvent être les mêmes ou différents,
Ar^{DA1}, Ar^{DA2}, Ar^{DA3}, Ar^{DA4}, Ar^{DA5}, Ar^{DA6} et Ar^{DA7} représentent chacun indépendamment un groupe arylène ou un groupe hétérocyclique divalent, et ces groupes peuvent chacun avoir un substituant ; et lorsqu'il y a une pluralité de : Ar^{DA1}, Ar^{DA2}, Ar^{DA3}, Ar^{DA4}, Ar^{DA5}, Ar^{DA6} et Ar^{DA7}, ils peuvent être les mêmes ou différents dans chaque cas, et
T^{DA} représente un groupe aryle ou un groupe hétérocyclique monovalent, et ces groupes peuvent chacun avoir un substituant ; la pluralité de T^{DA} peuvent être les mêmes ou différents ; 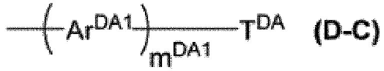
dans lequel
m^{DA1} représente un nombre entier relatif de 0 ou plus,
Ar^{DA1} représente un groupe arylène ou un groupe hétérocyclique divalent, et ces groupes peuvent chacun avoir un substituant ; et lorsqu'il y a une pluralité de Ar^{DA1}, ils peuvent être les mêmes ou différents, et
T^{DA} représente un groupe aryle ou un groupe hétérocyclique monovalent, et ces groupes peuvent chacun avoir un substituant.
